(19) Europäisches Patentamt
European Patent Office
Office européen des brevets

(11) EP 1 315 285 B1

(12) # EUROPEAN PATENT SPECIFICATION

(45) Date of publication and mention of the grant of the patent:
**03.06.2009 Bulletin 2009/23**

(51) Int Cl.:
***H03D 3/00*** *(2006.01)* ***H03D 7/00*** *(2006.01)*

(21) Application number: **02079190.1**

(22) Date of filing: **20.10.1999**

(54) **Method and system for down-converting an electromagnetic signal**

Verfahren und System zur Abwärtsumsetzung von einem elektromagnetischen Signal

Procédé et système de conversion-abaissement d'un signal électromagnetique

(84) Designated Contracting States:
**AT BE CH CY DE DK ES FI FR GB GR IE IT LI LU MC NL PT SE**
Designated Extension States:
**AL LT LV MK RO SI**

(30) Priority: **21.10.1998 US 176022**
**16.04.1999 US 293095**
**16.04.1999 US 293342**

(43) Date of publication of application:
**28.05.2003 Bulletin 2003/22**

(62) Document number(s) of the earlier application(s) in accordance with Art. 76 EPC:
**99954996.7 / 1 125 359**

(73) Proprietor: **Parker Vision, Inc.**
**Jacksonville, FL 32256 (US)**

(72) Inventors:
- **Sorrels, David F.**
  **Middleburgh, FL 32068 (US)**
- **Bultman, Michael J.**
  **Jacksonville, FL 32246 (US)**
- **Cook, Robert W.**
  **Switzerland, FL 32259 (US)**
- **Looke, Richard C.**
  **Jacksonville, FL 32257 (US)**
- **Moses, Charley D. Jr.**
  **DeBary, FL 32713 (US)**
- **Rawlins, Gregory S.**
  **Heathrow, FL 32746 (US)**
- **Rawlins, Michael W.**
  **Lake Mary, FL 32746-5917 (US)**

(74) Representative: **Cross, James Peter Archibald et al**
**R.G.C. Jenkins & Co.**
**26 Caxton Street**
**London SW1H 0RJ (GB)**

(56) References cited:

| | |
|---|---|
| **WO-A-94/05087** | **WO-A-96/02977** |
| **WO-A-96/39750** | **US-A- 4 888 557** |
| **US-A- 5 172 070** | **US-A- 5 557 641** |

- **SHEN D H ET AL: "A 900MHZ INTEGRATED DISCRETE-TIME FILTERING RF FRONT-END" IEEE INTERNATIONAL SOLID STATE CIRCUITS CONFERENCE, vol. 39, February 1996 (1996-02), page 54/55, 417, XP000685536**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

## Description

### *Background of the Invention*

### *Field of the Invention*

The present invention relates to down-conversion of electromagnetic (EM) signals. More particularly, the present invention relates to direct down-conversion of EM modulated carrier signals to demodulated baseband signals. The present invention also relates to transferring energy at aliasing rates.

### *Related Art*

Electromagnetic (EM) information signals (baseband signals) include, but are not limited to, video baseband signals, voice baseband signals, computer baseband signals, etc. Baseband signals include analog baseband signals and digital baseband signals.

It is often beneficial to propagate EM signals at higher frequencies. This is generally true regardless of whether the propagation medium is wire, optic fiber, space, air, liquid, etc.. To enhance efficiency and practicality, such as improved ability to radiate and added ability for multiple channels of baseband signals, up-conversion to a higher frequency is utilized. Conventional up-conversion processes modulate higher frequency carrier signals with baseband signals. Modulation refers to a variety of techniques for impressing information from the baseband signals onto the higher frequency carrier signals. The resultant signals are referred to herein as modulated carrier signals. For example, the amplitude of an AM carrier signal varies in relation to changes in the baseband signal, the frequency of an FM carrier signal varies in relation to changes in the baseband signal, and the phase of a PM carrier signal varies in relation to changes in the baseband signal.

In order to process the information that was in the baseband signal, the information must be extracted, or demodulated, from the modulated carrier signal. However, because conventional signal processing technology is limited in operational speed, conventional signal processing technology cannot easily demodulate a baseband signal from higher frequency modulated carrier signal directly. Instead, higher frequency modulated carrier signals must be down-converted to an intermediate frequency (IF), from where a conventional demodulator can demodulate the baseband signal.

Conventional down-converters include electrical components whose properties are frequency dependent. As a result, conventional down-converters are designed around specific frequencies or frequency ranges and do not work well outside their designed frequency range.

Conventional down-converters generate unwanted image signals and thus must include filters for filtering the unwanted image signals. However, such filters reduce the power level of the modulated carrier signals. As a result, conventional down-converters include power amplifiers, which require external energy sources.

When a received modulated carrier signal is relatively weak, as in, for example, a radio receiver, conventional down-converters include additional power amplifiers, which require additional external energy. WO-A-96/02977, for example, describes such a down-converter.

What is needed includes, without limitation:

an improved method and system for down-converting EM signals;
a method and system for directly down-converting modulated carrier signals to demodulated baseband signals;
a method and system for transferring energy and for augmenting such energy transfer when down-converting EM signals;
a controlled impedance method and system for down-converting an EM signal;
a method and system for down-converting EM signals using a universal down-converter design that can be easily configured for different frequencies;
a method and system for down-converting EM signals using a local oscillator frequency that is substantially lower than the carrier frequency;
a method and system for down-converting EM signals using only one local oscillator;
a method and system for down-converting EM signals that uses fewer filters than conventional down-converters;
a method and system for down-converting EM signals using less power than conventional down-converters;
a method and system for down-converting EM signals that uses less space than conventional down-converters;
a method and system for down-converting EM signals that uses fewer components than conventional down-converters;
a method and system for down-converting EM signals that can be implemented on an integrated circuit (IC); and
a method and system for down-converting EM signals that can also be used as a method and system for up-converting a baseband signal.

### *Summary of the Invention*

Briefly stated, the present invention is directed to methods, systems, and apparatuses for down-converting an electromagnetic (EM) signal by aliasing the EM signal, and applications thereof.

Generally, the invention operates by receiving an EM signal. The invention also receives an aliasing signal having an aliasing rate. The invention aliases the EM signal according to the aliasing signal to down-convert the EM signal. The term aliasing, as used herein and as covered by the invention, refers to both down-converting an EM signal by under-sampling the EM signal at an aliasing rate, and down-converting an EM signal by transferring energy from the EM signal at the aliasing rate.

In an embodiment, the invention down-converts the EM signal to a demodulated baseband information signal.

The invention is applicable to any type of EM signal, including but not limited to, modulated carrier signals (the invention is applicable to any modulation scheme or combination thereof) and unmodulated carrier signals.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

The drawing in which an element first appears is typically indicated by the leftmost digit(s) in the corresponding reference number.

### *Brief Description of the Drawings*

The present invention will be described with reference to the accompanying drawings wherein:

FIGS. 1 illustrates a structural block diagram of an example modulator;
FIG. 2 illustrates an example analog modulating baseband signal;
FIG. 3 illustrates an example digital modulating baseband signal;
FIG. 4 illustrates an example carrier signal;
FIGS. 5A-5C illustrate example signal diagrams related to amplitude modulation;
FIGS. 6A-6C illustrate example signal diagrams related to amplitude shift keying modulation;
FIGS. 7A-7C illustrate example signal diagrams related to frequency modulation;
FIGS. 8A-8C illustrate example signal diagrams related to frequency shift keying modulation;
FIGS. 9A-9C illustrate example signal diagrams related to phase modulation;
FIGS. 10A-10C illustrate example signal diagrams related to phase shift keying modulation;
FIG. 11 illustrates a structural block diagram of a conventional receiver;
FIG. 12 illustrates a structural block diagram of an aliasing system according to an embodiment of the invention;
FIGS. 13A-D illustrate various flowcharts for down-converting an EM signal by under-sampling the EM signal according to embodiments of the invention;
FIG. 14A illustrates a structural block diagram of a make before break under-sampling system according to an embodiment of the invention;
FIG. 14B illustrates an example timing diagram of an under sampling signal according to an embodiment of the invention;
FIG. 14C illustrates an example timing diagram of an isolation signal according to an embodiment of the invention;
FIG. 15 illustrates a structural block diagram of sample and hold module according to an embodiment of the invention;
FIGS. 16A-D illustrate example implementations of a switch module according to embodiments of the invention;
FIGS 17A-B illustrate a conceptual illustration of aliasing including under-sampling and energy transfer according to embodiments of the invention;
FIGS. 18A-D illustrate various flowchart for down-converting an EM signal by transferring energy from the EM signal at an aliasing rate according to embodiments of the invention;
FIGS. 19A-D illustrate an example signal diagram associated with direct down-conversion according to embodiments of the invention;
FIGS. 20A-F illustrate directly down-converting an analog AM signal to a demodulated baseband signal according to embodiments of the invention;
FIGS. 21A-F illustrate directly down-converting an digital AM signal to a demodulated baseband signal according to embodiments of the invention;
FIGS. 22A-F illustrate directly down-converting an analog PM signal to a demodulated baseband signal according to embodiments of the invention;

FIGS. 23A-F illustrate directly down-converting an digital PM signal to a demodulated baseband signal according to embodiments of the invention;

FIG. 24 illustrates a block diagram of an energy transfer system according to an embodiment of the invention;

FIG. 25A illustrates an exemplary gated transfer system according to an embodiment of the invention;

FIG. 25B illustrates an exemplary inverted gated transfer system according to an embodiment of the invention;

FIG. 26 illustrates an example embodiment of the gated transfer module according to an embodiment of the invention;

FIGS. 27A-D illustrate example implementations of a switch module according to embodiments of the invention;

FIG. 28A illustrates an example embodiment of the gated transfer module as including a break-before-make module according to an embodiment of the invention;

FIG. 28B illustrates an example timing diagram for an energy transfer signal according to an embodiment of the invention;

FIG. 28C illustrates an example timing diagram for an isolation signal according to an embodiment of the invention;

FIGS. 29A-F illustrate example storage modules according to embodiments of the invention;

FIG. 29G illustrates an integrated gated transfer system according to an embodiment of the invention;

FIGS. 29H-K illustrate example aperture generators;

FIG. 29L illustrates an oscillator according to an embodiment of the present invention;

FIG. 30 illustrates an energy transfer system with an optional energy transfer signal module according to an embodiment of the invention;

FIG. 31 illustrates an aliasing module with input and output impedance match according to an embodiment of the invention;

FIG. 32 illustrates an example pulse generator;

FIGS. 33A and B illustrate example waveforms related to the pulse generator of FIG. 32;

FIG. 34 illustrates an example energy transfer module with a switch module and a reactive storage module according to an embodiment of the invention;

FIG. 35 illustrates an example inverted gated transfer module as including a switch module and a storage module according to an embodiment of the invention;

FIGS. 36A-F illustrate an example signal diagrams associated with an inverted gated energy transfer module according to embodiments of the invention;

FIGS. 37A-F illustrate energy transfer modules in configured in various differential configurations according to embodiments of the invention;

FIGS. 38A-B illustrate example under-sampling systems according to embodiments of the invention;

FIGS. 39A-F illustrate example timing diagrams for under-sampling systems according to embodiments of the invention;

FIGS. 40A-F illustrate example timing diagrams for an under-sampling system when the load is a relatively low impedance load according to embodiments of the invention;

FIGS. 41A-F illustrate example timing diagrams for an under-sampling system when the holding capacitance has a larger value according to embodiments of the invention;

FIGS. 42A-B illustrate example energy transfer systems according to embodiments of the invention;

FIGS. 43A-F illustrate example timing diagrams for energy transfer systems according to embodiments of the present invention;

FIG. 44A illustrates an example energy transfer signal module according to an embodiment of the present invention;

FIG. 44B illustrates a flowchart of state machine operation according to an embodiment of the present invention;

FIG. 44C is an example energy transfer signal module;

FIG. 45 is a schematic diagram of a circuit to down-convert a 915 MHZ signal to a 5 MHZ signal using a 101.1 MHZ clock according to an embodiment of the present invention;

FIG. 46 shows simulation waveforms for the circuit of FIG. 45 according to embodiments of the present invention;

FIG. 47 is a schematic diagram of a circuit to down-convert a 915 MHZ signal to a 5 MHz signal using a 101 MHZ clock according to an embodiment of the present invention;

FIG. 48 shows simulation waveforms for the circuit of FIG. 47 according to embodiments of the present invention;

FIG. 49 is a schematic diagram of a circuit to down-convert a 915 MHZ signal to a 5 MHZ signal using a 101.1 MHZ clock according to an embodiment of the present invention;

FIG. 50 shows simulation waveforms for the circuit of FIG. 49 according to an embodiment of the present invention;

FIG. 51 shows a schematic of the circuit in FIG. 45 connected to an FSK source that alternates between 913 and 917 MHZ at a baud rate of 500 Kbaud according to an embodiment of the present invention;

FIG. 52 shows the original FSK waveform 5102 and the down-converted waveform 5104 at the output of the load impedance match circuit according to an embodiment of the present invention;

FIG. 53A illustrates an example energy transfer system according to an embodiment of the invention;

FIGS. 53B-C illustrate example timing diagrams for the example system of FIG. 53A;
FIG. 54 illustrates an example bypass network according to an embodiment of the invention;
FIG. 55 illustrates an example bypass network according to an embodiment of the invention;
FIG. 56 illustrates an example embodiment of the invention;
FIG. 57A illustrates an example real time aperture control circuit according to an embodiment of the invention;
FIG. 57B illustrates a timing diagram of an example clock signal for real time aperture control, according to an embodiment of the invention;
FIG. 57C illustrates a timing diagram of an example optional enable signal for real time aperture control, according to an embodiment of the invention;
FIG. 57D illustrates a timing diagram of an inverted clock signal for real time aperture control, according to an embodiment of the invention;
FIG. 57E illustrates a timing diagram of an example delayed clock signal for real time aperture control, according to an embodiment of the invention;
FIG. 57F illustrates a timing diagram of an example energy transfer including pulses having apertures that are controlled in real time, according to an embodiment of the invention;
FIG. 58 is a block diagram of a differential system that utilizes non-inverted gated transfer units, according to an embodiment of the invention;
FIG. 59 illustrates an example embodiment of the invention;
FIG. 60 illustrates an example embodiment of the invention;
FIG. 61 illustrates an example embodiment of the invention;
FIG. 62 illustrates an example embodiment of the invention;
FIG. 63 illustrates an example embodiment of the invention;
FIG. 64 illustrates an example embodiment of the invention;
FIG. 65 illustrates an example embodiment of the invention;
FIG. 66A is a timing diagram for the example embodiment of FIG. 62;
FIG. 66B is a timing diagram for the example embodiment of FIG. 63;
FIG. 67A is a timing diagram for the example embodiment of FIG. 64;
FIG. 67B is a timing diagram for the example embodiment of FIG. 65;
FIG. 68A illustrates and example embodiment of the invention;
FIG. 68B illustrates equations for determining charge transfer. in accordance with the present invention;
FIG. 68C illustrates relationships between capacitor charging and aperture, in accordance with the present invention;
FIG. 68D illustrates relationships between capacitor charging and aperture, in accordance with the present invention;
FIG. 68E illustrates power-charge relationship equations, in accordance with the present invention;
FIG. 68F illustrates insertion loss equations, in accordance with the present invention;
FIG. 69A illustrates aliasing module 6900 a single FET configuration;
FIG. 69B illustrates FET conductivity vs. VGS;
FIGS. 70A-C illustrate signal waveforms associated with aliasing module 6900;
FIG. 71 illustrates aliasing module 7100 with a complementary FET configuration;
FIGS. 72A-E illustrate signal waveforms associated with aliasing module 7100;
FIG. 73 illustrates aliasing module 7300;
FIG. 74 illustrates aliasing module 7400;
FIG. 75 illustrates aliasing module 7502;
FIG. 76 illustrates aliasing module 7602;
FIGs. 77-79 illustrate signal waveforms associated with aliasing module 7502;
FIGs. 80-82 illustrate signal waveforms associated with aliasing module 7602.
FIG. 83A is a block diagram of a splitter according to an embodiment of the invention;
FIG. 83B is a more detailed diagram of a splitter according to an embodiment of the invention;
FIGS. 83C and 83D are example waveforms related to the splitter of FIGS. 83A and 83B;
FIG. 83E is a block diagram of an I/Q circuit with a splitter according to an embodiment of the invention;
FIGS. 83F-83J are example waveforms related to the diagram of FIG. 83A;
FIG. 84 is a block diagram of a switch module according to an embodiment of the invention;
FIG. 85A is an implementation example of the block diagram of FIG. 84;
FIGS. 85B-85Q are example waveforms related to FIG. 85A;
FIG. 86A is another implementation example of the block diagram of FIG. 84;
FIGS. 86B-86Q are example waveforms related to FIG. 86A;
FIG. 87A is an example MOSFET embodiment of the invention;
FIG. 87B is an example MOSFET embodiment of the invention;
FIG. 87C is an example MOSFET embodiment of the invention;

FIG. 88A is another implementation example of the block diagram of FIG. 84;
FIGS. 88B-88Q are example waveforms related to FIG. 86A;

**Table of Contents**

**I. Introduction**

I. Modulation
- 1.1 Amplitude Modulation
- 1.2 Frequency Modulation
- 1.3 Phase Modulation

2. Demodulation

3. Overview of the Invention
- 3.1 Determining the Aliasing rate

4. Benefits of the Invention Using an Example Conventional Receiver for Comparison

**II. Energy Transfer**

1. Energy Transfer Compared to Under-Sampling
- 1.1 Review of Under-Sampling
  - 1.1.1 Effects of Lowering the Impedance of the Load
  - 1.1.2 Effects of Increasing the Value of the Holding Capacitance
- 1.2 Introduction to Energy Transfer

2. Directly Down-Converting an EM Signal to an Demodulated Baseband Signal by Transferring Energy from the EM Signal
- 2.1 High Level Description
  - 2.1.1 Operational Description
  - 2.1.2 Structural Description
- 2.2 Example Embodiments
  - 2.2.1 First Example Embodiment: Amplitude Modulation
    - 2.2.1.1 Operational Description
      - 2.2.1.1.1 Analog AM Carrier Signal
      - 2.2.1.1.2 Digital AM Carrier Signal
    - 2.2.1.2 Structural Description
  - 2.2.2 Second Example Embodiment: Phase Modulation
    - 2.2.2.1 Operational Description
      - 2.2.2.1.1 Analog PM Carrier Signal
      - 2.2.2.1.2 Digital PM Carrier Signal
    - 2.2.2.2 Structural Description

3. Implementation Examples
- 3.1 The Energy Transfer System as a Gated Transfer System

(continued)

**II. Energy Transfer**

- 3.1.1 The Gated Transfer System as a Switch Module and a Storage Module
- 3.1.2 The Gated Transfer System as Break-Before-Make Module
- 3.1.3 Example Implementations of the Switch Module
- 3.1.4 Example Implementations of the Storage Module
- 3.1.5 Optional Energy Transfer Signal Module
- 3.2 The Energy Transfer System as an Inverted Gated Transfer System
  - 3.2.1 The Inverted Gated Transfer System as a Switch Module and a Storage Module
- 3.3 Rail to Rail Operation for Improved Dynamic Range
  - 3.3.1 Introduction
  - 3.3.2 Complementary UFT Structure for Improved Dynamic Range
  - 3.3.3 Biased Configurations
  - 3.3.4 Simulation Examples
- 3.4 Optimized Switch Structures
  - 3.4.1 Splitter in CMOS
  - 3.4.2 I/Q Circuit
- 3.5 Example I and Q Implementations
  - 3.5.1 Switches of Different Sizes
  - 3.5.2 Reducing Overall Switch Area
  - 3.5.3 Charge Injection Cancellation
  - 3.5.4 Overlapped Capacitance

4. Optional Optimizations of Energy Transfer at an Aliasing Rate
- 4.1 Doubling the Aliasing Rate ($F_{AR}$) of the Energy Transfer Signal
- 4.2 Differential Implementations
  - 4.2.1 An Example Illustrating Energy Transfer Differentially
    - 4.2.1.1 Differential Input-to-Differential Output
    - 4.2.1.2 Single Input-to-Differential Output
    - 4.2.1.3 Differential Input-to-Single Output
  - 4.2.2 Specific Alternative Embodiments
  - 4.2.3 Specific Examples of Optimizations and Configurations for Inverted and Non-Inverted Differential Designs
- 4.3 Smoothing the Down-Converted Signal
- 4.4 Impedance Matching
- 4.5 Tanks and Resonant Structures
- 4.6 Charge and Power Transfer Concepts
- 4.7 Optimizing and Adjusting the Non-Negligible Aperture Width/Duration
  - 4.7.1 Varying Input and Output Impedances
  - 4.7.2 Real Time Aperture Control
- 4.8 Adding a Bypass Network
- 4.9 Modifying the Energy Transfer Signal Utilizing Feedback

5. Example Energy Transfer Downconverters

**III. Conclusions**

## *I. Introduction*

### *1. Modulation*

It is often beneficial to propagate electromagnetic (EM) signals at higher frequencies. This includes baseband signals, such as digital data information signals and analog information signals. A baseband signal can be up-converted to a higher frequency EM signal by using the baseband signal to modulate a higher frequency carrier signal, $F_C$. When used in this manner, such a baseband signal is herein called a modulating baseband signal $F_{MB}$.

Modulation imparts changes to the carrier signal $F_C$ that represent information in the modulating baseband signal $F_{MB}$. The changes can be in the form of amplitude changes, frequency changes, phase changes, etc., or any combination thereof. The resultant signal is referred to herein as a modulated carrier signal $F_{MC}$. The modulated carrier signal $F_{MC}$ includes the carrier signal $F_C$ modulated by the modulating baseband signal, $F_{MB}$ as in:

$$F_{MB} \text{ combined with } F_C \rightarrow F_{MC}$$

The modulated carrier signal $F_{MC}$ oscillates at, or near the frequency of the carrier signal $F_C$ and can thus be efficiently propagated.

FIG. 1 illustrates an example modulator 110, wherein the carrier signal $F_C$ is modulated by the modulating baseband signal $F_{MB}$, thereby generating the modulated carrier signal $F_{MC}$.

Modulating baseband signal $F_{MB}$ can be an analog baseband signal, a digital baseband signal, or a combination thereof.

FIG. 2 illustrates the modulating baseband signal $F_{MB}$, as an exemplary analog modulating baseband signal 210. The exemplary analog modulating baseband signal 210 can represent any type of analog information including, but not limited to, voice/speech data, music data, video data, etc. The amplitude of analog modulating baseband signal 210 varies in time.

Digital information includes a plurality of discrete states. For ease of explanation, digital information signals are discussed below as having two discrete states. But the invention is not limited to this embodiment.

FIG. 3 illustrates the modulating baseband signal $F_{MB}$ as an exemplary digital modulating baseband signal 310. The digital modulating baseband signal 310 can represent any type of digital data including, but not limited to, digital computer information and digitized analog information. The digital modulating baseband signal 310 includes a first state 312 and a second state 314. In an embodiment, first state 312 represents binary state 0 and second state 314 represents binary state 1. Alternatively, first state 312 represents binary state 1 and second state 314 represents binary state 0. Throughout the remainder of this disclosure, the former convention is followed, whereby first state 312 represents binary state zero and second state 314 represents binary state one. But the invention is not limited to this embodiment. First state 312 is thus referred to herein as a low state and second state 314 is referred to herein as a high state.

Digital modulating baseband signal 310 can change between first state 312 and second state 314 at a data rate, or baud rate, measured as bits per second.

Carrier signal $F_C$ is modulated by the modulating baseband signal $F_{MB}$, by any modulation technique, including, but not limited to, amplitude modulation (AM), frequency modulation (FM), phase modulation (PM), etc., or any combination thereof. Examples are provided below for amplitude modulating, frequency modulating, and phase modulating the analog modulating baseband signal 210 and the digital modulating baseband signal 310, on the carrier signal $F_C$. The examples are used to assist in the description of the invention. The invention is not limited to, or by, the examples.

FIG. 4 illustrates the carrier signal $F_C$ as a carrier signal 410. In the example of FIG. 4, the carrier signal 410 is illustrated as a 900 MHZ carrier signal. Alternatively, the carrier signal 410 can be any other frequency. Example modulation schemes are provided below, using the examples signals from FIGS. 2, 3 and 4.

#### *1.1 Amplitude Modulation*

In amplitude modulation (AM), the amplitude of the modulated carrier signal $F_{MC}$ is a function of the amplitude of the modulating baseband signal FMB. FIGS. 5A-5C illustrate example timing diagrams for amplitude modulating the carrier signal 410 with the analog modulating baseband signal 210. FIGS. 6A-6C illustrate example timing diagrams for amplitude modulating the carrier signal 410 with the digital modulating baseband signal 310.

FIG. 5A illustrates the analog modulating baseband signal 210. FIG. 5B illustrates the carrier signal 410. FIG. 5C illustrates an analog AM carrier signal 516, which is generated when the carrier signal 410 is amplitude modulated using the analog modulating baseband signal 210. As used herein, the term "analog AM carrier signal" is used to indicate that the modulating baseband signal is an analog signal.

The analog AM carrier signal 516 oscillates at the frequency of carrier signal 410. The amplitude of the analog AM carrier signal 516 tracks the amplitude of analog modulating baseband signal 210, illustrating that the information contained in the analog modulating baseband signal 210 is retained in the analog AM carrier signal 516.

FIG. 6A illustrates the digital modulating baseband signal 310. FIG. 6B illustrates the carrier signal 410. FIG. 6C illustrates a digital AM carrier signal 616, which is generated when the carrier signal 410 is amplitude modulated using the digital modulating baseband signal 310. As used herein, the term "digital AM carrier signal" is used to indicate that the modulating baseband signal is a digital signal.

The digital AM carrier signal 616 oscillates at the frequency of carrier signal 410. The amplitude of the digital AM carrier signal 616 tracks the amplitude of digital modulating baseband signal 310, illustrating that the information contained in the digital modulating baseband signal 310 is retained in the digital AM signal 616. As the digital modulating baseband signal 310 changes states, the digital AM signal 616 shifts amplitudes. Digital amplitude modulation is often referred to as amplitude shift keying (ASK), and the two terms are used interchangeably throughout the specification.

### *1.2 Frequency Modulation*

In frequency modulation (FM), the frequency of the modulated carrier signal $F_{MC}$ varies as a function of the amplitude of the modulating baseband signal $F_{MB}$. FIGS. 7A-7C illustrate example timing diagrams for frequency modulating the carrier signal 410 with the analog modulating baseband signal 210. FIGS. 8A-8C illustrate example timing diagrams for frequency modulating the carrier signal 410 with the digital modulating baseband signal 310.

FIG. 7A illustrates the analog modulating baseband signal 210. FIG. 7B illustrates the carrier signal 410. FIG. 7C illustrates an analog FM carrier signal 716, which is generated when the carrier signal 410 is frequency modulated using the analog modulating baseband signal 210. As used herein, the term "analog FM carrier signal" is used to indicate that the modulating baseband signal is an analog signal.

The frequency of the analog FM carrier signal 716 varies as a function of amplitude changes on the analog baseband signal 210. In the illustrated example, the frequency of the analog FM carrier signal 716 varies in proportion to the amplitude of the analog modulating baseband signal 210. Thus, at time t1, the amplitude of the analog baseband signal 210 and the frequency of the analog FM carrier signal 716 are at maximums. At time t3, the amplitude of the analog baseband signal 210 and the frequency of the analog AM carrier signal 716 are at minimums.

The frequency of the analog FM carrier signal 716 is typically centered around the frequency of the carrier signal 410. Thus, at time t2, for example, when the amplitude of the analog baseband signal 210 is at a mid-point, illustrated here as zero volts, the frequency of the analog FM carrier signal 716 is substantially the same as the frequency of the carrier signal 410.

FIG. 8A illustrates the digital modulating baseband signal 310. FIG. 8B illustrates the carrier signal 410. FIG. 8C illustrates a digital FM carrier signal 816, which is generated when the carrier signal 410 is frequency modulated using the digital baseband signal 310. As used herein, the term "digital FM carrier signal" is used to indicate that the modulating baseband signal is a digital signal.

The frequency of the digital FM carrier signal 816 varies as a function of amplitude changes on the digital modulating baseband signal 310. In the illustrated example, the frequency of the digital FM carrier signal 816 varies in proportion to the amplitude of the digital modulating baseband signal 310. Thus, between times t0 and t1, and between times t2 and t4, when the amplitude of the digital baseband signal 310 is at the higher amplitude second state, the frequency of the digital FM carrier signal 816 is at a maximum. Between times t1 and t2, when the amplitude of the digital baseband signal 310 is at the lower amplitude first state, the frequency of the digital FM carrier signal 816 is at a minimum. Digital frequency modulation is often referred to as frequency shift keying (FSK), and the terms are used interchangeably throughout the specification.

Typically, the frequency of the digital FM carrier signal 816 is centered about the frequency of the carrier signal 410, and the maximum and minimum frequencies are equally offset from the center frequency. Other variations can be employed but, for ease of illustration, this convention will be followed herein.

### *1.3 Phase Modulation*

In phase modulation (PM), the phase of the modulated carrier signal $F_{MC}$ varies as a function of the amplitude of the modulating baseband signal $F_{MB}$. FIGS. 9A-9C illustrate example timing diagrams for phase modulating the carrier signal 410 with the analog modulating baseband signal 210. FIGS. 10A-10C illustrate example timing diagrams for phase modulating the carrier signal 410 with the digital modulating baseband signal 310.

FIG. 9A illustrates the analog modulating baseband signal 210. FIG. 9B illustrates the carrier signal 410. FIG. 9C illustrates an analog PM carrier signal 916, which is generated by phase modulating the carrier signal 410 with the analog baseband signal 210. As used herein, the term "analog PM carrier signal" is used to indicate that the modulating baseband signal is an analog signal.

Generally, the frequency of the analog PM carrier signal 916 is substantially the same as the frequency of carrier signal 410. But the phase of the analog PM carrier signal 916 varies with amplitude changes on the analog modulating baseband signal 210. For relative comparison, the carrier signal 410 is illustrated in FIG. 9C by a dashed line.

The phase of the analog PM carrier signal 916 varies as a function of amplitude changes of the analog baseband signal 210. In the illustrated example, the phase of the analog PM signal 916 lags by a varying amount as determined by the amplitude of the baseband signal 210. For example, at time t1, when the amplitude of the analog baseband signal 210 is at a maximum, the analog PM carrier signal 916 is in phase with the carrier signal 410. Between times t1 and t3, when the amplitude of the analog baseband signal 210 decreases to a minimum amplitude, the phase of the analog PM carrier signal 916 lags the phase of the carrier signal 410, until it reaches a maximum out of phase value at time t3. In the illustrated example, the phase change is illustrated as approximately 180 degrees. Any suitable amount of phase change, varied in any manner that is a function of the baseband signal, can be utilized.

FIG. 10A illustrates the digital modulating baseband signal 310. FIG. 10B illustrates the carrier signal 410. FIG. 10C illustrates a digital PM carrier signal 1016, which is generated by phase modulating the carrier signal 410 with the digital baseband signal 310. As used herein, the term "digital PM carrier signal" is used to indicate that the modulating baseband signal is a digital signal.

The frequency of the digital PM carrier signal 1016 is substantially the same as the frequency of carrier signal 410. The phase of the digital PM carrier signal 1016 varies as a function of amplitude changes on the digital baseband signal 310. In the illustrated example, when the digital baseband signal 310 is at the first state 312, the digital PM carrier signal 1016 is out of phase with the carrier signal 410. When the digital baseband signal 310 is at the second state 314, the digital PM carrier signal 1016 is in-phase with the carrier signal 410. Thus, between times t1 and t2, when the amplitude of the digital baseband signal 310 is at the first state 312, the digital PM carrier signal 1016 is out of phase with the carrier signal 410. Between times t0 and t1, and between times t2 and t4, when the amplitude of the digital baseband signal 310 is at the second state 314, the digital PM carrier signal 1016 is in phase with the carrier signal 410.

In the illustrated example, the out of phase value between times t1 and t3 is illustrated as approximately 180 degrees out of phase. Any suitable amount of phase change, varied in any manner that is a function of the baseband signal, can be utilized. Digital phase modulation is often referred to as phase shift keying (PSK), and the terms are used interchangeably throughout the specification.

***2. Demodulation***

When the modulated carrier signal $F_{MC}$ is received, it can be demodulated to extract the modulating baseband signal $F_{MB}$. Because of the typically high frequency of modulated carrier signal $F_{MC}$, however, it is generally impractical to demodulate the baseband signal $F_{MB}$ directly from the modulated carrier signal $F_{MC}$. Instead, the modulated carrier signal $F_{MC}$ must be down-converted to a lower frequency signal that contains the original modulating baseband signal.

When a modulated carrier signal is down-converted to a lower frequency signal, the lower frequency signal is referred to herein as an intermediate frequency (IF) signal $F_{IF}$. The IF signal $F_{IF}$ oscillates at any frequency, or frequency band, below the frequency of the modulated carrier frequency $F_{MC}$ Down-conversion of $F_{MC}$ to $F_{IF}$ is illustrated as:

$$F_{MC} \rightarrow F_{IF}$$

After $F_{MC}$ is down-converted to the IF modulated carrier signal $F_{IF}$, $F_{IF}$ can be demodulated to a baseband signal $F_{DMB}$, as illustrated by:

$$F_{IF} \rightarrow F_{DMB}$$

$F_{DMB}$ is intended to be substantially similar to the modulating baseband signal $F_{MB}$, illustrating that the modulating baseband signal $F_{MB}$ can be substantially recovered.

It will be emphasized throughout the disclosure that the present invention can be implemented with any type of EM signal, including, but not limited to. modulated carrier signals and unmodulated carrier signals. The above examples of modulated carrier signals are provided for illustrative purposes only. Many variations to the examples are possible. For examples a carrier signal can be modulated with a plurality of the modulation types described above. A carrier signal can also be modulated with a plurality of baseband signals, including analog baseband signals, digital baseband signals, and combinations of both analog and digital baseband signals.

### *3. Overview of the Invention*

Conventional signal processing techniques follow the Nyquist sampling theorem. which states that, in order to faithfully reproduce a sampled signal, the signal must be sampled at a rate that is greater than twice the frequency of the signal being sampled. When a signal is sampled at less than or equal to twice the frequency of the signal, the signal is said to be under-sampled, or aliased. Conventional signal processing thus teaches away from under-sampling and aliasing, in order to faithfully reproduce a sampled signal.

By taking a carrier and aliasing it at an aliasing rate, the invention can down-convert that carrier to lower frequencies. One aspect that can be exploited by this invention is realizing that the carrier is not the item of interest, the lower baseband signal is of interest to reproduce sufficiently. This baseband signal's frequency content, even though its carrier may be aliased, does satisfy the Nyquist criteria and as a result, the baseband information can be sufficiently reproduced.

The term aliasing, as used herein, refers to down-converting an EM signal by transferring non-negligible amounts energy from the EM signal at the aliasing rate. Methods for transferring energy from an EM signal to down-convert the EM signal are now described at an overview level. More detailed descriptions are provided in subsequent sections.

In an embodiment, an EM signal is down-converted to a demodulated baseband signal by transferring energy from the EM signal at an aliasing rate. This embodiment is referred to herein as direct-to-data down-conversion. The EM signal can be a modulated EM signal or an unmodulated EM signal. In an exemplary embodiment, the EM signal is the modulated carrier signal $F_{MC}$, and is directly down-converted to a demodulated baseband signal $F_{DMB}$.

$$F_{MC} \rightarrow F_{DMB}$$

FIG. 18C depicts a flowchart 1813 that illustrates a method for transferring energy from the EM signal at an aliasing rate to directly down-convert the EM signal to a demodulated baseband signal. The process begins at step 1814, which includes receiving an EM signal. Step 1816 includes receiving an energy transfer signal having an aliasing rate. Step 1818 includes transferring energy from the EM signal at the aliasing rate to directly down-convert the EM signal to a baseband signal.

#### *3.1 Determining the Aliasing rate*

In accordance with the definition of aliasing, the aliasing rate is equal to, or less than. twice the frequency of the EM carrier signal. Preferably, the aliasing rate is much less than the frequency of the carrier signal. The aliasing rate is preferably more than twice the highest frequency component of the modulating baseband signal $F_{MB}$ that is to be reproduced. The above requirements are illustrated in EQ. (1).

$$2 \cdot F_{MC} \geq F_{AR} > 2 \cdot (\text{Highest Freq. Component of } F_{MB}) \qquad \text{EQ. (1)}$$

In other words, by taking a carrier and aliasing it at an aliasing rate, the invention can down-convert that carrier to lower frequencies. One aspect that can be exploited by this invention is that the carrier is not the item of interest; instead the lower baseband signal is of interest to be reproduced sufficiently. The baseband signal's frequency content, even though its carrier may be aliased, satisfies the Nyquist criteria and as a result, the baseband information can be sufficiently reproduced, either as the intermediate modulating carrier signal $F_{IF}$ or as the demodulated direct-to-data baseband signal $F_{DMB}$.

In accordance with the invention, relationships between the frequency of an EM carrier signal, the aliasing rate, and the intermediate frequency of the down-converted signal, are illustrated in EQ. (2).

$$F_C = n \cdot F_{AR} \pm F_{IF} \qquad \text{EQ. (2)}$$

Where:

$F_C$ is the frequency of the EM carrier signal that is to be aliased;

$F_{AR}$ is the aliasing rate;
*n* identifies a harmonic or sub-harmonic of the aliasing rate (generally, n = 0.5, 1, 2, 3, 4, ...); and
$F_{IF}$ is the intermediate frequency of the down-converted signal.

Note that as $(n \cdot F_{AR})$ approaches $F_C$, $F_{IF}$ approaches zero. This is a special case where an EM signal is directly down-converted to a demodulated baseband signal. This special case is referred to herein as Direct-to-Data down-conversion. Direct-to-Data down-conversion is described in later sections.

High level descriptions, exemplary embodiments and exemplary implementations of the above and other embodiments of the invention are provided in sections below.

### *4. Benefits of the Invention Using an Example Conventional Receiver for Comparison*

FIG. 11 illustrates an example conventional receiver system 1102. The conventional system 1102 is provided both to help the reader to understand the functional differences between conventional systems and the present invention, and to help the reader to understand the benefits of the present invention.

The example conventional receiver system 1102 receives an electromagnetic (EM) signal 1104 via an antenna 1106. The EM signal 1104 can include a plurality of EM signals such as modulated carrier signals. For example, the EM signal 1104 includes one or more radio frequency (RF) EM signals, such as a 900 MHZ modulated carrier signal. Higher frequency RF signals, such as 900 MHZ signals, generally cannot be directly processed by conventional signal processors. Instead, higher frequency RF signals are typically down-converted to lower intermediate frequencies (IF) for processing. The receiver system 1102 down-converts the EM signal 1104 to an intermediate frequency (IF) signal 1108n, which can be provided to a signal processor 1110. When the EM signal 1104 includes a modulated carrier signal, the signal processor 1110 usually includes a demodulator that demodulates the IF signal 1108n to a baseband information signal (demodulated baseband signal).

Receiver system 1102 includes an RF stage 1112 and one or more IF stages 1114. The RF stage 1112 receives the EM signal 1104. The RF stage 1112 includes the antenna 1106 that receives the EM signal 1104.

The one or more IF stages 1114a-1114n down-convert the EM signal 1104 to consecutively lower intermediate frequencies. Each of the one or more IF sections 1114a-1114n includes a mixer 1118a-1118n that down-converts an input EM signal 1116 to a lower frequency IF signal 1108. By cascading the one or more mixers 1118a-1118n, the EM signal 1104 is incrementally down-converted to a desired IF signal 1108n.

In operation, each of the one or more mixers 1118 mixes an input EM signal 1116 with a local oscillator (LO) signal 1119, which is generated by a local oscillator (LO) 1120. Mixing generates sum and difference signals from the input EM signal 1116 and the LO signal 1119. For example, mixing an input EM signal 1116a, having a frequency of 900 MHZ, with a LO signal 1119a, having a frequency of 830 MHZ, results in a sum signal, having a frequency of 900 MHZ + 830 MHZ = 1.73 GHZ, and a difference signal, having a frequency of 900 MHZ-830 MHZ = 70 MHZ.

Specifically, in the example of FIG. 11, the one or more mixers 1118 generate a sum and difference signals for all signal components in the input EM signal 1116. For example, when the EM signal 1116a includes a second EM signal, having a frequency of 760 MHZ, the mixer 1118a generates a second sum signal, having a frequency of 760 MHZ + 830 MHZ = 1.59 GHZ, and a second difference signal, having a frequency of 830 MHZ-760 MHZ = 70 MHZ. In this example, therefore, mixing two input EM signals, having frequencies of 900 MHZ and 760 MHZ, respectively, with an LO signal having a frequency of 830 MHZ, results in two IF signals at 70 MHZ.

Generally, it is very difficult, if not impossible, to separate the two 70 MHZ signals. Instead, one or more filters 1122 and 1123 are provided upstream from each mixer 1118 to filter the unwanted frequencies, also known as image frequencies. The filters 1122 and 1123 can include various filter topologies and arrangements such as bandpass filters, one or more high pass filters, one or more low pass filters, combinations thereof, etc.

Typically, the one or more mixers 1118 and the one or more filters 1122 and 1123 attenuate or reduce the strength of the EM signal 1104. For example, a typical mixer reduces the EM signal strength by 8 to 12 dB. A typical filter reduces the EM signal strength by 3 to 6 dB.

As a result, one or more low noise amplifiers (LNAs) 1121 and 1124a-1124n are provided upstream of the one or more filters 1123 and 1122a-1122n. The LNAs and filters can be in reversed order. The LNAs compensate for losses in the mixers 1118. the filters 1122 and 1123, and other components by increasing the EM signal strength prior to filtering and mixing. Typically, for example, each LNA contributes 15 to 20 dB of amplification.

However, LNAs require substantial power to operate. Higher frequency LNAs require more power than lower frequency LNAs. When the receiver system 1102 is intended to be portable, such as a cellular telephone receiver, for example, the LNAs require a substantial portion of the total power.

At higher frequencies, impedance mismatches between the various stages further reduce the strength of the EM signal 1104. In order to optimize power transferred through the receiver system 1102, each component should be impedance matched with adjacent components. Since no two components have the exact same impedance characteristics, even for components that were manufactured with high tolerances, impedance matching must often be individually fine tuned for each receiver system 1102. As a result, impedance matching in conventional receivers tends to be labor intensive and more art than science. Impedance matching requires a significant amount of added time and expense to both the design and manufacture of conventional receivers. Since many of the components, such as LNA, filters, and impedance matching circuits, are highly frequency dependent, a receiver designed for one application is generally not suitable for other applications. Instead, a new receiver must be designed, which requires new impedance matching circuits between many of the components.

Conventional receiver components are typically positioned over multiple IC substrates instead of on a single IC substrate. This is partly because there is no single substrate that is optimal for both RF, IF, and baseband frequencies. Other factors may include the sheer number of components, their various sizes and different inherent impedance characteristics, etc. Additional signal amplification is often required when going from chip to chip. Implementation over multiple substrates thus involves many costs in addition to the cost of the ICs themselves.

Conventional receivers thus require many components, are difficult and time consuming to design and manufacture, and require substantial external power to maintain sufficient signal levels. Conventional receivers are thus expensive to design, build, and use.

In an embodiment, the present invention is implemented to replace many, if not all, of the components between the antenna 1106 and the signal processor 1110, with an aliasing module that includes a universal frequency translator (UFT) module. The UFT is able to down-convert a wide range of EM signal frequencies using very few components. The UFT is easy to design and build, and requires very little external power. The UFT design can be easily tailored for different frequencies or frequency ranges. For example, UFT design can be easily impedance matched with relatively little tuning. In a direct-to-data embodiment of the invention, where an EM signal is directly down-converted to a demodulated baseband signal, the invention also eliminates the need for a demodulator in the signal processor 1110.

When the invention is implemented in a receiver system, such as the receiver system 1102, power consumption is significantly reduced and signal to noise ratio is significantly increased.

In an embodiment, the invention can be implemented and tailored for specific applications with easy to calculate and easy to implement impedance matching circuits. As a result, when the invention is implemented as a receiver, such as the receiver 1102, specialized impedance matching experience is not required.

In conventional receivers, components in the IF sections comprise roughly eighty to ninety percent of the total components of the receivers. The UFT design eliminates the IF section(s) and thus eliminates the roughly eighty to ninety percent of the total components of conventional receivers.

Other advantages of the invention include, but are not limited to:

The invention can be implemented as a receiver with only a single local oscillator;
The invention can be implemented as a receiver with only a single. lower frequency, local oscillator;
The invention can be implemented as a receiver using few filters;
The invention can be implemented as a receiver using unit delay filters;
The invention can be implemented as a receiver that can change frequencies and receive different modulation formats with no hardware changes;
The invention can be also be implemented as frequency up-converter in an EM signal transmitter;
The invention can be also be implemented as a combination up-converter (transmitter) and down-converter (receiver), referred to herein as a transceiver;
The invention can be implemented in a differential configuration, whereby signal to noise ratios are increased;
A receiver designed in accordance with the invention can be implemented on a single IC substrate, such as a silicon-based IC substrate;
A receiver designed in accordance with the invention and implemented on a single IC substrate, such as a silicon-based IC substrate, can down-convert EM signals from frequencies in the giga Hertz range;
A receiver built in accordance with the invention has a relatively flat response over a wide range of frequencies. For example, in an embodiment, a receiver built in accordance with the invention to operate around 800 MHZ has a substantially flat response (i.e., plus or minus a few dB of power) from 100 MHZ to 1 GHZ. This is referred to herein as a wide-band receiver; and

A receiver built in accordance with the invention can include multiple, user-selectable, impedance match modules, each designed for a different wide-band of frequencies, which can be used to scan an ultra-wide-band of frequencies.

## II. Down-Converting by Transferring Energy

The energy transfer embodiments of the invention provide enhanced signal to noise ratios and sensitivity to very small signals, as well as permitting the down-converted signal to drive lower impedance loads unassisted. The energy transfer aspects of the invention are represented generally by 1706 in FIGS. 17A and 17B. Fundamental descriptions of how this is accomplished is presented step by step beginning with a comparison with an under-sampling system.

### *1. Energy Transfer Compared to Under-Sampling*

Under-sampling systems utilize a sample and hold system controlled by an under-sampling signal. The under-sampling signal includes a train of pulses having negligible apertures that tend towards zero time in duration. The negligible aperture pulses minimize the amount of energy transferred from the EM signal. This protects the under-sampled EM signal from distortion or destruction. The negligible aperture pulses also make the sample and hold system a high impedance system. An advantage of under-sampling is that the high impedance input allows accurate voltage reproduction of the under-sampled EM signal. Under-sampling systems are thus useful for many situations including, but not limited to, monitoring EM signals without distorting or destroying them.

Because under-sampling systems transfer only negligible amounts of energy, they are not suitable for all situations. For example, in radio communications, received radio frequency (RF) signals are typically very weak and must be amplified in order to distinguish them over noise. The negligible amounts of energy transferred by under-sampling systems may not be sufficient to distinguish received RF signals over noise.

In accordance with an aspect of the invention, methods and systems are disclosed below for down-converting EM signals by transferring non-negligible amounts of energy from the EM signals. The resultant down-converted signals have sufficient energy to allow the down-converted signals to be distinguishable from noise. The resultant down-converted signals also have sufficient energy to drive lower impedance circuits without buffering.

Down-converting by transferring energy is introduced below in an incremental fashion to distinguish it from under-sampling. The introduction begins with further descriptions of under-sampling.

### *1.1 Review of Utider-Sampling*

FIG. 38A illustrates an exemplary under-sampling system 3802 for down-converting an input EM signal 3804. The under-sampling system 3802 includes a switching module 3806 and a holding module shown as a holding capacitance 3808. An under-sampling signal 3810 controls the switch module 3806. The under-sampling signal 3810 includes a train of pulses having negligible pulse widths that tend toward zero time. An example of a negligible pulse width or duration can be in the range of 1-10 psec for under-sampling a 900 MHZ signal. Any other suitable negligible pulse duration can be used as well, where accurate reproduction of the original unaffected input signal voltage is desired without substantially affecting the original input signal voltage.

In an under-sampling environment, the holding capacitance 3808 preferably has a small capacitance value. This allows the holding capacitance 3808 to substantially charge to the voltage of the input EM signal 3804 during the negligible apertures of the under-sampling signal pulses. For example, in an embodiment, the holding capacitance 3808 has a value in the range of 1pF. Other suitable capacitance values can be used to achieve substantially the voltage of the original unaffected input signal. Various capacitances can be employed for certain effects, which are described below. The under-sampling system is coupled to a load 3812. In FIG. 38B, the load 3812 of FIG. 38A is illustrated as a high impedance load 3818. A high impedance load is one that is relatively insignificant to an output drive impedance of the system for a given output frequency. The high impedance load 3818 allows the holding capacitance 3808 to substantially maintain the charge accumulated during the under-sampling pulses.

FIGS. 39A-F illustrate example timing diagrams for the under-sampling system 3802. FIG. 39A illustrates an example input EM signal 3804.

FIG. 39C illustrates an example under-sampling signal 3810, including pulses 3904 having negligible apertures that tend towards zero time in duration.

FIG. 39B illustrates the negligible effects to the input EM signal 3804 when under-sampled, as measured at a terminal 3814 of the under-sampling system 3802. In FIG. 39B, negligible distortions 3902 correlate with the pulses of the under-sampling signal 3810. In this embodiment, the negligible distortions 3902 occur at different locations of subsequent cycles of the input EM signal 3804. As a result, the input EM signal will be down-converted. The negligible distortions 3902 represent negligible amounts of energy, in the form of charge that is transferred to the holding capacitance 3808.

When the load 3812 is a high impedance load, the holding capacitance 3808 does not significantly discharge between pulses 3904. As a result, charge that is transferred to the holding capacitance 3808 during a pulse 3904 tends to "hold" the voltage value sampled constant at the terminal 3816 until the next pulse 3904. When voltage of the input EM signal 3804 changes between pulses 3904, the holding capacitance 3808 substantially attains the new voltage and the resultant voltage at the terminal 3816 forms a stair step pattern, as illustrated in FIG. 39D.

FIG. 39E illustrates the stair step voltage of FIG. 39D on a compressed time scale. The stair step voltage illustrated in FIG. 39E can be filtered to produce the signal illustrated in FIG. 39F. The signals illustrated in FIGS. 39D, E, and F have substantially all of the baseband characteristics of the input EM signal 3804 in FIG. 39A, except that the signals illustrated in FIGS. 39D, E, and F have been successfully down-converted.

Note that the voltage level of the down-converted signals illustrated in FIGS. 39E and 39F are substantially close to the voltage level of the input EM signal 3804. The under-sampling system 3802 thus down-converts the input EM signal 3804 with reasonable voltage reproduction, without substantially affecting the input EM signal 3804. But also note that the power available at the output is relatively negligible (e.g.: $V^2/R$;~5mV and 1 MOhm), given the input EM signal 3804 would typically have a driving impedance, in an RF environment, of 50 Ohms (e.g.: $V^2/R$;~5mV and 50 Ohms).

### *1.1.1 Effects of Lowering the Impedance of the Load*

Effects of lowering the impedance of the load 3812 are now described. FIGS. 40A-E illustrate example timing diagrams for the under-sampling system 3802 when the load 3812 is a relatively low impedance load, one that is significant relative to the output drive impedance of the system for a given output frequency.

FIG. 40A illustrates an example input EM signal 3804, which is substantially similar to that illustrated in FIG. 39A.

FIG. 40C illustrates an example under-sampling signal 3810, including pulses 4004 having negligible apertures that tend towards zero time in duration. The example under-sampling signal 3810 illustrated in FIG. 40C is substantially similar to that illustrated in FIGS. 39C.

FIG. 40B illustrates the negligible effects to the input EM signal 3804 when under-sampled, as measured at a terminal 3814 of the under-sampling system 3802. In FIG. 40B, negligible distortions 4002 correlate with the pulses 4004 of the under-sampling signal 3810 in FIG. 40C. In this example, the negligible distortions 4002 occur at different locations of subsequent cycles of the input EM signal 3804. As a result, the input EM signal 3804 will be down-converted. The negligible distortions 4002 represent negligible amounts of energy, in the form of charge that is transferred to the holding capacitance 3808.

When the load 3812 is a low impedance load, the holding capacitance 3808 is significantly discharged by the load between pulses 4004 (FIG. 40C). As a result, the holding capacitance 3808 cannot reasonably attain or "hold" the voltage of the original EM input signal 3804, as was seen in the case of FIG. 39D. Instead, the charge appears as the output illustrated in FIG. 40D.

FIG. 40E illustrates the output from FIG. 40D on a compressed time scale. The output in FIG. 40E can be filtered to produce the signal illustrated in FIG. 40F. The down-converted signal illustrated in FIG. 40F is substantially similar to the down-converted signal illustrated in FIG. 39F, except that the signal illustrated in FIG. 40F is substantially smaller in magnitude than the amplitude of the down-converted signal illustrated in FIG. 39F. This is because the low impedance of the load 3812 prevents the holding capacitance 3808 from reasonably attaining or "holding" the voltage of the original EM input signal 3804. As a result, the down-converted signal illustrated in FIG. 40F cannot provide optimal voltage reproduction, and has relatively negligible power available at the output (e.g.: $V^2/R$;~200μV and 2KOhms), given the input EM signal 3804 would typically have a driving impedance, in an RF environment, of 50 Ohms (e.g.: $V^2/R$;~5mV and 50 Ohms).

### *1.1.2 Effects of Increasing the Value of the Holding Capacitance*

Effects of increasing the value of the holding capacitance 3808, while having to drive a low impedance load 3812, is now described. FIGS. 81A-F illustrate example timing diagrams for the under-sampling system 3802 when the holding capacitance 3808 has a larger value, in the range of 18pF for example.

FIG. 41A illustrates an example input EM signal 3804, which is substantially similar to that illustrated in FIGS. 39A and 40A.

FIG. 41C illustrates an example under-sampling signal 3810, including pulses 4104 having negligible apertures that tend towards zero time in duration. The example under-sampling signal 3810 illustrated in FIG. 41C is substantially similar to that illustrated in FIGS. 39C and 40C.

FIG. 41B illustrates the negligible effects to the input EM signal 3804 when under-sampled, as measured at a terminal 3814 of the under-sampling system 3802. In FIG. 41B, negligible distortions 4102 correlate with the pulses 4104 of the under-sampling signal 3810 in FIG. 41C. Upon close inspection, the negligible distortions 4102 occur at different locations of subsequent cycles of the input EM signal 3804. As a result, the input EM signal 3804 will be down-converted. The negligible distortions 4102 represent negligible amounts of energy, in the form of charge that is transferred to the holding capacitance 3808.

FIG. 41D illustrates the voltage measured at the terminal 3816, which is a result of the holding capacitance 3808 attempting to attain and "hold" the original input EM signal voltage, but failing to do so, during the negligible apertures of the pulses 4104 illustrated in FIG. 41C.

Recall that when the load 3812 is a low impedance load, the holding capacitance 3808 is significantly discharged by the load between pulses 4104 (FIG. 41C), this again is seen in FIGS. 41D and E. As a result, the holding capacitance 3808 cannot reasonably attain or "hold" the voltage of the original EM input signal 3804, as was seen in the case of FIG. 39D. Instead, the charge appears as the output illustrated in FIG. 41D.

FIG. 41E illustrates the down-converted signal 4106 on a compressed time scale. Note that the amplitude of the down-converted signal 4106 is significantly less than the amplitude of the down-converted signal illustrated in FIGS. 40D and 40E. This is due to the higher capacitive value of the holding capacitance 3808. Generally, as the capacitive value increases, it requires more charge to increase the voltage for a given aperture. Because of the negligible aperture of the pulses 4104 in FIG. 41C, there is insufficient time to transfer significant amounts of energy or charge from the input EM signal 3804 to the holding capacitance 3808. As a result, the amplitudes attained by the holding capacitance 3808 are significantly less than the amplitudes of the down-converted signal illustrated in FIGS. 40D and 40E.

In FIGS. 40E and 40F, the output signal, non-filtered or filtered, cannot provide optimal voltage reproduction, and has relatively negligible power available at the output (e.g.: $V^2/R$; ~ 150μV and 2KOhms), given the input EM signal 3804 would typically have a driving impedance, in an RF environment, of 50 Ohms (e.g.: $V^2/R$;~5mV and 50 Ohms).

In summary, under-sampling systems, such as the under-sampling system 3802 illustrated in FIG. 38, are well suited for down-converting EM signals with relatively accurate voltage reproduction. Also, they have a negligible affect on the original input EM signal. As illustrated above, however, the under-sampling systems, such as the under-sampling system 3802 illustrated in FIG. 38, are not well suited for transferring energy or for driving lower impedance loads.

### *1.2 Introduction to Energy Transfer*

In an embodiment, the present invention transfers energy from an EM signal by utilizing an energy transfer signal instead of an under-sampling signal. Unlike under-sampling signals that have negligible aperture pulses, the energy transfer signal includes a train of pulses having non-negligible apertures that tend away from zero. This provides more time to transfer energy from an EM input signal. One direct benefit is that the input impedance of the system is reduced so that practical impedance matching circuits can be implemented to further improve energy transfer and thus overall efficiency. The non-negligible transferred energy significantly improves the signal to noise ratio and sensitivity to very small signals, as well as permitting the down-converted signal to drive lower impedance loads unassisted. Signals that especially benefit include low power ones typified by RF signals. One benefit of a non-negligible aperture is that phase noise within the energy transfer signal does not have as drastic of an effect on the down-converted output signal as under-sampling signal phase noise or conventional sampling signal phase noise does on their respective outputs.

FIG. 42A illustrates an exemplary energy transfer system 4202 for down-converting an input EM signal 4204. The energy transfer system 4202 includes a switching module 4206 and a storage module illustrated as a storage capacitance 4208. The terms storage module and storage capacitance, as used herein, are distinguishable from the terms holding module and holding capacitance, respectively. Holding modules and holding capacitances, as used above, identify systems that store negligible amounts of energy from an under-sampled input EM signal with the intent of "holding" a voltage value. Storage modules and storage capacitances, on the other hand, refer to systems that store non-negligible amounts of energy from an input EM signal.

The energy transfer system 4202 receives an energy transfer signal 4210, which controls the switch module 4206. The energy transfer signal 4210 includes a train of energy transfer pulses having non-negligible pulse widths that tend away from zero time in duration. The non-negligible pulse widths can be any non-negligible amount. For example, the non-negligible pulse widths can be 1/2 of a period of the input EM signal. Alternatively, the non-negligible pulse widths can be any other fraction of a period of the input EM signal, or a multiple of a period plus a fraction. In an example embodiment, the input EM signal is approximately 900 MHZ and the non-negligible pulse width is approximately 550 pico seconds. Any other suitable non-negligible pulse duration can be used.

In an energy transfer environment, the storage module, illustrated in FIG. 42 as a storage capacitance 4208, preferably has the capacity to handle the power being transferred, and to allow it to accept a non-negligible amount of power during a non-negligible aperture period. This allows the storage capacitance 4208 to store energy transferred from the input EM signal 4204, without substantial concern for accurately reproducing the original, unaffected voltage level of the input EM signal 4204. For example, in an embodiment, the storage capacitance 4208 has a value in the range of 18pF. Other suitable capacitance values and storage modules can be used.

One benefit of the energy transfer system 4202 is that, even when the input EM signal 4204 is a very small signal, the energy transfer system 4202 transfers enough energy from the input EM signal 4204 that the input EM signal can be efficiently down-converted.

The energy transfer system 4202 is coupled to a load 4212. Recall from the overview of under-sampling that loads can be classified as high impedance loads or low impedance loads. A high impedance load is one that is relatively insignificant to an output drive impedance of the system for a given output frequency. A low impedance load is one that is relatively significant. Another benefit of the energy transfer system 4202 is that the non-negligible amounts of transferred energy permit the energy transfer system 4202 to effectively drive loads that would otherwise be classified as low impedance loads in under-sampling systems and conventional sampling systems. In other words, the non-negligible amounts of transferred energy ensure that, even for lower impedance loads, the storage capacitance 4208 accepts and maintains sufficient energy or charge to drive the load 4202. This is illustrated below in the timing diagrams of FIGS. 43A-F.

FIGS. 43A-F illustrate example timing diagrams for the energy transfer system 4202 in FIG. 42. FIG. 43A illustrates an example input EM signal 4302.

FIG. 43C illustrates an example under-sampling signal 4304, including energy transfer pulses 4306 having non-negligible apertures that tend away from zero time in duration.

FIG. 43B illustrates the effects to the input EM signal 4302, as measured at a terminal 4214 in FIG. 42A, when non-negligible amounts of energy are transfer from it. In FIG. 43B, non-negligible distortions 4308 correlate with the energy transfer pulses 4306 in FIG. 43C. In this example, the non-negligible distortions 4308 occur at different locations of subsequent cycles of the input EM signal 4302. The non-negligible distortions 4308 represent non-negligible amounts of transferred energy, in the form of charge that is transferred to the storage capacitance 4208 in FIG. 42.

FIG. 43D illustrates a down-converted signal 4310 that is formed by energy transferred from the input EM signal 4302.

FIG. 43E illustrates the down-converted signal 4310 on a compressed time scale. The down-converted signal 4310 can be filtered to produce the down-converted signal 4312 illustrated in FIG. 43F. The down-converted signal 4312 is similar to the down-converted signal illustrated in FIG. 39F, except that the down-converted signal 4312 has substantially more power (e.g.: $V^2/R$; approximately (~) 2mV and 2KOhms) than the down-converted signal illustrated in FIG. 39F (e.g.: $V^2/R$;~5mV and 1 MOhms). As a result, the down-converted signals 4310 and 4312 can efficiently drive lower impedance loads, given the input EM signal 4204 would typically have a driving impedance, in an RF environment, of 50 Ohms ($V^2/R$;~5mV and 50 Ohms).

The energy transfer aspects of the invention are represented generally by 1706 in FIGS. 17A and 17B.

### *2. Directly Down-Converting an EM Signal to an Demodulated Baseband Signal by Transferring Energy from the EM Signal*

In an embodiment, the invention directly down-converts an EM signal to a baseband signal, by transferring energy from the EM signal. This embodiment is referred to herein as direct-to-data down-conversion and is illustrated by 1716 in FIG. 17B.

This embodiment can be implemented with modulated and unmodulated EM signals. This embodiment is described herein using the modulated carrier signal $F_{MC}$ in FIG. 1, as an example. In the example, the modulated carrier signal $F_{MC}$ is directly down-converted to the demodulated baseband signal $F_{DMB}$. Upon reading the disclosure and examples therein, one skilled in the relevant art(s) will understand that the invention can be implemented to down-convert any EM signal, including but not limited to, modulated carrier signals and unmodulated carrier signals.

The following sections describe methods for directly down-converting the modulated carrier signal $F_{MC}$ to the demodulated baseband signal $F_{DMB}$. Exemplary structural embodiments for implementing the methods are also described. It should be understood that the invention is not limited to the particular embodiments described below. Equivalents, extensions, variations, deviations, etc., of the following will be apparent to persons skilled in the relevant art(s) based on the teachings contained herein. Such equivalents, extensions, variations. deviations, etc., are within the scope and spirit of the present invention.

The following sections include a high level discussion, example embodiments, and implementation examples.

### *2.1 High Level Description*

This section (including its subsections) provides a high-level description of transferring energy from the modulated carrier signal $F_{MC}$ to directly down-convert the modulated carrier signal $F_{MC}$ to the demodulated baseband signal $F_{DMB}$, according to the invention. In particular, an operational process of directly down-converting the modulated carrier signal $F_{MC}$ to the demodulated baseband signal $F_{DMB}$ is described at a high-level. Also, a structural implementation for implementing this process is described at a high-level. The structural implementation is described herein for illustrative purposes, and is not limiting. In particular, the process described in this section can be achieved using any number of structural implementations, one of which is described in this section. The details of such structural implementations will be apparent to persons skilled in the relevant art(s) based on the teachings contained herein.

### *2.1.1 Operational Description*

FIG. 18C depicts a flowchart 1813 that illustrates an exemplary method for transferring energy from the modulated carrier signal $F_{MC}$ to directly down-convert the modulated carrier signal $F_{MC}$ to the demodulated baseband signal $F_{DMB}$. The exemplary method illustrated in the flowchart 1813 is an embodiment of the flowchart 1801 in FIG. 18A.

Any and all combinations of modulation techniques are valid for this invention. For ease of discussion, the digital AM carrier signal 616 is used to illustrate a high level operational description of the invention. Subsequent sections provide detailed flowcharts and descriptions for AM and PM example embodiments. Upon reading the disclosure and examples therein, one skilled in the relevant art(s) will understand that the invention can be implemented to down-convert any type of EM signal, including any form of modulated carrier signal and unmodulated carrier signals.

The high-level process illustrated in the flowchart 1813 is now described at a high level using the digital AM carrier signal 616, from FIG. 6C. The digital AM carrier signal 616 is re-illustrated in FIG. 19A for convenience.

The process of the flowchart 1813 begins at step 1814, which includes receiving an EM signal. Step 1813 is represented by the digital AM carrier signal 616.

Step 1816 includes receiving an energy transfer signal having an aliasing rate $F_{AR}$. FIG. 19B illustrates an example energy transfer signal 1902, which includes a train of energy transfer pulses 1904 having apertures 1906 that are optimized for energy transfer. The optimized apertures 1906 are non-negligible and tend away from zero.

The non-negligible apertures 1906 can be any width other than the period of the EM signal, or a multiple thereof. For example, the non-negligible apertures 1906 can be less than the period of the signal 616 such as, 1/8, 1/4 1/2, 3/4, etc., of the period of the signal 616. Alternatively, the non-negligible apertures 1906 can be greater than the period of the signal 616. The width and amplitude of the apertures 1906 can be optimized based on one or more of a variety of criteria, as described in sections below.

The energy transfer pulses 1904 repeat at the aliasing rate or pulse repetition rate. The aliasing rate is determined in accordance with EQ. (2), reproduced below for convenience.

$$F_C = n \cdot F_{AR} \pm F_{IF} \qquad \text{EQ. (2)}$$

When directly down-converting an EM signal to baseband (i.e., zero IF), EQ. (2) becomes:

$$F_C = n \cdot F_{AR} \qquad \text{EQ. (8)}$$

Thus, to directly down-convert the AM signal 616 to a demodulated baseband signal, the aliasing rate is substantially equal to the frequency of the AM signal 616 or to a harmonic or sub-harmonic thereof. Although the aliasing rate is too low to permit reconstruction of higher frequency components of the AM signal 616 (i.e., the carrier frequency), it is high enough to permit substantial reconstruction of the lower frequency modulating baseband signal 310.

Step 1818 includes transferring energy from the EM signal at the aliasing rate to directly down-convert the EM signal to a demodulated baseband signal $F_{DMB}$. FIG. 19C illustrates a demodulated baseband signal 1910 that is generated by the direct down-conversion process. The demodulated baseband signal 1910 is similar to the digital modulating baseband signal 310 in FIG. 3.

FIG. 19D depicts a filtered demodulated baseband signal 1912, which can be generated from the demodulated baseband signal 1910. The invention can thus generate a filtered output signal, a partially filtered output signal, or a relatively unfiltered output signal. The choice between filtered, partially filtered and non-filtered output signals is generally a design choice that depends upon the application of the invention.

### *2.1.2 Structural Description*

In an embodiment, the energy transfer system 2402 transfers energy from any type of EM signal, including modulated carrier signals and unmodulated carrier signal, to directly downconvert the EM signal to a demodulated baseband signal. Preferably, the energy transfer system 2402 transfers energy from the EM signal 1204 to down-convert it to demodulated baseband signal in the manner shown in the operational flowchart 1813. However, it should be understood that the scope and spirit of the invention includes other structural embodiments for performing the steps of the flowchart 1813. The specifics of the other structural embodiments will be apparent to persons skilled in the relevant art(s) based on the discussion contained herein.

Operation of the energy transfer system 2402 is now described in at a high level for the digital AM carrier signal 616, with reference to the flowchart 1813 and the timing diagrams illustrated in FIGS. 19A-D. In step 1814, the energy transfer module 2404 receives the digital AM carrier signal 616. In step 1816, the energy transfer module 2404 receives the energy transfer signal 1902. In step 1818, the energy transfer module 2404 transfers energy from the digital AM carrier signal 616 at the aliasing rate to directly down-convert it to the demodulated baseband signal 1910.

Example implementations of the energy transfer module 2402 are disclosed in Sections 4 and 5 below..

### *2.2 Example Embodiments*

Various embodiments related to the method(s) and structure(s) described above are presented in this section (and its subsections). These embodiments are described herein for purposes of illustration, and not limitation. The invention is not limited to these embodiments. Alternate embodiments (including equivalents, extensions, variations, deviations, etc., of the embodiments described herein) will be apparent to persons skilled in the relevant art(s) based on the teachings contained herein. The invention is intended and adapted to include such alternate embodiments.

The method for down-converting the EM signal to the demodulated baseband signal $F_{DMB}$, illustrated in the flowchart 1813 of FIG. 18C, can be implemented with various types of modulated carrier signals including, but not limited to, AM, PM, etc., or any combination thereof The flowchart 1813 of FIG. 18C is described below for AM and PM. The exemplary descriptions below are intended to facilitate an understanding of the present invention. The present invention is not limited to or by the exemplary embodiments below.

### *2.2.1 First Example Embodiment: Amplitude Modulation*

#### *2.2.1.1 Operational Description*

Operation of the exemplary process of the flowchart 1813 of FIG. 18C is described below for the analog AM carrier signal 516, illustrated in FIG. 5C, and for the digital AM carrier signal 616, illustrated in FIG. 6C.

#### *2.2.1.1.1 Analog AM Carrier Signal*

A process for directly down-converting the analog AM carrier signal 516 in FIG. 5C to a demodulated baseband signal is now described with reference to the flowchart 1813 of FIG. 18C. The analog AM carrier signal 516 is re-illustrated in 20A for convenience. For this example, the analog AM carrier signal 516 oscillates at approximately 900 MHZ. In FIG. 20B, an analog AM carrier signal portion 2004 illustrates a portion of the analog AM carrier signal 516 on an expanded time scale.

The process begins at step 1814, which includes receiving an EM signal. This is represented by the analog AM carrier signal 516.

Step 1816 includes receiving an energy transfer signal having an aliasing rate $F_{AR}$. In FIG. 20C, an example energy transfer signal 2006 is illustrated on approximately the same time scale as FIG. 20B. The energy transfer signal 2006 includes a train of energy transfer pulses 2007 having non-negligible apertures that tend away from zero time in duration. The energy transfer pulses 2007 repeat at the aliasing rate, which is determined or selected as previously described. Generally, when down-converting an EM signal to a demodulated baseband signal. the aliasing rate $F_{AR}$ is substantially equal to a harmonic or, more typically, a sub-harmonic of the EM signal.

Step 1818 includes transferring energy from the EM signal at the aliasing rate to directly down-convert the EM signal to the demodulated baseband signal $F_{DMB}$. In FIG. 20D, an affected analog AM carrier signal 2008 illustrates effects of transferring energy from the analog AM carrier signal 516 at the aliasing rate $F_{AR}$. The affected analog AM carrier signal 2008 is illustrated on substantially the same time scale as FIGS. 20B and 20C.

FIG. 20E illustrates a demodulated baseband signal 2012, which is generated by the down-conversion process. Because a harmonic of the aliasing rate is substantially equal to the frequency of the signal 516, essentially no IF is produced. The only substantial aliased component is the baseband signal. The demodulated baseband signal 2012 is illustrated with an arbitrary load impedance.

The demodulated baseband signal 2012 includes portions 2010A, which correlate with the energy transfer pulses 2007 in FIG. 20C, and portions 2010B, which are between the energy transfer pulses 2007. Portions 2010A represent energy transferred from the analog AM carrier signal 516 to a storage device, while simultaneously driving an output load. The portions 2010A occur when a switching module is closed by the energy transfer pulses 2007. Portions 2010B represent energy stored in a storage device continuing to drive the load. Portions 2010B occur when the switching module is opened after energy transfer pulses 2007.

In FIG. 20F, a demodulated baseband signal 2016 represents a filtered version of the demodulated baseband signal 2012, on a compressed time scale. The demodulated baseband signal 2016 is substantially similar to the modulating baseband signal 210 and can be further processed using any signal processing technique(s) without further down-conversion or demodulation.

The present invention can output the unfiltered demodulated baseband signal 2012, the filtered demodulated baseband signal 2016, a partially filtered demodulated baseband signal, a stair step output signal, etc. The choice between these embodiments is generally a design choice that depends upon the application of the invention.

The aliasing rate of the energy transfer signal is preferably controlled to optimize the demodulated baseband signal for amplitude output and polarity, as desired.

The drawings referred to herein illustrate direct down-conversion in accordance with the invention. For example, the demodulated baseband signals 2012 in FIG. 20E and 2016 in FIG. 20F illustrate that the analog AM carrier signal 516 was directly down-converted to a demodulated baseband signal by retaining enough baseband information for sufficient reconstruction.

### *2.2.1.1.2 Digital AM Carrier Signal*

A process for directly down-converting the digital AM carrier signal 616 in FIG. 6C to a demodulated baseband signal is now described for the flowchart 1813 of FIG. 18C. The digital AM carrier signal 616 is re-illustrated in 21A for convenience. For this example, the digital AM carrier signal 616 oscillates at approximately 900 MHZ. In FIG. 21B, a digital AM carrier signal portion 2104 illustrates a portion of the digital AM carrier signal 616 on an expanded time scale.

The process begins at step 1814, which includes receiving an EM signal. This is represented by the digital AM carrier signal 616.

Step 1816 includes receiving an energy transfer signal having an aliasing rate $F_{AR}$. In FIG. 21C, an example energy transfer signal 2106 is illustrated on approximately the same time scale as FIG. 21B. The energy transfer signal 2106 includes a train of energy transfer pulses 2107 having non-negligible apertures that tend away from zero time in duration. The energy transfer pulses 2107 repeat at the aliasing rate, which is determined or selected as previously described. Generally, when directly down-converting an EM signal to a demodulated baseband signal, the aliasing rate $F_{AR}$ is substantially equal to a harmonic or, more typically, a sub-harmonic of the EM signal.

Step 1818 includes transferring energy from the EM signal at the aliasing rate to directly down-convert the EM signal to the demodulated baseband signal $F_{DMB}$. In FIG. 21D, an affected digital AM carrier signal 2108 illustrates effects of transferring energy from the digital AM carrier signal 616 at the aliasing rate $F_{AR}$. The affected digital AM carrier signal 2108 is illustrated on substantially the same time scale as FIGS. 21B and 21C.

FIG. 21E illustrates a demodulated baseband signal 2112, which is generated by the down-conversion process. Because a harmonic of the aliasing rate is substantially equal to the frequency of the signal 616, essentially no IF is produced. The only substantial aliased component is the baseband signal. The demodulated baseband signal 2112 is illustrated with an arbitrary load impedance.

The demodulated baseband signal 2112 includes portions 2110A, which correlate with the energy transfer pulses 2107 in FIG. 21C, and portions 2110B, which are between the energy transfer pulses 2107. Portions 2110A represent energy transferred from the digital AM carrier signal 616 to a storage device, while simultaneously driving an output load. The portions 2110A occur when a switching module is closed by the energy transfer pulses 2107. Portions 2110B represent energy stored in a storage device continuing to drive the load. Portions 2110B occur when the switching module is opened after energy transfer pulses 2107.

In FIG. 21F, a demodulated baseband signal 2116 represents a filtered version of the demodulated baseband signal 2112, on a compressed time scale. The demodulated baseband signal 2116 is substantially similar to the modulating baseband signal 310 and can be further processed using any signal processing technique(s) without further down-conversion or demodulation.

The present invention can output the unfiltered demodulated baseband signal 2112, the filtered demodulated baseband signal 2116, a partially filtered demodulated baseband signal, a stair step output signal, etc. The choice between these embodiments is generally a design choice that depends upon the application of the invention.

The aliasing rate of the energy transfer signal is preferably controlled to optimize the down-converted signal for amplitude output and polarity, as desired.

The drawings referred to herein illustrate direct down-conversion in accordance with the invention. For example, the demodulated baseband signals 2112 in FIG. 21E and 2116 in FIG. 21F illustrate that the digital AM carrier signal 616 was directly down-converted to a demodulated baseband signal by retaining enough baseband information for sufficient reconstruction.

### *2.2.1.2 Structural Description*

In an embodiment, the energy transfer module 2404 preferably transfers energy from the EM signal to directly down-convert it to a demodulated baseband signal in the manner shown in the operational flowchart 1813. But it should be understood that the scope and spirit of the invention includes other structural embodiments for performing the steps of the flowchart 1313. The specifics of the other structural embodiments will be apparent to persons skilled in the relevant art(s) based on the discussion contained herein.

Operation of the energy transfer system 2402 is now described for the digital AM carrier signal 516, with reference to the flowchart 1813 and the timing diagrams in FIGS. 20A-F. In step 1812, the energy transfer module 2504 receives the analog AM carrier signal 516. In step 1814, the energy transfer module 2504 receives the energy transfer signal 2006. In step 1818, the energy transfer module 2504 transfers energy from the analog AM carrier signal 516 at the aliasing rate of the energy transfer signal 2006, to directly down-convert the digital AM carrier signal 516 to the demodulated baseband signals 2012 or 2016.

The operation of the energy transfer system 2502 is now described for the digital AM carrier signal 616, with reference to the flowchart 1813 and the timing diagrams in FIGS. 21A-F. In step 1814, the energy transfer module 2504 receives the digital AM carrier signal 616. In step 1816, the energy transfer module 2504 receives the energy transfer signal 2106. In step 1818, the energy transfer module 2504 transfers energy from the digital AM carrier signal 616 at the aliasing rate of the energy transfer signal 2106, to directly down-convert the digital AM carrier signal 616 to the demodulated baseband signals 2112 or 2116.

### *2.2.2 Second Example Embodiment: Phase Modulation*

#### *2.2.2.1 Operational Description*

Operation of the exemplary process of flowchart 1813 in FIG. 18C is described below for the analog PM carrier signal 916, illustrated in FIG. 9C and for the digital PM carrier signal 1016, illustrated in FIG. 10C.

#### *2.2.2.1.1 Analog PM Carrier Signal*

A process for directly down-converting the analog PM carrier signal 916 to a demodulated baseband signal is now described for the flowchart 1813 in FIG. 18C. The analog PM carrier signal 916 is re-illustrated in 22A for convenience. For this example, the analog PM carrier signal 916 oscillates at approximately 900 MHZ. In FIG. 22B, an analog PM carrier signal portion 2204 illustrates a portion of the analog PM carrier signal 916 on an expanded time scale.

The process begins at step 1814, which includes receiving an EM signal. This is represented by the analog PM carrier signal 916.

Step 1816 includes receiving an energy transfer signal having an aliasing rate $F_{AR}$. In FIG. 22C, an example energy transfer signal 2206 is illustrated on approximately the same time scale as FIG. 22B. The energy transfer signal 2206 includes a train of energy transfer pulses 2207 having non-negligible apertures that tend away from zero time in duration. The energy transfer pulses 2207 repeat at the aliasing rate, which is determined or selected as previously described. Generally, when directly down-converting an EM signal to a demodulated baseband signal, the aliasing rate $F_{AR}$ is substantially equal to a harmonic or, more typically, a sub-harmonic of the EM signal.

Step 1818 includes transferring energy from the EM signal at the aliasing rate to directly down-convert the EM signal to the demodulated baseband signal $F_{DMB}$. In FIG. 22D, an affected analog PM carrier signal 2208 illustrates effects of transferring energy from the analog PM carrier signal 916 at the aliasing rate $F_{AR}$. The affected analog PM carrier signal 2208 is illustrated on substantially the same time scale as FIGS. 22B and 22C.

FIG. 22E illustrates a demodulated baseband signal 2212, which is generated by the down-conversion process. Because a harmonic of the aliasing rate is substantially equal to the frequency of the signal 516, essentially no IF is produced. The only substantial aliased component is the baseband signal. The demodulated baseband signal 2212 is illustrated with an arbitrary load impedance.

The demodulated baseband signal 2212 includes portions 2210A, which correlate with the energy transfer pulses 2207 in FIG. 22C, and portions 2210B, which are between the energy transfer pulses 2207. Portions 2210A represent energy transferred from the analog PM carrier signal 916 to a storage device, while simultaneously driving an output load. The portions 2210A occur when a switching module is closed by the energy transfer pulses 2207. Portions 2210B represent energy stored in a storage device continuing to drive the load. Portions 2210B occur when the switching module is opened after energy transfer pulses 2207.

In FIG. 22F, a demodulated baseband signal 2216 represents a filtered version of the demodulated baseband signal 2212, on a compressed time scale. The demodulated baseband signal 2216 is substantially similar to the modulating baseband signal 210 and can be further processed using any signal processing technique(s) without further down-conversion or demodulation.

The present invention can output the unfiltered demodulated baseband 2212, the filtered demodulated baseband signal 2216, a partially filtered demodulated baseband signal, a stair step output signal, etc. The choice between these embodiments is generally a design choice that depends upon the application of the invention.

The aliasing rate of the energy transfer signal is preferably controlled to optimize the down-converted signal for amplitude output and polarity, as desired.

The drawings referred to herein illustrate direct down-conversion in accordance with the invention. For example, the demodulated baseband signals 2212 in FIG. 22E and 2216 in FIG. 22F illustrate that the analog PM carrier signal 916 was successfully down-converted to a demodulated baseband signal by retaining enough baseband information for sufficient reconstruction.

### 2.2.2.1.2 Digital PM Carrier Signal

A process for directly down-converting the digital PM carrier signal 1016 in FIG. 6C to a demodulated baseband signal is now described for the flowchart 1813 in FIG. 18C. The digital PM carrier signal 1016 is re-illustrated in 23A for convenience. For this example, the digital PM carrier signal 1016 oscillates at approximately 900 MHZ. In FIG. 23B, a digital PM carrier signal portion 2304 illustrates a portion of the digital PM carrier signal 1016 on an expanded time scale.

The process begins at step 1814, which includes receiving an EM signal. This is represented by the digital PM carrier signal 1016.

Step 1816 includes receiving an energy transfer signal $F_{AR}$. In FIG. 23C, an example energy transfer signal 2306 is illustrated on approximately the same time scale as FIG. 23B. The energy transfer signal 2306 includes a train of energy transfer pulses 2307 having non-negligible apertures that tend away from zero time in duration. The energy transfer pulses 2307 repeat at the aliasing rate, which is determined or selected as previously described. Generally, when directly down-converting an EM signal to a demodulated baseband signal, the aliasing rate $F_{AR}$ is substantially equal to a harmonic or, more typically, a sub-harmonic of the EM signal.

Step 1818 includes transferring energy from the EM signal at the aliasing rate to directly down-convert the EM signal to the demodulated baseband signal $F_{DMB}$. In FIG. 23D, an affected digital PM carrier signal 2308 illustrates effects of transferring energy from the digital PM carrier signal 1016 at the aliasing rate $F_{AR}$. The affected digital PM carrier signal 2308 is illustrated on substantially the same time scale as FIGS. 23B and 23C.

FIG. 23E illustrates a demodulated baseband signal 2312, which is generated by the down-conversion process. Because a harmonic of the aliasing rate is substantially equal to the frequency of the signal 1016, essentially no IF is produced. The only substantial aliased component is the baseband signal. The demodulated baseband signal 2312 is illustrated with an arbitrary load impedance.

The demodulated baseband signal 2312 includes portions 2310A, which correlate with the energy transfer pulses 2307 in FIG. 23C, and portions 2310B, which are between the energy transfer pulses 2307. Portions 2310A represent energy transferred from the digital PM carrier signal 1016 to a storage device, while simultaneously driving an output load. The portions 2310A occur when a switching module is closed by the energy transfer pulses 2307. Portions 2310B represent energy stored in a storage device continuing to drive the load. Portions 2310B occur when the switching module is opened after energy transfer pulses 2307.

In FIG. 23F, a demodulated baseband signal 2316 represents a filtered version of the demodulated baseband signal 2312, on a compressed time scale. The demodulated baseband signal 2316 is substantially similar to the modulating baseband signal 310 and can be further processed using any signal processing technique(s) without further down-conversion or demodulation.

The present invention can output the unfiltered demodulated baseband signal 2312, the filtered demodulated baseband signal 2316, a partially filtered demodulated baseband signal, a stair step output signal, etc. The choice between these embodiments is generally a design choice that depends upon the application of the invention.

The aliasing rate of the energy transfer signal is preferably controlled to optimize the down-converted signal for amplitude output and polarity, as desired.

The drawings referred to herein illustrate direct down-conversion in accordance with the invention. For example, the demodulated baseband signals 2312 in FIG. 23E and 2316 in FIG. 23F illustrate that the digital PM carrier signal 1016 was successfully down-converted to a demodulated baseband signal by retaining enough baseband information for sufficient reconstruction.

### 2.2.2.2 Structural Description

In an embodiment, the energy transfer system 2402 preferably transfers energy from an EM signal to directly down-convert it to a demodulated baseband signal in the manner shown in the operational flowchart 1813. But it should be understood that the scope and spirit of the invention includes other structural embodiments for performing the steps of the flowchart 1313. The specifics of the other structural embodiments will be apparent to persons skilled in the relevant art(s) based on the discussion contained herein.

Operation of the energy transfer system 2402 is now described for the analog PM carrier signal 916, with reference to the flowchart 1813 and the timing diagrams in FIGS. 22A-F. In step 1814, the energy transfer module 2404 receives the analog PM carrier signal 916. In step 1816, the energy transfer module 2404 receives the energy transfer signal 2206. In step 1818, the energy transfer module 2404 transfers energy from the analog PM carrier signal 916 at the aliasing rate of the energy transfer signal 2206, to directly down-convert the analog PM carrier signal 916 to the demodulated baseband signals 2212 or 2216.

Operation of the energy transfer system 2402 is now described for the digital PM carrier signal 1016, with reference to the flowchart 1813 and to the timing diagrams in FIGS. 23A-F. In step 1814, the energy transfer module 2504 receives the digital PM carrier signal 1016. In step 1816, the energy transfer module 2504 receives the energy transfer signal 2306. In step 1818, the energy transfer module 2504 transfers energy from the digital PM carrier signal 1016 at the aliasing rate of the energy transfer signal 2306, to directly down-convert the digital PM carrier signal 1016 to the demodulated baseband signal 2312 or 2316.

### *3. Implementation Examples*

Exemplary operational and/or structural implementations related to the method(s), structure(s), and/or embodiments described above are presented in this section (and its subsections). These implementations are presented herein for purposes of illustration, and not limitation. The invention is not limited to the particular implementation examples described herein. Alternate implementations (including equivalents, extensions, variations, deviations, etc., of those described herein) will be apparent to persons skilled in the relevant art(s) based on the teachings contained herein. Such alternate implementations fall within the scope and spirit of the present invention.

FIG. 24 illustrates an energy transfer system 2402, which is an exemplary embodiment of the generic aliasing system 1202 in FIG. 12. The energy transfer system 2402 includes an energy transfer module 2404, which receives the EM signal 1204 and an energy transfer signal 2406. The energy transfer signal 2406 includes a train of energy transfer pulses having non-negligible apertures that tend away from zero time in duration. The energy transfer pulses repeat at an aliasing rate $F_{AR}$.

The energy transfer module 2404 transfers energy from the EM signal 1204 at the aliasing rate of the energy transfer signal 2406, as described in the sections above with respect to the flowcharts 1801 in FIG. 18A, 1807 in FIG. 18B, 1813 in FIG. 18C and 1819 in FIG. 18D. The energy transfer module 2404 outputs a down-converted signal 1208B, which includes non-negligible amounts of energy transferred from the EM signal 1204.

FIG. 25A illustrates an exemplary gated transfer system 2502, which is an example of the energy transfer system 2402. The gated transfer system 2502 includes a gated transfer module 2504, which is described below.

FIG. 25B illustrates an exemplary inverted gated transfer system 2506, which is an alternative example of the energy transfer system 2402. The inverted gated transfer system 2506. includes an inverted gated transfer module 2508, which is described below.

#### *3.1 The Energy Transfer System as a Gated Transfer System*

FIG. 25A illustrates the exemplary gated transfer system 2502, which is an exemplary implementation of the energy transfer system 2402. The gated transfer system 2502 includes the gated transfer module 2504, which receives the EM signal 1204 and the energy transfer signal 2406. The energy transfer signal 2406 includes a train of energy transfer pulses having non-negligible apertures that tend away from zero time in duration. The energy transfer pulses repeat at an aliasing rate $F_{AR}$.

The gated transfer module 2504 transfers energy from the EM signal 1204 at the aliasing rate of the energy transfer signal 2406, as described in the sections above with respect to the flowcharts 1801 in FIG. 18A, 1807 in FIG. 18B, 1813 in FIG. 18C and 1819 in FIG. 18D. The gated transfer module 2504 outputs the down-converted signal 1208B, which includes non-negligible amounts of energy transferred from the EM signal 1204.

#### *3.1.1 The Gated Transfer System as a Switch Module and a Storage Module*

FIG. 26 illustrates an example embodiment of the gated transfer module 2504 as including a switch module 2602 and a storage module 2606. Preferably, the switch module 2602 and the storage module 2606 transfer energy from the EM signal 1204 to down-convert it in any of the manners shown in the operational flowcharts 1801 in FIG. 18A, 1807 in FIG. 18B, 1813 in FIG. 18C and 1819 in FIG. 18D.

For example, operation of the switch module 2602 and the storage module 2606 is now described for down-converting the EM signal 1204 to an intermediate signal, with reference to the flowchart 1807 and the example timing diagrams in FIG. 43A-F.

In step 1808, the switch module 2602 receives the EM signal 1204 (FIG. 43A). In step 1810, the switch module 2602 receives the energy transfer signal 2406 (FIG. 43C). In step 1812, the switch module 2602 and the storage module 2606 cooperate to transfer energy from the EM signal 1204 and down-convert it to an intermediate signal. More specifically, during step 1812, the switch module 2602 closes during each energy transfer pulse to couple the EM signal 1204 to the storage module 2606. In an embodiment, the switch module 2602 closes on rising edges of the energy transfer pulses. In an alternative embodiment, the switch module 2602 closes on falling edges of the energy transfer pulses. While the EM signal 1204 is coupled to the storage module 2606, non-negligible amounts of energy are transferred from the EM signal 1204 to the storage module 2606. FIG. 43B illustrates the EM signal 1204 after the energy is transferred from it. FIG. 43D illustrates the transferred energy stored in the storage module 2606. The storage module 2606 outputs the transferred energy as the down-converted signal 1208B. The storage module 2606 can output the down-converted signal 1208B as an unfiltered signal such as signal shown in FIG. 43E, or as a filtered down-converted signal (FIG. 43F).

### *3.1.2 The Gated Transfer System as Break-Before-Make Module*

FIG. 28A illustrates an example embodiment of the gated transfer module 2504 as including a break-before-make module 2802 and a storage module 2816. Preferably, the break before make module 2802 and the storage module 2816 transfer energy from the EM signal 1204 to down-convert it in any of the manners shown in the operational flowcharts 1801 in FIG. 18A, 1807 in FIG. 18B, 1813 in FIG. 18C and 1819 in FIG. 18D.

In FIG. 28A, the break-before-make module 2802 includes a includes a normally open switch 2804 and a normally closed switch 2806. The normally open switch 2804 is controlled by the energy transfer signal 2406. The normally closed switch 2806 is controlled by an isolation signal 2812. In an embodiment, the isolation signal 2812 is generated from the energy transfer signal 2406. Alternatively, the energy transfer signal 2406 is generated from the isolation signal 2812. Alternatively, the isolation signal 2812 is generated independently from the energy transfer signal 2406. The break-before-make module 2802 substantially isolates an input 2808 from an output 2810.

FIG. 28B illustrates an example timing diagram of the energy transfer signal 2406, which controls the normally open switch 2804. FIG. 28C illustrates an example timing diagram of the isolation signal 2812, which controls the normally closed switch 2806. Operation of the break-before-make module 2802 is now described with reference to the example timing diagrams in FIGS. 28B and 28C.

Prior to time t0, the normally open switch 2804 and the normally closed switch 2806 are at their normal states.

At time t0, the isolation signal 2812 in FIG. 28C opens the normally closed switch 2806. Thus, just after time t0, the normally open switch 2804 and the normally closed switch 2806 are open and the input 2808 is isolated from the output 2810.

At time t1, the energy transfer signal 2406 in FIG. 28B closes the normally open switch 2804 for the non-negligible duration of a pulse. This couples the EM signal 1204 to the storage module 2816.

Prior to t2, the energy transfer signal 2406 in FIG. 28B opens the normally open switch 2804. This de-couples the EM signal 1204 from the storage module 2816.

At time t2, the isolation signal 2812 in FIG. 28C closes the normally closed switch 2806. This couples the storage module 2816 to the output 2810.

The storage module 2816, is similar to the storage module 2606 FIG. 26. The break-before-make gated transfer system 2801 down-converts the EM signal 1204 in a manner similar to that described with reference to the gated transfer system 2601 in FIG. 26.

### *3.1.3 Example Implementations of the Switch Module*

The switch module 2602 in FIG. 26 and the switch modules 2804 and 2806 in FIG. 28A can be any type of switch device that preferably has a relatively low impedance when closed and a relatively high impedance when open. The switch modules 2602, 2804 and 2806 can be implemented with normally open or normally closed switches. The switch modules need not be ideal switch modules.

FIG. 27B illustrates the switch modules 2602, 2804 and 2806 as a switch module 2710. Switch module 2710 can be implemented in either normally open or normally closed architecture. The switch module 2710 (e.g., switch modules 2602, 2804 and 2806) can be implemented with any type of suitable switch device, including, but not limited, to mechanical switch devices and electrical switch devices, optical switch devices, etc., and combinations thereof. Such devices include, but are not limited to transistor switch devices, diode switch devices, relay switch devices, optical switch devices, micro-machine switch devices, etc., or combinations thereof.

In an embodiment, the switch module 2710 can be implemented as a transistor, such as, for example, a field effect transistor (FET), a bi-polar transistor, or any other suitable circuit switching device.

In FIG. 27A, the switch module 2710 is illustrated as a FET 2702. The FET 2702 can be any type of FET, including, but not limited to, a MOSFET, a JFET, a GaAsFET, etc. The FET 2702 includes a gate 2704, a source 2706 and a drain 2708. The gate 2704 receives the energy transfer signal 2406 to control the switching action between the source 2706 and the drain 2708. In an embodiment, the source 2706 and the drain 2708 are interchangeable.

It should be understood that the illustration of the switch module 2710 as a FET 2702 in FIG. 27A is for example purposes only. Any device having switching capabilities could be used to implement the switch module 2710 (i.e., switch modules 2602, 2804 and 2806), as will be apparent to persons skilled in the relevant art(s) based on the discussion contained herein.

In FIG. 27C, the switch module 2710 is illustrated as a diode switch 2712, which operates as a two lead device when the energy transfer signal 2406 is coupled to the output 2713.

In FIG. 27D, the switch module 2710 is illustrated as a diode switch 2714, which operates as a two lead device when the energy transfer signal 2406 is coupled to the output 2715.

### *3.1.4 Example Implementations of the Storage Module*

The storage modules 2606 and 2816 store non-negligible amounts of energy from the EM signal 1204. In an exemplary embodiment, the storage modules 2606 and 2816 are implemented as a reactive storage module 2901 in FIG. 29A, although the invention is not limited to this embodiment. A reactive storage module is a storage module that employs one or more reactive electrical components to store energy transferred from the EM signal 1204. Reactive electrical components include, but are not limited to, capacitors and inductors.

In an embodiment, the storage modules 2606 and 2816 include one or more capacitive storage elements, illustrated in FIG. 29B as a capacitive storage module 2902. In FIG. 29C, the capacitive storage module 2902 is illustrated as one or more capacitors illustrated generally as capacitor(s) 2904.

The goal of the storage modules 2606 and 2816 is to store non-negligible amounts of energy transferred from the EM signal 1204. Amplitude reproduction of the original, unaffected EM input signal is not necessarily important. In an energy transfer environment, the storage module preferably has the capacity to handle the power being transferred, and to allow it to accept a non-negligible amount of power during a non-negligible aperture period.

A terminal 2906 serves as an output of the capacitive storage module 2902. The capacitive storage module 2902 provides the stored energy at the terminal 2906. FIG. 29F illustrates the capacitive storage module 2902 as including a series capacitor 2912, which can be utilized in an inverted gated transfer system described below.

In an alternative embodiment, the storage modules 2606 and 2816 include one or more inductive storage elements, illustrated in FIG. 29D as an inductive storage module 2908.

In an alternative embodiment, the storage modules 2606 and 2816 include a combination of one or more capacitive storage elements and one or more inductive storage elements, illustrated in FIG. 29E as a capacitive/inductive storage module 2910.

FIG. 29G illustrates an integrated gated transfer system 2918 that can be implemented to down-convert the EM signal 1204 as illustrated in, and described with reference to, FIGS. 43A-F.

### *3.1.5 Optional Energy Transfer Signal Module*

FIG. 30 illustrates an energy transfer system 3001, which is an example embodiment of the energy transfer system 2402. The energy transfer system 3001 includes an optional energy transfer signal module 3002, which can perform any of a variety of functions or combinations of functions including, but not limited to, generating the energy transfer signal 2406.

In an embodiment, the optional energy transfer signal module 3002 includes an aperture generator, an example of which is illustrated in FIG. 29J as an aperture generator 2920. The aperture generator 2920 generates non-negligible aperture pulses 2926 from an input signal 2924. The input signal 2924 can be any type of periodic signal, including, but not limited to, a sinusoid, a square wave, a saw-tooth wave, etc. Systems for generating the input signal 2924 are described below.

The width or aperture of the pulses 2926 is determined by delay through the branch 2922 of the aperture generator 2920. Generally, as the desired pulse width increases, the difficulty in meeting the requirements of the aperture generator 2920 decrease. In other words, to generate non-negligible aperture pulses for a given EM input frequency, the components utilized in the example aperture generator 2920 do not require as fast reaction times as those that are required in an under-sampling system operating with the same EM input frequency.

The example logic and implementation shown in the aperture generator 2920 are provided for illustrative purposes only, and are not limiting. The actual logic employed can take many forms. The example aperture generator 2920 includes an optional inverter 2928, which is shown for polarity consistency with other examples provided herein.

An example implementation of the aperture generator 2920 is illustrated in FIG. 29K. Additional examples of aperture generation logic are provided in FIGS. 29H and 29I. FIG. 29H illustrates a rising edge pulse generator 2940, which generates pulses 2926 on rising edges of the input signal 2924. FIG. 29I illustrates a falling edge pulse generator 2950, which generates pulses 2926 on falling edges of the input signal 2924.

In an embodiment, the input signal 2924 is generated externally of the energy transfer signal module 3002, as illustrated in FIG. 30. Alternatively, the input signal 2924 is generated internally by the energy transfer signal module 3002. The input signal 2924 can be generated by an oscillator, as illustrated in FIG. 29L by an oscillator 2930. The oscillator 2930 can be internal to the energy transfer signal module 3002 or external to the energy transfer signal module 3002. The oscillator 2930 can be external to the energy transfer system 3001. The output of the oscillator 2930 may be any periodic waveform.

The type of down-conversion performed by the energy transfer system 3001 depends upon the aliasing rate of the energy transfer signal 2406, which is determined by the frequency of the pulses 2926. The frequency of the pulses 2926 is determined by the frequency of the input signal 2924. For example, when the frequency of the input signal 2924 is substantially equal to a harmonic or a sub-harmonic of the EM signal 1204, the EM signal 1204 is directly down-converted to baseband (e.g. when the EM signal is an AM signal or a PM signal), or converted from FM to a non-FM signal. When the frequency of the input signal 2924 is substantially equal to a harmonic or a sub-harmonic of a difference frequency, the EM signal 1204 is down-converted to an intermediate signal.
The optional energy transfer signal module 3002 can be implemented in hardware, software, firmware, or any combination thereof.

### *3.2 The Energy Transfer System as an Inverted Gated Transfer System*

FIG. 25B illustrates an exemplary inverted gated transfer system 2506, which is an exemplary implementation of the energy transfer system 2402. The inverted gated transfer system 2506 includes an inverted gated transfer module 2508, which receives the EM signal 1204 and the energy transfer signal 2406. The energy transfer signal 2406 includes a train of energy transfer pulses having non-negligible apertures that tend away from zero time in duration. The energy transfer pulses repeat at an aliasing rate $F_{AR}$. The inverted gated transfer module 2508 transfers energy from the EM signal 1204 at the aliasing rate of the energy transfer signal 2406, as described in the sections above with respect to the flowcharts 1801 in FIG. 18A, 1807 in FIG. 18B, 1813 in FIG. 18C and 1819 in FIG. 18D. The inverted gated transfer module 2508 outputs the down-converted signal 1208B, which includes non-negligible amounts of energy transferred from the EM signal 1204.

#### *3.2.1 The Inverted Gated Transfer System as a Switch Module and a Storage Module*

FIG. 35 illustrates an example embodiment of the inverted gated transfer module 2508 as including a switch module 3504 and a storage module 3506. Preferably, the switch module 3504 and the storage module 3506 transfer energy from the EM signal 1204 to down-convert it in any of the manners shown in the operational flowcharts 1801 in FIG. 18A, 1807 in FIG. 18B, 1813 in FIG. 18C and 1819 in FIG. 18D.
The switch module 3504 can be implemented as described above with reference to FIGS. 27A-D. The storage module 3506 can be implemented as described above with reference to FIGS. 29A-F.
In the illustrated embodiment, the storage module 3306 includes one or more capacitors 3508. The capacitor (s) 3508 are selected to pass higher frequency components of the EM signal 1204 through to a terminal 3510, regardless of the state of the switch module 3504. The capacitor 3508 stores non-negligible amounts of energy from the EM signal 1204. Thereafter, the signal at the terminal 3510 is off-set by an amount related to the energy stored in the capacitor 3508.
Operation of the inverted gated transfer system 3501 is illustrated in FIGS. 36A-F. FIG. 36A illustrates the EM signal 1204. FIG. 36B illustrates the EM signal 1204 after transferring energy from it. FIG. 36C illustrates the energy transfer signal 2406, which includes a train of energy transfer pulses having non-negligible apertures.
FIG. 36D illustrates an example down-converted signal 1208B. FIG. 36E illustrates the down-converted signal 1208B on a compressed time scale. Since the storage module 3506 is a series element, the higher frequencies (e. g., RF) of the EM signal 1204 can be seen on the down-converted signal. This can be filtered as illustrated in FIG. 36F.
The inverted gated transfer system 3501 can be used to down-convert any type of EM signal, including modulated carrier signals and unmodulated carrier signals.

### *3.3 Rail to Rail Operation for Improved Dynamic Range*

#### *3.3.1 Introduction*

FIG. 69A illustrates aliasing module 6900 that down-converts EM signal 6902 to down-converted signal 6912 using aliasing signal 6914 (sometimes called an energy transfer signal). Aliasing module 6900 is an example of energy transfer module 2404 in FIG. 24. Aliasing module 6900 includes UFT module 6904 and storage module 6908. As shown in FIG. 69A, UFT module 6904 is implemented as a n-channel FET 6906, and storage module 6908 is implemented as a capacitor 6910, although the invention is not limited to this embodiment.
FET 6906 receives the EM signal 6902 and aliasing signal 6914. In one embodiment, aliasing signal 6914 includes a train of pulses having non-negligible apertures that repeat at an aliasing rate. The aliasing rate may be harmonic or sub-harmonic of the EM signal 6902. FET 6906 samples EM signal 6902 at the aliasing rate of aliasing signal 6914 to generate down-converted signal 6912. In one embodiment, aliasing signal 6914 controls the gate of FET 6906 so that FET 6906 conducts (or turns on) when the FET gate-to-source voltage ($V_{GS}$) exceeds a threshold voltage ($V_T$). When the FET 6906 conducts, a channel is created from source to drain of FET 6906 so that charge is transferred from the EM signal 6902 to the capacitor 6910. More specifically, the FET 6906 conductance (I/R) vs $V_{GS}$ is a continuous function that reaches an acceptable level at $V_T$, as illustrated in FIG. 69B. The charge stored by capacitor 6910 during successive samples forms down-converted signal 6912.

As stated above, n-channel FET 6906 conducts when $V_{GS}$ exceeds the threshold voltage $V_T$. As shown in FIG. 69A, the gate voltage of FET 6906 is determined by aliasing signal 6914, and the source voltage is determined by the input EM signal 6902. Aliasing signal 6914 is preferably a plurality of pulses whose amplitude is predictable and set by a system designer. However, the EM signal 6902 is typically received over a communications medium by a coupling device (such as antenna). Therefore, the amplitude of EM signal 6902 may be variable and dependent on a number of factors including the strength of the transmitted signal, and the attenuation of the communications medium. Thus, the source voltage on FET 6906 is not entirely predictable and will affect $V_{GS}$ and the conductance of FET 6906, accordingly.

For example, FIG. 70A illustrates EM signal 7002, which is an example of EM signal 6902 that appears on the source of FET 6906. EM signal 7002 has a section 7004 with a relatively high amplitude as shown. FIG. 70B illustrates the aliasing signal 7006 as an example of aliasing signal 6914 that controls the gate of FET 6906. FIG. 70C illustrates $V_{GS}$ 7008, which is the difference between the gate and source voltages shown in FIGs. 70B and 70A, respectively. FET 6906 has an inherent threshold voltage $V_T$ 7012 shown in FIG. 70C, above which FET 6906 conducts. It is preferred that $V_{GS} > V_T$ during each pulse of aliasing signal 7006, so that FET 6906 conducts and charge is transferred from the EM signal 7002 to the capacitor 6910 during each pulse of aliasing signal 7006. As shown in FIG. 70C, the high amplitude section 7004 of EM signal 7002 causes a $V_{GS}$ pulse 7010 that does exceed the $V_T$ 7012, and therefore FET 6906 will not fully conduct as is desired. Therefore, the resulting sample of EM signal 7002 may be degraded, which potentially negatively affects the down-converted signal 6912.

As stated earlier, the conductance of FET 6906 vs $V_{GS}$ is mathematically continuous and is not a hard cutoff. In other words, FET 6906 will marginally conduct when controlled by pulse 7010, even though pulse 7010 is below $V_T$ 7012. However, the insertion loss of FET 6906 will be increased when compared with a $V_{GS}$ pulse 7011, which is greater than $V_T$ 7012. The performance reduction caused by a large amplitude input signal is often referred to as clipping or compression. Clipping causes distortion in the down-converted signal 6912, which adversely affects the faithful down-conversion of input EM signal 7002. Dynamic range is a figure of merit associated with the range of input signals that can be faithfully down-converted without introducing distortion in the down-converted signal. The higher the dynamic range of a down-conversion circuit, the larger the input signals that can down-converted without introducing distortion in the down-converted signal.

### *3.3.2 Complementary UFT Structure for Improved Dynamic Range*

FIG. 71 illustrates aliasing module 7100, according to an embodiment of the invention, that down-converts EM signal 7108 to generate down-converted signal 7114 using aliasing signal 7120. Aliasing module 7100 is able to down-convert input signals over a larger amplitude range as compared to aliasing module 6900, and therefore aliasing module 7100 has an improved dynamic range when compared with aliasing module 6900. The dynamic range improvement occurs because aliasing module 7100 includes two UFT modules that are implemented with complementary FET devices. In other words, one FET is n-channel, and the other FET is p-channel, so that at least one FET is always conducting during an aliasing signal pulse, assuming the input signal does not exceed the power supply constraints. Aliasing module 7100 includes: delay 7102; UFT modules 7106, 7116; nodes 7107, 7112; and inverter 7122. Inverter 7122 is tied to voltage supplies $V_+$ 7132 and V. 7134. UFT module 7106 comprises n-channel FET 7104, and UFT module 7116 comprises p-channel FET 7118.

As stated, aliasing module 7100 operates two complementary FETs to extend the dynamic range and reduce any distortion effects. This requires that two complementary aliasing signals 7124, 7126 be generated from aliasing signal 7120 to control the sampling by FETs 7118, 7104, respectively. To do so, inverter 7122 receives and inverts aliasing signal 7120 to generate aliasing signal 7124 that controls p-channel FET 7118. Delay 7102 delays aliasing signal 7120 to generate aliasing signal 7126, where the amount of time delay is approximately equivalent to that associated with inverter 7122. As such, aliasing signals 7124 and 7126 are approximately complementary in amplitude.

Node 7110 receives EM signal 7108, and couples EM signals 7127, 7128 to the sources of n-channel FET 7104 and p-channel FET 7118, respectively, where EM signals 7127, 7128 are substantially replicas of EM signal 7108. N-channel FET 7104 samples EM signal 7127 as controlled by aliasing signal 7126, and produces samples 7136 at the drain of FET 7104. Likewise, p-channel FET 7118 samples EM signal 7128 as controlled by aliasing signal 7124, and produces samples 7138 at the drain of FET 7118. Node 7112 combines the resulting charge samples into charge samples 7140, which are stored by capacitor 7130. The charge stored by capacitor 7130 during successive samples forms down-converted signal 7114. Aliasing module 7100 offers improved dynamic range over aliasing module 6900 because n-channel FET 7104 and p-channel FET 7114 are complementary devices. Therefore, if one device is cutoff because of a large input EM signal 7108, the other device will conduct and sample the input signal, as long as the input signal is between the power supply voltages $V_+$ 7132 and $V_-$ 7134. This is often referred to as rail-to-rail operation as will be understood by those skilled in the arts.

For example, FIG. 72A illustrates EM signal 7202 which is an example of EM signals 7127, 7128 that are coupled to the sources of n-channel FET 7104 and p-channel FET 7118, respectively. As shown, EM signal 7202 has a section 7204 with a relatively high amplitude including pulses 7203, 7205. FIG. 72B illustrates the aliasing signal 7206 as an example of aliasing signal 7126 that controls the gate of n-channel FET 7104. Likewise for the p-channel FET, FIG. 72D illustrates the aliasing signal 7214 as an example of aliasing signal 7124 that controls the gate of p-channel FET 7118. Aliasing signal 7214 is the amplitude complement of aliasing signal 7206.

FIG. 72C illustrates $V_{GS}$ 7208, which is the difference between the gate and source voltages on n-channel FET 7104 that are depicted in FIGs. 72B and 72A, respectively. FIG. 72C also illustrates the inherent threshold voltage $V_T$ 7209 for FET 7104, above which FET 7104 conducts. Likewise for the p-channel FET, FIG. 72E illustrates $V_{GS}$ 7216, which is the difference between the gate and source voltages for p-channel FET 7118 that are depicted in FIGs. 72D and 72A, respectively. FIG. 72E also illustrates the inherent threshold voltage $V_T$ 7217 for FET 7118, below which FET 7118 conducts.

As stated, n-channel FET 7104 conducts when $V_{GS}$ 7208 exceeds $V_T$ 7209, and p-channel FET 7118 conducts when $V_{GS}$ 7216 drops below $V_T$ 7217. As illustrated by FIG. 72C, n-channel FET 7104 conducts over the range of EM signal 7202 depicted in FIG. 72A, except for the EM signal pulse 7205 that results in a corresponding $V_{GS}$ pulse 7210 (FIG. 72C) that does not exceed $V_T$ 7209. However, p-channel FET 7118 does conduct because the same EM signal pulse 7205 causes a $V_{GS}$ pulse 7220 (FIG. 72E) that drops well below that of $V_T$ 7217 for the p-channel FET. Therefore, the sample of the EM signal 7202 is properly taken by p-channel FET 7118, and no distortion is introduced in down-converted signal 7118. Similarly, EM signal pulse 7203 results in $V_{GS}$ pulse 7222 (FIG. 72E) that is inadequate for the p-channel FET 7118 to fully conduct. However, n-channel FET 7104 does fully conduct because the same EM signal pulse 7203 results in a $V_{GS}$ 7211 (FIG. 72C) that greatly exceeds $V_T$ 7209.

As illustrated above, aliasing module 7100 offers an improvement in dynamic range over aliasing module 6900 because of the complimentary FET structure. Any input signal that is within the power supply voltages $V_+$ 7132 and V. 7134 will cause either FET 7104 or FET 7118 to conduct, or cause both FETs to conduct, as is demonstrated by FIGs. 72A-72E. This occurs because any input signal that produces a $V_{GS}$ that cuts-off the n-channel FET 7104 will push the p-channel FET 7118 into conduction. Likewise, any input signal that cuts-off the p-channel FET 7118 will push the n-channel FET 7104 into conduction, and therefore prevent any distortion of the down-converted output signal.

### *3.3.3 Biased Configurations*

FIG. 73 illustrates aliasing module 7300, which is an alternate embodiment of aliasing module 7100. Aliasing module 7300 includes positive voltage supply ($V_+$) 7302, resistors 7304, 7306, and the elements in aliasing module 7100. $V_+$ 7302 and resistors 7304, 7306 produce a positive DC voltage at node 7305. This allows node 7305 to drive a coupled circuit that requires a positive voltage supply, and enables unipolar supply operation of aliasing module 7300. The positive supply voltage also has the effect of raising the DC level of the input EM signal 7108. As such, any input signal that is within the power supply voltages $V_+$ 7302 and ground will cause either FET 7104 or FET 7118 to conduct, or cause both FETs to conduct, as will be understood by those skilled in the arts based on the discussion herein.

FIG. 74 illustrates aliasing module 7400, which is an alternate biased configuration of aliasing module 7100. Aliasing module 7400 includes positive voltage supply 7402, negative voltage supply 7408, resistors 7404, 7406, and the elements in aliasing module 7100. The use of both a positive and negative voltage supply allows for node 7205 to be biased anywhere between $V_+$ 7202 and V. 7208. This allows node 7205 to drive a coupled circuit that requires either a positive or negative supply voltage. Furthermore, any input signal that is within the power supply voltages $V_+$ 7202 and $V_-$ 7208 will cause either FET 7104 or FET 7118 to conduct, or cause both FETs to conduct, as will be understood by those skilled in the arts based on the discussion herein.

### *3.3.4 Simulation Examples*

As stated, an aliasing module with a complementary FET structure offers improved dynamic range when compared with a single (or unipolar) FET configuration. This is further illustrated by comparing the signal waveforms associated aliasing module 7502 (of FIG. 75) which has a complementary FET structure, with that of aliasing module 7602 (of FIG. 76) which has a single (or unipolar) FET structure.

Aliasing module 7502 (of FIG. 75) down-converts EM signal 7508 using aliasing signal 7512 to generate down-converted signal 7510. Aliasing module 7502 has a complementary FET structure and includes n-channel FET 7504, p-channel FET 7506, inverter 7514, and aliasing signal generator 7508. Aliasing module 7502 is biased by supply circuit 7516 as is shown. Aliasing module 7602 (FIG. 76) down-converts EM signal 7604 using aliasing signal 7608 to generate down-converted signal 7606. Aliasing module 7602 is a single FET structure comprising n-channel FET 7612 and aliasing signal generator 7614, and is biased using voltage supply circuit 7610.

FIGs. 77-79 are signal waveforms that correspond to aliasing module 7502, and FIGs. 80-82 are signal waveforms that correspond to aliasing module 7602. FIGs. 77, 80 are down-converted signals 7510, 7606, respectively. FIGs. 78, 81 are the sampled EM signal 7508, 7604, respectively. FIGs. 79, 82 are the aliasing signals 7512, 7608, respectively. Aliasing signal 7512 is identical to aliasing signal 7608 in order that a proper comparison between modules 7502 and 7602 can be made.

EM signals 7508, 7604 are relatively large input signals that approach the power supply voltages of 1.65 volts, as is shown in FIGs. 78, 81, respectively. In FIG. 78, sections 7802 and 7804 of signal 7508 depict energy transfer from EM signal 7508 to down-converted signal 7510 during by aliasing module 7502. More specifically, section 7802 depicts energy transfer near the -1.65v supply, and section 7804 depicts energy transfer near the +1.65v supply. The symmetrical quality of the energy transfer near the voltage supply rails indicates that at least one of complementary FETs 7504, 7506 are appropriately sampling the EM signal during each of the aliasing pulses 7512. This results in a down-converted signal 7510 that has minimal high frequency noise, and is centered between -1.0v and 1.0v (i.e. has negligible DC voltage component).

Similarly in FIG. 81, sections 8102 and 8104 illustrate the energy transfer from EM signal 7604 to down-converted signal 7606 by aliasing module 7602 (single FET configuration). More specifically, section 8102 depicts energy transfer near the -1.65v supply, and section 8104 depicts energy transfer near the +1.65v supply. By comparing sections 8102, 8104 with sections 7802, 7804 of FIG. 78, it is clear that the energy transfer in sections 8102, 8104 is not as symmetrical near the power supply rails as that of sections 7802, 7804. This is evidence that the EM signal 7604 is partially pinching off single FET 7612 over part of the signal 7604 trace. This results in a down-converted signal 7606 that has more high frequency noise when compared to down-converted signal 7510, and has a substantial negative DC voltage component.

In summary, down-converted signal 7604 reflects distortion introduced by a relatively large EM signal that is pinching-off the single FET 7612 in aliasing module 7602. Down-converted signal 7510 that is produced by aliasing module 7502 is relatively distortion free. This occurs because the complementary FET configuration in aliasing module 7502 is able to handle input signals with large amplitudes without introducing distortion in the down-converted signal 7510. Therefore, the complementary FET configuration in the aliasing module 7502 offers improved dynamic range when compared with the single FET configuration of the aliasing module 7602.

### *3.4 Optimized Switch Structures*

#### *3.4.1 Splitter in CMOS*

FIG. 83A illustrates an embodiment of a splitter circuit 8300 implemented in CMOS. This embodiment is provided for illustrative purposes, and is not limiting. In an embodiment, splitter circuit 8300 is used to split a local oscillator (LO) signal into two oscillating signals that are approximately 90° out of phase. The first oscillating signal is called the I-channel oscillating signal. The second oscillating signal is called the Q-channel oscillating signal. The Q-channel oscillating signal lags the phase of the 1-channel oscillating signal by approximately 90°. Splitter circuit 8300 includes a first I-channel inverter 8302, a second I-channel inverter 8304, a third I-channel inverter 8306, a first Q-channel inverter 8308, a second Q-channel inverter 8310, an I-channel flip-flop 8312, and a Q-channel flip-flop 8314.

FIGS. 83F-J are example waveforms used to illustrate signal relationships of splitter circuit 8300. The waveforms shown in FIGS. 83F-J reflect ideal delay times through splitter circuit 8300 components. LO signal 8316 is shown in FIG. 83F. First, second, and third I-channel inverters 8302, 8304, and 8306 invert LO signal 8316 three times, outputting inverted LO signal 8318, as shown in FIG. 83G. First and second Q-channel inverters 8308 and 8310 invert LO signal 8316 twice, outputting non-inverted LO signal 8320, as shown in FIG. 83H. The delay through first, second, and third I-channel inverters 8302, 8304, and 8306 is substantially equal to that through first and second Q-channel inverters 8308 and 8310, so that inverted LO signal 83 14 and non-inverted LO signal 8320 are approximately 180° out of phase. The operating characteristics of the inverters may be tailored to achieve the proper delay amounts, as would be understood by persons skilled in the relevant art(s).

I-channel flip-flop 8312 inputs inverted LO signal 8318. Q-channel flip-flop 8314 inputs non-inverted LO signal 8320. In the current embodiment, I-channel flip-flop 8312 and Q-channel flip-flop 8314 are edge-triggered flip-flops. When either flip-flop receives a rising edge on its input, the flip-flop output changes state. Hence, I-channel flip-flop 8312 and Q-channel flip-flop 8314 each output signals that are approximately half of the input signal frequency. Additionally, as would be recognized by persons skilled in the relevant art(s), because the inputs to I-channel flip-flop 8312 and Q-channel flip-flop 8314 are approximately 180° out of phase, their resulting outputs are signals that are approximately 90° out of phase. I-channel flip-flop 8312 outputs I-channel oscillating signal 8322, as shown in FIG. 83I. Q-channel flip-flop 8314 outputs Q-channel oscillating signal 8324, as shown in FIG. 83J. Q-channel oscillating signal 8324 lags the phase of I-channel oscillating signal 8322 by 90°, also as shown in a comparison of FIGS. 83I and 83J.

FIG. 83B illustrates a more detailed circuit embodiment of the splitter circuit 8300 of FIG. 83. The circuit blocks of FIG. 83B that are similar to those of FIG. 83A are indicated by corresponding reference numbers. FIGS. 83C-D show example output waveforms relating to the splitter circuit 8300 of FIG. 83B. FIG. 83C shows I-channel oscillating signal 8322. FIG. 83D shows Q-channel oscillating signal 8324. As is indicated by a comparison of FIGS. 83C and 83D, the waveform of Q-channel oscillating signal 8324 of FIG. 83D lags the waveform of 1-channel oscillating signal 8322 of FIG. 83C by approximately 90°.

It should be understood that the illustration of the splitter circuit 8300 in FIGS. 83A and 83B is for example purposes only. Splitter circuit 8300 may be comprised of an assortment of logic and semiconductor devices of a variety of types, as will be apparent to persons skilled in the relevant art(s) based on the discussion contained herein.

### *3.4.2 I/Q Circuit*

FIG. 83E illustrates an example embodiment of a complete I/Q circuit 8326 in CMOS. I/Q circuit 8326 includes a splitter circuit 8300 as described in detail above. Further description regarding I/Q circuit implementations are provided herein, including the applications referenced above.

### *3.5 Example I and Q Implementations*

### *3.5.1 Switches of Different Sizes*

In an embodiment, the switch modules discussed herein can be implemented as a series of switches operating in parallel as a single switch. The series of switches can be transistors, such as, for example, field effect transistors (FET), bi-polar transistors, or any other suitable circuit switching devices. The series of switches can be comprised of one type of switching device, or a combination of different switching devices.

For example, FIG. 84 illustrates a switch module 8400. In FIG. 84, the switch module is illustrated as a series of FETs 8402a-n. The FETs 8402a-n can be any type of FET, including, but not limited to, a MOSFET, a JFET, a GaAsFET, etc. Each of FETs 8402a-n includes a gate 8404a-n, a source 8406a-n, and a drain 8408a-n, similarly to that of FET 1502 of FIG. 15A. The series of FETs 8402a-n operate in parallel. Gates 8404a-n are coupled together, sources 8406a-n are coupled together, and drains 8408a-n are coupled together. Each of gates 8404a-n receives the control signal 1604, 4210 to control the switching action between corresponding sources 8406a-n and drains 8408a-n. Generally, the corresponding sources 8406a-n and drains 8408a-n of each of FETs 8402a-n are interchangeable. There is no numerical limit to the number of FETs. Any limitation would depend on the particular application, and the "a-n" designation is not meant to suggest a limit in any way.

In an embodiment, FETs 8402a-n have similar characteristics. In another embodiment, one or more of FETs 8402a-n have different characteristics than the other FETs. For example, FETs 8402a-n may be of different sizes. In CMOS, generally, the larger size a switch is (meaning the larger the area under the gate between the source and drain regions), the longer it takes for the switch to turn on. The longer turn on time is due in part to a higher gate to channel capacitance that exists in larger switches. Smaller CMOS switches turn on in less time, but have a higher channel resistance. Larger CMOS switches have lower channel resistance relative to smaller CMOS switches. Different turn on characteristics for different size switches provides flexibility in designing an overall switch module structure. By combining smaller switches with larger switches, the channel conductance of the overall switch structure can be tailored to satisfy given requirements.

In an embodiment, FETs 8402a-n are CMOS switches of different relative sizes. For example, FET 8402a may be a switch with a smaller size relative to FETs 8402b-n. FET 8402b may be a switch with a larger size relative to FET 8402a, but smaller size relative to FETs 8402c-n. The sizes of FETs 8402c-n also may be varied relative to each other. For instance, progressively larger switch sizes may be used. By varying the sizes of FETs 8402a-n relative to each other, the turn on characteristic curve of the switch module can be correspondingly varied. For instance, the turn on characteristic of the switch module can be tailored such that it more closely approaches that of an ideal switch. Alternately, the switch module could be tailored to produce a shaped conductive curve.

By configuring FETs 8402a-n such that one or more of them are of a relatively smaller size, their faster turn on characteristic can improve the overall switch module turn on characteristic curve. Because smaller switches have a lower gate to channel capacitance, they can turn on more rapidly than larger switches.

By configuring FETs 8402a-n such that one or more of them are of a relatively larger size, their lower channel resistance also can improve the overall switch module turn on characteristics. Because larger switches have a lower channel resistance, they can provide the overall switch structure with a lower channel resistance, even when combined with smaller switches. This improves the overall switch structure's ability to drive a wider range of loads. Accordingly, the ability to tailor switch sizes relative to each other in the overall switch structure allows for overall switch structure operation to more nearly approach ideal, or to achieve application specific requirements, or to balance trade-offs to achieve specific goals, as will be understood by persons skilled in the relevant arts(s) from the teachings herein.

It should be understood that the illustration of the switch module as a series of FETs 8402a-n in FIG. 84 is for example purposes only. Any device having switching capabilities could be used to implement the switch module (e.g., switch modules 1602, 1502, 1404 and 1406), as will be apparent to persons skilled in the relevant art(s) based on the discussion contained herein.

### *3.5.2 Reducing Overall Switch Area*

Circuit performance also can be improved by reducing overall switch area. As discussed above, smaller switches (i.e., smaller area under the gate between the source and drain regions) have a lower gate to channel capacitance relative to larger switches. The lower gate to channel capacitance allows for lower circuit sensitivity to noise spikes. FIG. 85A illustrates an embodiment of a switch module, with a large overall switch area. The switch module of FIG. 85A includes twenty FETs 8502-8540. As shown, FETs 8502-8540 are the same size ("Wd" and "lng" parameters are equal). Input source 8546 produces the input EM signal. Pulse generator 8548 produces the energy transfer signal for FETs 8502-8540. Capacitor C1 is the storage element for the input signal being sampled by FETs 8502-8540. FIGS. 85B-85Q illustrate example waveforms related to the switch module of FIG. 85A. FIG. 85B shows a received 1.01 GHz EM signal to be sampled and downconverted to a 10 MHZ intermediate frequency signal. FIG. 85C shows an energy transfer signal having an aliasing rate of 200 MHZ, which is applied to the gate of each of the twenty FETs 8502-8540. The energy transfer signal includes a train of energy transfer pulses having non-negligible apertures that tend away from zero time in duration. The energy transfer pulses repeat at the aliasing rate. FIG. 85D illustrates the affected received EM signal, showing effects of transferring energy at the aliasing rate, at point 8542 of FIG. 85A. FIG. 85E illustrates a down-converted signal at point 8544 of FIG. 85A, which is generated by the down-conversion process.

FIG. 85F illustrates the frequency spectrum of the received 1.01 GHz EM signal. FIG. 85G illustrates the frequency spectrum of the received energy transfer signal. FIG. 85H illustrates the frequency spectrum of the affected received EM signal at point 8542 of FIG. 85A. FIG. 85I illustrates the frequency spectrum of the down-converted signal at point 8544 of FIG. 85A.

FIGS. 85J-85M respectively further illustrate the frequency spectrums of the received 1.01 GHz EM signal, the received energy transfer signal, the affected received EM signal at point 8542 of FIG. 85A, and the down-converted signal at point 8544 of FIG. 85A, focusing on a narrower frequency range centered on 1.00 GHz. As shown in FIG. 85L, a noise spike exists at approximately 1.0 GHz on the affected received EM signal at point 8542 of FIG. 85A. This noise spike may be radiated by the circuit, causing interference at 1.0 GHz to nearby receivers.

FIGS. 85N-85Q respectively illustrate the frequency spectrums of the received 1.01 GHz EM signal, the received energy transfer signal, the affected received EM signal at point 8542 of FIG. 85A, and the down-converted signal at point 8544 of FIG. 85A, focusing on a narrow frequency range centered near 10.0 MHZ. In particular, FIG. 85Q shows that an approximately 5 mV signal was downconverted at approximately 10 MHZ.

FIG. 86A illustrates an alternative embodiment of the switch module, this time with fourteen FETs 8602-8628 shown, rather than twenty FETs 8502-8540 as shown in FIG. 85A. Additionally, the FETs are of various sizes (some "Wd" and "lng" parameters are different between FETs).

FIGS. 86B-86Q, which are example waveforms related to the switch module of FIG. 86A, correspond to the similarly designated figures of FIGS. 85B-85Q. As FIG. 86L shows, a lower level noise spike exists at 1.0 GHz than at the same frequency of FIG. 85L. This correlates to lower levels of circuit radiation. Additionally, as FIG. 86Q shows, the lower level noise spike at 1.0 GHz was achieved with no loss in conversion efficiency. This is represented in FIG. 86Q by the approximately 5 mV signal downconverted at approximately 10 MHZ. This voltage is substantially equal to the level downconverted by the circuit of FIG. 85A. In effect, by decreasing the number of switches, which decreases overall switch area, and by reducing switch area on a switch-by-switch basis, circuit parasitic capacitance can be reduced, as would be understood by persons skilled in the relevant art(s) from the teachings herein. In particular this may reduce overall gate to channel capacitance, leading to lower amplitude noise spikes and reduced unwanted circuit radiation.

It should be understood that the illustration of the switches above as FETs in FIGSs. 85A-85Q and 86A-86Q is for example purposes only. Any device having switching capabilities could be used to implement the switch module, as will be apparent to persons skilled in the relevant art(s) based on the discussion contained herein.

### *3.5.3 Charge Injection Cancellation*

In embodiments wherein the switch modules discussed herein are comprised of a series of switches in parallel, in some instances it may be desirable to minimize the effects of charge injection. Minimizing charge injection is generally desirable in order to reduce the unwanted circuit radiation resulting therefrom. In an embodiment, unwanted charge injection effects can be reduced through the use of complementary n-channel MOSFETs and p-channel MOSFETs. N-channel MOSFETs and p-channel MOSFETs both suffer from charge injection. However, because signals of opposite polarity are applied to their respective gates to turn the switches on and off, the resulting charge injection is of opposite polarity. Resultingly, n-channel MOSFETs and p-channel MOSFETs may be paired to cancel their corresponding charge injection. Hence, in an embodiment, the switch module may be comprised of n-channel MOSFETs and p-channel MOSFETS, wherein the members of each are sized to minimize the undesired effects of charge injection.

FIG 88A illustrates an alternative embodiment of the switch module, this time with fourteen n-channel FETs 8802-8828 and twelve p-channel FETs 8830-8852 shown, rather than twenty FETs 8502-8540 as shown in FIG. 85A. The n-channel and p-channel FETs are arranged in a complementary configuration. Additionally, the FETs are of various sizes (some "Wd" and "lng" parameters are different between FETs).

FIGS. 88B-88Q, which are example waveforms related to the switch module of FIG. 88A, correspond to the similarly designated figures of FIGS. 85B-85Q. As FIG. 88L shows, a lower level noise spike exists at 1.0 GHz than at the same frequency of FIG. 85L. This correlates to lower levels of circuit radiation. Additionally, as FIG. 88Q shows, the lower level noise spike at 1.0 GHz was achieved with no loss in conversion efficiency. This is represented in FIG. 88Q by approximately 5 mV signal downconverted at approximately 10 MHZ. This voltage is substantially equal to the level downconverted by the circuit of FIG. 85A. In effect, by arranging the switches in a complementary configuration, which assists in reducing charge injection, and by tailoring switch area on a switch-by-switch basis, the effects of charge injection can be reduced, as would be understood by persons skilled in the relevant art(s) from the teachings herein. In particular this leads to lower amplitude noise spikes and reduced unwanted circuit radiation.

It should be understood that the use of FETs in FIGs. 88A-88Q in the above description is for example purposes only. From the teachings herein, it would be apparent to persons of skill in the relevant art(s) to manage charge injection in various transistor technologies using transistor pairs.

### *3.5.4 Overlapped Capacitance*

The process involved in fabricating semiconductor circuits, such as MOSFETs, have limitations. In some instances, these process limitations may lead to circuits that do not function as ideally as desired. For instance, a non-ideally fabricated MOSFET may suffer from parasitic capacitances, which in some cases may cause the surrounding circuit to radiate noise. By fabricating circuits with structure layouts as close to ideal as possible, problems of non-ideal circuit operation can be minimized.

FIG. 87A illustrates a cross-section of an example n-channel enhancement-mode MOSFET 8700, with ideally shaped n+ regions. MOSFET 8700 includes a gate 8702, a channel region 8704, a source contact 8706, a source region 8708, a drain contact 8710, a drain region 8712, and an insulator 8714. Source region 8708 and drain region 8712 are separated by p-type material of channel region 8704. Source region 8708 and drain region 8712 are shown to be n+ material. The n+ material is typically implanted in the p-type material of channel region 8704 by an ion implantation/diffusion process. Ion implantation/diffusion processes are well known by persons skilled in the relevant art(s). Insulator 8714 insulates gate 8702 which bridges over the p-type material. Insulator 8714 generally comprises a metal-oxide insulator. The channel current between source region 8708 and drain region 8712 for MOSFET 8700 is controlled by a voltage at gate 8702.

Operation of MOSFET 8700 shall now be described. When a positive voltage is applied to gate 8702, electrons in the p-type material of channel region 8704 are attracted to the surface below insulator 8714, forming a connecting near-surface region of n-type material between the source and the drain, called a channel. The larger or more positive the voltage between the gate contact 8706 and source region 8708, the lower the resistance across the region between.

In FIG. 87A, source region 8708 and drain region 8712 are illustrated as having n+ regions that were formed into idealized rectangular regions by the ion implantation process. FIG. 87B illustrates a cross-section of an example n-channel enhancement-mode MOSFET 8716 with non-ideally shaped n+ regions. Source region 8720 and drain region 8722 are illustrated as being formed into irregularly shaped regions by the ion implantation process. Due to uncertainties in the ion implantation/diffusion process, in practical applications, source region 8720 and drain region 8722 do not form rectangular regions as shown in FIG. 87A. FIG. 87B shows source region 8720 and drain region 8722 forming exemplary irregular regions. Due to these process uncertainties, the n+ regions of source region 8720 and drain region 8722 also may diffuse further than desired into the p-type region of channel region 8718, extending underneath gate 8702. The extension of the source region 8720 and drain region 8722 underneath gate 8702 is shown as source overlap 8724 and drain overlap 8726. Source overlap 8724 and drain overlap 8726 are further illustrated in FIG. 87C. FIG. 87C illustrates a top-level view of an example layout configuration for MOSFET 8716. Source overlap 8724 and drain overlap 8726 may lead to unwanted parasitic capacitances between source region 8720 and gate 8702, and between drain region 8722 and gate 8702. These unwanted parasitic capacitances may interfere with circuit function. For instance, the resulting parasitic capacitances may produce noise spikes that are radiated by the circuit, causing unwanted electromagnetic interference.

As shown in FIG. 87C, an example MOSFET 8716 may include a gate pad 8728. Gate 8702 may include a gate extension 8730, and a gate pad extension 8732. Gate extension 8730 is an unused portion of gate 8702 required due to metal implantation process tolerance limitations. Gate pad extension 8732 is a portion of gate 8702 used to couple gate 8702 to gate pad 8728. The contact required for gate pad 8728 requires gate pad extension 8732 to be of non-zero length to separate the resulting contact from the area between source region 8720 and drain region 8722. This prevents gate 8702 from shorting to the channel between source region 8720 and drain region 8722 (insulator 8714 of FIG. 87B is very thin in this region). Unwanted parasitic capacitances may form between gate extension 8730 and the substrate (FET 8716 is fabricated on a substrate), and between gate pad extension 8732 and the substrate. By reducing the respective areas of gate extension 8730 and gate pad extension 8732, the parasitic capacitances resulting therefrom can be reduced. Accordingly, embodiments address the issues of uncertainty in the ion implantation/diffusion process. It will be obvious to persons skilled in the relevant art(s) how to decrease the areas of gate extension 8730 and gate pad extension 8732 in order to reduce the resulting parasitic capacitances.

It should be understood that the illustration of the n-channel enhancement-mode MOSFET is for example purposes only. The present invention is applicable to depletion mode MOSFETs, and other transistor types, as will be apparent to persons skilled in the relevant art(s) based on the discussion contained herein.

### *4. Optional Optimizations of Energy Transfer at an Aliasing Rate*

The methods and systems described in sections above can be optimized with one or more of the optimization methods or systems described below.

### *4.1 Doubling the Aliasing Rate ($F_{AR}$) of the Energy Transfer Signal*

In an embodiment, the optional energy transfer signal module 3002 in FIG. 30 includes a pulse generator module that generates aliasing pulses at twice the frequency of the oscillating source. The input signal 2928 may be any suitable oscillating source.

FIG. 32 illustrates a circuit 3202 that generates a doubler output signal 3204 (FIG. 33B) that may be used as an energy transfer signal 2406. The circuit 3202 generates pulses on both rising and falling edges of the input oscillating signal 3206 of FIG. 33A. The circuit 3202 can be implemented as a pulse generator and aliasing rate ($F_{AR}$) doubler. The doubler output signal 3204 can be used as the energy transfer signal 2406.

In the example of FIG. 32, the aliasing rate is twice the frequency of the input oscillating signal F 3206, as shown by EQ. (9) below.

$$F_{AR} = 2 \cdot F_{OSC} \qquad \text{EQ. (9)}$$

The aperture width of the aliasing pulses is determined by the delay through a first inverter 3208 of FIG. 32. As the delay is increased, the aperture is increased. A second inverter 3212 is shown to maintain polarity consistency with examples described elsewhere. In an alternate embodiment inverter 3212 is omitted. Preferably, the pulses have non-negligible aperture widths that tend away from zero time. The doubler output signal 3204 may be further conditioned as appropriate to drive the switch module with non-negligible aperture pulses. The circuit 3202 may be implemented with integrated circuitry, discretely, with equivalent logic circuitry, or with any valid fabrication technology.

### *4.2 Differential Implementations*

The invention can be implemented in a variety of differential configurations. Differential configurations are useful for reducing common mode noise. This can be very useful in receiver systems where common mode interference can be caused by intentional or unintentional radiators such as cellular phones, CB radios, electrical appliances etc. Differential configurations are also useful in reducing any common mode noise due to charge injection of the switch in the switch module or due to the design and layout of the system in which the invention is used. Any spurious signal that is induced in equal magnitude and equal phase in both input leads of the invention will be substantially reduced or eliminated. Some differential configurations, including some of the configurations below, are also useful for increasing the voltage and/or for increasing the power of the down-converted signal 1208B.

Differential systems are most effective when used with a differential front end (inputs) and a differential back end (outputs). They can also be utilized in the following configurations, for example:

a) A single-input front end and a differential back end; and
b) A differential front end and a single-output back end.

Examples of these system are provided below, with a first example illustrating a specific method by which energy is transferred from the input to the output differentially.

While an example of a differential energy transfer module is shown below, the example is shown for the purpose of illustration, not limitation. Alternate embodiments (including equivalents, extensions, variations, deviations etc.) of the embodiment described herein will be apparent to those skilled in the relevant art based on the teachings contained herein. The invention is intended and adapted to include such alternate embodiments.

### *4.2.1 An Example Illustrating Energy Transfer Differentially*

FIG. 37A illustrates a differential system 3702 that can be included in the energy transfer module 2404. The differential system 3702 includes an inverted gated transfer design similar to that described with reference to FIG. 35. The differential system 3702 includes inputs 3704 and 3706 and outputs 3708 and 3710. The differential system 3702 includes a first inverted gated transfer module 3712, which includes a storage module 3714 and a switch module 3716. The differential system 3702 also includes a second inverted gated transfer module 3718, which includes a storage module 3720 and a switch module 3716, which it shares in common with inverted gated transfer module 3712.

One or both of the inputs 3704 and 3706 are coupled to an EM signal source. For example, the inputs can be coupled to an EM signal source, wherein the input voltages at the inputs 3704 and 3706 are substantially equal in amplitude but 180 degrees out of phase with one another. Alternatively, where dual inputs are unavailable, one of the inputs 3704 and 3706 can be coupled to ground.

In operation, when the switch module 3716 is closed, the storage modules 3714 and 3720 are in series and, provided they have similar capacitive values, accumulate charge of equal magnitude but opposite polarities. When the switch module 3716 is open, the voltage at the output 3708 is relative to the input 3704, and the voltage at the output 3710 is relative to the voltage at the input 3706.

Portions of the signals at the outputs 3708 and 3710 include signals resulting from energy stored in the storage modules 3714 and 3720, respectively, when the switch module 37116 was closed. The portions of the signals at the outputs 3708 and 3710 resulting from the stored charge are generally equal in amplitude to one another but 180 degrees out of phase.

Portions of the signals at the outputs 3708 and 3710 also include ripple voltage or noise resulting from the switching action of the switch module 3716. But because the switch module is positioned between the two outputs 3708 and 3710, the noise introduced by the switch module appears at the outputs as substantially equal and in-phase with one another. As a result, the ripple voltage can be substantially canceled out by inverting the signal at one of the outputs 3708 and 3710 and adding it to the other remaining output. Additionally, any noise that is impressed with equal amplitude and equal phase onto the input terminals 3704 and 3706 by any other noise sources will tend to be canceled in the same way.

#### *4.2.1.1 Differential Input-to-Differential Output*

FIG. 37B illustrates the differential system 3702 wherein the inputs 3704 and 3706 are coupled to equal and opposite EM signal sources, illustrated here as dipole antennas 3724 and 3726. In this embodiment, when one of the outputs 3708 and 3710 is inverted and added to the other output, the common mode noise due to the switching module 3716 and other common mode noise present at the input terminals 3704 and 3706 tend to substantially cancel out.

#### *4.2.1.2 Single Input-to-Differential Output*

FIG. 37C illustrates the differential system 3702 wherein the input 3704 is coupled to an EM signal source such as a monopole antenna 3728 and the input 3706 is coupled to ground. In this configuration, the voltages at the outputs 3708 and 3710 are approximately one half the value of the voltages at the outputs in the implementation illustrated in FIG. 37B, given all other parameters are equal.

FIG. 37E illustrates an example single input to differential output receiver/down-converter system 3736. The system 3736 includes the differential system 3702 wherein the input 3706 is coupled to ground as in FIG. 37C. The input 3704 is coupled to an EM signal source 3738 through an optional input impedance match 3742.

The outputs 3708 and 3710 are coupled to a differential circuit 3744 such as a filter, which preferably inverts one of the outputs 3708 and 3710 and adds it to the other output 3708 and 3710. This substantially cancels common mode noise generated by the switch module 3716. The differential circuit 3744 preferably filters the higher frequency components of the EM signal 1204 that pass through the storage modules 3714 and 3720. The resultant filtered signal is output as the down-converted signal 1208B.

#### *4.2.1.3 Differential Input-to-Single Output*

FIG. 37D illustrates the differential input to single output system 3729 wherein the inputs 3704 and 3706 of the differential system 3702 are coupled to equal and opposite EM signal dipole antennas 3730 and 3732. In system 3729, the common mode noise voltages are not canceled as in systems shown above. The output is coupled from terminal 3708 to a load 3748.

#### *4.2.2 Specific Alternative Embodiments*

In specific alternative embodiments, the present invention is implemented using a plurality of gated transfer modules controlled by a common energy transfer signal with a storage module coupled between the outputs of the plurality of gated transfer modules. For example, FIG. 58 illustrates a differential system 5802 that includes first and second gated transfer modules 5804 and 5806, and a storage module 5808 coupled between. Operation of the differential system 5802 will be apparent to one skilled in the relevant art(s), based on the description herein.

The gated transfer differential system 5802 can be implemented with a single input, differential inputs, a single output, differential outputs, and combinations thereof. For example, FIG. 59 illustrates an example single input-to-differential output system 5902.

Where common-mode rejection is desired to protect the input from various common-mode effects, and where common mode rejection to protect the output is not necessary, a differential input-to-single output implementation can be utilized. FIG. 61 illustrates an example differential-to-single ended system 6102, where a balance/unbalance (balun) circuit 6104 is utilized to generate the differential input. Other input configurations are contemplated. A first output 6106 is coupled to a load 6108. A second output 6110 is coupled to ground point 6112.

Typically, in a balanced-to-unbalanced system, where a single output is taken from a differential system without the use of a balun, (i.e., where one of the output signals is grounded), a loss of about 6 db is observed. In the configuration of FIG. 61, however, the ground point 6112 simply serves as a DC voltage reference for the circuit. The system 6102 transfers charge from the input in the same manner as if it were full differential, with its conversion efficiency generally affected only by the parasitics of the circuit components used, such as the Rds(on) on FET switches if used in the switch module. In other words, the charge transfer still continues in the same manner of a single ended implementation, providing the necessary single-ended ground to the input circuitry when the aperture is active, yet configured to allow the input to be differential for specific common-mode rejection capability and/or interface between a differential input and a single ended output system.

#### *4.2.3 Specific Examples of Optimizations and Configurations for Inverted and Non-Inverted Differential Designs*

Gated transfer systems and inverted gated transfer systems can be implemented with any of the various optimizations and configurations disclosed through the specification, such as, for example, impedance matching, tanks and resonant structures, bypass networks, etc. For example, the differential system 5902 in FIG. 59, which utilizes gated transfer modules with an input impedance matching system 5904 and a tank circuit 5906, which share a common capacitor. Similarly, differential system 6002 in FIG. 60, utilizes an inverted gated transfer module with an input impedance matching system 6004 and a tank circuit 6006, which share a common capacitor.

### *4.3 Smoothing the Down-Converted Signal*

The down-converted signal 1208B may be smoothed by filtering as desired. The differential circuit 3744 implemented as a filter in FIG 37E illustrates but one example. This may be accomplished in any of the described embodiments by hardware, firmware and software implementation as is well known by those skilled in the arts.

### *4.4 Impedance Matching*

The energy transfer module has input and output impedances generally defined by (1) the duty cycle of the switch module, and (2) the impedance of the storage module, at the frequencies of interest (e.g. at the EM input, and intermediate/baseband frequencies).

Starting with an aperture width of approximately 1/2 the period of the EM signal being down-converted as a preferred embodiment, this aperture width (e.g. the "closed time") can be decreased. As the aperture width is decreased, the characteristic impedance at the input and the output of the energy transfer module increases. Alternatively, as the aperture width increases from 1/2 the period of the EM signal being down-converted, the impedance of the energy transfer module decreases.

One of the steps in determining the characteristic input impedance of the energy transfer module could be to measure its value. In an embodiment, the energy transfer module's characteristic input impedance is 300 ohms. An impedance matching circuit can be utilized to efficiently couple an input EM signal that has a source impedance of, for example, 50 ohms, with the energy transfer module's impedance of, for example, 300 ohms. Matching these impedances can be accomplished in various manners, including providing the necessary impedance directly or the use of an impedance match circuit as described below.

Referring to FIG. 31, a specific embodiment using an RF signal as an input, assuming that the impedance 3112 is a relatively low impedance of approximately 50 Ohms, for example, and the input impedance 3116 is approximately 300 Ohms, an initial configuration for the input impedance match module 3106 can include an inductor 3406 and a capacitor 3408, configured as shown in FIG. 34. The configuration of the inductor 3406 and the capacitor 3408 is a possible configuration when going from a low impedance to a high impedance. Inductor 3406 and the capacitor 3408 constitute an L match, the calculation of the values which is well known to those skilled in the relevant arts.

The output characteristic impedance can be impedance matched to take into consideration the desired output frequencies. One of the steps in determining the characteristic output impedance of the energy transfer module could be to measure its value. Balancing the very low impedance of the storage module at the input EM frequency, the storage module should have an impedance at the desired output frequencies that is preferably greater than or equal to the load that is intended to be driven (for example, in an embodiment, storage module impedance at a desired 1MHz output frequency is 2K ohm and the desired load to be driven is 50 ohms). An additional benefit of impedance matching is that filtering of unwanted signals can also be accomplished with the same components.

In an embodiment, the energy transfer module's characteristic output impedance is 2K ohms. An impedance matching circuit can be utilized to efficiently couple the down-converted signal with an output impedance of, for example, 2K ohms, to a load of, for example, 50 ohms. Matching these impedances can be accomplished in various manners, including providing the necessary load impedance directly or the use of an impedance match circuit as described below.

When matching from a high impedance to a low impedance, a capacitor 3414 and an inductor 3416 can be configured as shown in FIG. 34. The capacitor 3414 and the inductor 3416 constitute an L match, the calculation of the component values being well known to those skilled in the relevant arts.

The configuration of the input impedance match module 3106 and the output impedance match module 3108 are considered to be initial starting points for impedance matching, in accordance with the present invention. In some situations, the initial designs may be suitable without further optimization. In other situations, the initial designs can be optimized in accordance with other various design criteria and considerations.

As other optional optimizing structures and/or components are utilized, their affect on the characteristic impedance of the energy transfer module should be taken into account in the match along with their own original criteria.

### *4.5 Tanks and Resonant Structures*

Resonant tank and other resonant structures can be used to further optimize the energy transfer characteristics of the invention. For example, resonant structures, resonant about the input frequency, can be used to store energy from the input signal when the switch is open, a period during which one may conclude that the architecture would otherwise be limited in its maximum possible efficiency. Resonant tank and other resonant structures can include, but are not limited to, surface acoustic wave (SAW) filters, dielectric resonators, diplexers, capacitors, inductors, etc.

An example embodiment is shown in FIG. 53A. Two additional embodiments are shown in FIG. 47 and FIG. 56. Alternate implementations will be apparent to persons skilled in the relevant art(s) based on the teachings contained herein. Alternate implementations fall within the scope and spirit of the present invention. These implementations take advantage of properties of series and parallel (tank) resonant circuits.

FIG. 53A illustrates parallel tank circuits in a differential implementation. A first parallel resonant or tank circuit consists of a capacitor 5338 and an inductor 5320 (tankl). A second tank circuit consists of a capacitor 5334 and an inductor 5336 (tank2).

As is apparent to one skilled in the relevant art(s), parallel tank circuits provide:

low impedance to frequencies below resonance;
low impedance to frequencies above resonance; and
high impedance to frequencies at and near resonance.

In the illustrated example of FIG. 53A, the first and second tank circuits resonate at approximately 920Mhz. At and near resonance, the impedance of these circuits is relatively high. Therefore, in the circuit configuration shown in FIG 53A, both tank circuits appear as relatively high impedance to the input frequency of 950Mhz, while simultaneously appearing as relatively low impedance to frequencies in the desired output range of 50Mhz.

An energy transfer signal 5342 controls a switch 5314. When the energy transfer signal 5342 controls the switch 5314 to open and close, high frequency signal components are not allowed to pass through tank1 or tank2.

However, the lower signal components (50Mhz in this embodiment) generated by the system are allowed to pass through tank1 and tank2 with little attenuation. The effect of tank 1 and tank2 is to further separate the input and output signals from the same node thereby producing a more stable input and output impedance. Capacitors 5318 and 5340 act to store the 50Mhz output signal energy between energy transfer pulses.

Further energy transfer optimization is provided by placing an inductor 5310 in series with a storage capacitor 5312 as shown. In the illustrated example, the series resonant frequency of this circuit arrangement is approximately 1 GHz. This circuit increases the energy transfer characteristic of the system. The ratio of the impedance of inductor 5310 and the impedance of the storage capacitor 5312 is preferably kept relatively small so that the majority of the energy available will be transferred to storage capacitor 5312 during operation. Exemplary output signals A and B are illustrated in FIGs. 53B and 53C, respectively.

In FIG. 53A, circuit components 5304 and 5306 form an input impedance match. Circuit components 5332 and 5330 form an output impedance match into a 50 ohm resistor 5328. Circuit components 5322 and 5324 form a second output impedance match into a 50 ohm resistor 5326. Capacitors 5308 and 5312 act as storage capacitors for the embodiment. Voltage source 5346 and resistor 5302 generate a 950Mhz signal with a 50ohm output impedance, which are used as the input to the circuit. Circuit element 5316 includes a 150Mhz oscillator and a pulse generator, which are used to generate the energy transfer signal 5342.

FIG. 47 illustrates a shunt tank circuit 4710 in a single-ended to-single-ended system 4712. Similarly, FIG. 56 illustrates a shunt tank circuit 5610 in a system 5612. The tank circuits 4710 and 5610 lower driving source impedance, which improves transient response. The tank circuits 4710 and 5610 are able store the energy from the input signal and provide a low driving source impedance to transfer that energy throughout the aperture of the closed switch. The transient nature of the switch aperture can be viewed as having a response that, in addition to including the input frequency, has large component frequencies above the input frequency, (i.e. higher frequencies than the input frequency are also able to effectively pass through the aperture). Resonant circuits or structures, for example resonant tanks 4710 or 5610, can take advantage of this by being able to transfer energy throughout the switch's transient frequency response (i.e. the capacitor in the resonant tank appears as a low driving source impedance during the transient period of the aperture).

The example tank and resonant structures described above are for illustrative purposes and are not limiting. Alternate configurations can be utilized. The various resonant tanks and structures discussed can be combined or utilized independently as is now apparent.

### *4.6 Charge and Power Transfer Concepts*

Concepts of charge transfer are now described with reference to FIGS. 68A-F. FIG. 68A illustrates a circuit 6802, including a switch S and a capacitor 6806 having a capacitance C. The switch S is controlled by a control signal 6808, which includes pulses 6810 having apertures T.

In FIG. 68B, Equation 10 illustrates that the charge q on a capacitor having a capacitance C, such as the capacitor 6806, is proportional to the voltage V across the capacitor, where:

q = Charge in Coulombs
C = Capacitance in Farads
V = Voltage in Volts
A = Input Signal Amplitude

Where the voltage V is represented by Equation 11, Equation 10 can be rewritten as Equation 12. The change in charge $\Delta q$ over time t is illustrated as in Equation 13 as $\Delta q(t)$, which can be rewritten as Equation 14. Using the sum-to-product trigonometric identity of Equation 15, Equation 14 can be rewritten as Equation 16, which can be rewritten as equation 17.

Note that the sin term in Equation 11 is a function of the aperture T only. Thus, $\Delta q$ (t) is at a maximum when T is equal to an odd multiple of $\pi$ (i.e., $\pi$, $3\pi$, $5\pi$, ...). Therefore, the capacitor 6806 experiences the greatest change in charge when the aperture T has a value of x or a time interval representative of 180 degrees of the input sinusoid. Conversely, when T is equal to $2\pi$, $4\pi$, $6\pi$s, ..., minimal charge is transferred.

Equations 18, 19, and 20 solve for q(t) by integrating Equation 10, allowing the charge on the capacitor 6806 with respect to time to be graphed on the same axis as the input sinusoid sin(t), as illustrated in the graph of FIG. 68C. As the aperture T decreases in value or tends toward an impulse, the phase between the charge on the capacitor C or q(t) and sin(t) tend toward zero. This is illustrated in the graph of FIG. 68D, which indicates that the maximum impulse charge transfer occurs near the input voltage maxima. As this graph indicates, considerably less charge is transferred as the value of T decreases.

Power/charge relationships are illustrated in Equations 21-26 of FIG. 68E, where it is shown that power is proportional to charge, and transferred charge is inversely proportional to insertion loss.

Concepts of insertion loss are illustrated in FIG. 68F. Generally, the noise figure of a lossy passive device is numerically equal to the device insertion loss. Alternatively, the noise figure for any device cannot be less that its insertion loss. Insertion loss can be expressed by Equation 27 or 28.

From the above discussion, it is observed that as the aperture T increases, more charge is transferred from the input to the capacitor 6806, which increases power transfer from the input to the output. It has been observed that it is not necessary to accurately reproduce the input voltage at the output because relative modulated amplitude and phase information is retained in the transferred power.

### *4. 7 Optimizing and Adjusting the Non-Negligible Aperture Width/Duration*

#### *4. 7.1 Varying Input and Output Impedances*

In an embodiment of the invention, the energy transfer signal 2406 of FIG. 24 is used to vary the input impedance seen by the EM Signal 1204 and to vary the output impedance driving a load. An example of this embodiment is described below using the gated transfer module 2504 shown in FIG. 29G, and in FIG. 42A. The method described below is not limited to the gated transfer module 2504, as it can be applied to all of the embodiments of energy transfer module 2404.

In FIG. 42A, when switch 4206 is closed, the impedance looking into circuit 4202 is substantially the impedance of storage module illustrated as the storage capacitance 4208, in parallel with the impedance of the load 4212. When the switch 4206 is open, the impedance at point 4214 approaches infinity. It follows that the average impedance at point 4214 can be varied from the impedance of the storage module illustrated as the storage capacitance 4208, in parallel with the load 4212, to the highest obtainable impedance when switch 4206 is open, by varying the ratio of the time that switch 4206 is open to the time switch 4206 is closed. Since the switch 4206 is controlled by the energy transfer signal 4210, the impedance at point 4214 can be varied by controlling the aperture width of the energy transfer signal, in conjunction with the aliasing rate.

An example method of altering the energy transfer signal 2406 of FIG. 24 is now described with reference to FIG. 32, where the circuit 3202 receives the input oscillating signal 3206 and outputs a pulse train shown as doubler output signal 3204. The circuit 3202 can be used to generate the energy transfer signal 2406. Example waveforms of 3204 are shown on FIG. 33B.

It can be shown that by varying the delay of the signal propagated by the inverter 3208, the width of the pulses in the doubler output signal 3204 can be varied. Increasing the delay of the signal propagated by inverter 3208, increases the width of the pulses. The signal propagated by inverter 3208 can be delayed by introducing a R/C low pass network in the output of inverter 3208. Other means of altering the delay of the signal propagated by inverter 3208 will be well known to those skilled in the art.

#### *4. 7.2 Real Time Aperture Control*

In an embodiment, the aperture width/duration is adjusted in real time. For example, referring to the timing diagrams in FIGS. 57B-F, a clock signal 5714 (FIG. 57B) is utilized to generate an energy transfer signal 5716 (FIG. 57F), which includes energy transfer pulses 5718, having variable apertures 5720. In an embodiment, the clock signal 5714 is inverted as illustrated by inverted clock signal 5722 (FIG. 57D). The clock signal 5714 is also delayed, as illustrated by delayed clock signal 5724 (FIG. 57E). The inverted clock signal 5714 and the delayed clock signal 5724 are then ANDed together, generating an energy transfer signal 5716, which is active-energy transfer pulses 5718 - when the delayed clock signal 5724 and the inverted clock signal 5722 are both active. The amount of delay imparted to the delayed clock signal 5724 substantially determines the width or duration of the apertures 5720. By varying the delay in real time, the apertures are adjusted in real time.

In an alternative implementation, the inverted clock signal 5722 is delayed relative to the original clock signal 5714, and then ANDed with the original clock signal 5714. Alternatively, the original clock signal 5714 is delayed then inverted, and the result ANDed with the original clock signal 5714.

FIG. 57A illustrates an exemplary real time aperture control system 5702 that can be utilized to adjust apertures in real time. The example real time aperture control system 5702 includes an RC circuit 5704, which includes a voltage variable capacitor 5712 and a resistor 5726. The real time aperture control system 5702 also includes an inverter 5706 and an AND gate 5708. The AND gate 5708 optionally includes an enable input 5710 for enabling/disabling the AND gate 5708. The RC circuit 5704. The real time aperture control system 5702 optionally includes an amplifier 5728.

Operation of the real time aperture control circuit is described with reference to the timing diagrams of FIGS. 57B-F. The real time control system 5702 receives the input clock signal 5714, which is provided to both the inverter 5706 and to the RC circuit 5704. The inverter 5706 outputs the inverted clock signal 5722 and presents it to the AND gate 5708. The RC circuit 5704 delays the clock signal 5714 and outputs the delayed clock signal 5724. The delay is determined primarily by the capacitance of the voltage variable capacitor 5712. Generally, as the capacitance decreases, the delay decreases.

The delayed clock signal 5724 is optionally amplified by the optional amplifier 5728, before being presented to the AND gate 5708. Amplification is desired, for example, where the RC constant of the RC circuit 5704 attenuates the signal below the threshold of the AND gate 5708.

The AND gate 5708 ANDs the delayed clock signal 5724, the inverted clock signal 5722, and the optional Enable signal 5710, to generate the energy transfer signal 5716. The apertures 5720 are adjusted in real time by varying the voltage to the voltage variable capacitor 5712.

In an embodiment, the apertures 5720 are controlled to optimize power transfer. For example, in an embodiment, the apertures 5720 are controlled to maximize power transfer. Alternatively, the apertures 5720 are controlled for variable gain control (e.g. automatic gain control - AGC). In this embodiment, power transfer is reduced by reducing the apertures 5720.

As can now be readily seen from this disclosure, many of the aperture circuits presented, and others, can be modified in the manner described above (e.g. circuits in FIGS. 29H-K). Modification or selection of the aperture can be done at the design level to remain a fixed value in the circuit, or in an alternative embodiment, may be dynamically adjusted to compensate for, or address, various design goals such as receiving RF signals with enhanced efficiency that are in distinctively different bands of operation, e.g. RF signals at 900MHz and 1.8GHz.

### *4.8 Adding a Bypass Network*

In an embodiment of the invention, a bypass network is added to improve the efficiency of the energy transfer module. Such a bypass network can be viewed as a means of synthetic aperture widening. Components for a bypass network are selected so that the bypass network appears substantially lower impedance to transients of the switch module (i.e., frequencies greater than the received EM signal) and appears as a moderate to high impedance to the input EM signal (e.g., greater that 100 Ohms at the RF frequency).

The time that the input signal is now connected to the opposite side of the switch module is lengthened due to the shaping caused by this network, which in simple realizations may be a capacitor or series resonant inductor-capacitor. A network that is series resonant above the input frequency would be a typical implementation. This shaping improves the conversion efficiency of an input signal that would otherwise, if one considered the aperture of the energy transfer signal only, be relatively low in frequency to be optimal.

For example, referring to FIG. 54 a bypass network 5402 (shown in this instance as capacitor 5412), is shown bypassing switch module 5404. In this embodiment the bypass network increases the efficiency of the energy transfer module when, for example, less than optimal aperture widths were chosen for a given input frequency on the energy transfer signal 5406. The bypass network 5402 could be of different configurations than shown in FIG 54. Such an alternate is illustrated in FIG. 49. Similarly, FIG. 55 illustrates another example bypass network 5502, including a capacitor 5504.

The following discussion will demonstrate the effects of a minimized aperture and the benefit provided by a bypassing network. Beginning with an initial circuit having a 550ps aperture in FIG. 62, its output is seen to be 2.8mVpp applied to a 50 ohm load in FIG. 66A. Changing the aperture to 270ps as shown in FIG. 63 results in a diminished output of 2.5Vpp applied to a 50 ohm load as shown in FIG. 66B. To compensate for this loss, a bypass network may be added, a specific implementation is provided in FIG. 64. The result of this addition is that 3.2Vpp can now be applied to the 50 ohm load as shown in FIG. 67A. The circuit with the bypass network in FIG. 64 also had three values adjusted in the surrounding circuit to compensate for the impedance changes introduced by the bypass network and narrowed aperture. FIG. 65 verifies that those changes added to the circuit, but without the bypass network, did not themselves bring about the increased efficiency demonstrated by the embodiment in FIG. 64 with the bypass network. FIG. 67B shows the result of using the circuit in FIG. 65 in which only 1.88Vpp was able to be applied to a 50 ohm load.

### *4.9 Modifying the Energy Transfer Signal Utilizing Feedback*

FIG. 30 shows an embodiment of a system 3001 which uses down-converted Signal 1208B as feedback 3006 to control various characteristics of the energy transfer module 2404 to modify the down-converted signal 1208B.

Generally, the amplitude of the down-converted signal 1208B varies as a function of the frequency and phase differences between the EM signal 1204 and the energy transfer signal 2406. In an embodiment, the down-converted signal 1208B is used as the feedback 3006 to control the frequency and phase relationship between the EM signal 1204 and the energy transfer signal 2406. This can be accomplished using the example logic in FIG 44A. The example circuit in FIG. 44A can be included in the energy transfer signal module 3002. Alternate implementations will be apparent to persons skilled in the relevant art(s) based on the teachings contained herein. Alternate implementations fall within the scope and spirit of the present invention. In this embodiment a state-machine is used as an example.

In the example of FIG. 44A, a state machine 4404 reads an analog to digital converter, A/D 4402, and controls a digital to analog converter, DAC 4406. In an embodiment, the state machine 4404 includes 2 memory locations, *Previous* and *Current*, to store and recall the results of reading A/D 4402. In an embodiment, the state machine 4404 utilizes at least one memory flag.

The DAC 4406 controls an input to a voltage controlled oscillator, VCO 4408. VCO 4408 controls a frequency input of a pulse generator 4410, which, in an embodiment, is substantially similar to the pulse generator shown in FIG. 29J. The pulse generator 4410 generates energy transfer signal 2406.

In an embodiment, the state machine 4404 operates in accordance with a state machine flowchart 4419 in FIG. 44B. The result of this operation is to modify the frequency and phase relationship between the energy transfer signal 2406 and the EM signal 1204, to substantially maintain the amplitude of the down-converted signal 1208B at an optimum level.

The amplitude of the down-converted signal 1208B can be made to vary with the amplitude of the energy transfer signal 2406. In an embodiment where the switch module 2602 is a FET as shown in FIG 27A, wherein the gate 2704 receives the energy transfer signal 2406, the amplitude of the energy transfer signal 2406 can determine the "on" resistance of the FET, which affects the amplitude of the down-converted signal 1208B. The energy transfer signal module 3002, as shown in FIG. 44C, can be an analog circuit that enables an automatic gain control function. Alternate implementations will be apparent to persons skilled in the relevant art(s) based on the teachings contained herein. Alternate implementations fall within the scope and spirit of the present invention.

### *5. Example Energy Transfer Downconverters*

Example implementations are described below for illustrative purposes. The invention is not limited to these examples.

FIG. 45 is a schematic diagram of an exemplary circuit to down convert a 915 MHz signal to a 5 MHz signal using a 101.1 MHz clock.

FIG. 46 shows example simulation waveforms for the circuit of figure 45. Waveform 4502 is the input to the circuit showing the distortions caused by the switch closure. Waveform 4504 is the unfiltered output at the storage unit. Waveform 4506 is the impedance matched output of the downconverter on a different time scale.

FIG. 47 is a schematic diagram of an exemplary circuit to downconvert a 915 MHz signal to a 5 MHz signal using a 101.1 MHz clock. The circuit has additional tank circuitry to improve conversion efficiency.

FIG. 48 shows example simulation waveforms for the circuit of figure 47. Waveform 4702 is the input to the circuit showing the distortions caused by the switch closure. Waveform 4704 is the unfiltered output at the storage unit. Waveform 4706 is the output of the downconverter after the impedance match circuit.

FIG. 49 is a schematic diagram of an exemplary circuit to downconvert a 915 MHz signal to a 5 MHz signal using a 101.1 MHz clock. The circuit has switch bypass circuitry to improve conversion efficiency.

FIG. 50 shows example simulation waveforms for the circuit of figure 49. Waveform 4902 is the input to the circuit showing the distortions caused by the switch closure. Waveform 4904 is the unfiltered output at the storage unit. Waveform 4906 is the output of the downconverter after the impedance match circuit.

FIG. 51 shows a schematic of the example circuit in FIG. 45 connected to an FSK source that alternates between 913 and 917 MHz, at a baud rate of 500 Kbaud. FIG. 52 shows the original FSK waveform 5102 and the downconverted waveform 5104 at the output of the load impedance match circuit.

## III. Conclusions

Example embodiments of the methods, systems, and components of the present invention have been described herein. As noted elsewhere, these example embodiments have been described for illustrative purposes only, and are not limiting. Other embodiments include but are not limited to hardware, software, and software/hardware implementations of the methods, systems, and components of the invention. Such other embodiments will be apparent to persons skilled in the relevant art(s) based on the teachings contained herein. Thus, the breadth and scope of the present invention should not be limited by any of the above-described exemplary embodiments, but should be defined only in accordance with the following claims and their equivalents.

## Claims

**1.** A method of down-converting and demodulating a modulated carrier signal (1204) to a baseband signal (1208B), comprising:

1) receiving (1814) the modulated carrier signal (1204);

2) storing (1818) energy from the received carrier signal (1204) over apertures (1906; 2009; 2109; 2209; 2309) at an aliasing rate equal to a frequency of the received carrier signal (1204) divided by an integer greater than 1; and

3) generating (1818) the baseband signal (1208B) directly from the stored energy;

wherein the apertures are repeated time intervals during which the energy is stored, each of the time intervals is at least a non-negligible fraction of a period of the received modulated carrier signal, and the stored energy of the baseband signal is sufficient to distinguish the baseband signal from noise and sufficient to directly drive a subsequent circuit.

**2.** A method according to claim 1, wherein step 2) includes:

generating an energy transfer signal (1906; 2006; 2106; 2206; 2306) having a train of pulses (1904; 2007; 2107; 2207; 2307) at the aliasing rate, with non-negligible apertures (1906; 2009; 2109; 2209; 2309), and using the energy transfer signal (1906; 2006; 2106; 2206; 2306) to transfer the energy from the received carrier signal (1204).

**3.** A method according to any preceding claim, wherein step 2) includes:

coupling the received modulated carrier signal (1204) to a reactive storage device (2901) at the aliasing rate.

**4.** A method according to claim 1, wherein step 2) includes:

gating the received carrier signal (1204) according to a control signal (2406) comprising a stream of pulses (1904; 2007; 2107; 2207; 2307), having non-negligible apertures (1906; 2009; 2109; 2209; 2309), that repeat at the aliasing rate.

**5.** A method according to claim 1, wherein step 2) includes:

a) transferring (1806) a non-negligible portion of energy contained in a portion of the received modulated carrier signal (1204); and

b) repeating step 2)a) at the aliasing rate.

**6.** A method according to any preceding claim, wherein step 2) includes controlling a frequency relationship between the received modulated carrier signal (1204) and the aliasing rate.

**7.** A method according to any preceding claim, wherein step 2) includes controlling a phase relationship between the received modulated carrier signal (1204) and the aliasing rate.

**8.** A method according to any one of claims 1 to 5, wherein each of the apertures (1906; 2009; 2109; 2209; 2309) is approximately equal in duration to half of the period of the received modulated carrier signal (1204).

**9.** A method according to any one of claims 1 to 5, wherein each of the apertures (1906; 2009; 2109; 2209; 2309) is approximately equal in duration to or greater in duration than ten percent of the period of the received modulated carrier signal (1204).

**10.** A method according to any one of claims 1 to 5, wherein each of the apertures (1906; 2009; 2109; 2209; 2309) is approximately equal in duration to or greater in duration than twenty five percent of the period of the received modulated carrier signal (1204).

**11.** A method according to any one of claims 1 to 5, wherein each of the apertures (1906; 2009; 2109; 2209; 2309) is approximately equal in duration to or greater in duration than fifty percent of the period of the received modulated carrier signal (1204).

**12.** A method according to any one of claims 1 to 5, wherein each of the apertures (1906; 2009; 2109; 2209; 2309) is approximately equal in duration to or greater in duration than seventy five percent of the period of the received modulated carrier signal (1204).

**13.** A method according to any one of claims 1 to 5, wherein each of the apertures (1906; 2009; 2109; 2209; 2309) is equal in duration to N cycles of the received modulated carrier signal (1204), wherein N equals A plus B, where A is a positive integer and B is a fraction of an integer.

**14.** A method according to any preceding claim, wherein step 2) includes transferring non-negligible amounts of energy relative to energy contained in cycles of the received modulated carrier signal (1204).

**15.** A method according to claim 1, wherein step 2) includes generating a train of pulses (1904; 2007; 2107; 2207; 2307) having non-negligible apertures relative to a period of the received modulated carrier signal (1204).

**16.** A method according to claim 5, wherein step 2)a) includes transferring at least ten percent of the energy contained in a period of the received modulated carrier signal (1204).

**17.** A method according to claim 5, wherein step 2)a) includes transferring at least twenty five percent of the energy contained in a period of the received modulated carrier signal (1204).

**18.** A method according to claim 5, wherein step 2)a) includes transferring at least fifty percent of the energy contained in a period of the received modulated carrier signal (1204).

**19.** A method according to claim 5, wherein step 2)a) includes transferring at least seventy five percent of the energy contained in a period of the received modulated carrier signal (1204).

**20.** A method according to any one of claims 1 to 5, wherein each of the apertures (2109) is approximately equal in duration to half of the period of the received modulated carrier signal (616) and is substantially aligned with the period of the received modulated carrier signal (616).

**21.** A method according to claim 20, wherein the apertures (2109) are substantially aligned with positive half cycles of the received modulated carrier signal (616).

**22.** A method according to claim 20, wherein the apertures (2309) are substantially aligned with negative half cycles of the received modulated carrier signal (1016).

**23.** A method according to any one of claims 1 to 5, wherein each of the apertures is approximately equal in duration to half of the period of the received modulated carrier signal (516) and is not aligned with the period of the received modulated carrier signal (516).

**24.** A method according to any one of claims 1 to 5, wherein the apertures (1906; 2009; 2109; 2209; 2309) are substantially synchronized with the received modulated carrier signal (1204).

**25.** A method according to any one of claims 1 to 5, wherein the apertures (2406) are not synchronized with the received modulated carrier signal (1204).

**26.** A method according to claim 2, wherein step 2) further includes generating the energy transfer signal (2406) independently of the received modulated carrier signal (1204).

**27.** A method according to any one of claims 1 to 5, wherein step 2) includes generating an asynchronous energy transfer signal (2406) having the aliasing rate and using the asynchronous energy transfer signal (2406) to store the energy from the received modulated carrier signal (1204).

**28.** A method according to any one of claims 1 to 5, wherein step 3) includes preserving modulation information without reproducing the received modulated carrier signal (1204).

**29.** A method according to any one of claims 1 to 5, wherein step 2) includes storing energy differentially.

**30.** A method according to any one of claims 1 to 5, wherein step 2) includes the step of:

i) controlling the amount of energy transferred from the received modulated carrier signal (1204).

**31.** A method according to claim 30, wherein step 2)i) includes controlling an aperture (5720).

**32.** A method according to claim 31, wherein step 2)i) further includes controlling an aperture width.

**33.** A method according to claim 31, wherein step 2)i) further includes controlling an aperture frequency.

**34.** A method according to claim 31, wherein step 2)i) further includes controlling an aperture shape.

**35.** A method according to claim 30, wherein step 2)i) includes controlling energy transfer characteristics.

**36.** A method according to any preceding claim, wherein step 3) includes: discharging the stored energy between apertures (1906; 2009; 2109; 2209; 2309) in a controlled manner.

**37.** A method according to any preceding claim, wherein step 2) includes storing sufficient energy from the received modulated carrier signal (4204) to drive a load (4212) without additional buffering or amplification, wherein the load is a high impedance load or a low impedance load (4218).

**38.** A method according to any preceding claim, wherein step 2) includes storing energy from the received modulated carrier signal (4204) without pre-amplification (LNA) of the received modulated carrier signal (4204).

**39.** A method according to any preceding claim, wherein said storing of energy from the received modulated carrier signal (1204) substantially prevents accurate voltage reproduction of the received modulated carrier signal (1204) during the apertures (1906; 2009; 2109; 2209; 2309).

**40.** A method according to any preceding claim, wherein step 1) includes receiving the modulated carrier signal (1204) through a relatively low input impedance path (3106).

**41.** A method according to any preceding claim, wherein step 1) includes receiving the modulated carrier signal (1204) through a relatively efficient power transfer path (3106).

**42.** A method according to any preceding claim, wherein step 2) includes gating the received modulated carrier signal (1204) using a switch (2602).

**43.** A method of claim 42, wherein the impedance of said switch (3116) is matched to a source impedance (3112), thereby increasing energy transferred from said received modulated carrier signal (1204).

**44.** A method of claim 42, wherein the impedance of said switch (3116) is matched to a load impedance (3118), thereby increasing energy transferred from said received modulated carrier signal (1204).

**45.** A method of claim 44, wherein said received modulated carrier signal (1204) is coupled to said switch (5314) via a resonant circuit (5338, 5320), said resonant circuit (5338, 5320) storing energy from components of said received modulated carrier signal (1204) while said switch (5314) is open, and wherein energy stored in said resonant circuit (5338, 5320) is discharged via said switch (5314) while said switch (5314) is closed, thereby increasing energy transferred from said received modulated carrier signal (1204).

**46.** Apparatus arranged to perform the method of any preceding claim.

**47.** Apparatus according to claim 46, further comprising:

an input impedance match circuit (3106).

**48.** Apparatus according to claim 46, further comprising:

an output impedance match circuit (3108).

**49.** Apparatus according to claim 46, further comprising:

a tank circuit.

**50.** Apparatus according to claim 46 when dependent on claim 42, further comprising:

a feed forward circuit (5402) in parallel with said switch (5404).

**51.** Apparatus according to claim 46, further comprising:

a feedback loop (3006).

**52.** Apparatus according to claim 46, wherein said means for storing said energy includes:

a capacitive storage device (4208) sized to store substantial amounts of energy relative to the approximate energy contained in half cycles of the received modulated carrier signal (4204).

**53.** Apparatus according to claim 46, wherein means for storing said energy is implemented in a complimentary, metal oxide, semiconductor (C-MOS) material (8326).

**54.** Apparatus according to claim 46, wherein means for storing said energy is implemented in a single integrated circuit (8326).

**55.** Apparatus according to claim 46, further comprising a controllable output impedance (5702).

**Patentansprüche**

**1.** Verfahren zum Abwärtswandeln und Demodulieren eines modulierten Trägersignals (1204) in ein Basisbandsignal (1208B), mit den Schritten:

1) Empfangen (1814) des modulierten Trägersignals (1204);
2) Speichern (1818) von Energie vom empfangenen Trägersignal (1204) über Fenster (1906; 2009; 2109; 2209; 2309) mit einer Alias-Frequenz, die einer Frequenz des empfangenen Trägersignals (1204), geteilt durch eine ganze Zahl gleicht, die größer ist als 1; und
3) direktes Erzeugen (1818) des Basisbandsignals (1208B) von der gespeicherten Energie;
wobei die Fenster sich wiederholende Zeitintervalle sind, während denen die Energie gespeichert wird, wobei jedes Zeitintervall mindestens ein nicht vernachlässigbarer Teil einer Periode des empfangenen modulierten Trägersignals ist, und wobei die gespeicherte Energie des Basisbandsignals ausreichend ist, um das Basisbandsignal von Rauschen zu unterscheiden, und ausreichend ist, um eine nachgeschaltete Schaltung direkt zu betreiben.

**2.** Verfahren nach Anspruch 1, wobei Schritt 2) aufweist:

Erzeugen eines Energieübertragungssignals (1906; 2006; 2106; 2206; 2306) mit einer Impulsfolge (1904; 2007; 2107; 2207; 2307) der Alias-Frequenz mit nicht vernachlässigbaren Fenstern (1906; 2009; 2109; 2209; 2309), und Verwenden des Energieübertragungssignals (1906; 2006; 2106; 2206; 2306) zum Übertragen der Energie vom empfangenen Trägersignal (1204).

**3.** Verfahren nach einem der vorangehenden Ansprüche, wobei Schritt 2) aufweist:

Koppeln des empfangenen modulierten Trägersignals (1204) mit der Alias-Frequenz zu einer reaktiven Speichereinrichtung (2901).

**4.** Verfahren nach Anspruch 1, wobei Schritt 2) aufweist:

Vorsteuern des empfangenen Trägersignals (1204) gemäß einem steuersignal (2406), das eine Folge von Pulsen (1904; 2007; 2107; 2207; 2307) mit nicht vernachlässigbaren Fenstern (1906; 2009; 2109; 2209; 2309) aufweist, die sich mit der Alias-Frequenz wiederholen.

**5.** Verfahren nach Anspruch 1, wobei Schritt 2) aufweist:

a) Übertragen (1806) eines nicht vernachlässigbaren Energieteils, der in einem Abschnitt des empfangenen modulierten Trägersignals (1204) enthalten ist; und
b) Wiederholen von Schritt 2)a) mit der Alias-Frequenz.

**6.** Verfahren nach einem der vorangehenden Ansprüche, wobei Schritt 2) das Steuern einer Frequenzbeziehung zwischen dem empfangenen modulierten Trägersignal (1204) und der Alias-Frequenz aufweist.

**7.** Verfahren nach einem der vorangehenden Ansprüche, wobei Schritt 2) das Steuern einer Phasenbeziehung zwischen dem empfangenen modulierten Trägersignal (1204) und der Alias-Frequenz aufweist.

**8.** Verfahren nach einem der Ansprüche 1 bis 5, wobei jedes der Fenster (1906; 2009; 2109; 2209; 2309) eine Dauer hat, die näherungsweise der Hälfte der Periode des empfangenen modulierten Trägersignals (1204) gleicht.

**9.** Verfahren nach einem der Ansprüche 1 bis 5, wobei jedes der Fenster (1906; 2009; 2109; 2209; 2309) eine Dauer hat, die näherungsweise gleich oder größer ist als 10 % der Periode des empfangenen modulierten Trägersignals (1204).

**10.** Verfahren nach einem der Ansprüche 1 bis 5, wobei jedes der Fenster (1906; 2009; 2109; 2209; 2309) eine Dauer hat, die näherungsweise gleich oder größer ist als 25 % der Periode des empfangenen modulierten Trägersignals (1204).

**11.** Verfahren nach einem der Ansprüche 1 bis 5, wobei jedes der Fenster (1906; 2009; 2109; 2209; 2309) eine Dauer hat, die näherungsweise gleich oder größer ist als 50 % der Periode des empfangenen modulierten Trägersignals (1204).

**12.** Verfahren nach einem der Ansprüche 1 bis 5, wobei jedes der Fenster (1906; 2009; 2109; 2209; 2309) eine Dauer hat, die näherungsweise gleich oder größer ist als 75 % der Periode des empfangenen modulierten Trägersignals (1204).

**13.** Verfahren nach einem der Ansprüche 1 bis 5, wobei jedes der Fenster (1906; 2009; 2109; 2209; 2309) eine Dauer hat, die N Zyklen des empfangenen modulierten Trägersignals (1204) gleicht, wobei N gleich A plus B ist, wobei A eine positive ganze Zahl und B ein Bruchteil einer ganzen Zahl ist.

**14.** Verfahren nach einem der vorangehenden Ansprüche, wobei Schritt 2) das Übertragen nicht vernachlässigbarer Energiemengen bezüglich der in Zyklen des empfangenen modulierten Trägersignals (1204) enthaltenen Energie aufweist.

**15.** Verfahren nach Anspruch 1, wobei Schritt 2) das Erzeugen einer Impulsfolge (1904; 2007; 2107; 2207; 2307) mit bezüglich einer Periode des empfangenen modulierten Trägersignals (1204) nicht vernachlässigbaren Fenstern aufweist.

**16.** Verfahren nach Anspruch 5, wobei Schritt 2)a) das Übertragen von mindestens 10 % der in einer Periode des empfangenen modulierten Trägersignals (1204) enthaltenen Energie aufweist.

**17.** Verfahren nach Anspruch 5, wobei Schritt 2)a) das Übertragen von mindestens 25 % der in einer Periode des empfangenen modulierten Trägersignals (1204) enthaltenen Energie aufweist.

**18.** Verfahren nach Anspruch 5, wobei Schritt 2)a) das übertragen von mindestens 50 % der in einer Periode des empfangenen modulierten Trägersignals (1204) enthaltenen Energie aufweist.

**19.** Verfahren nach Anspruch 5, wobei Schritt 2)a) das Übertragen von mindestens 75 % der in einer Periode des empfangenen modulierten Trägersignals (1204) enthaltenen Energie aufweist.

**20.** Verfahren nach einem der Ansprüche 1 bis 5, wobei jedes der Fenster (2109) eine Dauer hat, die näherungsweise der Hälfte der Periode des empfangenen modulierten Trägersignals (616) gleicht, und wobei jedes Fenster mit der Periode des empfangenen modulierten Trägersignals (616) im wesentlichen ausgerichtet ist.

**21.** Verfahren nach Anspruch 20, wobei die Fenster (2109) mit positiven Halbzyklen des empfangenen modulierten Trägersignals (616) im Wesentlichen ausgerichtet sind.

**22.** Verfahren nach Anspruch 20, wobei die Fenster (2309) mit negativen Halbzyklen des empfangenen modulierten Trägersignals (1016) im Wesentlichen ausgerichtet sind.

**23.** Verfahren nach einem der Ansprüche 1 bis 5, wobei jedes der Fenster eine Dauer hat, die der Hälfte der Periode des empfangenen modulierten Trägersignals (516) näherungsweise gleicht, und wobei jedes Fenster mit der Periode des empfangenen modulierten Trägersignals (516) nicht ausgerichtet ist.

**24.** Verfahren nach einem der Ansprüche 1 bis 5, wobei die Fenster (1906; 2009; 2109; 2209; 2309) mit dem empfangenen modulierten Trägersignal (1204) im Wesentlichen synchronisiert sind.

**25.** Verfahren nach einem der Ansprüche 1 bis 5, wobei die Fenster (2406) mit dem empfangenen modulierten Trägersignal (1204) nicht synchronisiert sind.

**26.** Verfahren nach Anspruch 2, wobei Schritt 2) ferner das Erzeugen des Energieübertragungssignals (2406) unabhängig vom empfangenen modulierten Trägersignal (1204) aufweist.

**27.** Verfahren nach einem der Ansprüche 1 bis 5, wobei Schritt 2) das Erzeugen eines asynchronen Energieübertragungssignals (2406) mit der Alias-Frequenz und das Verwenden des asynchronen Energieübertragungssignals (2406) zum Speichern der Energie vom empfangenen modulierten Trägersignal (1204) aufweist.

**28.** Verfahren nach einem der Ansprüche 1 bis 5, wobei Schritt 3) das Speichern von Modulationsinformation aufweist, ohne dass das empfangene modulierte Trägersignal (1204) reproduziert wird.

**29.** Verfahren nach einem der Ansprüche 1 bis 5, wobei Schritt 2) das differentielle Speichern von Energie aufweist.

**30.** Verfahren nach einem der Ansprüche 1 bis 5, wobei Schritt 2) den Schritt i) zum Steuern der vom empfangenen modulierten Trägersignal (1204) übertragenen Energiemenge aufweist.

**31.** Verfahren nach Anspruch 30, wobei Schritt 2)i) das Steuern eines Fensters (5720) aufweist.

**32.** Verfahren nach Anspruch 31, wobei Schritt 2)i) ferner das Steuern einer Fensterbreite aufweist.

**33.** Verfahren nach Anspruch 31, wobei Schritt 2)i) ferner das Steuern einer Fensterfrequenz aufweist.

**34.** Verfahren nach Anspruch 31, wobei Schritt 2)i) ferner das Steuern einer Fensterform aufweist.

**35.** Verfahren nach Anspruch 30, wobei Schritt 2)i) das Steuern einer Energieübertragungscharakteristik aufweist.

**36.** Verfahren nach einem der vorangehenden Ansprüche, wobei Schritt 3) das Abgeben der gespeicherten Energie zwischen Fenstern (1906; 2009; 2109; 2209; 2309) auf eine gesteuerte Weise aufweist.

**37.** Verfahren nach einem der vorangehenden Ansprüche, wobei Schritt 2) das Speichern von Energie vom empfangenen modulierten Trägersignal (4204) aufweist, die zum Betreiben einer Last (4212) ohne zusätzliche Pufferung oder Verstärkung ausreicht, wobei die Last eine hoch- oder eine niederimpedante Last (4218) ist.

**38.** Verfahren nach einem der vorangehenden Ansprüche, wobei Schritt 2) das Speichern von Energie vom empfangenen modulierten Trägersignal (4204) ohne Vorverstärkung (LNA) des empfangenen modulierten Trägersignals (4204) aufweist.

**39.** Verfahren nach einem der vorangehenden Ansprüche, wobei das Speichern von Energie vom empfangenen modulierten Trägersignal (1204) eine exakte Spannungsreproduktion des empfangenen modulierten Trägersignals (1204) während der Fenster (1906; 2009; 2109; 2209; 2309) im Wesentlichen verhindert.

**40.** Verfahren nach einem der vorangehenden Ansprüche, wobei Schritt 1) das Empfangen des modulierten Trägersignals (1204) über einen Pfad (3106) mit einer relativ niedrigen Eingangsimpedanz aufweist.

**41.** Verfahren nach einem der vorangehenden Ansprüche, wobei Schritt 1) das Empfangen des modulierten Trägersignals (1204) über einen relativ effizienten Leistungsübertragungspfad (3106) aufweist.

**42.** Verfahren nach einem der vorangehenden Ansprüche, wobei Schritt 2) das Torsteuern des empfangenen modulierten Trägersignals (1204) unter Verwendung eines Schalters (2602) aufweist.

**43.** Verfahren nach Anspruch 42, wobei die Impedanz des Schalters (3116) einer Quellenimpedanz (3112) angepaßt ist, um die vom empfangenen modulierten Trägersignal (1204) übertragene Energie zu erhöhen.

**44.** Verfahren nach Anspruch 42, wobei die Impedanz des Schalters (3116) einer Lastimpedanz (3118) angepaßt ist, um die vom empfangenen modulierten Trägersignal (1204) übertragene Energie zu erhöhen.

**45.** Verfahren nach Anspruch 44, wobei das empfangene modulierte Trägersignal (1204) über einen Resonanzkreis (5338, 5320) zum Schalter (5314) gekoppelt wird, wobei der Resonanzkreis (5338, 5320) Energie von Komponenten des empfangenen modulierten Trägersignals (1204) speichert, während der Schalter (5314) offen ist, und wobei die im Resonanzkreis (5338, 5320) gespeicherte Energie über den Schalter (5314) abgegeben wird, während der Schalter (5314) geschlossen ist, um die vom empfangenen modulierten Trägersignal (1204) übertragene Energie zu erhöhen.

**46.** Vorrichtung, die dazu geeignet ist, das Verfahren nach einem der vorangehenden Ansprüche auszuführen.

**47.** Vorrichtung nach Anspruch 46, ferner mit einer Eingangsimpedanzanpassungsschaltung (3106).

**48.** Vorrichtung nach Anspruch 46, ferner mit einer Ausgangsimpedanzanpassungsschaltung (3108).

**49.** Vorrichtung nach Anspruch 46, ferner mit einem offenen Schwingkreis.

**50.** Vorrichtung nach Anspruch 46, insofern abhängig von Anspruch 42, ferner mit einer zum Schalter (5404) parallel geschalteten Feed-Forward-Schaltung (5402)

**51.** Vorrichtung nach Anspruch 46, ferner mit einer Rückkopplungsschleife (3006).

**52.** Vorrichtung nach Anspruch 46, wobei die Energiespeichereinrichtung eine kapazitive Speichereinrichtung (4208) aufweist, die derart dimensioniert ist, dass sie bezüglich der Energie, die näherungsweise in Halbzyklen des empfangenen modulierten Trägersignals (4204) enthalten ist, wesentliche Energiemengen speichert.

**53.** Vorrichtung nach Anspruch 46, wobei die Energiespeichereinrichtung in einem komplementären Metalloxid-Halbleiter(C-MOS)material (8326) implementiert ist.

**54.** Vorrichtung nach Anspruch 46, wobei die Energiespeichereinrichtung in einer einzelnen integrierten Schaltung (8326) implementiert ist.

**55.** Vorrichtung nach Anspruch 46, ferner mit einer steuerbaren Ausgangsimpedanz (5702).

## Revendications

**1.** Procédé d'abaissement de fréquence et de démodulation d'un signal de porteuse modulée (1204) pour obtenir un signal en bande de base (1208B), comprenant les étapes consistant à :

1) recevoir (1814) le signal de porteuse modulée (1204) ;
2) emmagasiner (1818) de l'énergie provenant du signal de porteuse reçu (1204) sur des fenêtres (1906 ; 2009 ; 2109 ; 2209 ; 2309) à une fréquence de repliement du spectre égale à une fréquence du signal de porteuse reçu (1204) divisée par un entier naturel supérieur à 1 ; et
3) générer (1818) le signal en bande de base (1208B) directement à partir de l'énergie emmagasinée ;

dans lequel les fenêtres sont des intervalles de temps répétés pendant lesquels l'énergie est emmagasinée, chacun des intervalles de temps est au moins une fraction non négligeable d'une période du signal de porteuse modulée reçu, et l'énergie emmagasinée du signal en bande de base est suffisante pour distinguer le signal en bande de base du bruit et suffisante pour attaquer directement un circuit suivant.

**2.** Procédé selon la revendication 1, dans lequel l'étape 2) comprend le fait de générer un signal de transfert d'énergie (1906 ; 200G ; 210G ; 220G ; 2306) comprenant un train d'impulsions (1904 ; 2007 ; 2107 ; 2207 ; 2307) à la fréquence de repliement du spectre, ayant des fenêtres non négligeables (1906; 2009 ; 2109 ; 2209 ; 2309), et utiliser le signal de transfert d'énergie (1906 ; 2006 ; 2106 ; 2206 ; 2306) pour transférer l'énergie à partir du signal de porteuse reçu (1204).

**3.** Procédé selon l'une quelconque des revendications précédentes, dans lequel l'étape 2) comprend le fait de coupler le signal de porteuse modulée reçu (1204) à un dispositif d'accumulation à réactance (2901) à la fréquence de repliement du spectre.

**4.** Procédé selon la revendication 1, dans lequel l'étape 2) comprend le fait de transmettre par porte le signal de porteuse reçu (1204) conformément à un signal de commande (2406) comprenant un train d'impulsions (1904 ; 2007 ; 2107 ; 2207 ; 2307), ayant des fenêtres non négligeables (1906 ; 2009 ; 2109 ; 2209 ; 2309), qui se répètent à la fréquence de repliement du spectre.

**5.** Procédé selon la revendication 1, dans lequel l'étape 2) comprend le fait de :

a) transférer (1806) une partie non négligeable de l'énergie contenue dans une partie du signal de porteuse modulée reçu (1204) ; et
b) répéter l'étape 2)a) à la fréquence de repliement du spectre.

**6.** Procédé selon l'une quelconque des revendications précédentes, dans lequel l'étape 2) comprend le fait de commander une relation de fréquence entre le signal de porteuse modulée reçu (1204) et la fréquence de repliement du spectre.

**7.** Procédé selon l'une quelconque des revendications précédentes, dans lequel l'étape 2) comprend le fait de commander une relation de phase entre le signal de porteuse modulée reçu (1204) et la fréquence de repliement du spectre.

**8.** Procédé selon l'une quelconque des revendications 1 à 5, dans lequel chacune des fenêtres (1906 ; 2009 ; 2109 ; 2209 ; 2309) est d'une durée à peu près égale à la moitié de la période du signal de porteuse modulée reçu (1204).

**9.** Procédé selon l'une quelconque des revendications 1 à 5, dans lequel chacune des fenêtres (1906 ; 2009 ; 2109 ; 2209 ; 2309) est d'une durée à peu près égale ou supérieure à dix pour cent de la période du signal de porteuse modulée reçu (1204).

**10.** Procédé selon l'une quelconque des revendications 1 à 5, dans lequel chacune des fenêtres (1906 ; 2009 ; 2109 ; 2209 ; 2309) est d'une durée à peu près égale ou supérieure à vingt-cinq pour cent de la période du signal de porteuse modulée reçu (1204).

**11.** Procédé selon l'une quelconque des revendications 1 à 5, dans lequel chacune des fenêtres (1906 ; 2009 ; 2109 ; 2209 ; 2309) est d'une durée à peu près égale ou supérieure à cinquante pour cent de la période du signal de porteuse modulée reçu (1204).

**12.** Procédé selon l'une quelconque des revendications 1 à 5, dans lequel chacune des fenêtres (1906 ; 2009 ; 2109 ; 2209 ; 2309) est d'une durée à peu près égale ou supérieure à soixante-quinze pour cent de la période du signal de porteuse modulée reçu (1204).

**13.** Procédé selon l'une quelconque des revendications 1 à 5, dans lequel chacune des fenêtres (1906 ; 2009 ; 2109 ; 2209 ; 2309) est d'une durée égale à N cycles du signal de porteuse modulée reçu (1204), avec N égale A plus B, A étant un entier positif et B étant une fraction d'un entier.

**14.** Procédé selon l'une quelconque des revendications précédentes, dans lequel l'étape 2) comprend le fait de transférer des quantités d'énergie non négligeables par rapport à l'énergie contenue dans un cycle du signal de porteuse modulée reçu (1204).

**15.** Procédé selon la revendication 1, dans lequel l'étape 2) comprend le fait de générer un train d'impulsions (1904 ; 2007 ; 2107 ; 2207 ; 2307) ayant des fenêtres non négligeables par rapport à la période du signal de porteuse modulée reçu (1204).

**16.** Procédé selon la revendication 5, dans lequel l'étape 2)a) comprend le fait de transférer au moins dix pour cent de l'énergie contenue dans une période du signal de porteuse modulée reçu (1204).

**17.** Procédé selon la revendication 5, dans lequel l'étape 2)a) comprend le fait de transférer au moins vingt-cinq pour cent de l'énergie contenue dans une période du signal de porteuse modulée reçu (1204).

**18.** Procédé selon la revendication 5, dans lequel l'étape 2)a) comprend le fait de transférer au moins cinquante pour cent de l'énergie contenue dans une période du signal de porteuse modulée reçu (1204).

**19.** Procédé selon la revendication 5, dans lequel l'étape 2)a) comprend le fait de transférer au moins soixante-quinze pour cent de l'énergie contenue dans une période du signal de porteuse modulée reçu (1204).

**20.** Procédé selon l'une quelconque des revendications 1 à 5, dans lequel chacune des fenêtres (2109) est d'une durée à peu près égale à la moitié de la période du signal de porteuse modulée reçu (616) et est substantiellement alignée avec la période du signal de porteuse modulée reçu (616).

**21.** Procédé selon la revendication 20, dans lequel les fenêtres (2109) sont substantiellement alignées avec des moitiés de cycle positives du signal de porteuse modulée reçu (616).

**22.** Procédé selon la revendication 20, dans lequel les fenêtres (2309) sont substantiellement alignées avec des moitiés de cycle négatives du signal de porteuse modulée reçu (1016).

**23.** Procédé selon l'une quelconque des revendications 1 à 5, dans lequel chacune des fenêtres est d'une durée à peu près égale à la moitié de la période du signal de porteuse modulée reçu (516) et n'est pas alignée avec la période du signal de porteuse modulée reçu (516).

**24.** Procédé selon l'une quelconque des revendications 1 à 5, dans lequel les fenêtres (1906 ; 2009 ; 2109 ; 2209 ; 2309) sont substantiellement synchronisées avec le signal de porteuse modulée reçu (1204).

**25.** Procédé selon l'une quelconque des revendications 1 à 5, dans lequel les fenêtres (2406) ne sont pas synchronisées avec le signal de porteuse modulée reçu (1204).

**26.** Procédé selon la revendication 2, dans lequel l'étape 2) comprend en outre le fait de générer le signal de transfert d'énergie (2406) indépendamment du signal de porteuse modulée reçu (1204).

**27.** Procédé selon l'une quelconque des revendications 1 à 5, dans lequel l'étape 2) comprend le fait de générer un signal de transfert d'énergie asynchrone (2406) ayant la fréquence de repliement du spectre et d'utiliser le signal de transfert d'énergie asynchrone (2406) pour emmagasiner l'énergie provenant du signal de porteuse modulée reçu (1204).

**28.** Procédé selon l'une quelconque des revendications 1 à 5, dans lequel l'étape 3) comprend le fait de préserver l'information de modulation sans reproduire le signal de porteuse modulée reçu (1204).

**29.** Procédé selon l'une quelconque des revendications 1 à 5, dans lequel l'étape 2) comprend le fait d'emmagasiner l'énergie de manière différentielle.

**30.** Procédé selon l'une quelconque des revendications 1 à 5, dans lequel l'étape 2) comprend l'étape consistant à :

i) commander la quantité d'énergie transférée à partir du signal de porteuse modulée reçu (1204).

**31.** Procédé selon la revendication 30, dans lequel l'étape 2)i) comprend le fait de commander une fenêtre (5720).

**32.** Procédé selon la revendication 31, dans lequel l'étape 2)i) comprend en outre le fait de commander une largeur de fenêtre.

**33.** Procédé selon la revendication 31, dans lequel l'étape 2)i) comprend en outre le fait de commander une fréquence de fenêtre.

**34.** Procédé selon la revendication 31, dans lequel l'étape 2)i) comprend en outre le fait de commander une forme de fenêtre.

**35.** Procédé selon la revendication 30, dans lequel l'étape 2)i) comprend le fait de commander des caractéristiques de transfert d'énergie.

**36.** Procédé selon l'une quelconque des revendications précédentes, dans lequel l'étape 3) comprend le fait de décharger l'énergie emmagasinée entre les fenêtres (1906 ; 2009 ; 2109 ; 2209 ; 2309) d'une manière commandée.

**37.** Procédé selon l'une quelconque des revendications précédentes, dans lequel l'étape 2) comprend le fait d'emmagasiner suffisamment d'énergie à partir du signal de porteuse modulée reçu (4204) pour attaquer une charge (4212) sans employer d'organe tampon ou d'amplification supplémentaire, la charge étant une charge à haute impédance ou une charge à basse impédance (4218).

**38.** Procédé selon l'une quelconque des revendications précédentes, dans lequel l'étape 2) comprend le fait d'emmagasiner de l'énergie à partir du signal de porteuse modulée reçu (4204) sans pré-amplification (à faible bruit) du signal de porteuse modulée reçu (4204).

**39.** Procédé selon l'une quelconque des revendications précédentes, dans lequel ledit emmagasinage d'énergie à partir du signal de porteuse modulée reçu (1204) empêche substantiellement une reproduction de tension précise du signal de porteuse modulée reçu (1204) pendant les fenêtres (1906 ; 2009 ; 2109 ; 2209 ; 2309).

**40.** Procédé selon l'une quelconque des revendications précédentes, dans lequel l'étape 1) comprend le fait de recevoir le signal de porteuse modulée (1204) par un chemin à impédance d'entrée relativement basse (3106).

**41.** Procédé selon l'une quelconque des revendications précédentes, dans lequel l'étape 1) comprend le fait de recevoir le signal de porteuse modulée (1204) par un chemin de transfert d'énergie relativement efficace (3106).

**42.** Procédé selon l'une quelconque des revendications précédentes, dans lequel l'étape 2) comprend le fait de transmettre par porte le signal de porteuse modulée reçu (1204) en utilisant un commutateur (2602).

**43.** Procédé selon la revendication 42, dans lequel l'impédance dudit commutateur (3116) est adaptée à une impédance de source (3112), pour accroître l'énergie transférée à partir dudit signal de porteuse modulée reçu (1204).

**44.** Procédé selon la revendication 42, dans lequel l'impédance dudit commutateur (3116) est adaptée à une impédance de charge (3118), pour accroître l'énergie transférée à partir dudit signal de porteuse modulée reçu (1204).

**45.** Procédé selon la revendication 44, dans lequel ledit signal de porteuse modulée reçu (1204) est couplé audit commutateur (5314) via un circuit résonant (5338, 5320), ledit circuit résonant (5338, 5320) emmagasinant de l'énergie à partir de composantes dudit signal de porteuse modulée reçu (1204) pendant que ledit commutateur (5314) est ouvert, et dans lequel l'énergie emmagasinée dans ledit circuit résonant (5338, 5320) est déchargée via ledit commutateur (5314) pendant que ledit commutateur (5314) est fermé, pour accroître l'énergie transférée à partir dudit signal de porteuse modulée reçu (1204).

**46.** Appareil adapté pour exécuter le procédé de l'une quelconque des revendications précédentes.

**47.** Appareil selon la revendication 46, comprenant en outre un circuit d'adaptation d'impédance d'entrée (3106).

**48.** Appareil selon la revendication 46, comprenant en outre un circuit d'adaptation d'impédance de sortie (3108).

**49.** Appareil selon la revendication 46, comprenant en outre un circuit bouchon.

**50.** Appareil selon la revendication 46 quand elle dépend de la revendication 42, comprenant en outre un circuit à réaction positive (5402) parallèle audit commutateur (5404).

**51.** Appareil selon la revendication 46, comprenant en outre une chaîne de rétroaction (3006).

**52.** Appareil selon la revendication 46, dans lequel ledit moyen pour emmagasiner ladite énergie comprend un dispositif d'accumulation à capacitance (4208) dimensionné pour emmagasiner des quantités d'énergie substantielles par rapport à l'énergie approximative contenue dans des moitiés de cycles du signal de porteuse modulée reçu (4204).

**53.** Appareil selon la revendication 46, dans lequel le moyen pour emmagasiner ladite énergie est constitué par un matériau du type semiconducteur à oxyde de métal complémentaire (C-MOS) (8326).

**54.** Appareil selon la revendication 46, dans lequel le moyen pour emmagasiner ladite énergie est constitué par un seul circuit intégré (8326).

**55.** Appareil selon la revendication 46, comprenant en outre une impédance de sortie réglable (5702).

FIG. 1

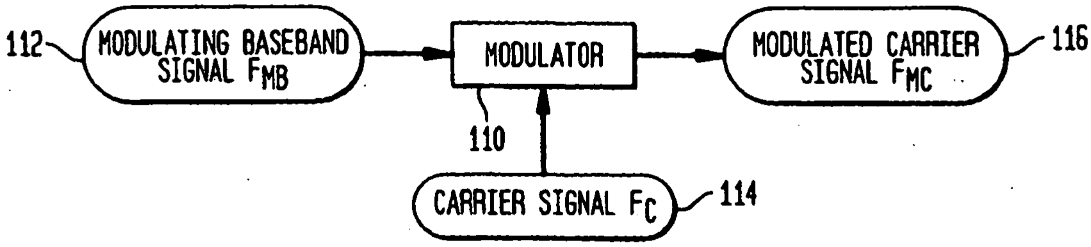


FIG. 2

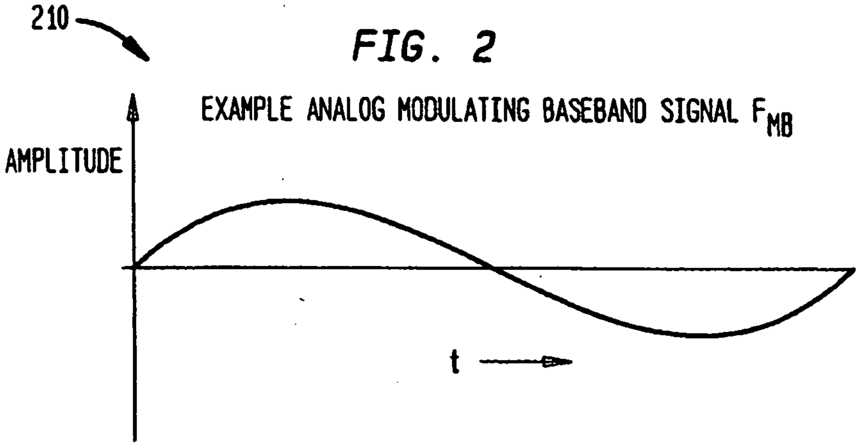


FIG. 3

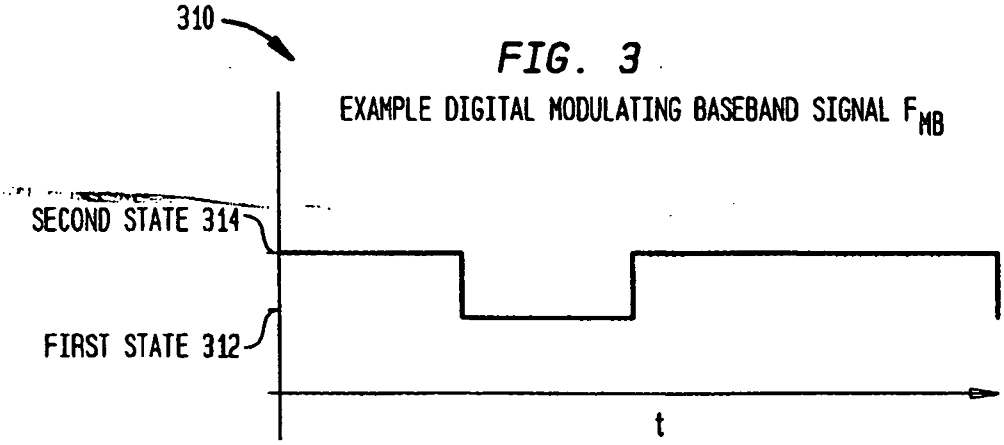


FIG. 4

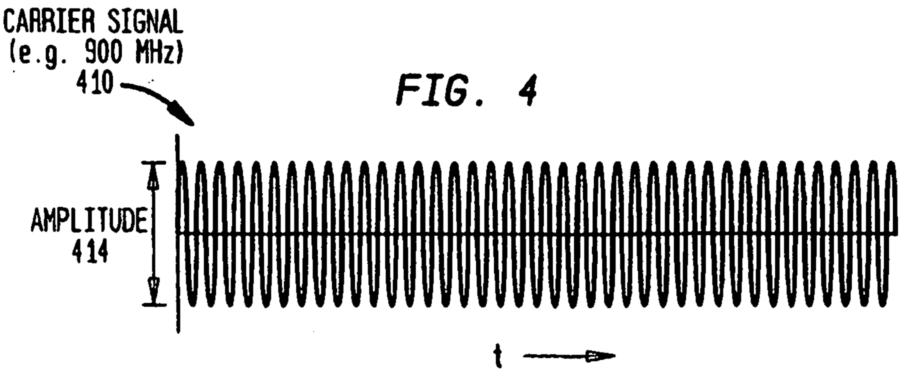

FIG. 5A

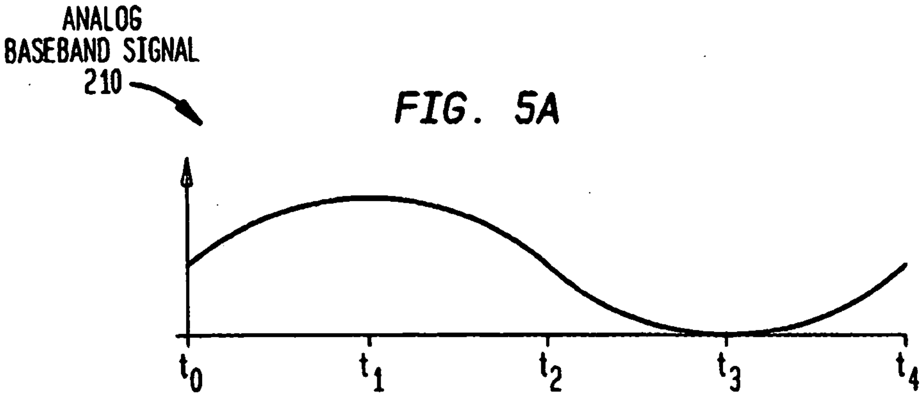


FIG. 5B

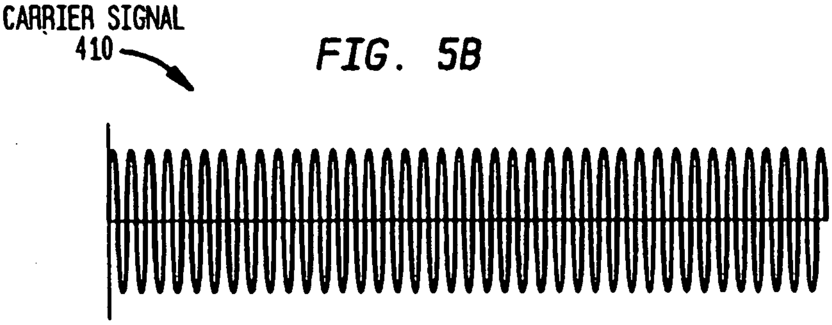


FIG. 5C

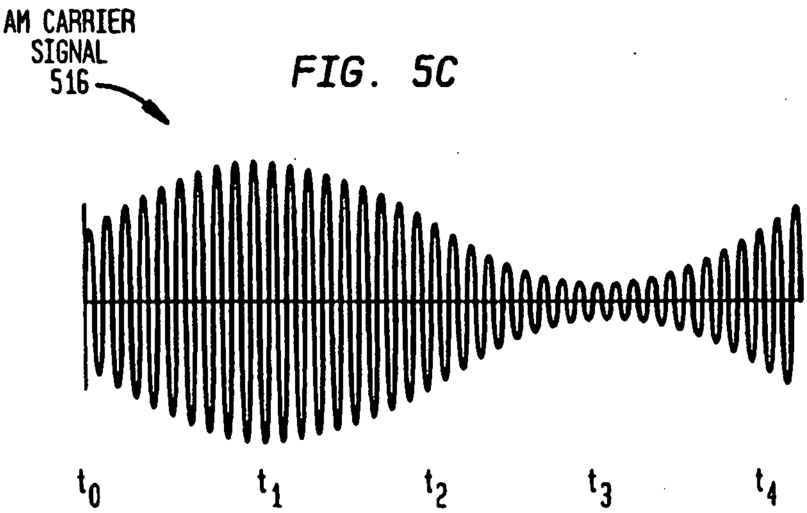

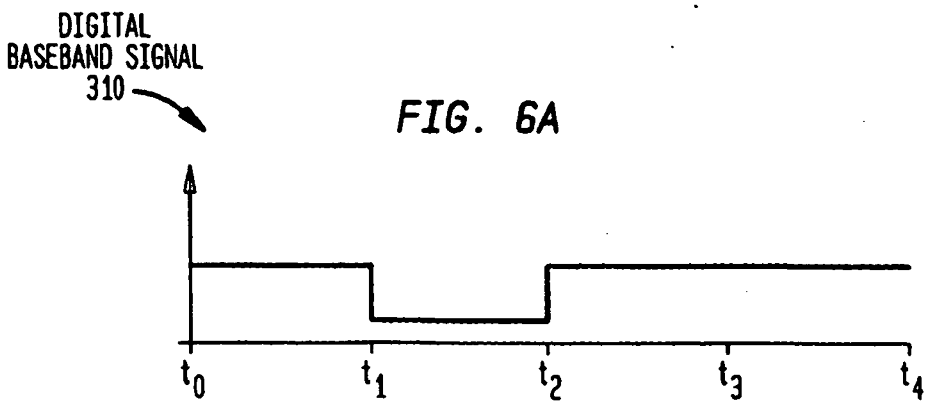


FIG. 6A

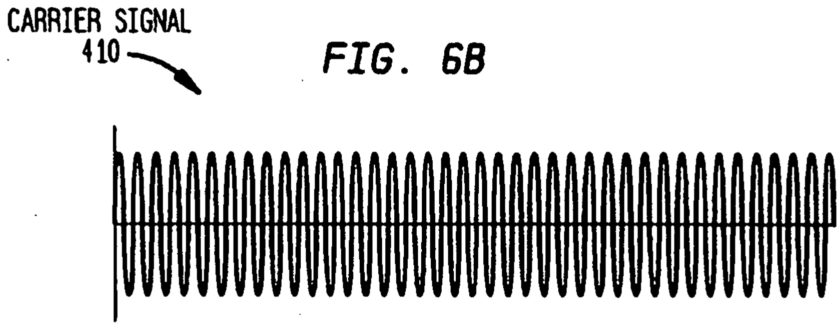


FIG. 6B

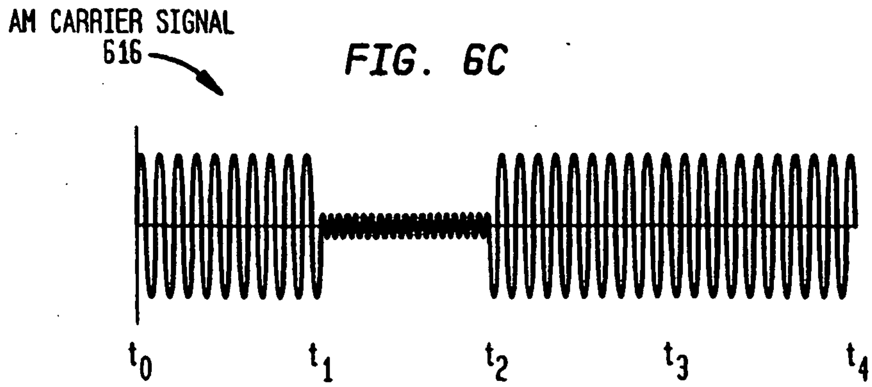


FIG. 6C

FIG. 7A

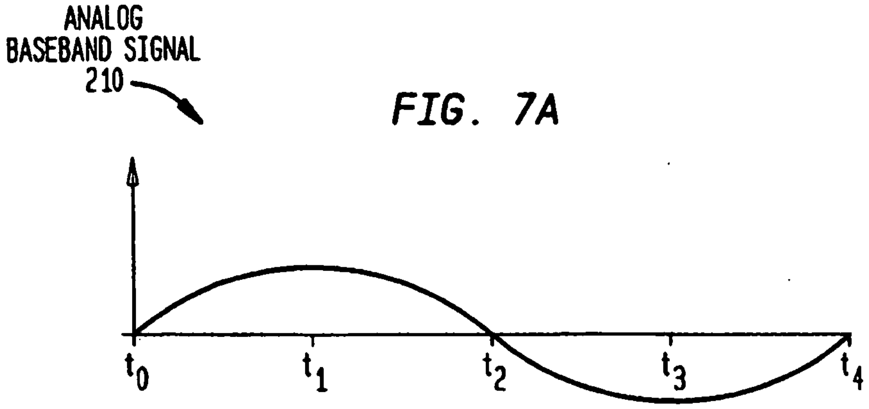


FIG. 7B

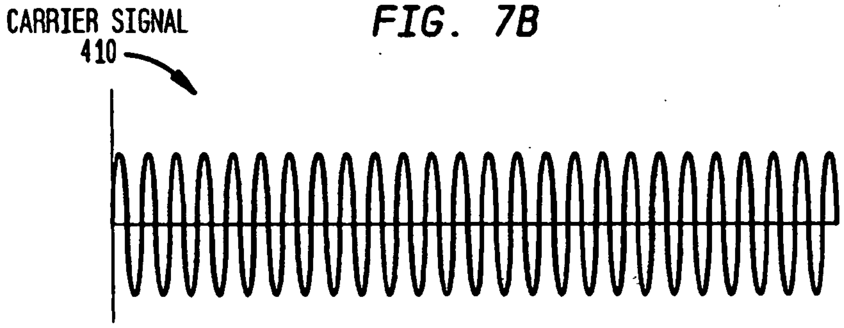


FIG. 7C

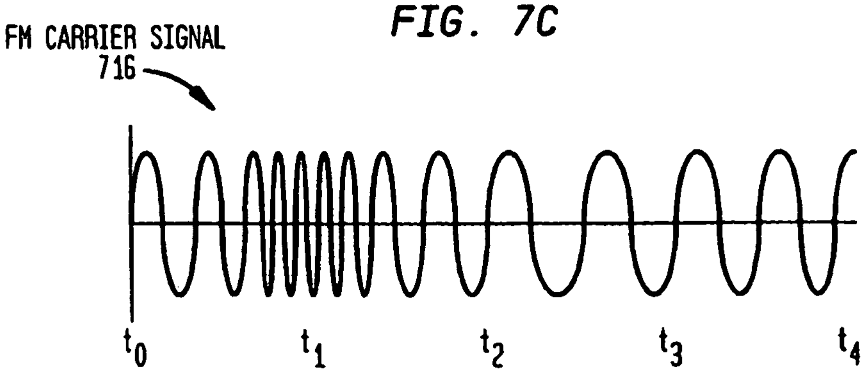

FIG. 8A

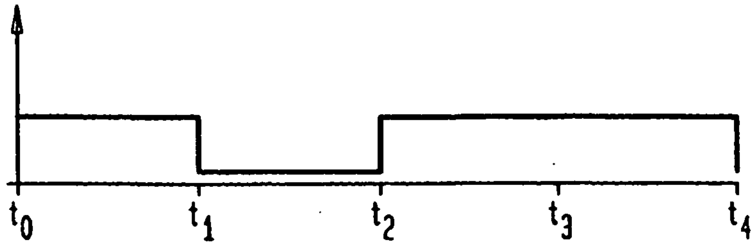


FIG. 8B

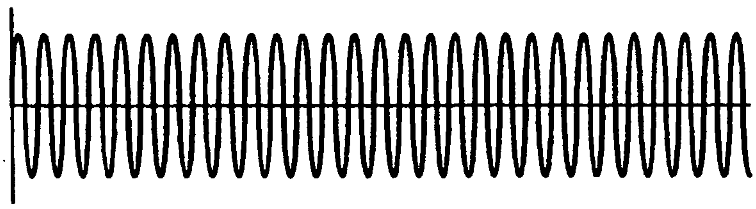


FIG. 8C

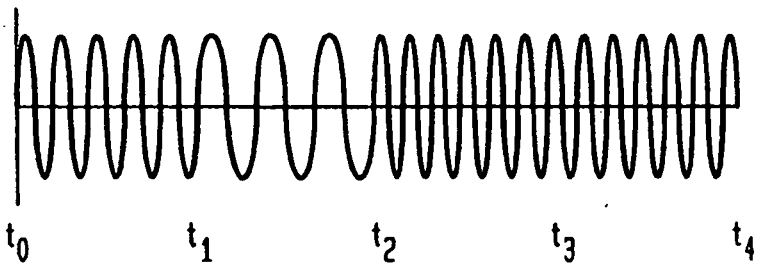

FIG. 9A

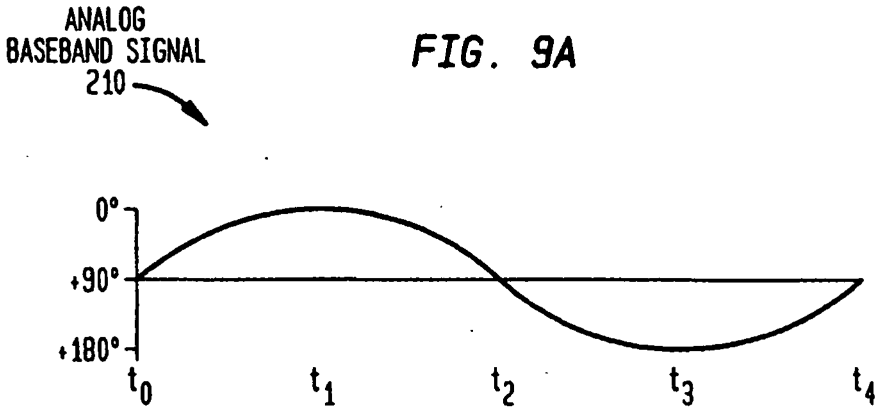


FIG. 9B

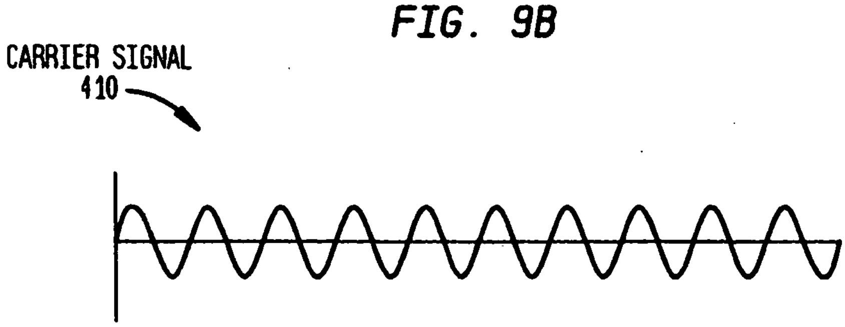


FIG. 9C

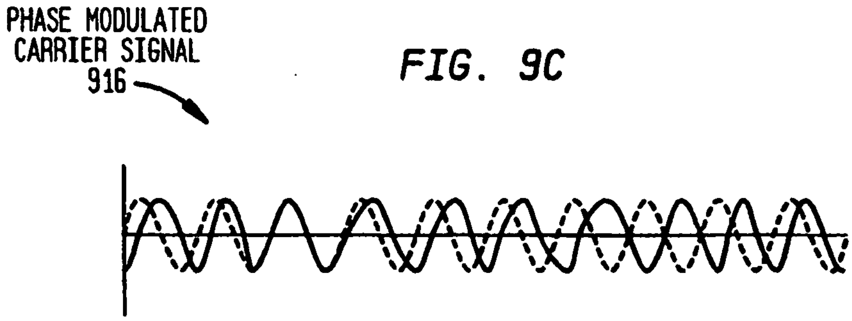

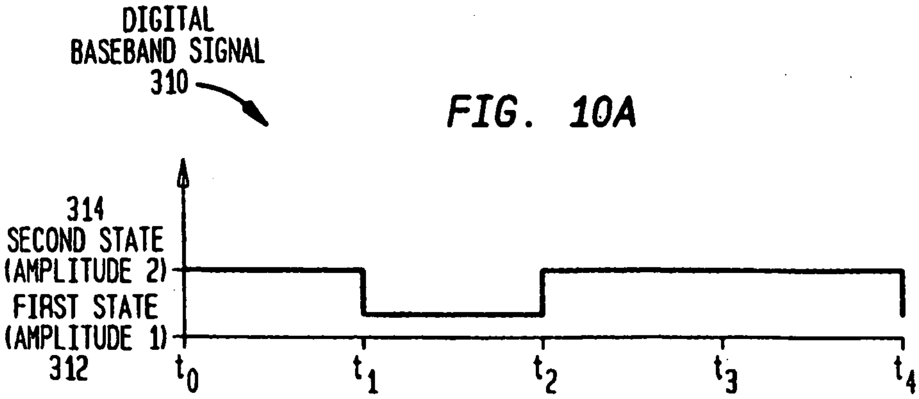


FIG. 10A

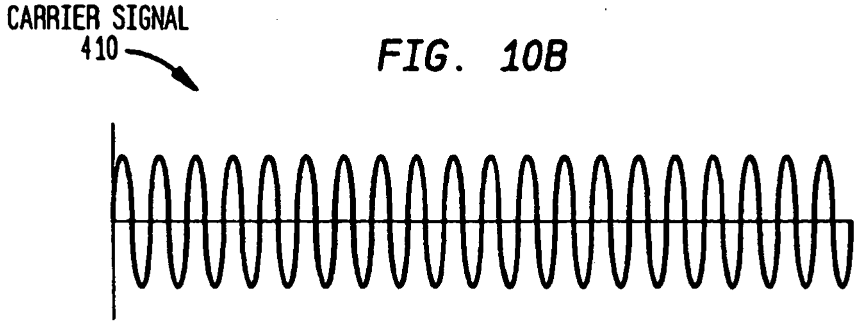


FIG. 10B

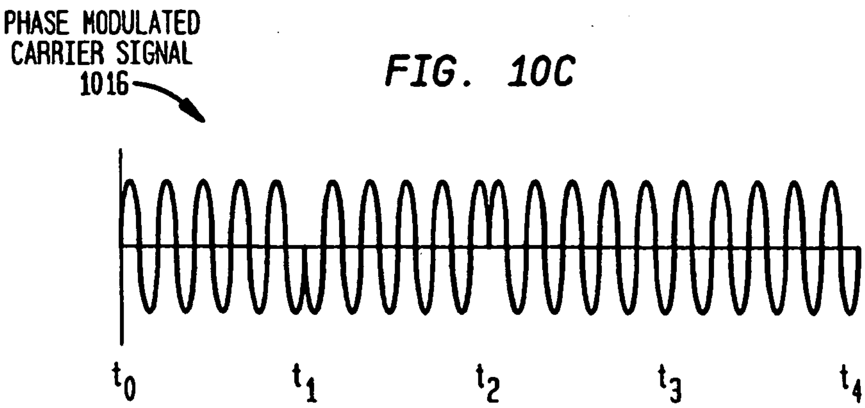


FIG. 10C

FIG. 11

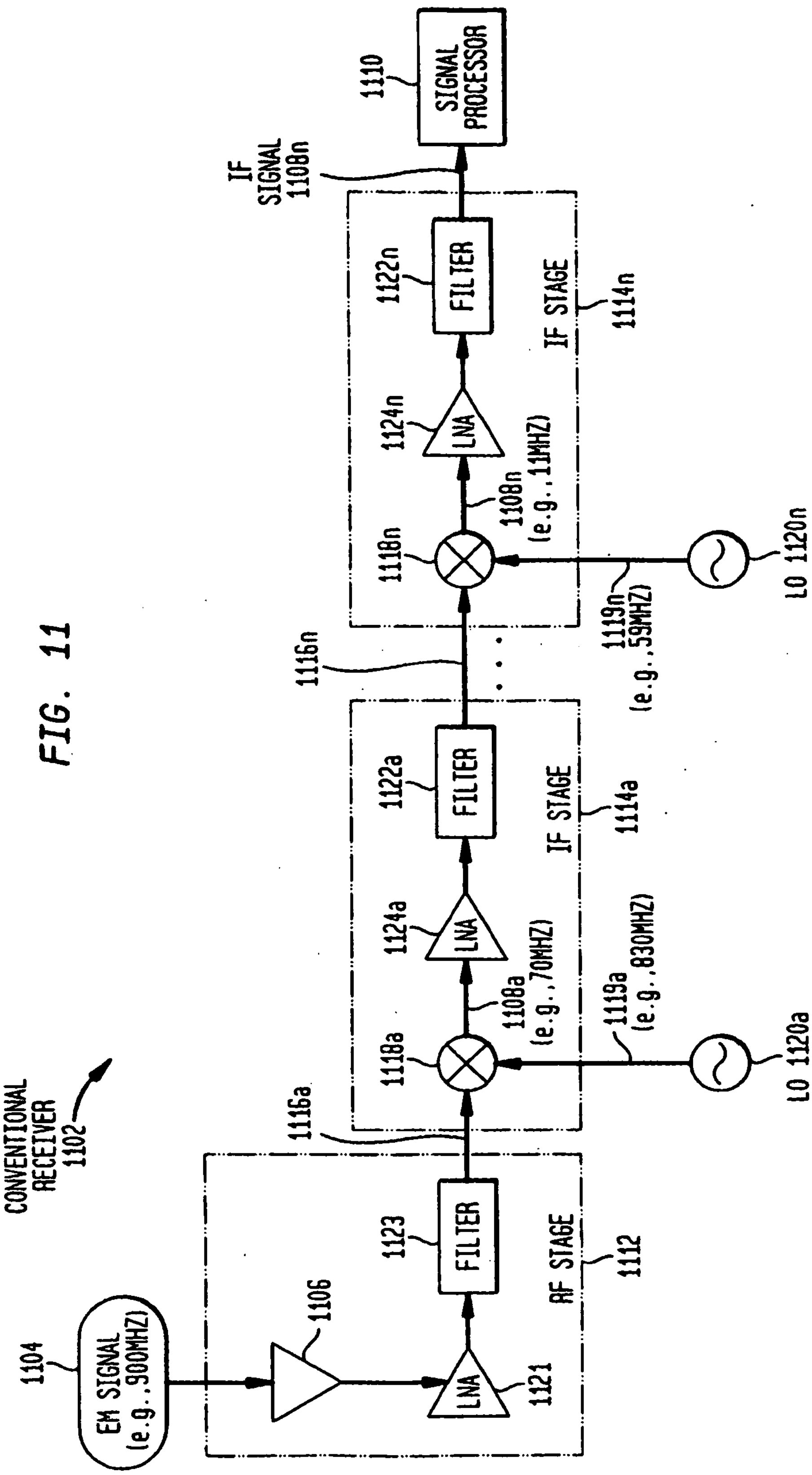
CONVENTIONAL RECEIVER 1102
1104
EM SIGNAL (e.g.,900MHZ)
1106
LNA
1121
FILTER
1123
RF STAGE
1112
1116a
1118a
1108a (e.g.,70MHZ)
1119a (e.g.,830MHZ)
LO 1120a
LNA
1124a
FILTER
1122a
IF STAGE
1114a
1116n
1118n
1108n (e.g.,11MHZ)
1119n (e.g.,59MHZ)
LO 1120n
LNA
1124n
FILTER
1122n
IF STAGE
1114n
IF SIGNAL 1108n
SIGNAL PROCESSOR
1110

FIG. 12

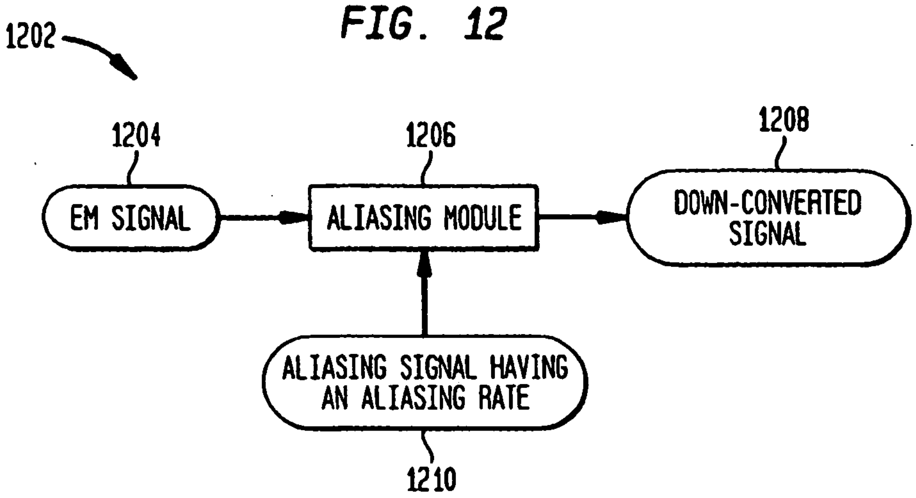


GENERIC DOWN-CONVERTING SYSTEM

FIG. 13A

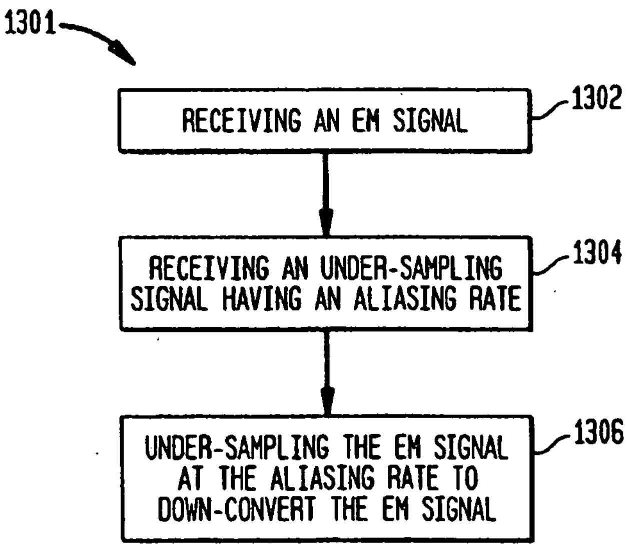

FIG. 13B

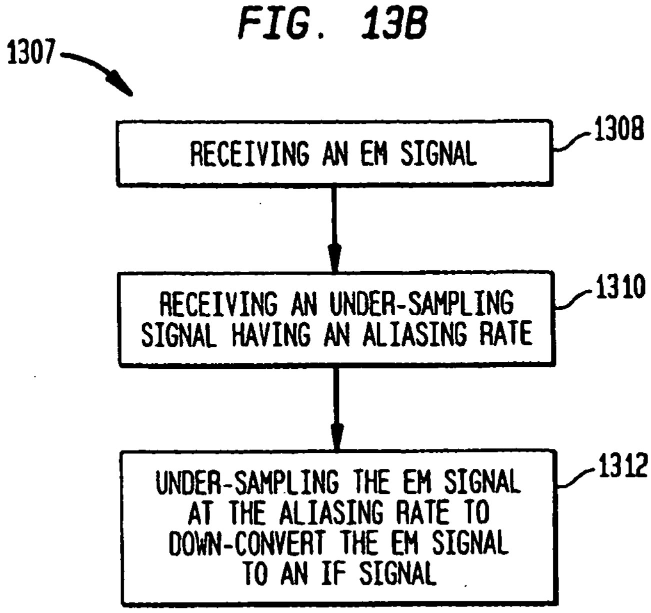


FIG. 13C

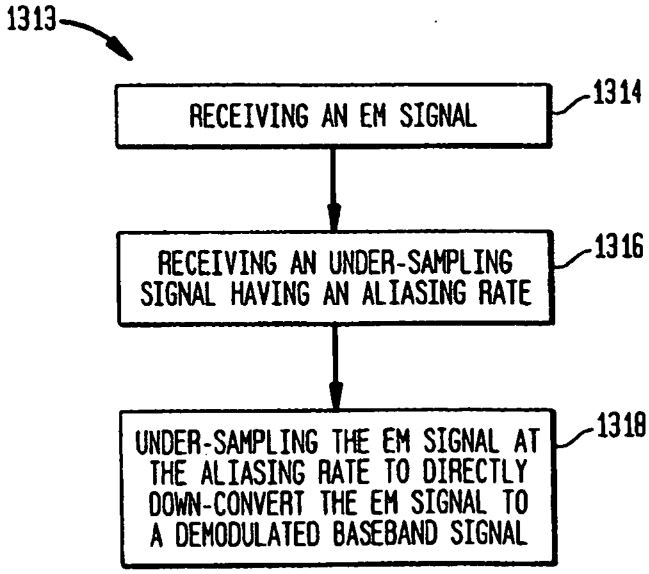

FIG. 13D

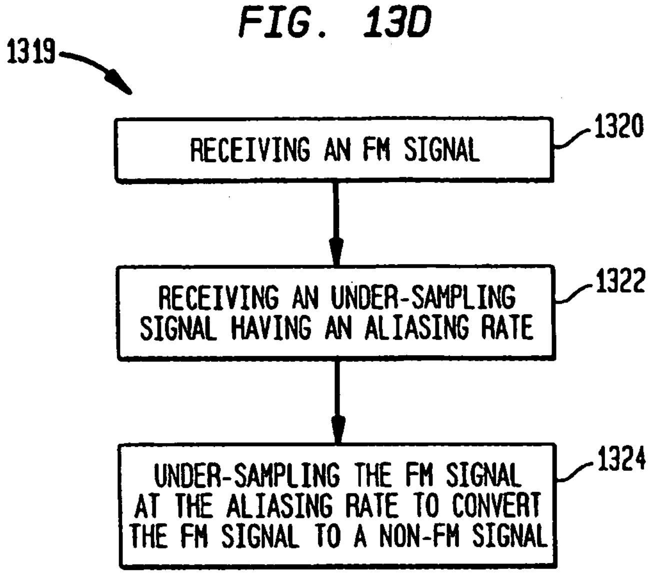
1319
RECEIVING AN FM SIGNAL
1320
RECEIVING AN UNDER-SAMPLING SIGNAL HAVING AN ALIASING RATE
1322
UNDER-SAMPLING THE FM SIGNAL AT THE ALIASING RATE TO CONVERT THE FM SIGNAL TO A NON-FM SIGNAL
1324

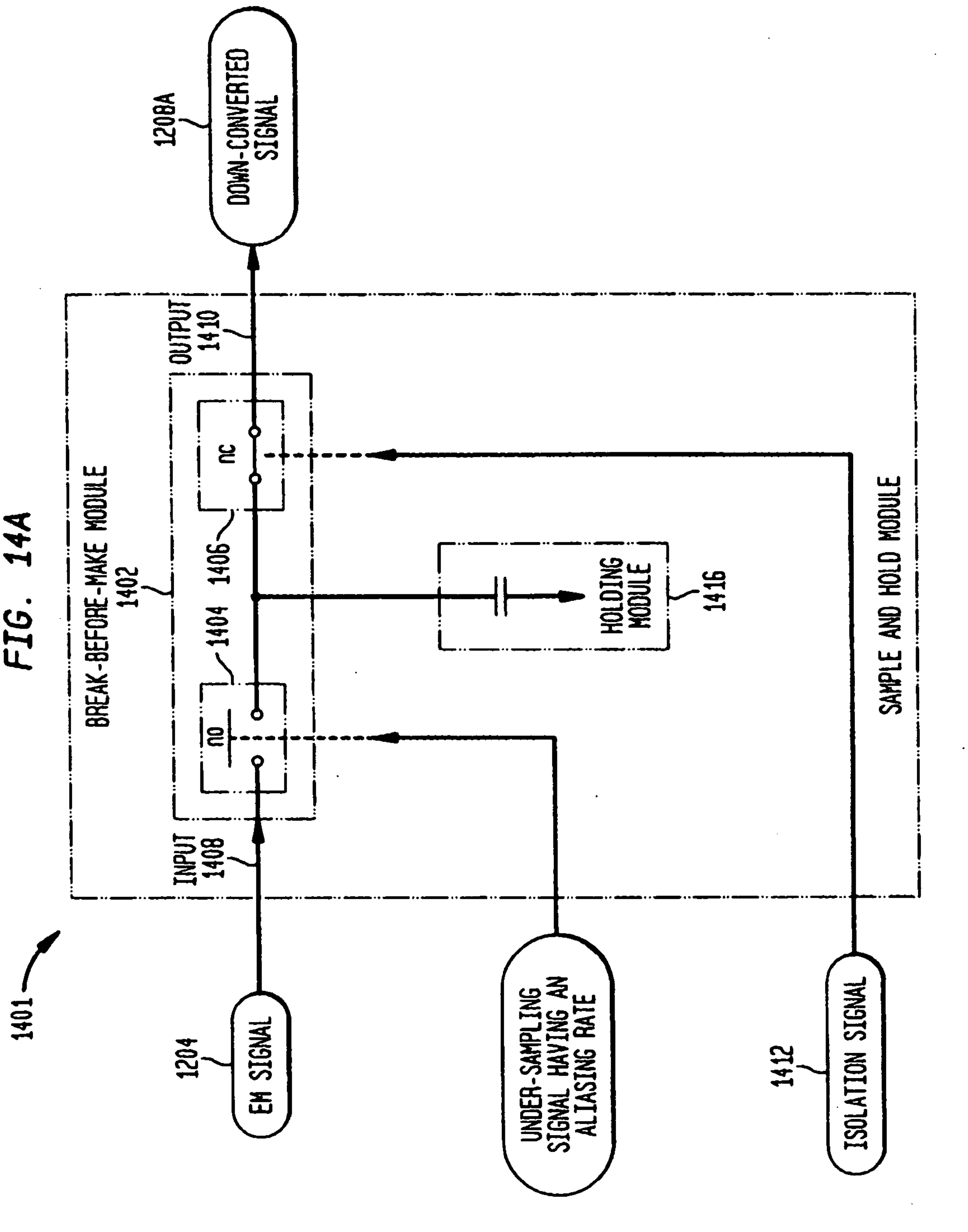
1401
EM SIGNAL
1204
UNDER-SAMPLING SIGNAL HAVING AN ALIASING RATE
ISOLATION SIGNAL
1412
INPUT
1408
BREAK-BEFORE-MAKE MODULE
1402
no
1404
1406
nc
OUTPUT
1410
HOLDING MODULE
1416
SAMPLE AND HOLD MODULE
DOWN-CONVERTED SIGNAL
1208A

FIG. 14A

FIG. 14B

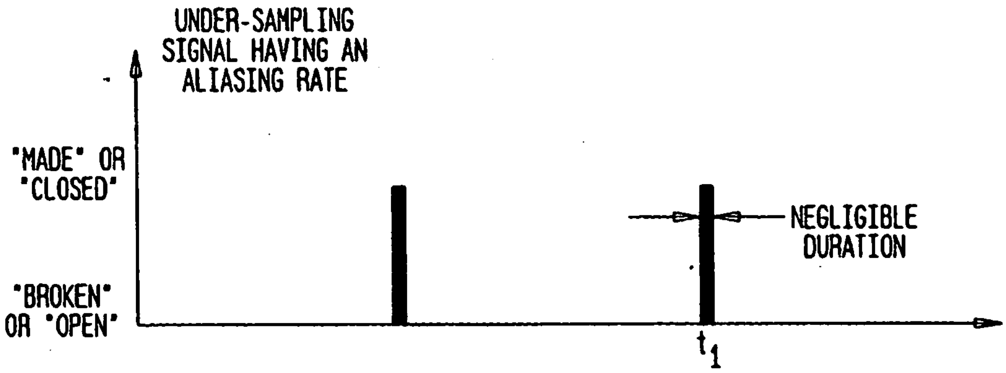


FIG. 14C

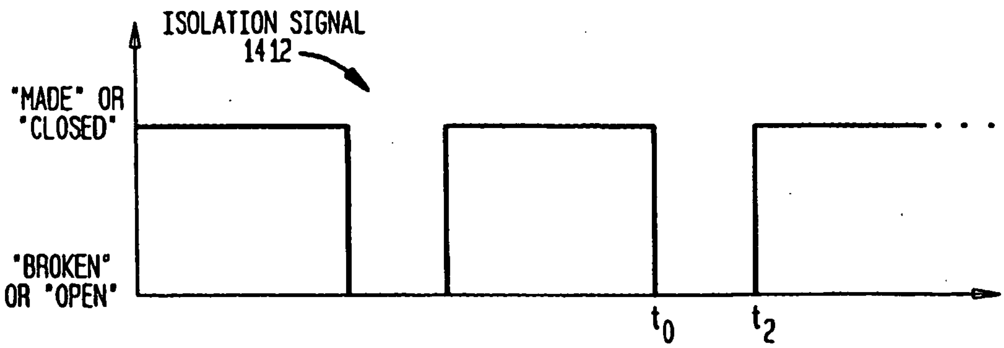

FIG. 15

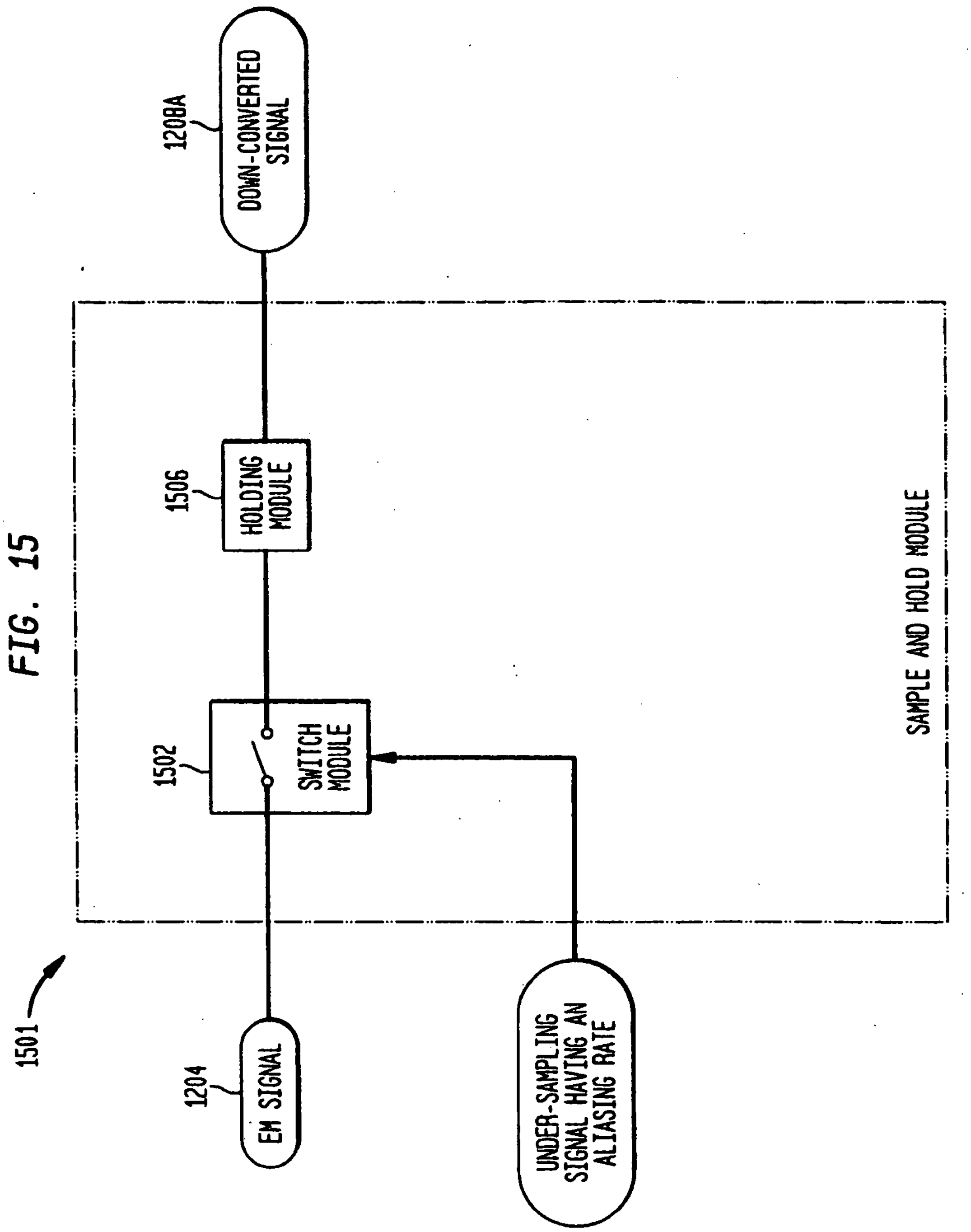
1501
1204
EM SIGNAL
1502
SWITCH MODULE
1506
HOLDING MODULE
1208A
DOWN-CONVERTED SIGNAL
UNDER-SAMPLING SIGNAL HAVING AN ALIASING RATE
SAMPLE AND HOLD MODULE

FIG. 16A

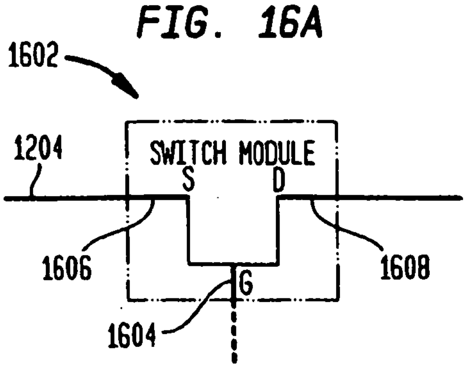


FIG. 16B

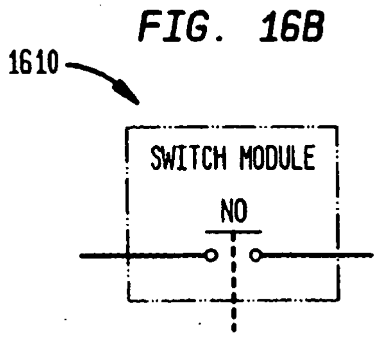


FIG. 16C

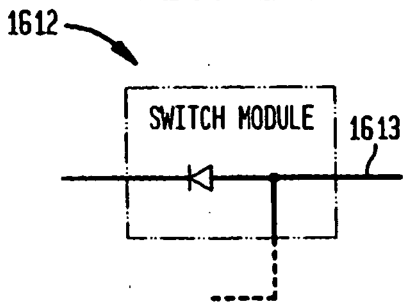


FIG. 16D

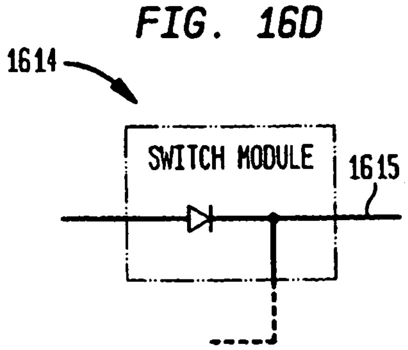

FIG. 17A

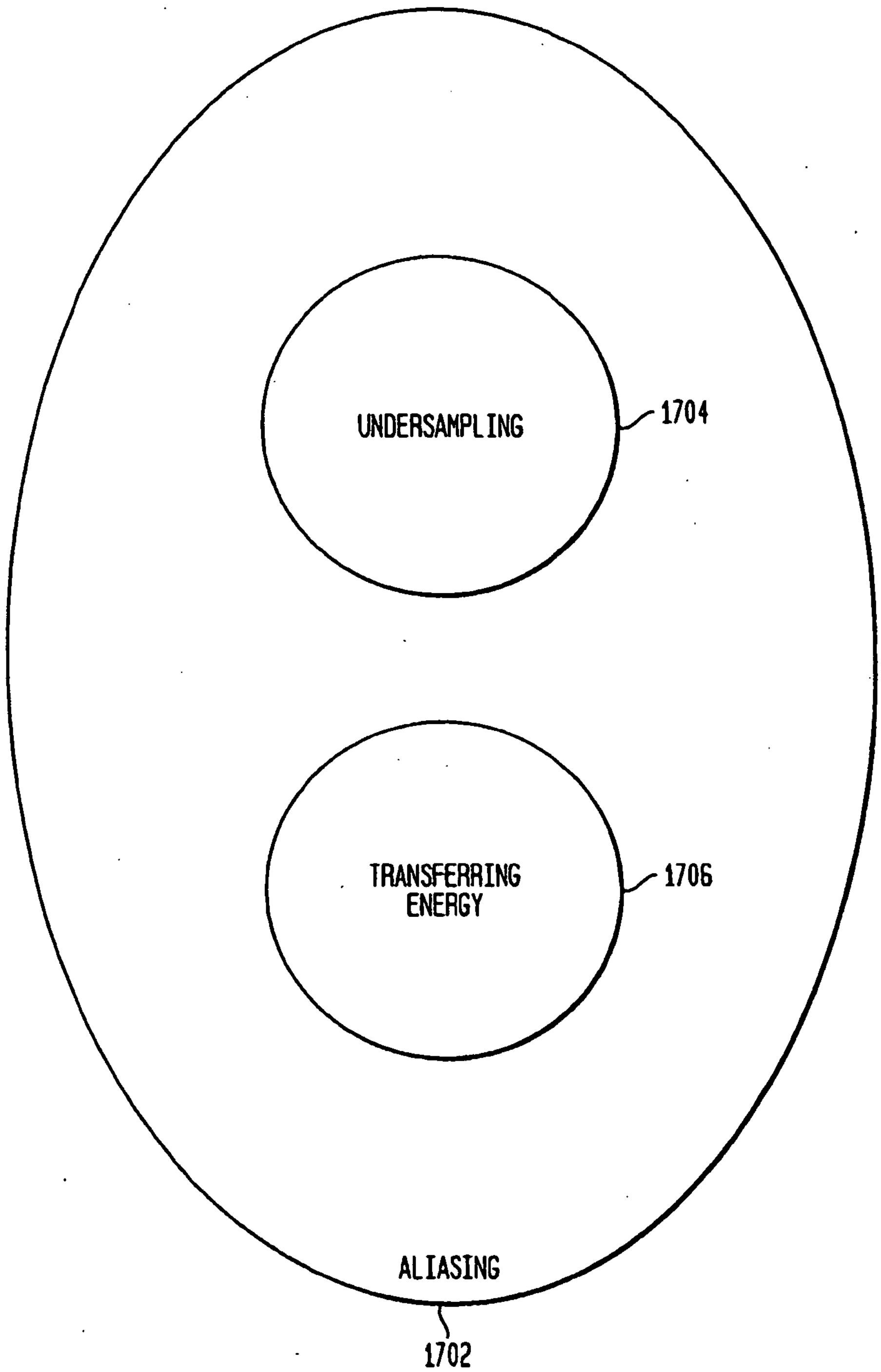
UNDERSAMPLING
1704
TRANSFERRING ENERGY
1706
ALIASING
1702

FIG. 17B

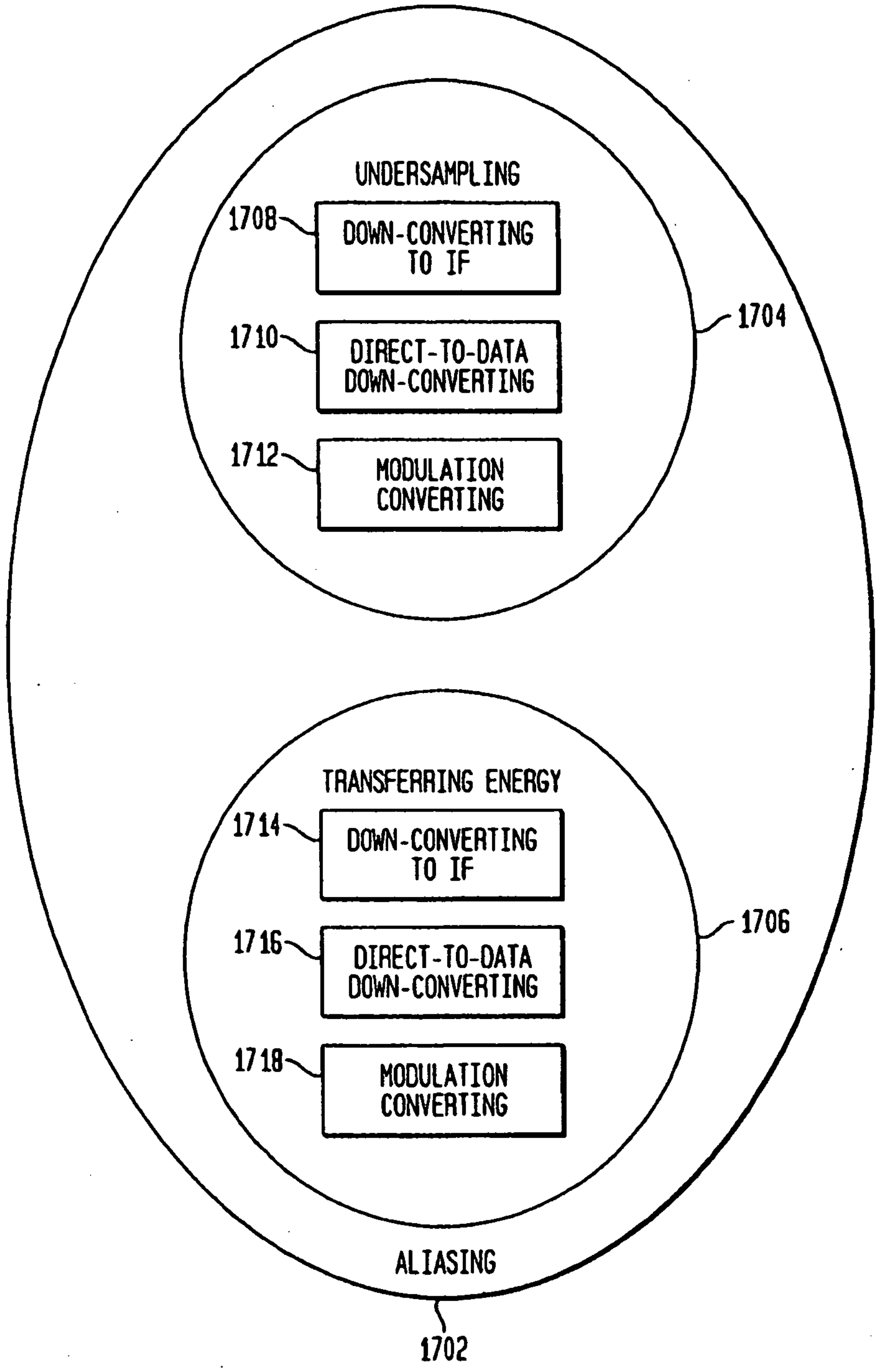
UNDERSAMPLING
1708
DOWN-CONVERTING TO IF
1710
DIRECT-TO-DATA DOWN-CONVERTING
1712
MODULATION CONVERTING
1704
TRANSFERRING ENERGY
1714
DOWN-CONVERTING TO IF
1716
DIRECT-TO-DATA DOWN-CONVERTING
1718
MODULATION CONVERTING
1706
ALIASING
1702

FIG. 18A

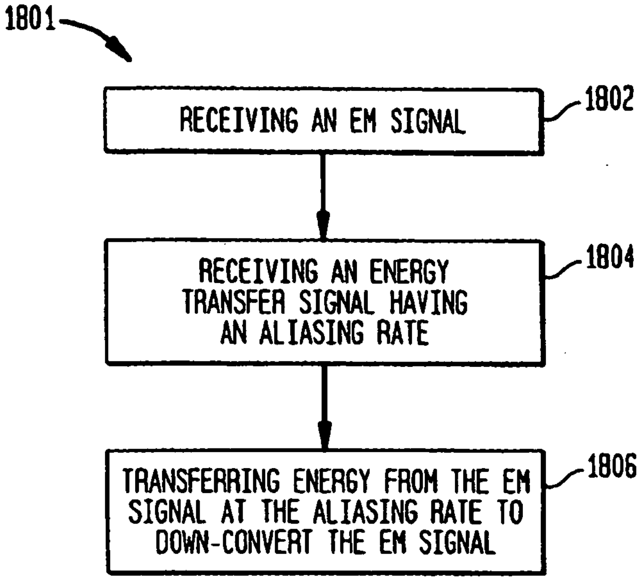


FIG. 18B

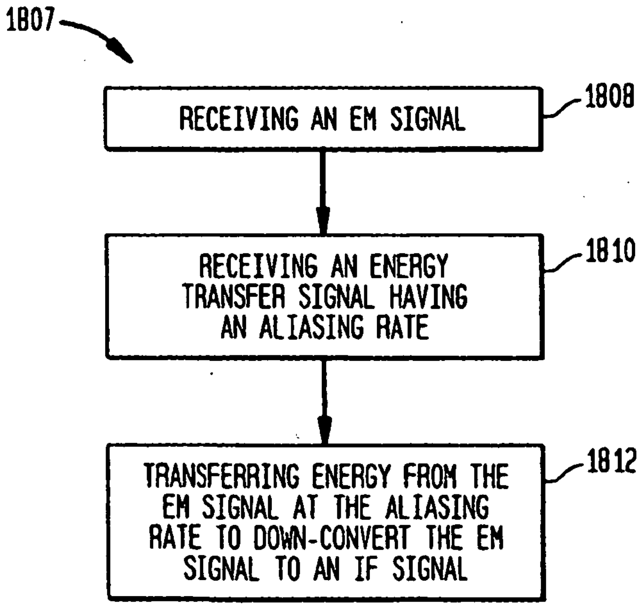

FIG. 18C

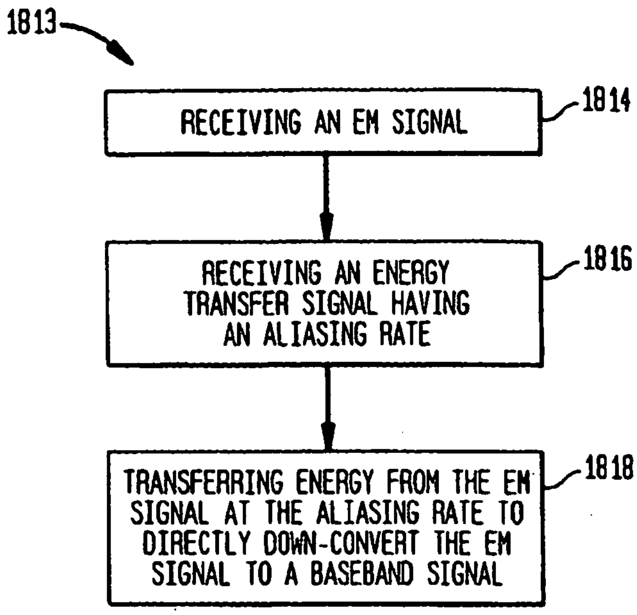


FIG. 18D

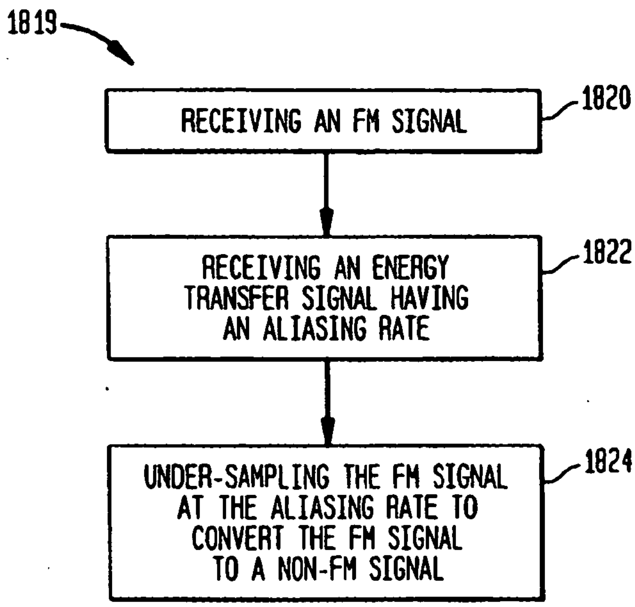

FIG. 19A

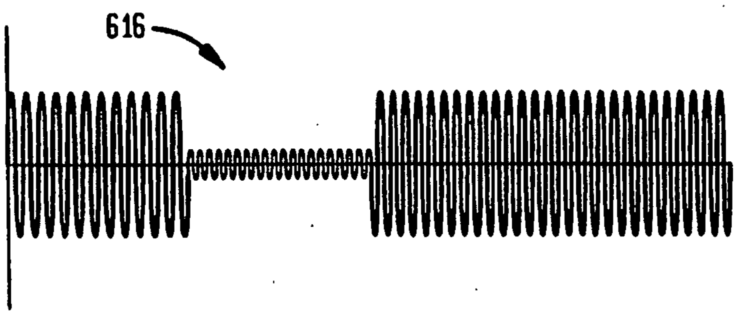


FIG. 19B

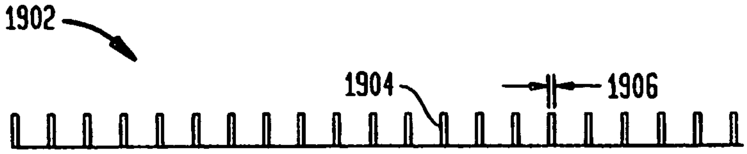


FIG. 19C

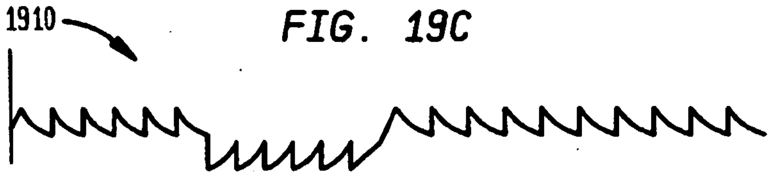


FIG. 19D

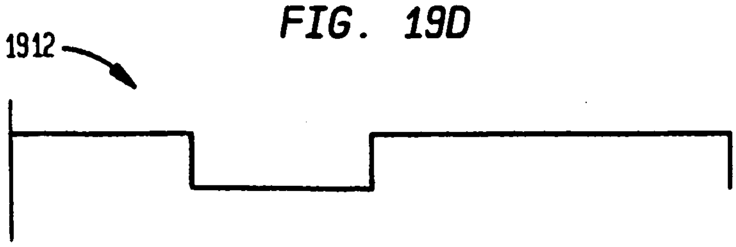

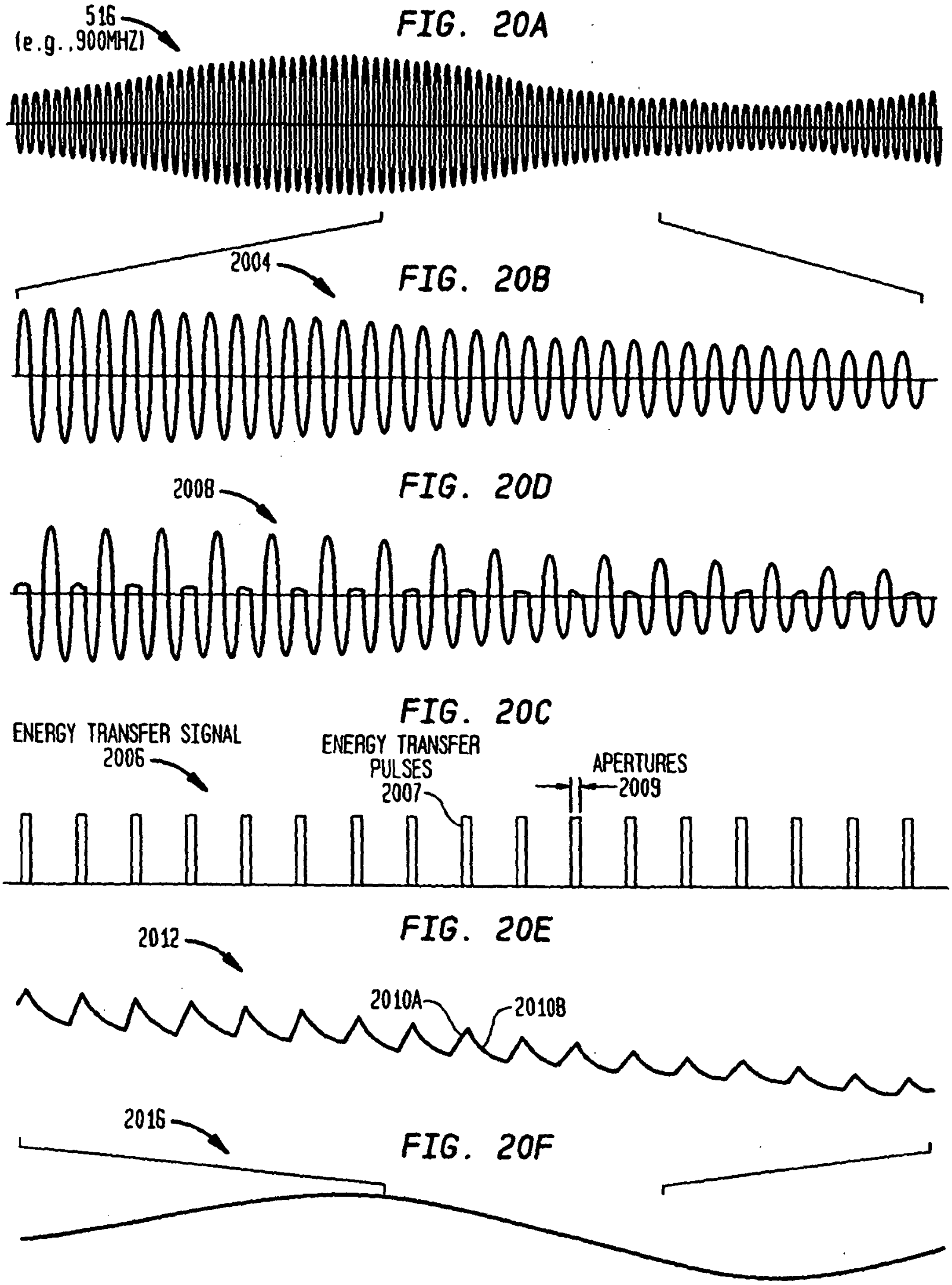


FIG. 20A

FIG. 20B

FIG. 20D

FIG. 20C

FIG. 20E

FIG. 20F

FIG. 21A

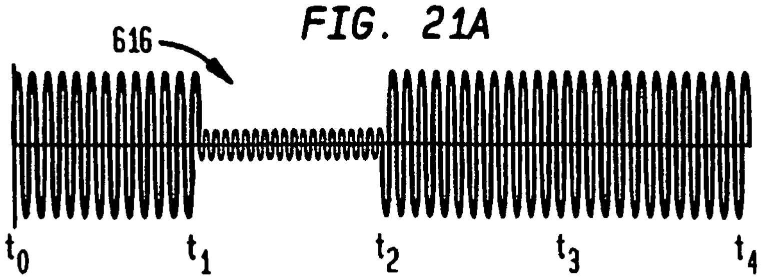


FIG. 21B

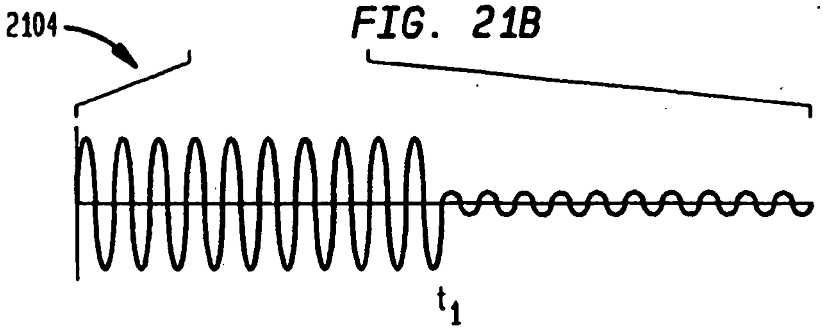


FIG. 21D

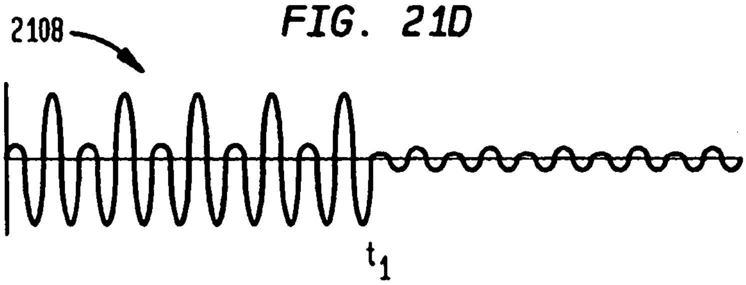


FIG. 21C

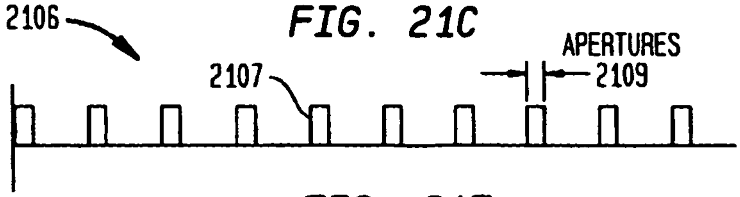


FIG. 21E

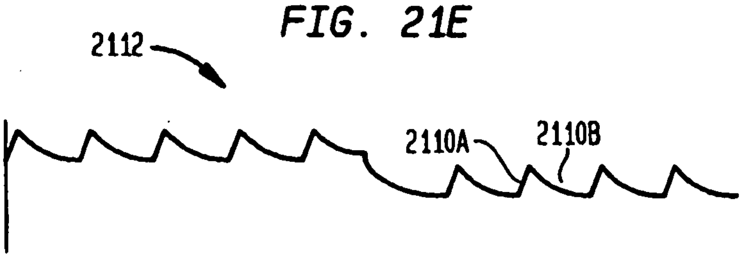


FIG. 21F

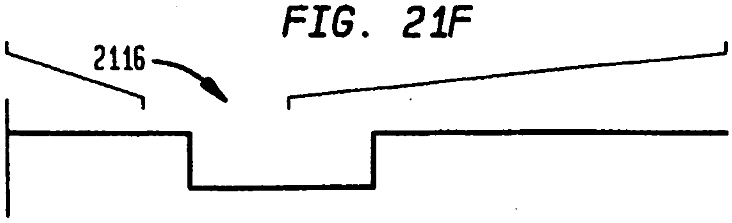

FIG. 22A

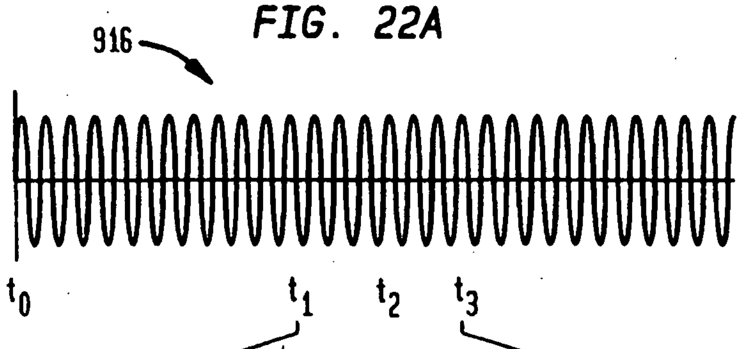


FIG. 22B

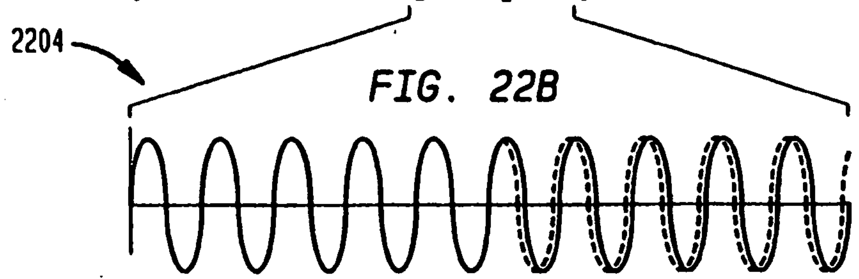


FIG. 22D

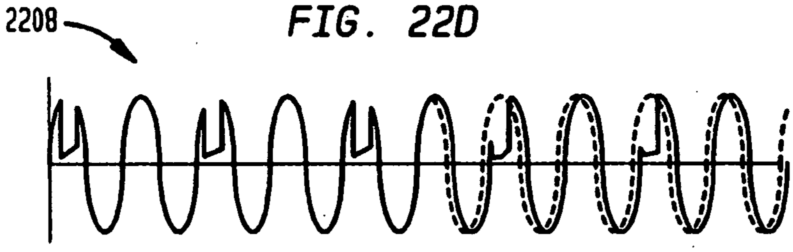


FIG. 22C

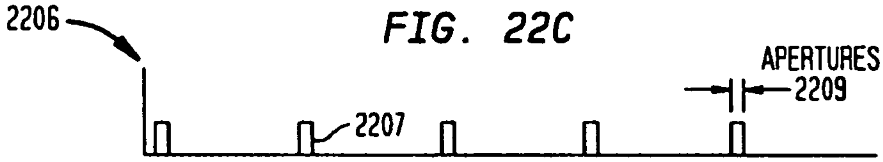


FIG. 22E

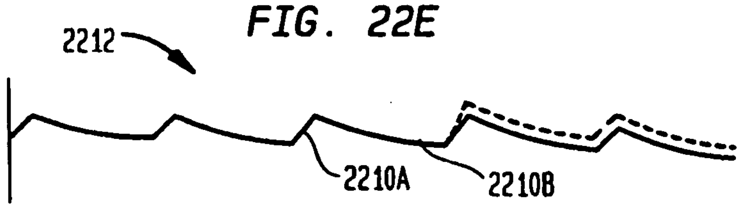


FIG. 22F

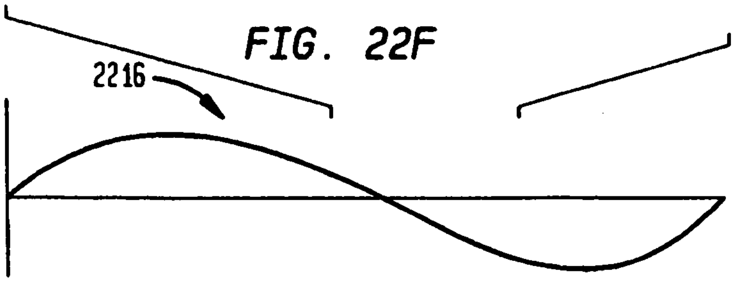

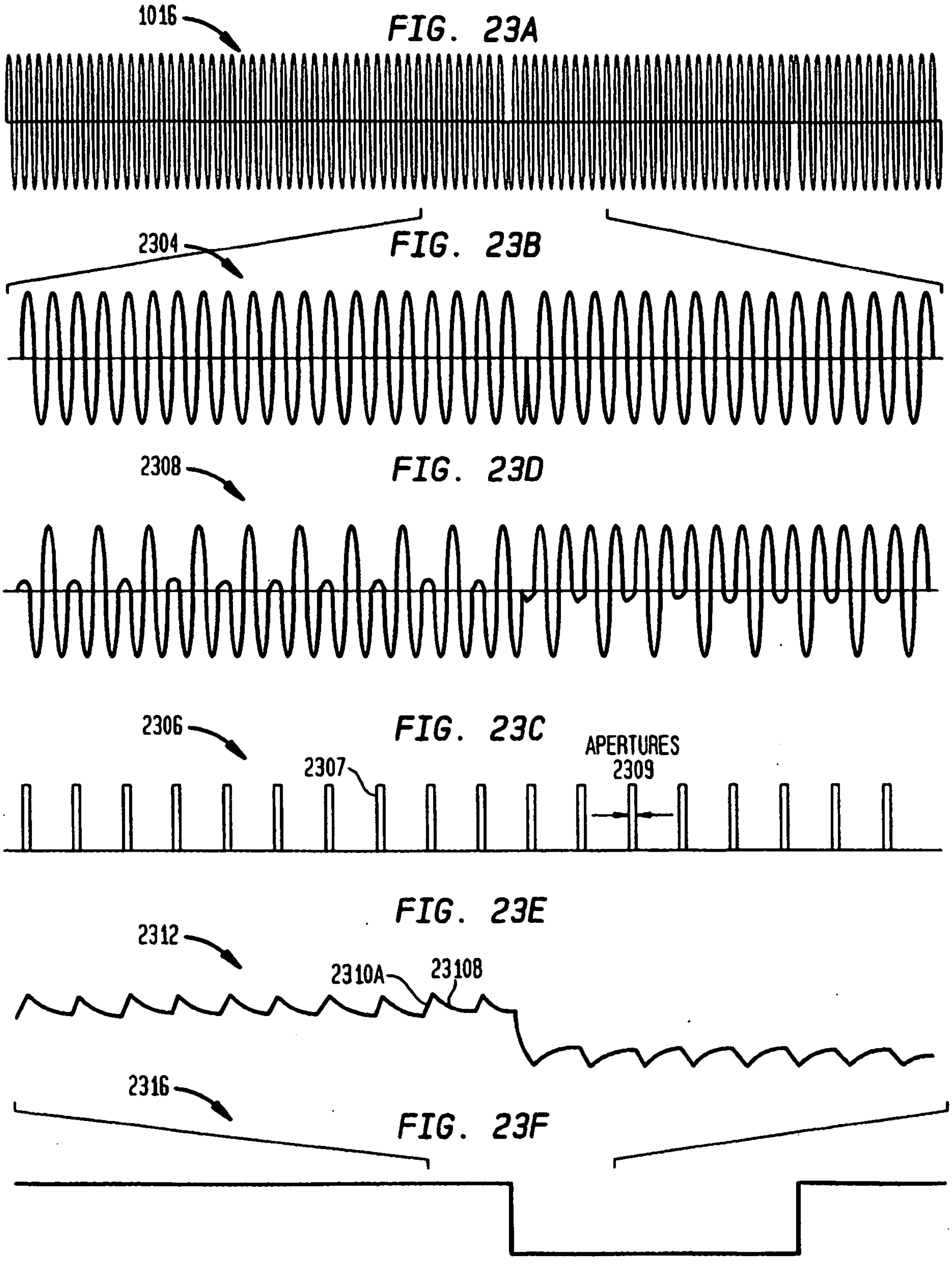
1016
FIG. 23A
2304
FIG. 23B
2308
FIG. 23D
2306
FIG. 23C
2307
APERTURES
2309
FIG. 23E
2312
2310A
2310B
2316
FIG. 23F

FIG. 24

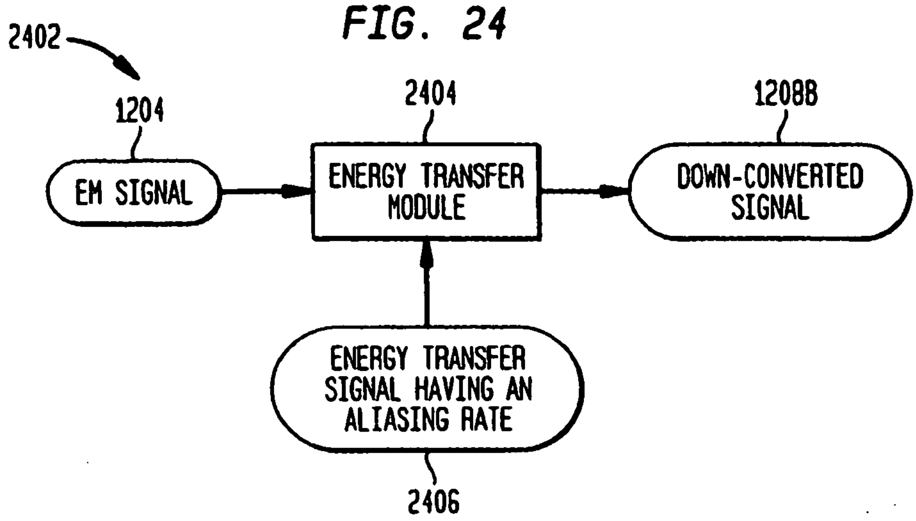


FIG. 25A

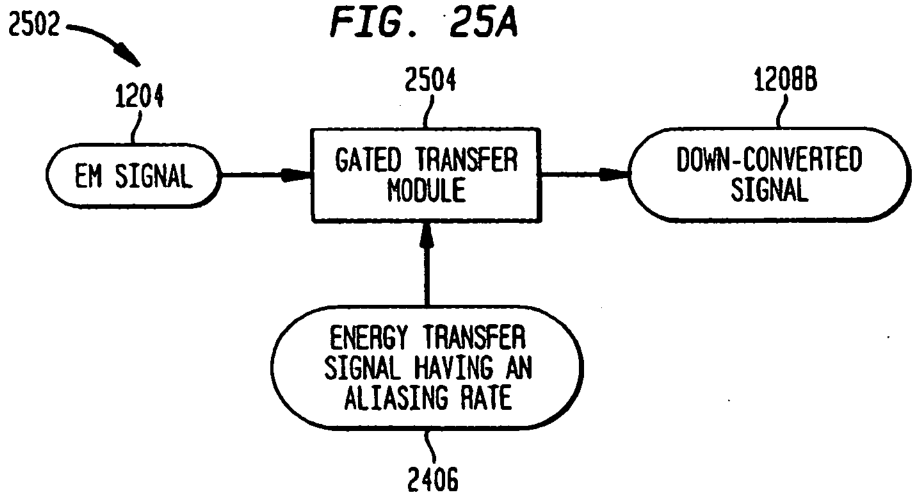


FIG. 25B

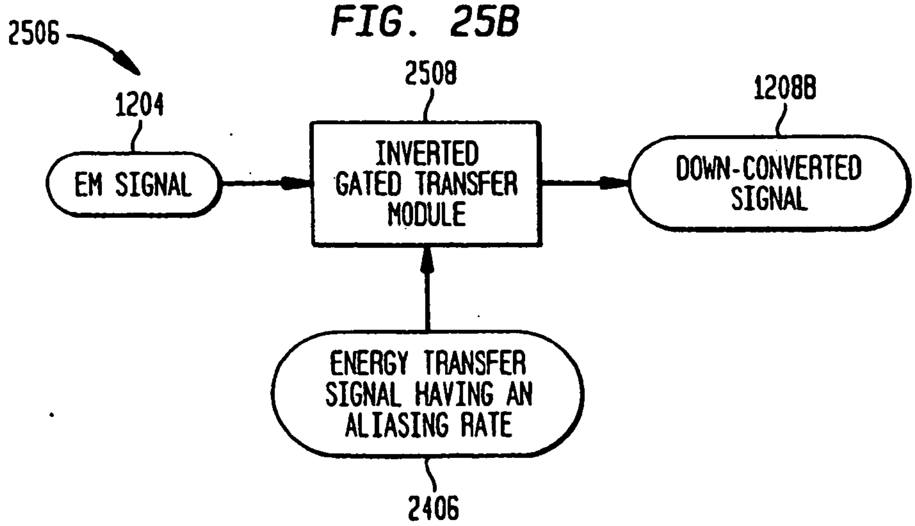

FIG. 26

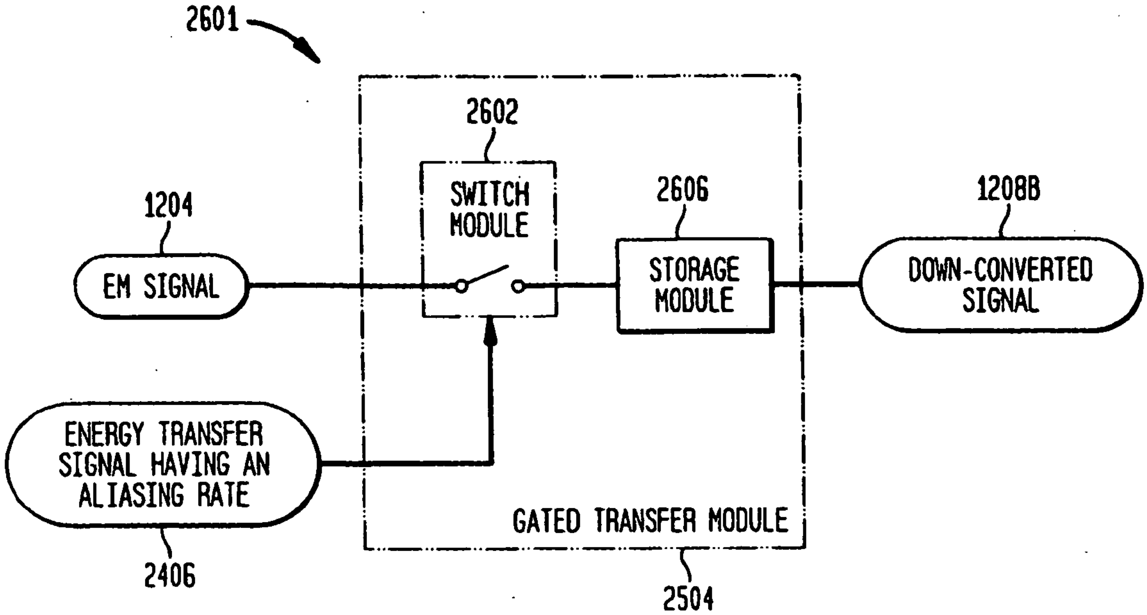


FIG. 27A

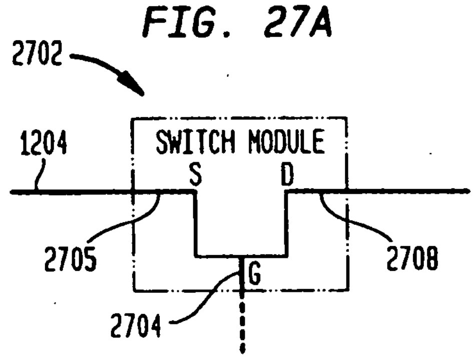


FIG. 27B

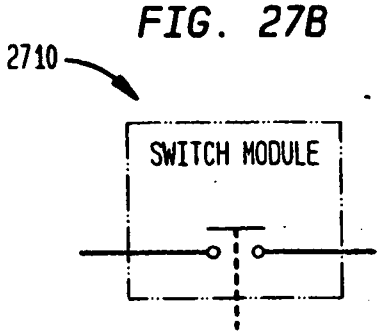

FIG. 27C

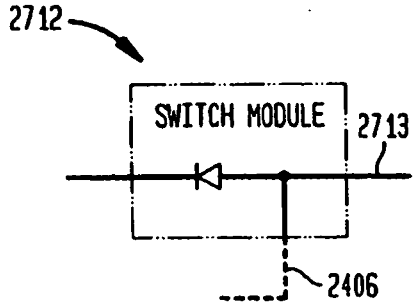


FIG. 27D

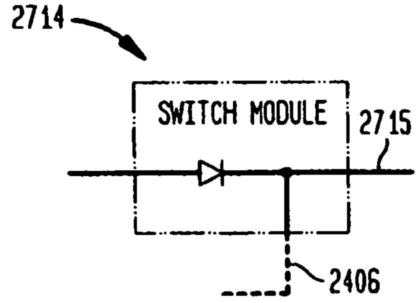

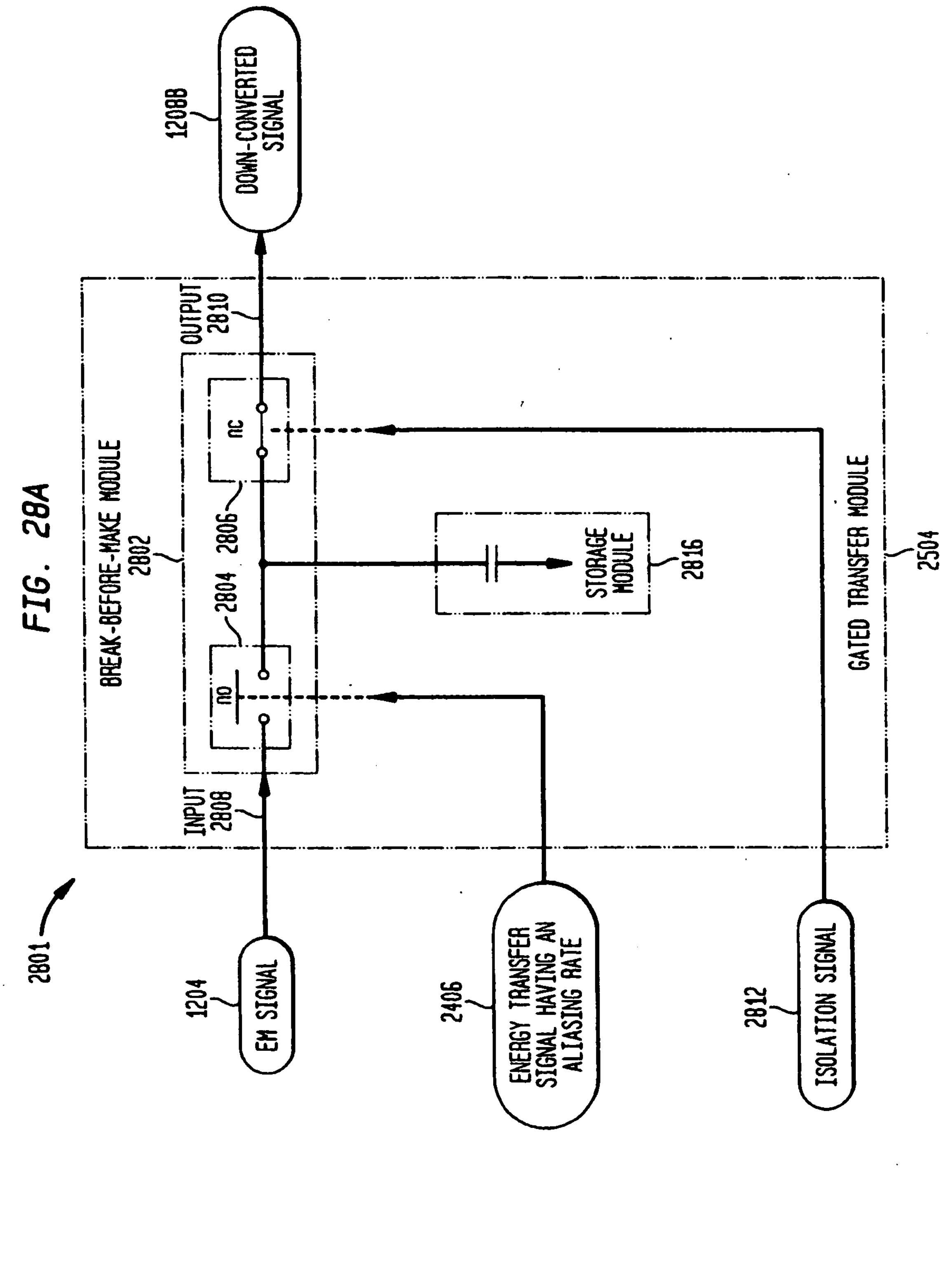
2801
BREAK-BEFORE-MAKE MODULE
2802
INPUT
2808
no
2804
2806
nc
OUTPUT
2810
STORAGE MODULE
2816
GATED TRANSFER MODULE
2504
1208B
DOWN-CONVERTED SIGNAL
1204
EM SIGNAL
2406
ENERGY TRANSFER SIGNAL HAVING AN ALIASING RATE
2812
ISOLATION SIGNAL

FIG. 28A

FIG. 28B

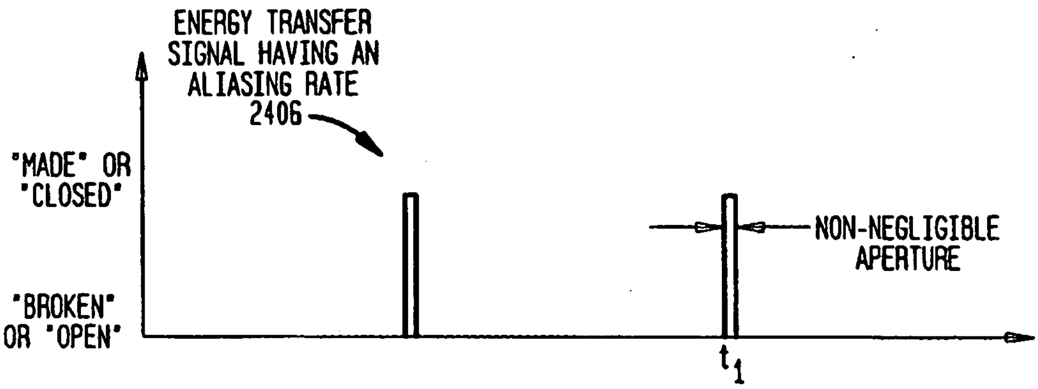


FIG. 28C

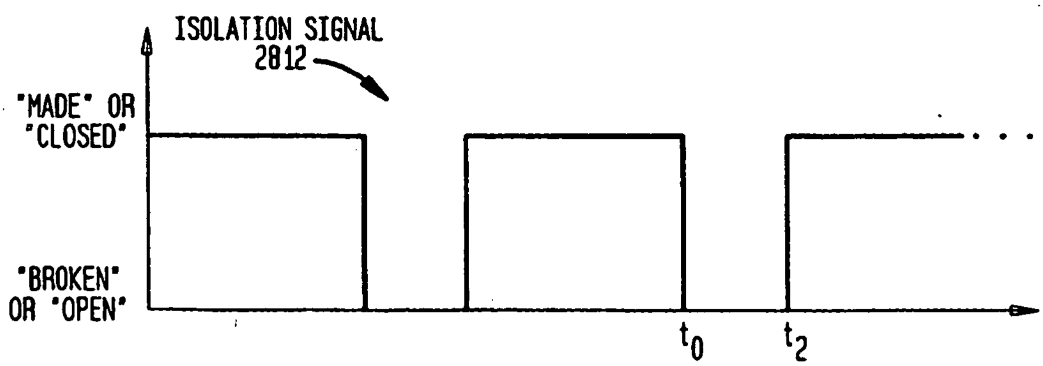

FIG. 29A

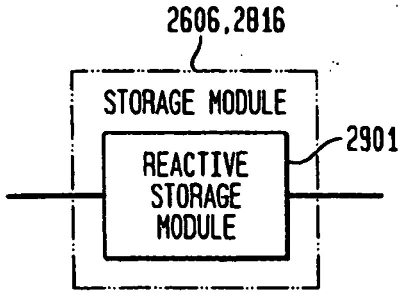


FIG. 29B

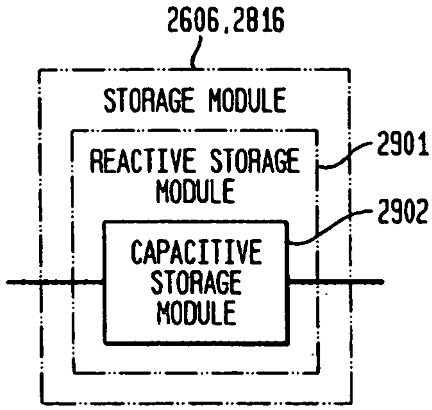


FIG. 29C

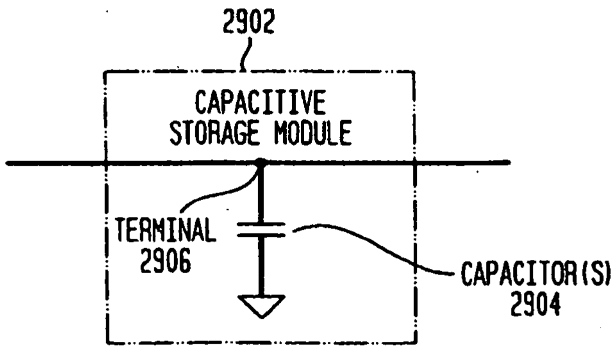

FIG. 29D

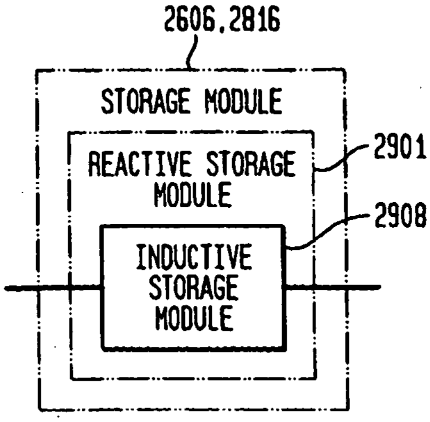


FIG. 29E

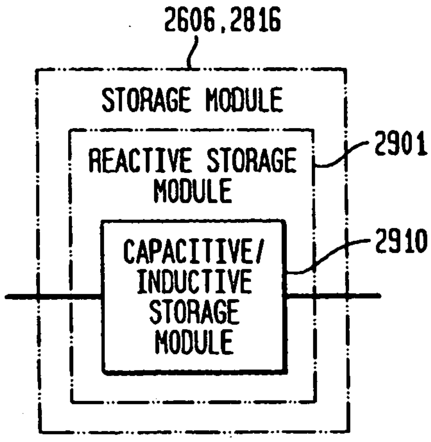


FIG. 29F

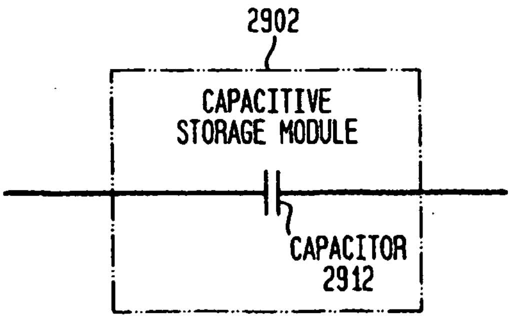

FIG. 29G

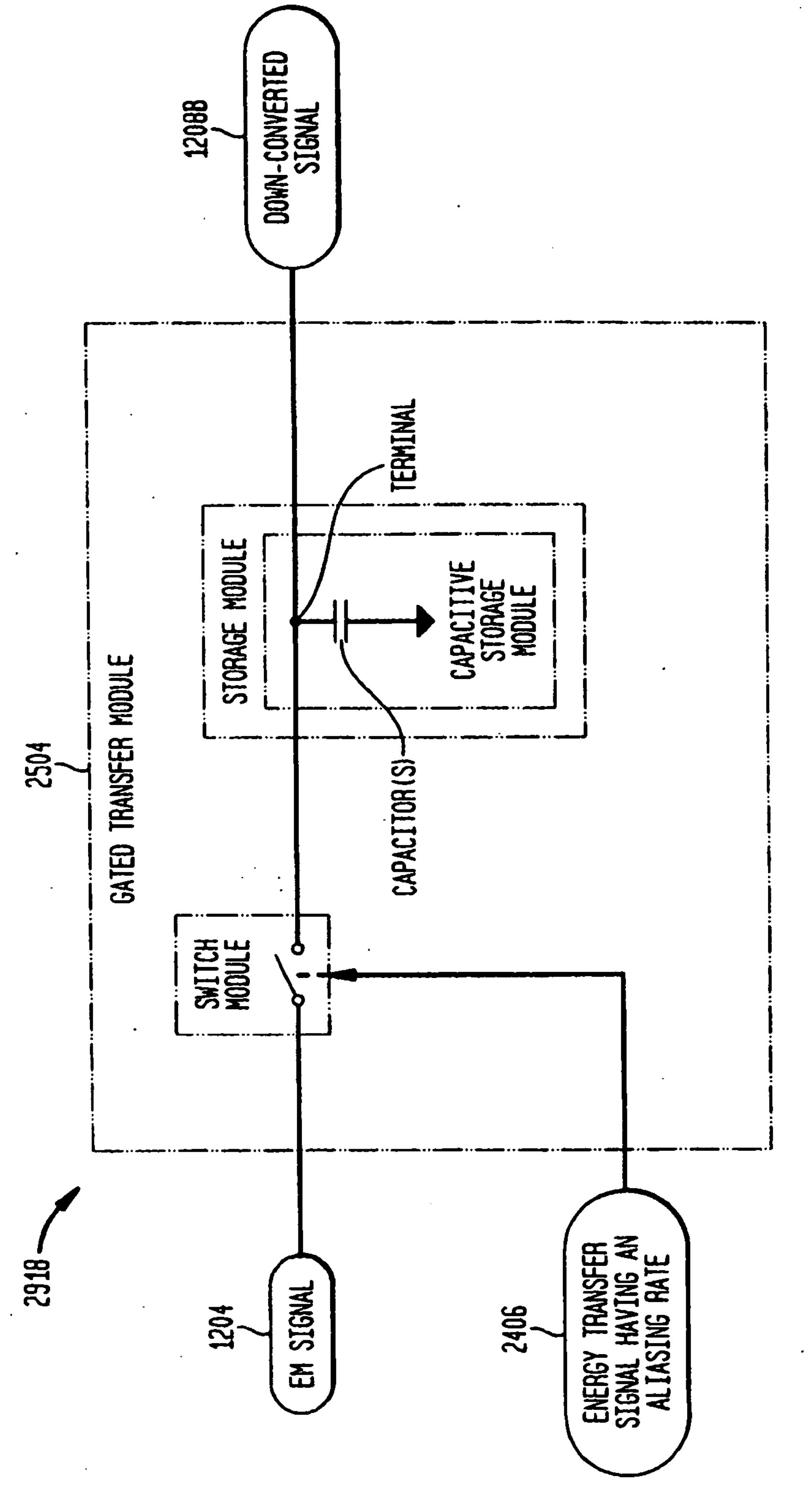

2918
1204
EM SIGNAL
2406
ENERGY TRANSFER SIGNAL HAVING AN ALIASING RATE
2504
GATED TRANSFER MODULE
SWITCH MODULE
STORAGE MODULE
CAPACITIVE STORAGE MODULE
TERMINAL
CAPACITOR(S)
1208B
DOWN-CONVERTED SIGNAL

FIG. 29H

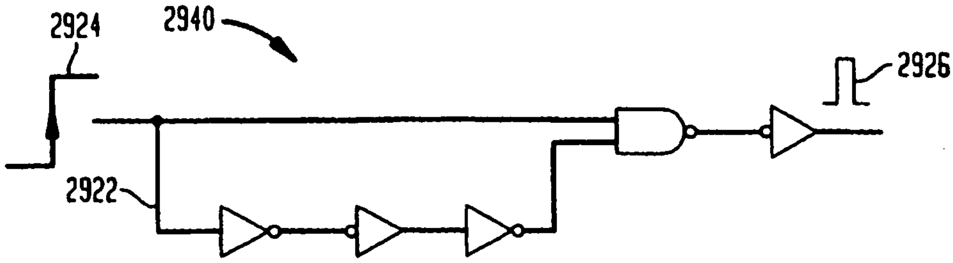


A. RISING EDGE PULSE GENERATOR

FIG. 29I

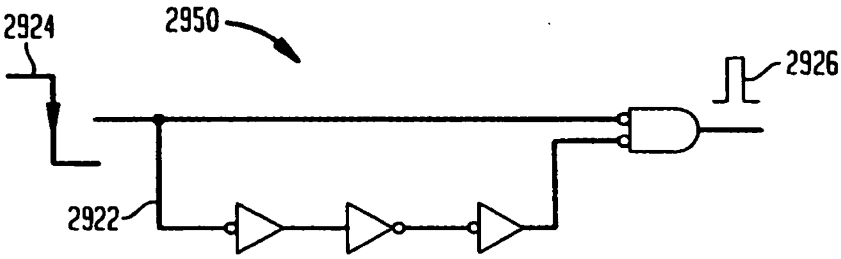


B. FALLING-EDGE PULSE GENERATOR

FIG. 29J

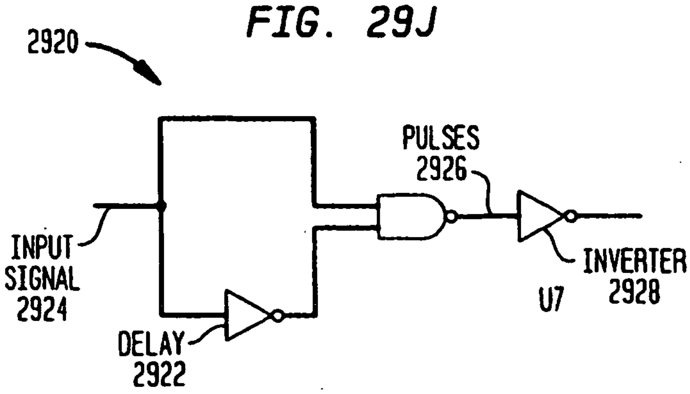

FIG. 29K

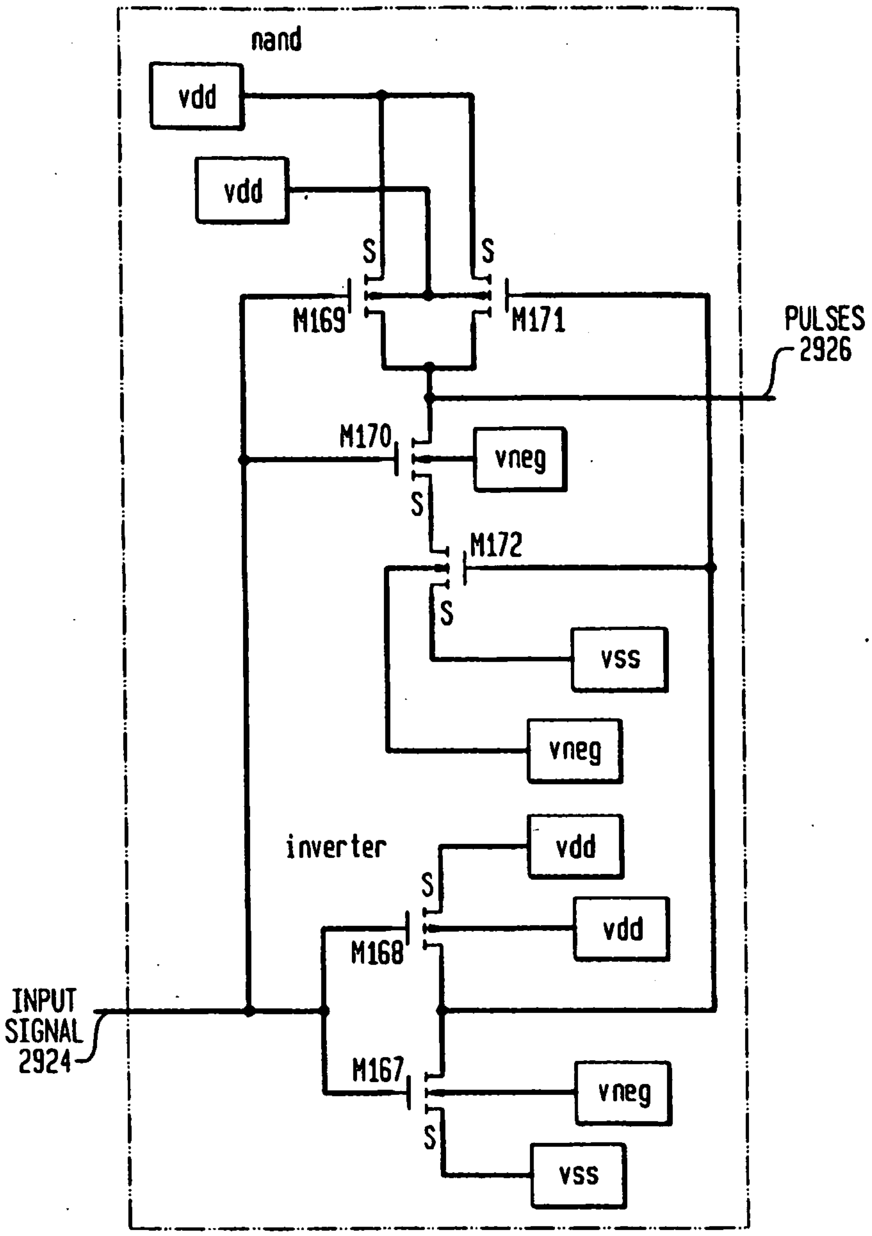


FIG. 29L

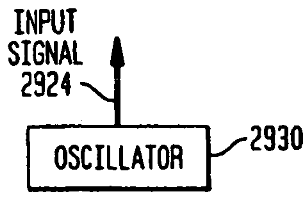

FIG. 30

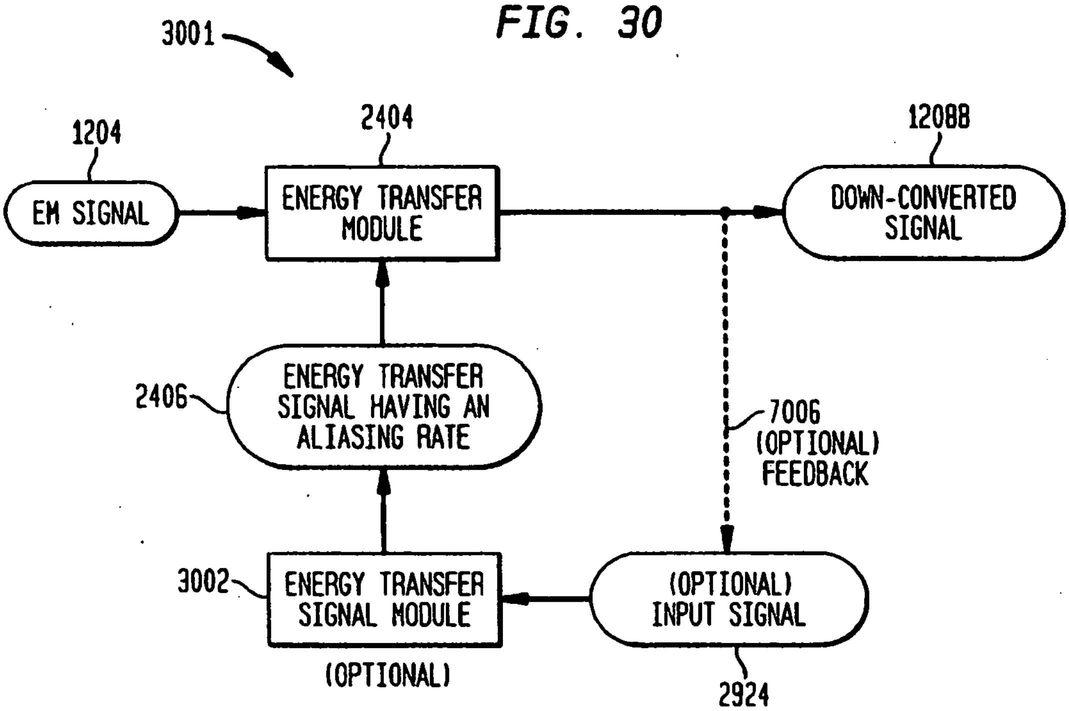
3001
1204
EM SIGNAL
2404
ENERGY TRANSFER MODULE
1208B
DOWN-CONVERTED SIGNAL
2406
ENERGY TRANSFER SIGNAL HAVING AN ALIASING RATE
7006
(OPTIONAL) FEEDBACK
3002
ENERGY TRANSFER SIGNAL MODULE
(OPTIONAL)
(OPTIONAL) INPUT SIGNAL
2924

FIG. 31

IMPEDANCE MATCHED ALIASING MODULE

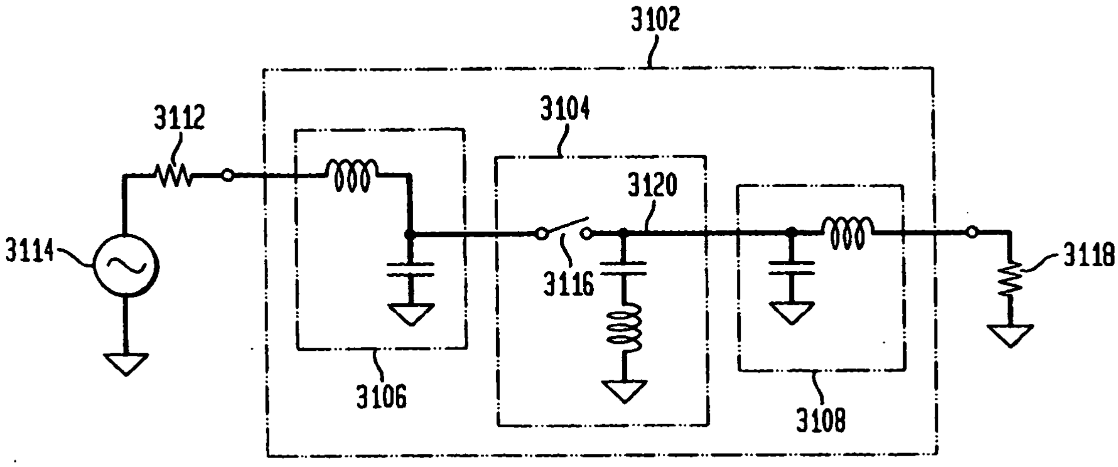


FIG. 32

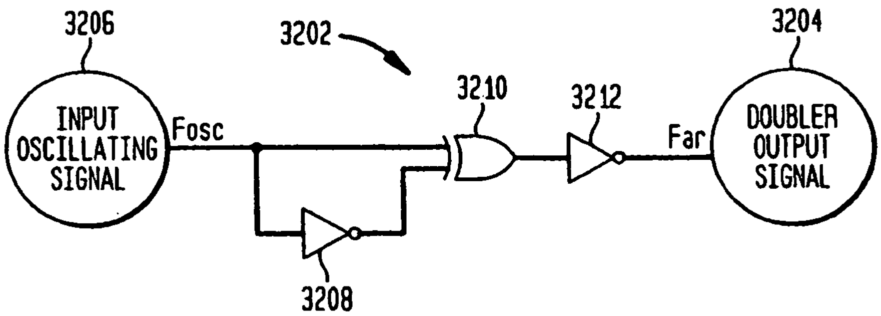

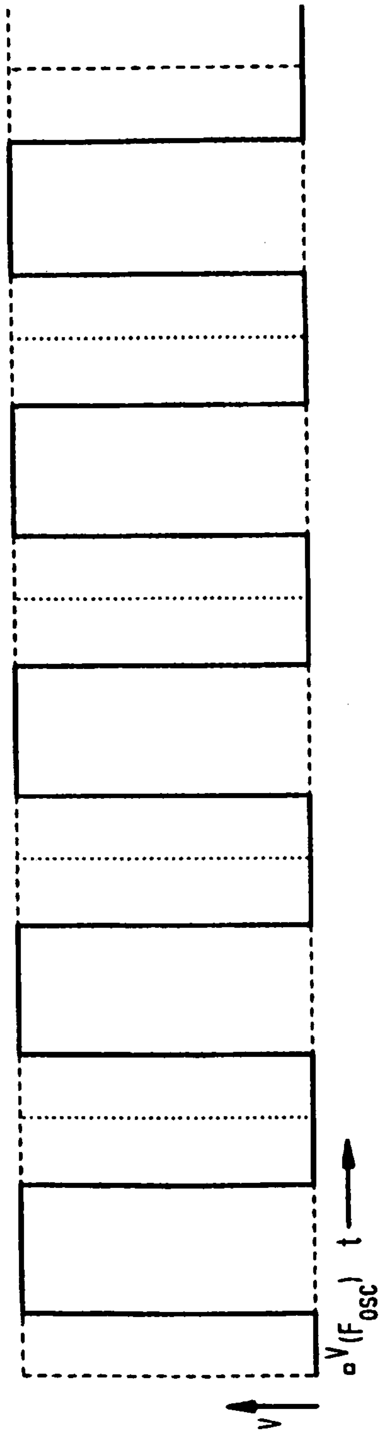


FIG. 33A

3206

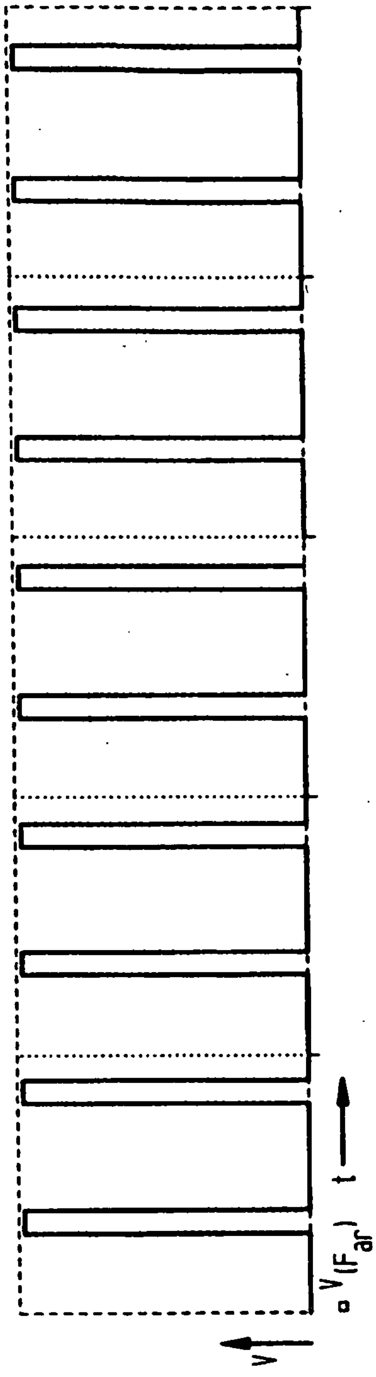


FIG. 33B

3204

FIG. 34

ALIASING MODULE

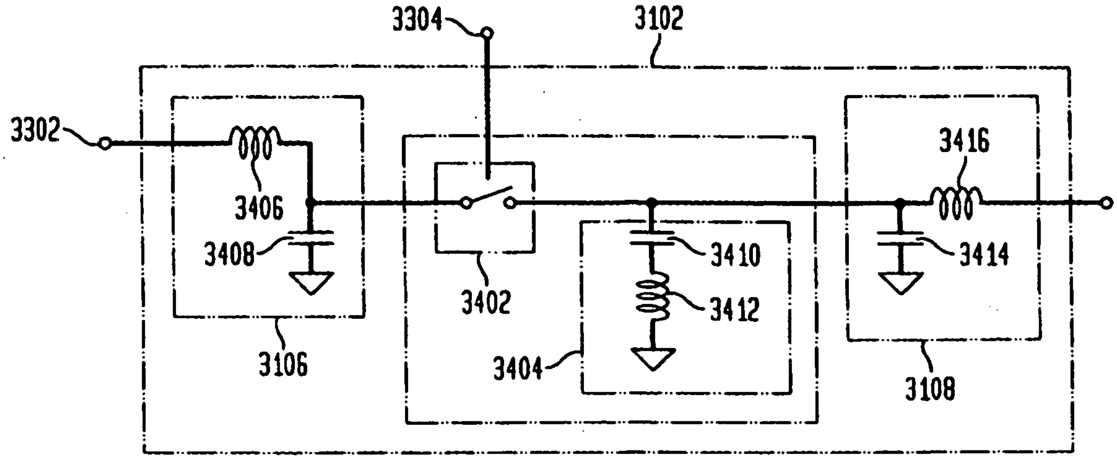


FIG. 35

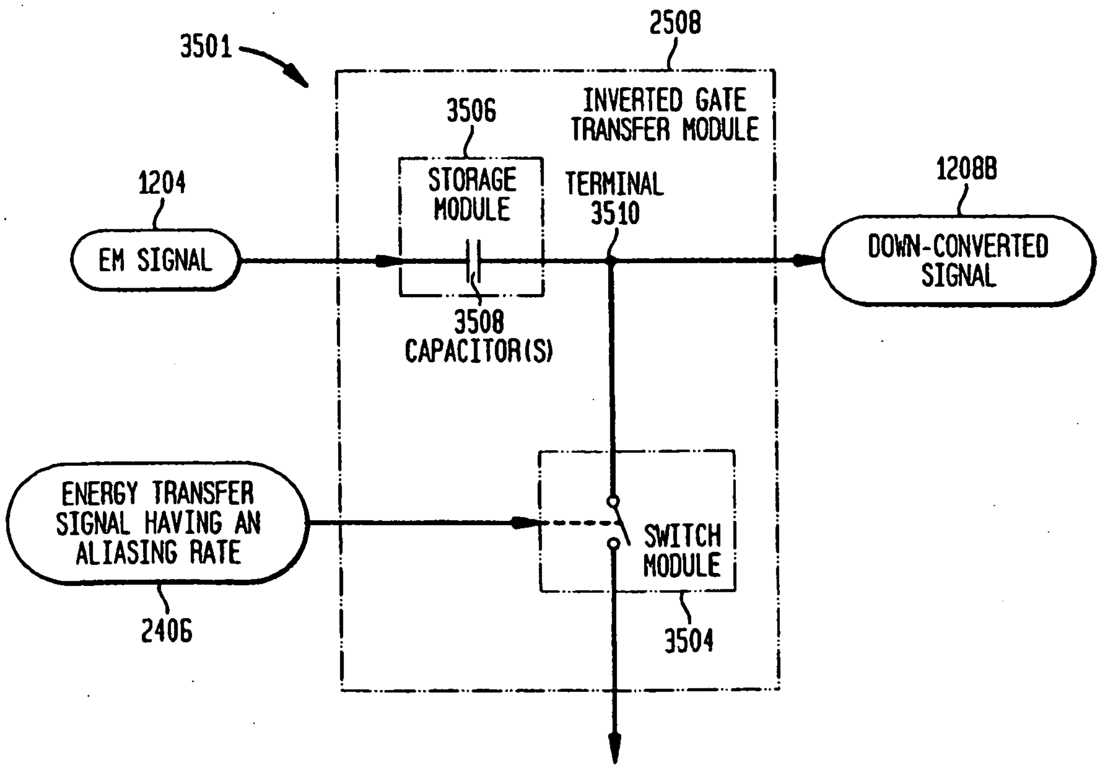

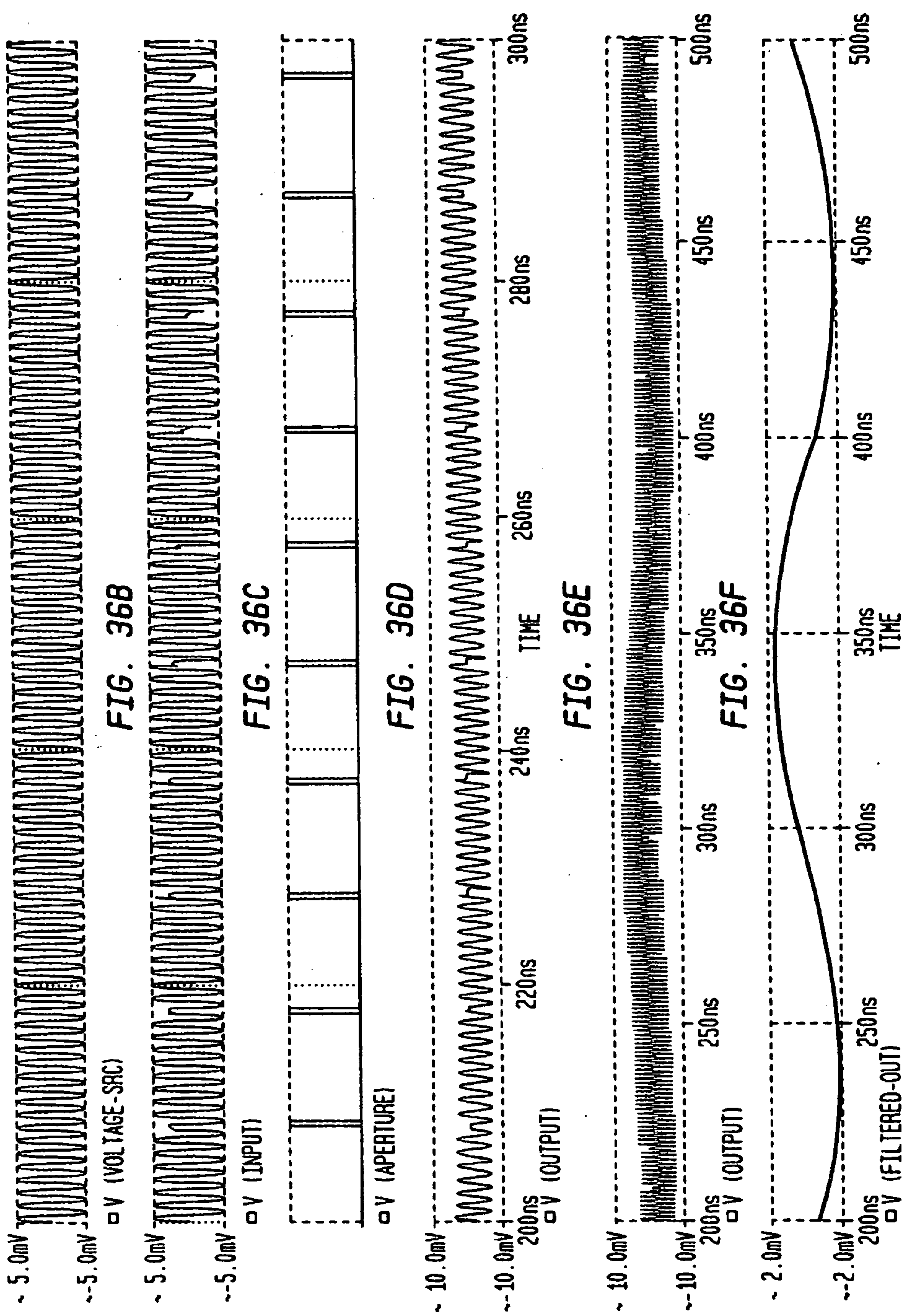
FIG. 36A
5.0mV
-5.0mV
V (VOLTAGE-SRC)
FIG. 36B
5.0mV
-5.0mV
V (INPUT)
FIG. 36C
V (APERTURE)
FIG. 36D
10.0mV
-10.0mV
V (OUTPUT)
200ns
220ns
240ns
260ns
280ns
300ns
TIME
FIG. 36E
10.0mV
-10.0mV
V (OUTPUT)
200ns
250ns
300ns
350ns
400ns
450ns
500ns
FIG. 36F
2.0mV
-2.0mV
V (FILTERED-OUT)
200ns
250ns
300ns
350ns
400ns
450ns
500ns
TIME

FIG. 37A
DIFFERENTIAL ENERGY TRANSFER CONFIGURATION

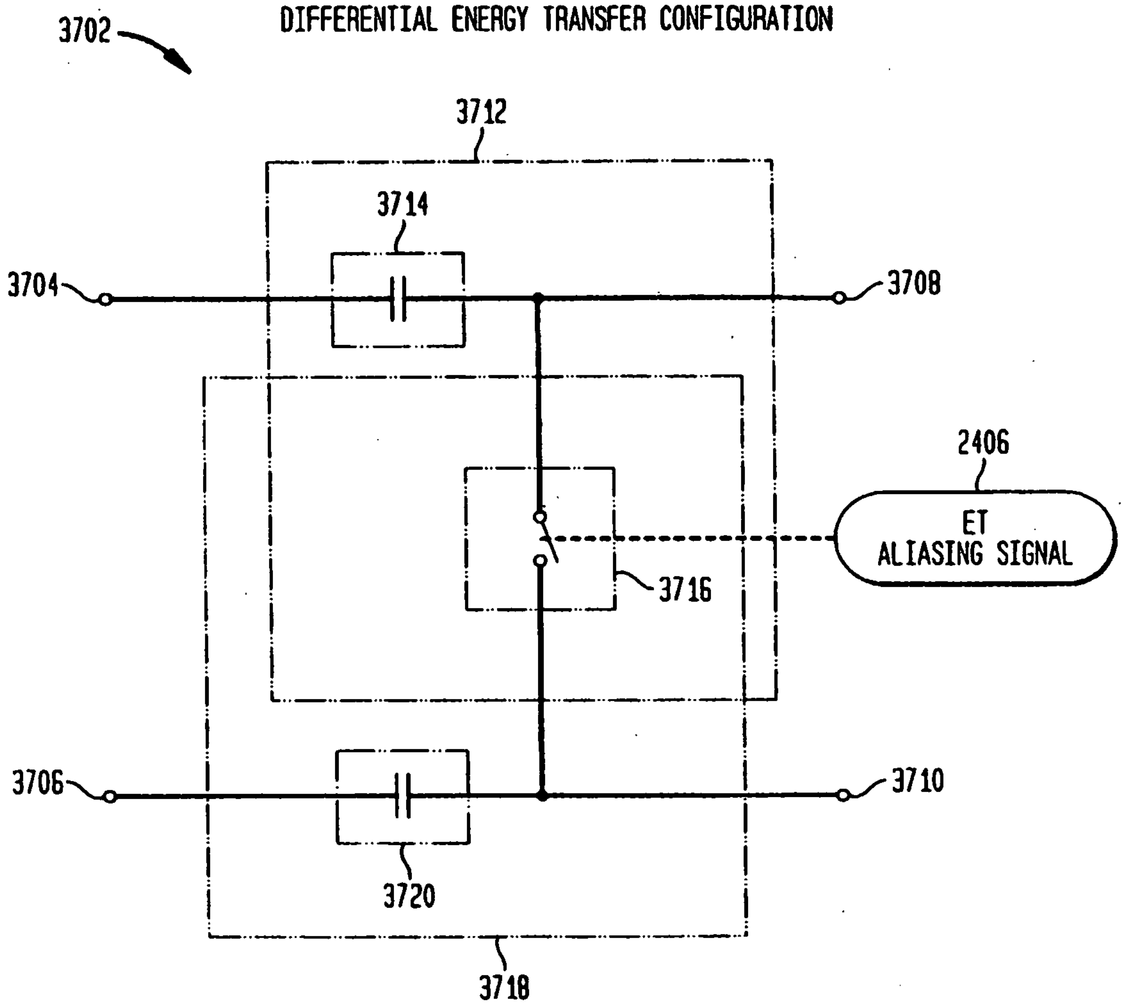

FIG. 37B

DIFFERENTIAL INPUT TO DIFFERENTIAL OUTPUT

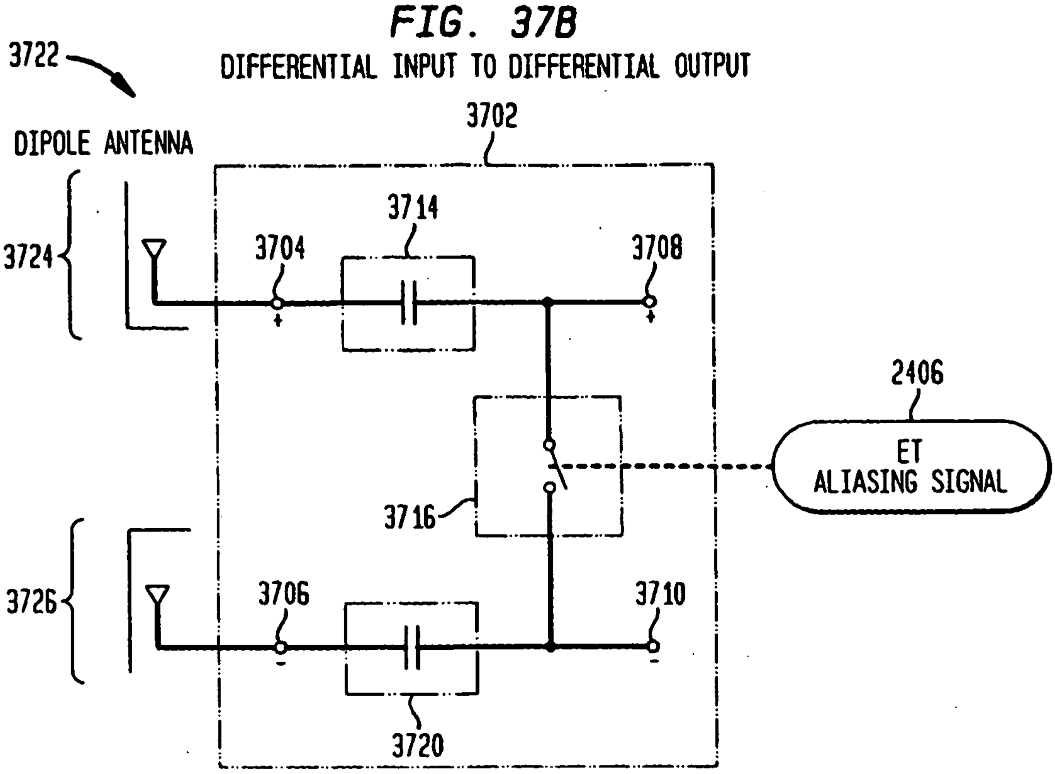


FIG. 37C

SINGLE INPUT TO DIFFERENTIAL OUTPUT

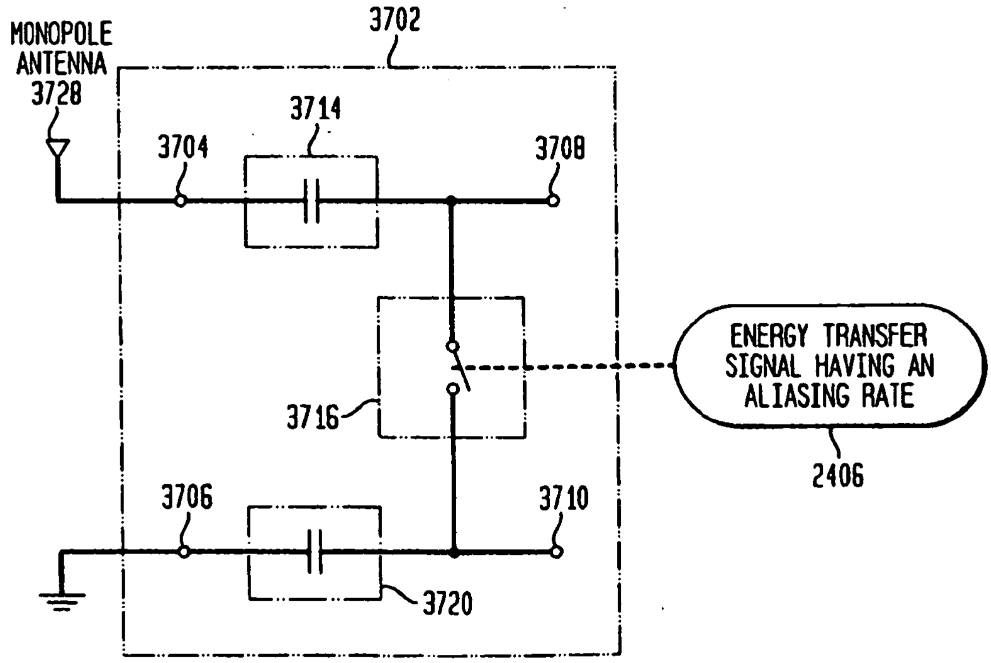

FIG. 37D
DIFFERENTIAL INPUT TO SINGLE OUTPUT

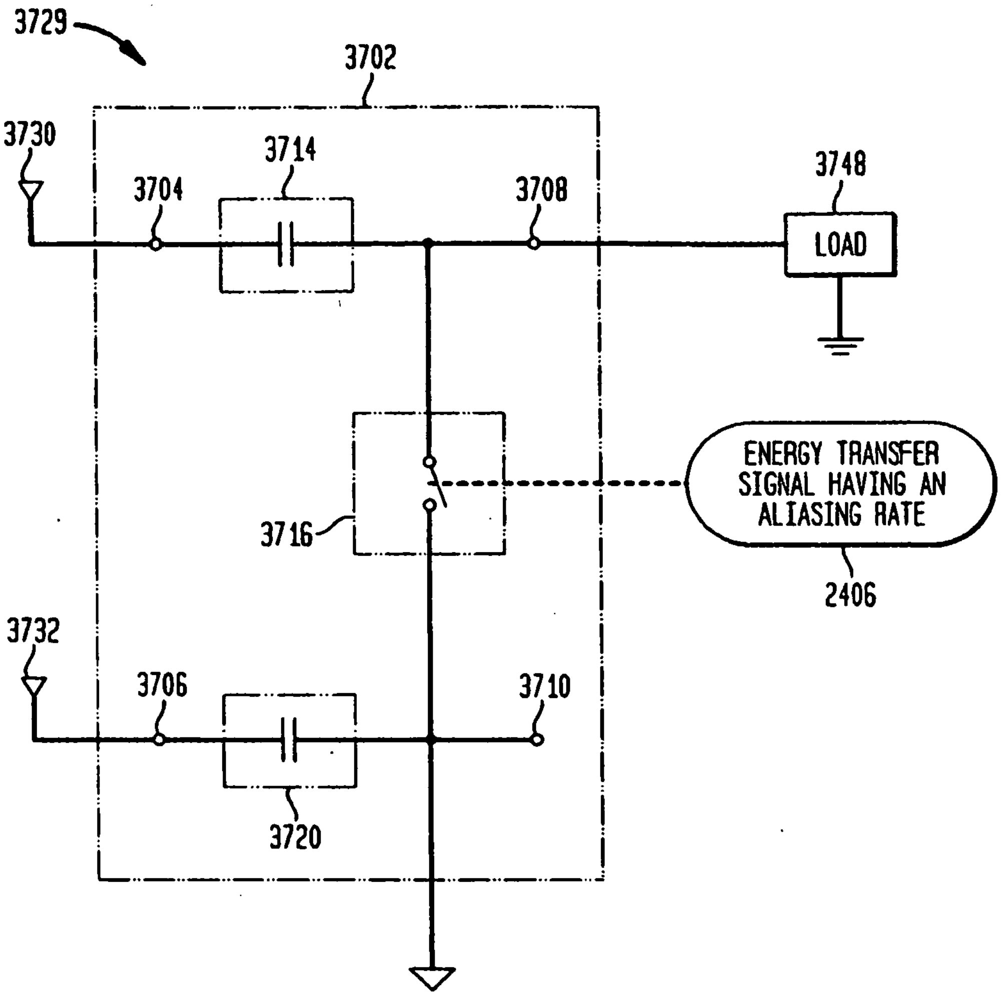

FIG. 37E
EXAMPLE INPUT/OUTPUT CIRCUITRY

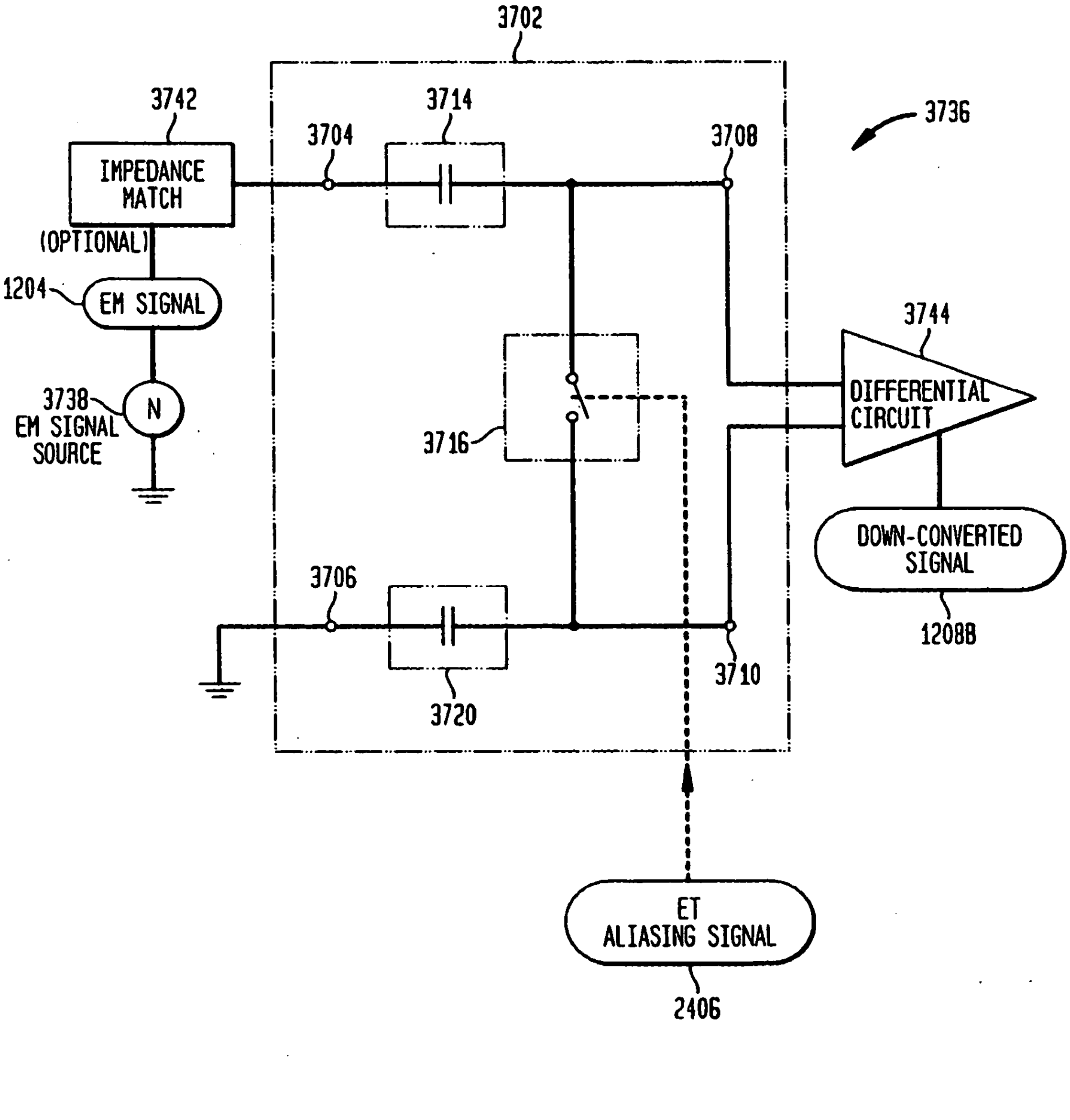

FIG. 38A

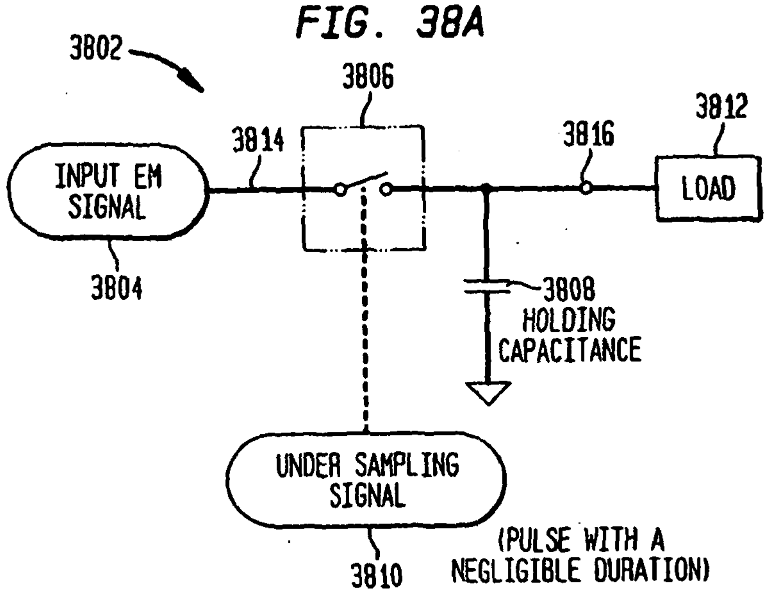


FIG. 38B

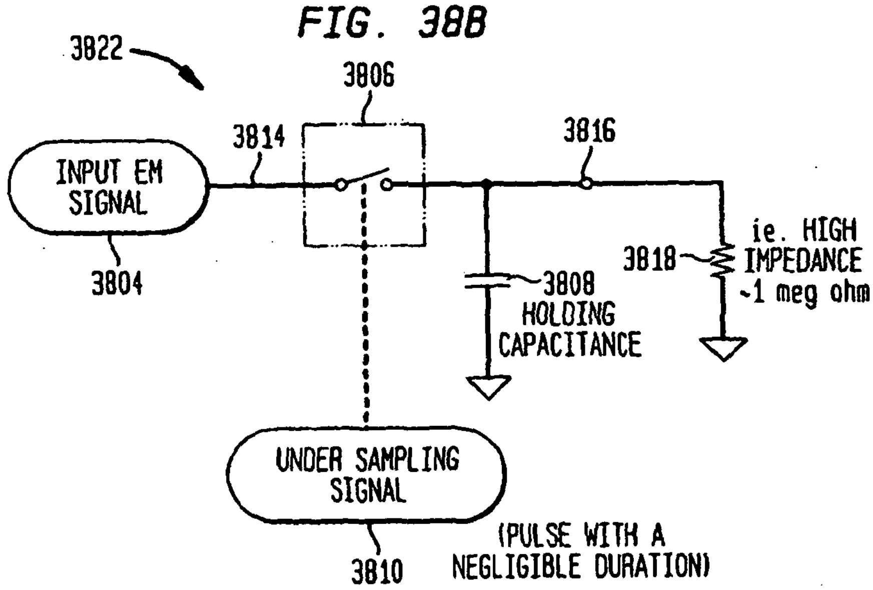

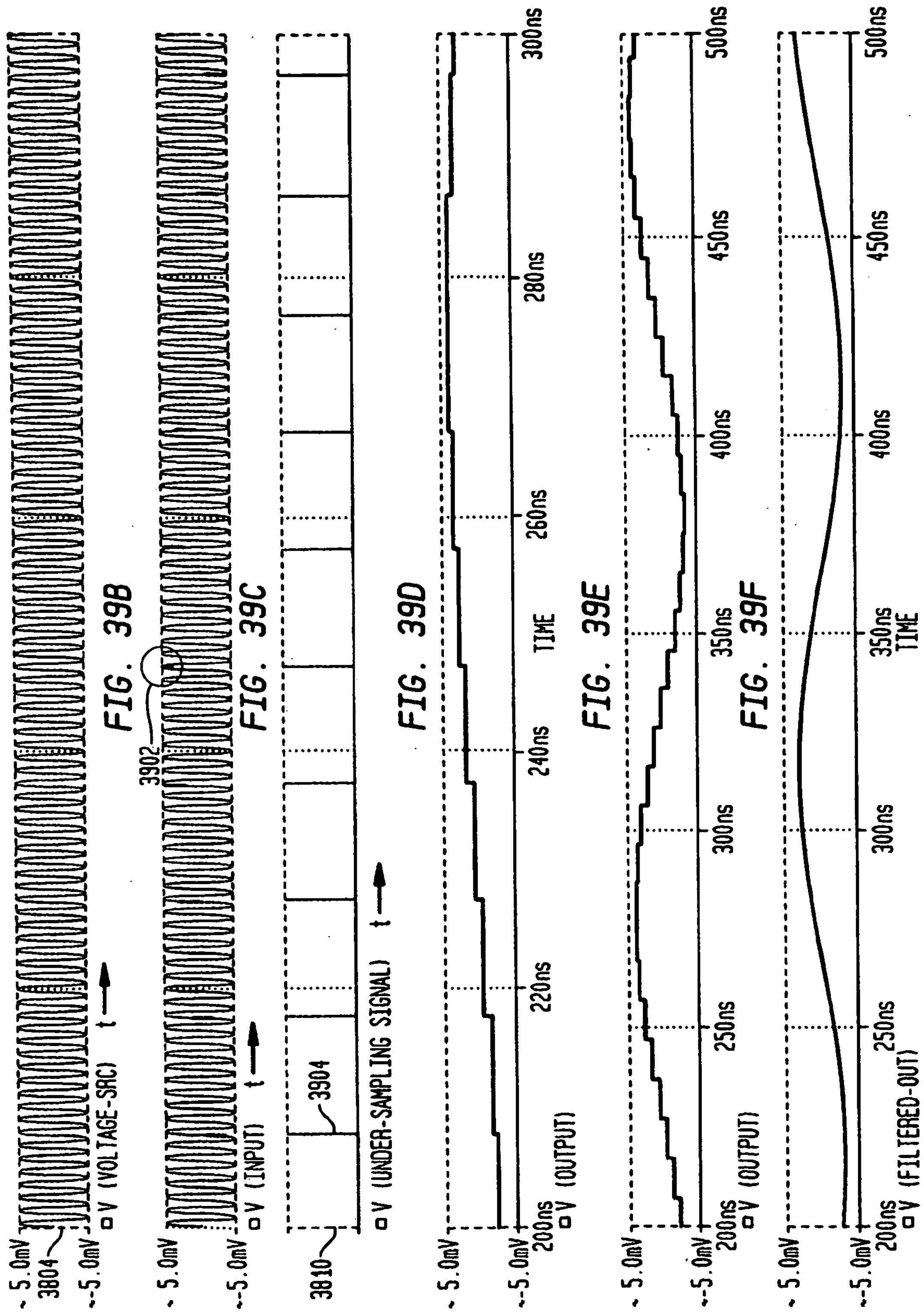


FIG. 39A

FIG. 39B

FIG. 39C

FIG. 39D

FIG. 39E

FIG. 39F

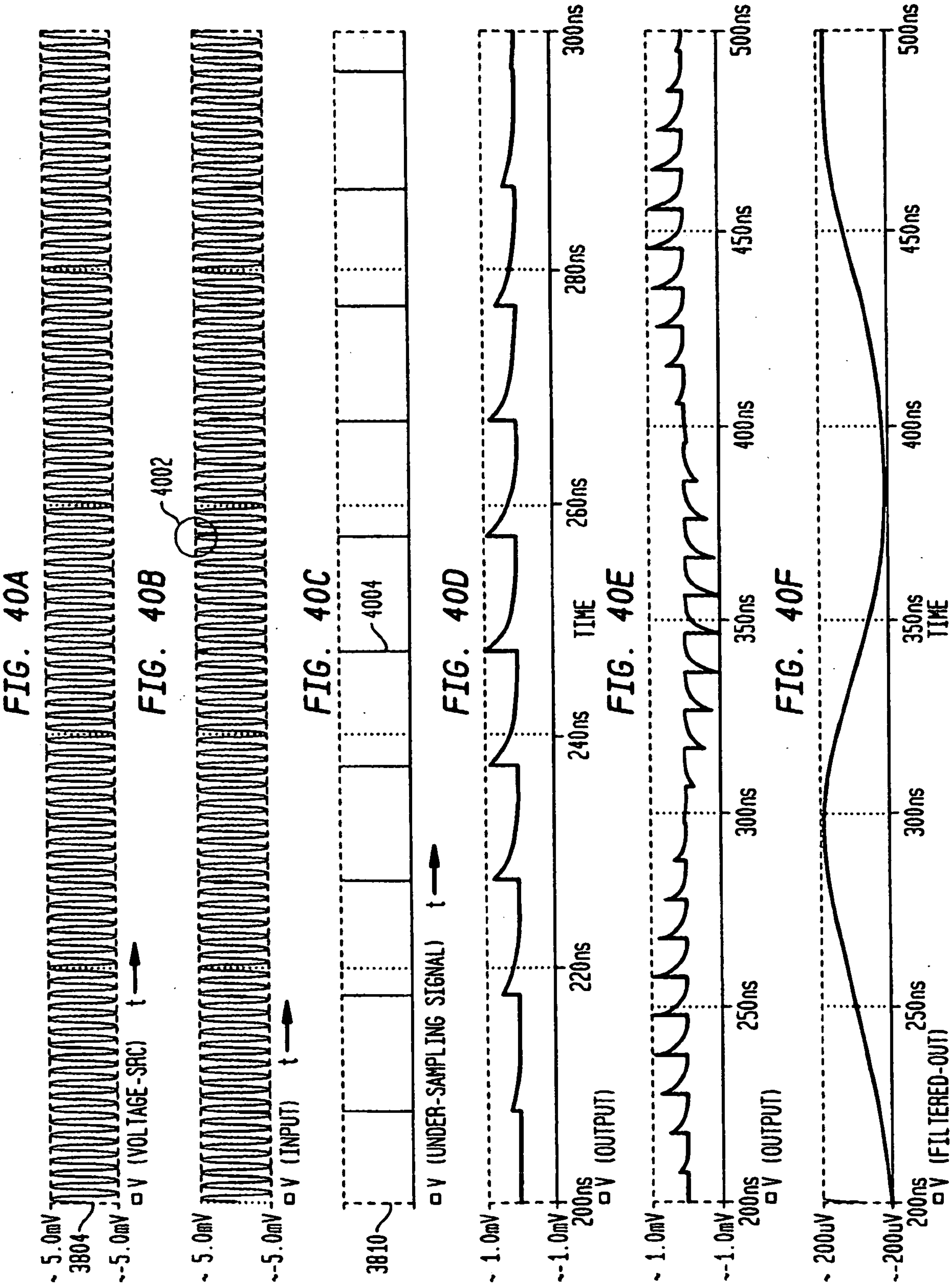
FIG. 40A
5.0mV
-5.0mV
3804
V (VOLTAGE-SRC)
FIG. 40B
5.0mV
-5.0mV
V (INPUT)
4002
FIG. 40C
3810
4004
V (UNDER-SAMPLING SIGNAL)
FIG. 40D
1.0mV
-1.0mV
V (OUTPUT)
200ns
220ns
240ns
260ns
280ns
300ns
TIME
FIG. 40E
1.0mV
-1.0mV
V (OUTPUT)
200ns
250ns
300ns
350ns
400ns
450ns
500ns
FIG. 40F
200uV
-200uV
V (FILTERED-OUT)
200ns
250ns
300ns
350ns
400ns
450ns
500ns
TIME

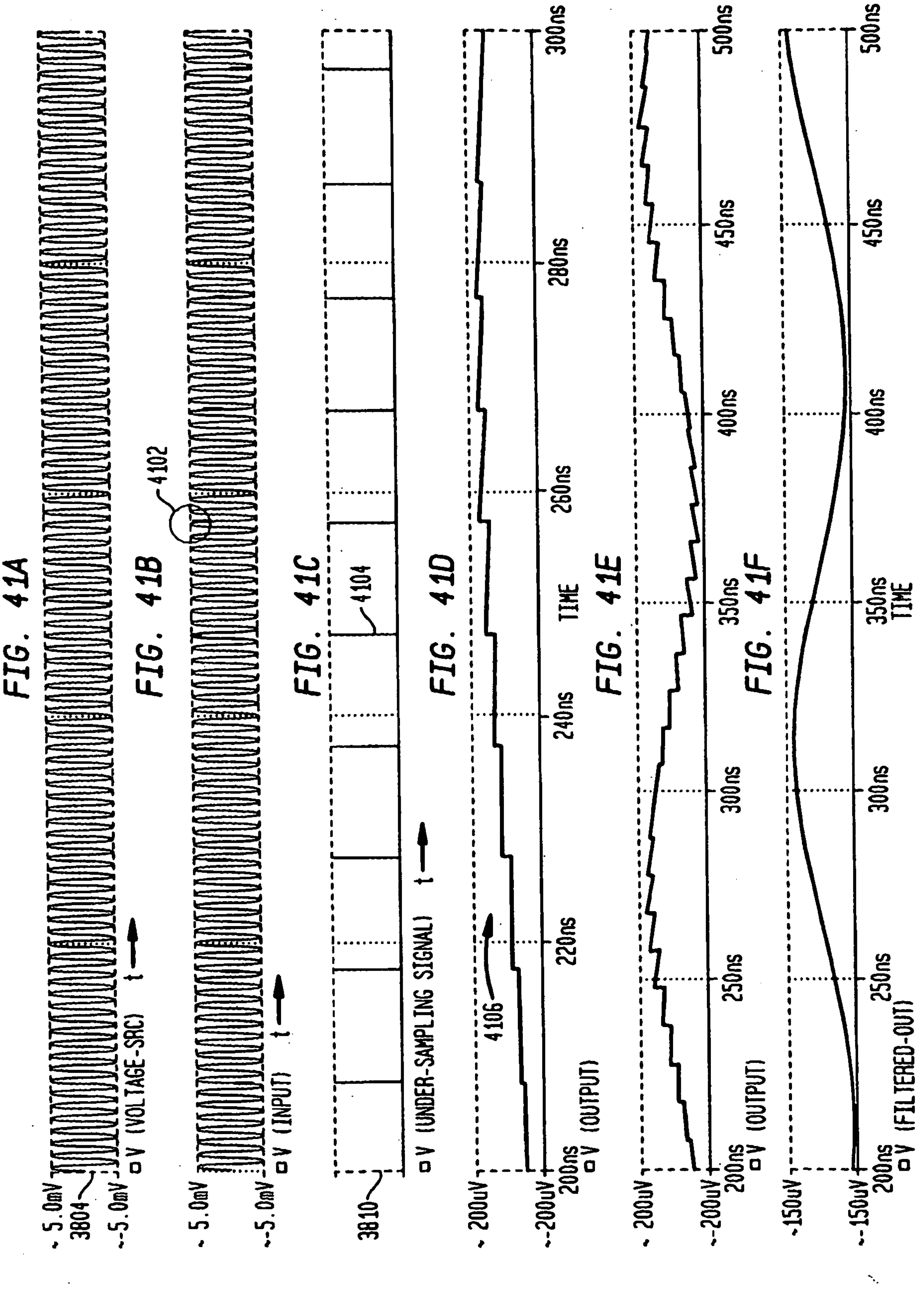
FIG. 41A
FIG. 41B
FIG. 41C
FIG. 41D
FIG. 41E
FIG. 41F
5.0mV
-5.0mV
3804
V (VOLTAGE-SRC)
V (INPUT)
4102
3810
4104
V (UNDER-SAMPLING SIGNAL)
200uV
-200uV
4106
V (OUTPUT)
-150uV
V (FILTERED-OUT)
200ns
220ns
240ns
260ns
280ns
300ns
250ns
350ns
400ns
450ns
500ns
TIME

FIG. 42A

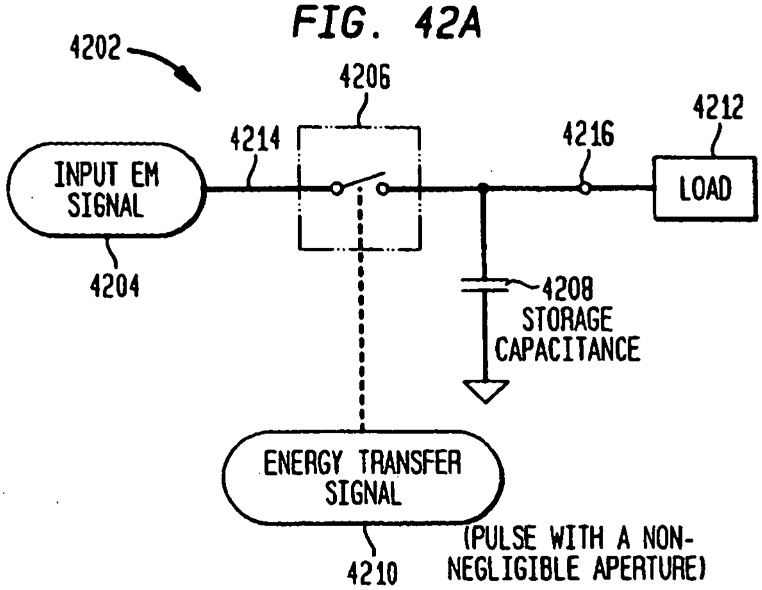


FIG. 42B

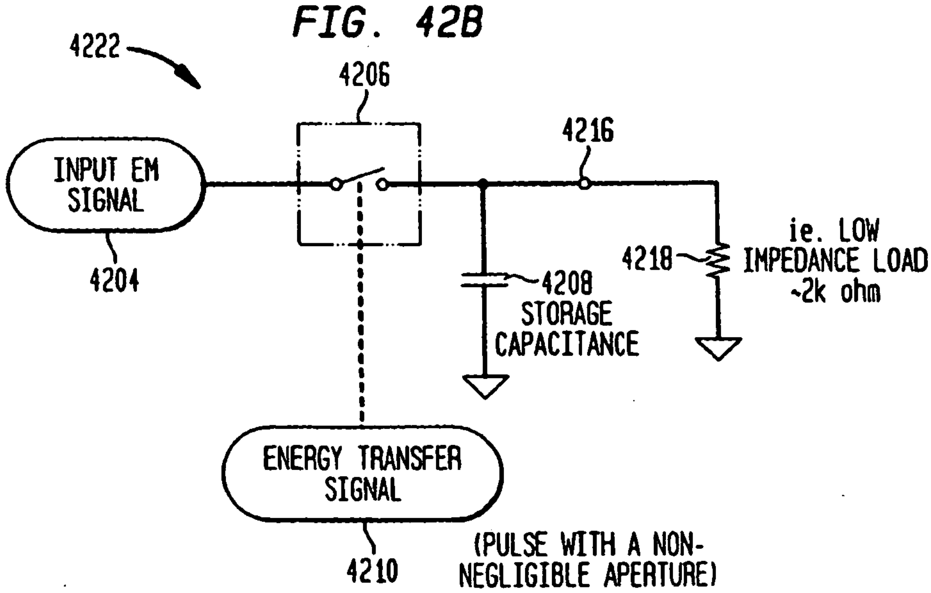

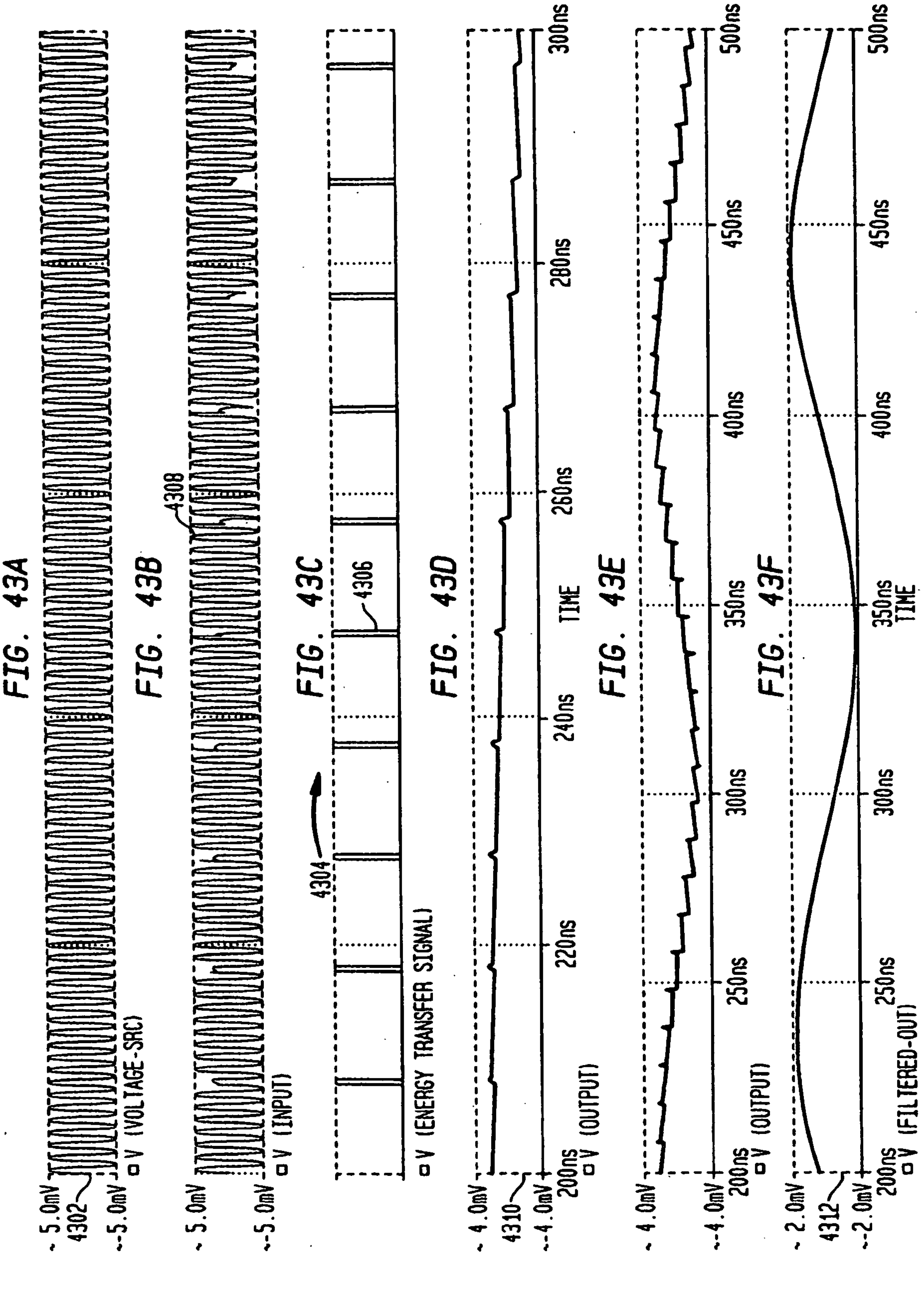
FIG. 43A
5.0mV
4302
-5.0mV
V (VOLTAGE-SRC)
FIG. 43B
4308
5.0mV
-5.0mV
V (INPUT)
FIG. 43C
4304
4306
V (ENERGY TRANSFER SIGNAL)
FIG. 43D
4.0mV
4310
-4.0mV
200ns
220ns
240ns
260ns
280ns
300ns
TIME
V (OUTPUT)
FIG. 43E
4.0mV
-4.0mV
200ns
250ns
300ns
350ns
400ns
450ns
500ns
V (OUTPUT)
FIG. 43F
2.0mV
4312
-2.0mV
200ns
250ns
300ns
350ns
400ns
450ns
500ns
TIME
V (FILTERED-OUT)

FIG. 44A

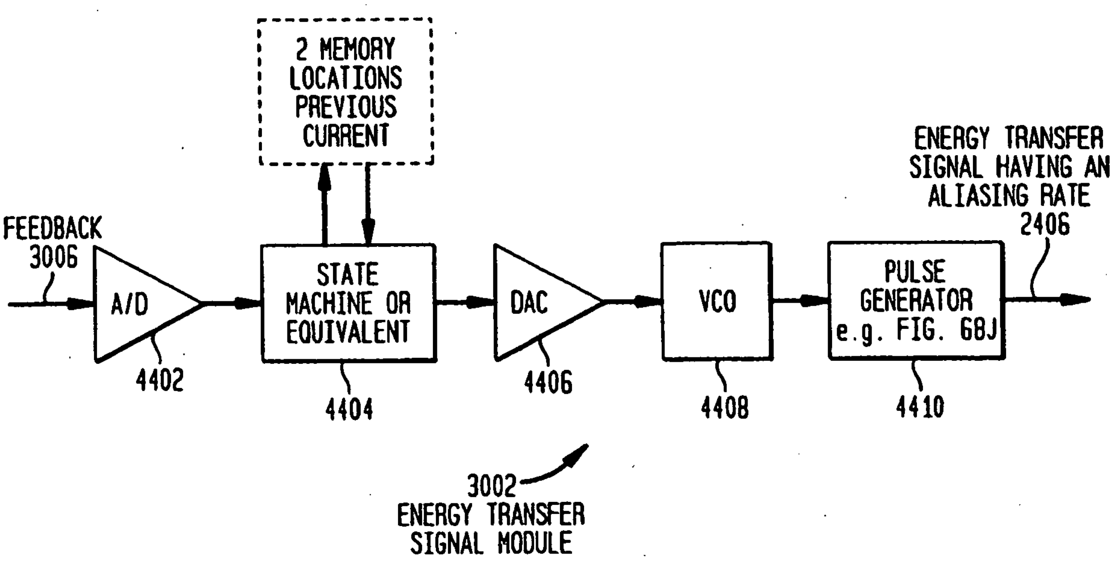
2 MEMORY
LOCATIONS
PREVIOUS
CURRENT
FEEDBACK
3006
A/D
4402
STATE
MACHINE OR
EQUIVALENT
4404
DAC
4406
VCO
4408
PULSE
GENERATOR
e.g. FIG. 68J
4410
ENERGY TRANSFER
SIGNAL HAVING AN
ALIASING RATE
2406
3002
ENERGY TRANSFER
SIGNAL MODULE

FIG. 44B

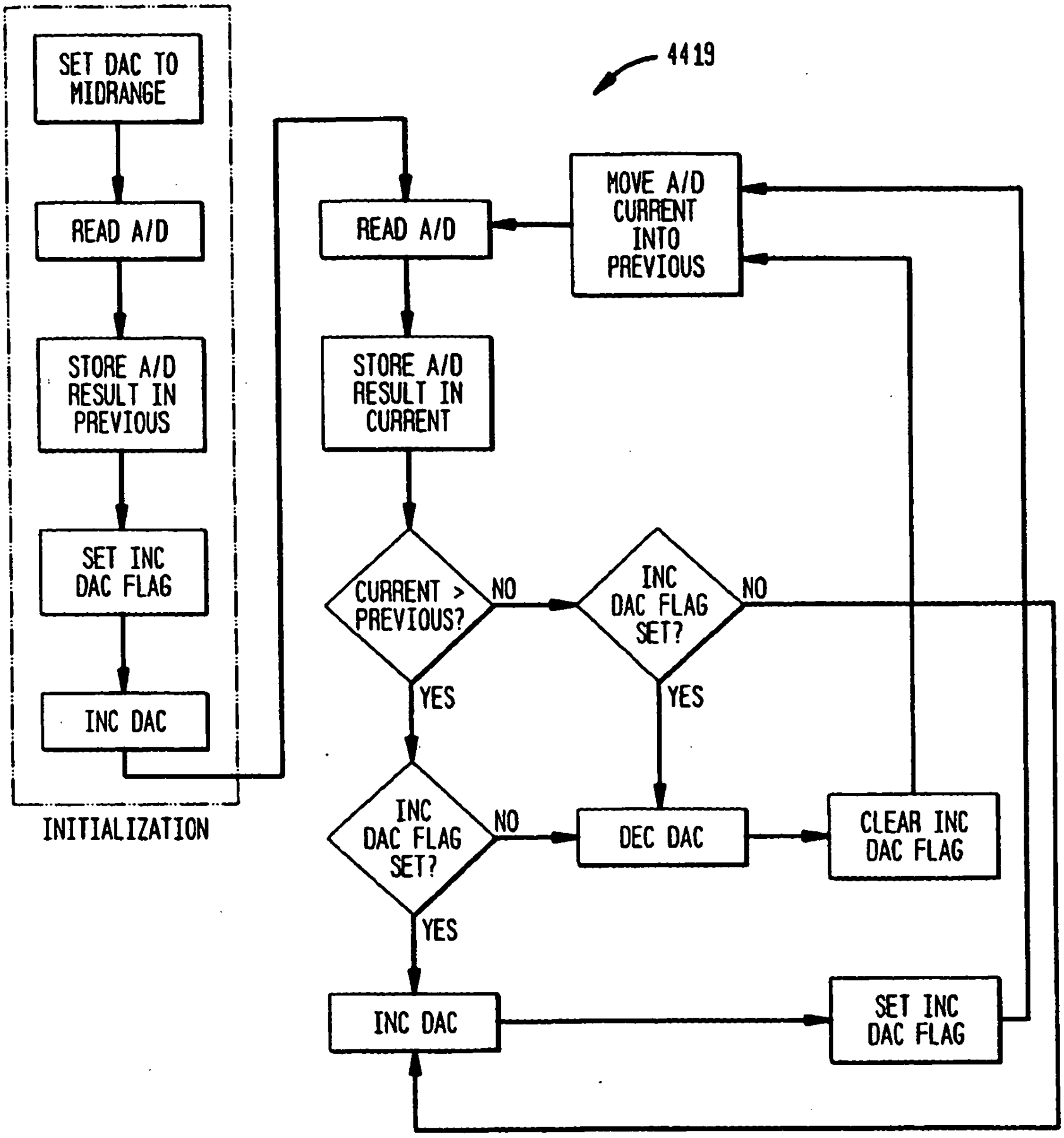


STATE MACHINE FLOWCHART

FIG. 44C

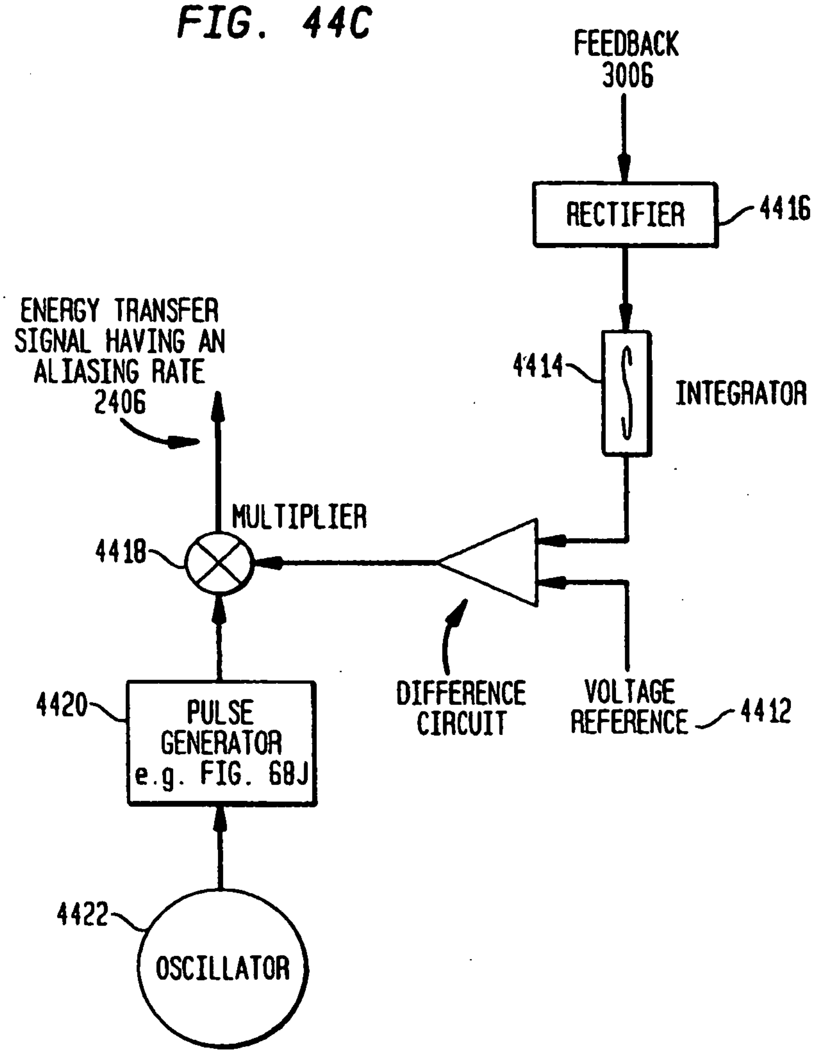


ENERGY TRANSFER SIGNAL MODULE 3002

FIG. 45

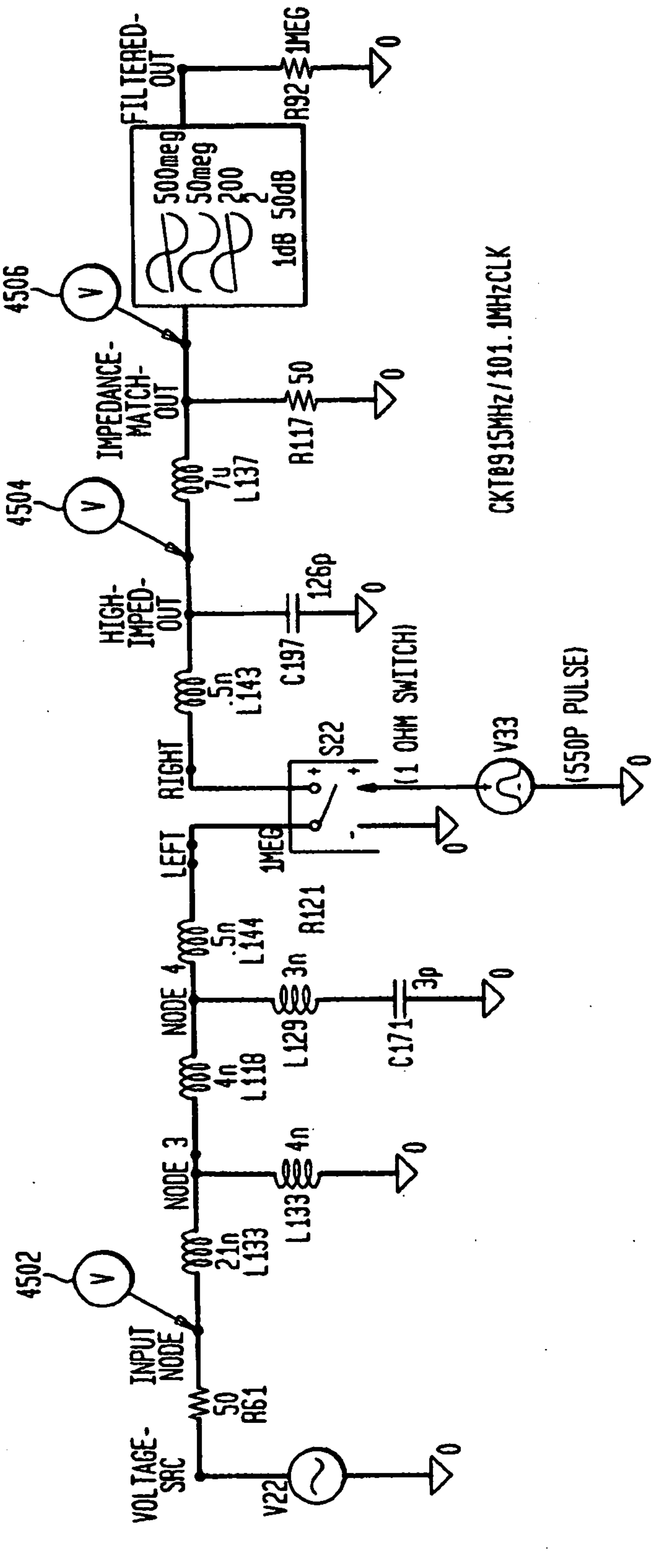
VOLTAGE-SRC
V22
0
50
R61
INPUT NODE
4502
V
21n
L133
NODE 3
L133
4n
4n
L118
NODE 4
L129
3n
C171
3p
.5n
L144
LEFT
1MEG
R121
S22
(1 OHM SWITCH)
V33
(550P PULSE)
RIGHT
.5n
L143
HIGH-IMPED-OUT
C197
126p
4504
7u
L137
IMPEDANCE-MATCH-OUT
R117
50
4506
500meg
50meg
200
2
1dB 50dB
FILTERED-OUT
R92
1MEG
CKT@915MHz/101.1MHzCLK

FIG. 46

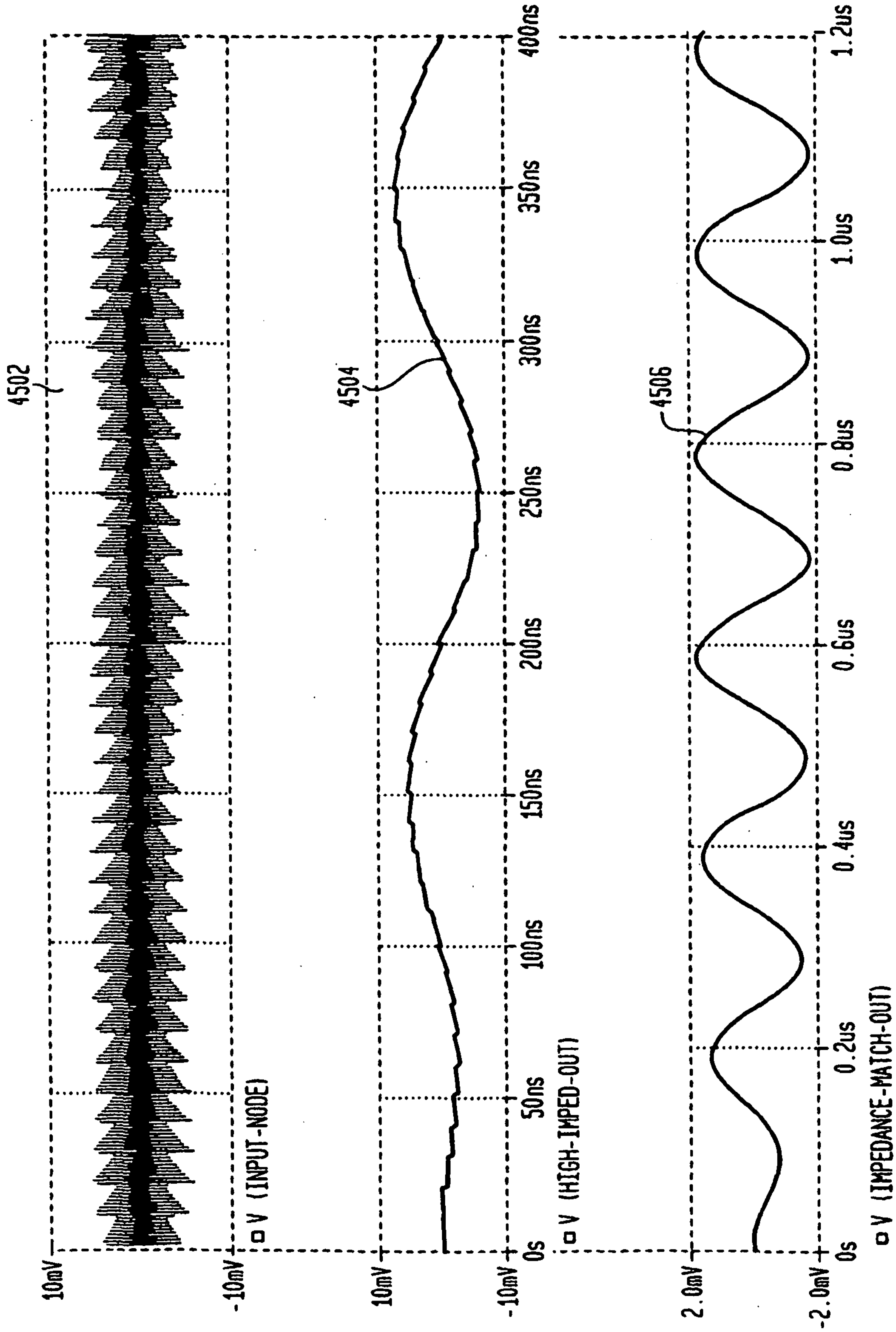
4502
4504
4506
10mV
-10mV
□ V (INPUT-NODE)
10mV
-10mV
□ V (HIGH-IMPED-OUT)
0s
50ns
100ns
150ns
200ns
250ns
300ns
350ns
400ns
2.0mV
-2.0mV
□ V (IMPEDANCE-MATCH-OUT)
0s
0.2us
0.4us
0.6us
0.8us
1.0us
1.2us

FIG. 47

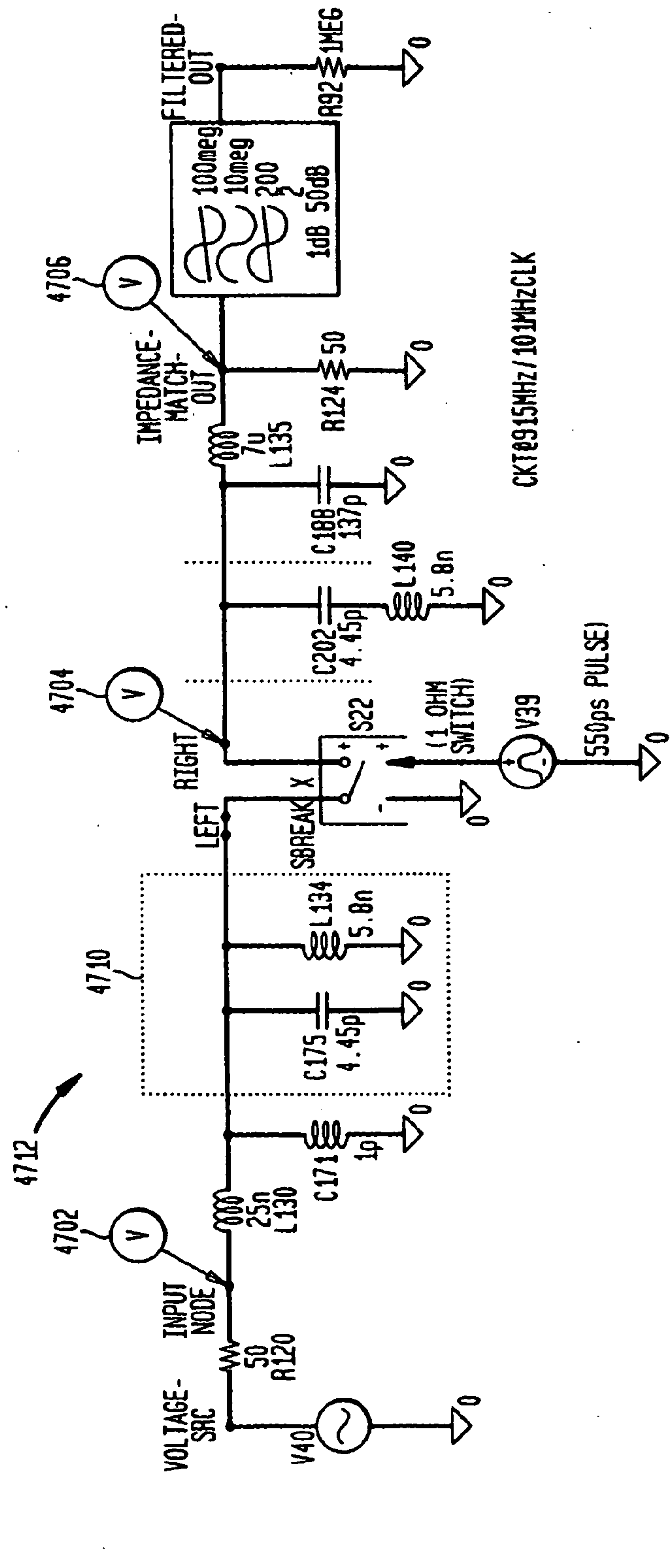
4712
4702
4710
4704
4706
VOLTAGE-SRC
V40
50
R120
INPUT NODE
25n
L130
C171
1p
C175
4.45p
L134
5.8n
LEFT
SBREAK
X
RIGHT
S22
(1 OHM SWITCH)
V39
550ps PULSE)
C202
4.45p
L140
5.8n
C188
137p
7u
L135
IMPEDANCE-MATCH-OUT
R124
50
100meg
10meg
200
2
1dB 50dB
FILTERED-OUT
R92
1MEG
CKT0915MHz/101MHzCLK
0

FIG. 48

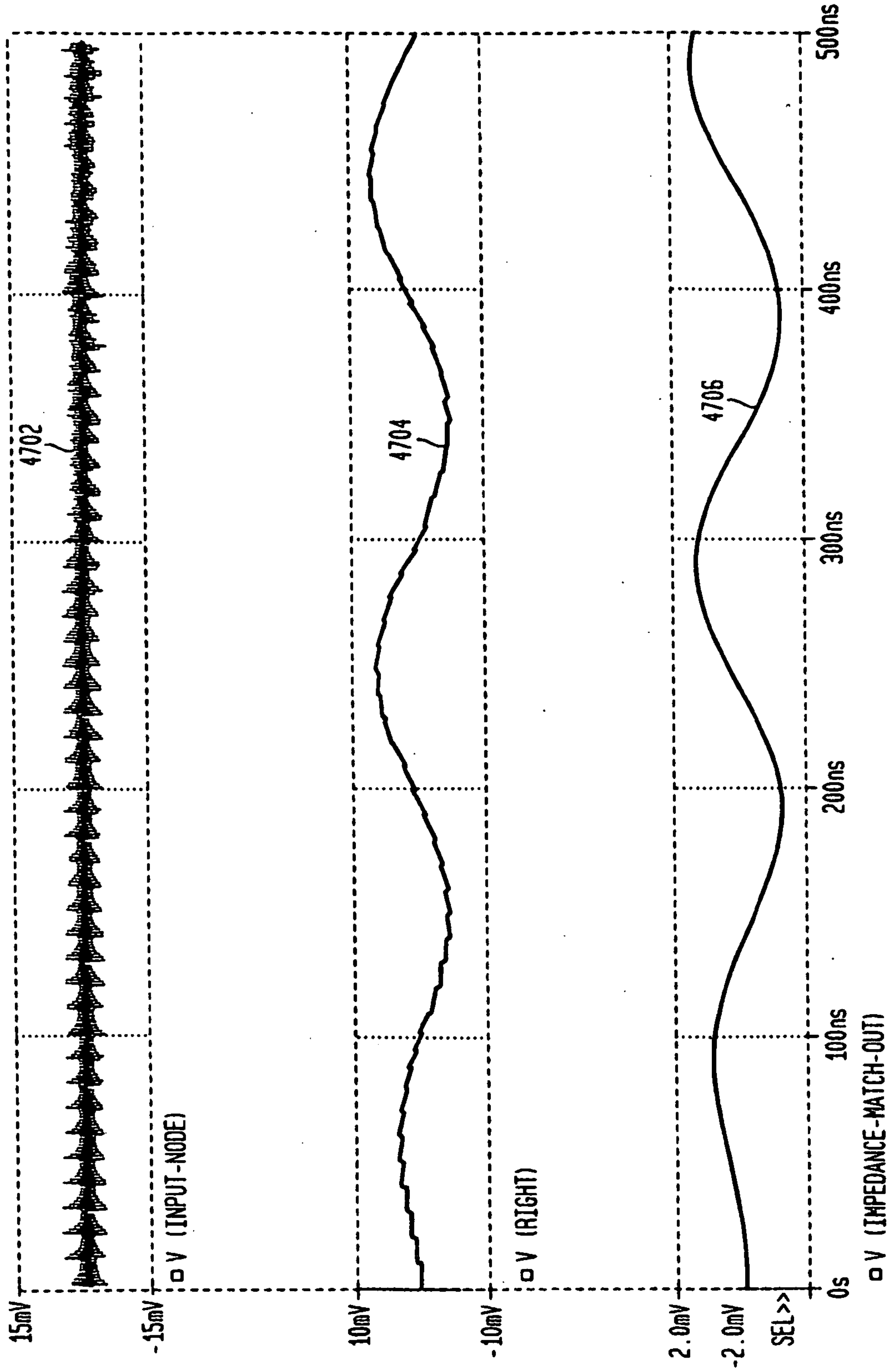
15mV
-15mV
V (INPUT-NODE)
4702
10mV
-10mV
V (RIGHT)
4704
2.0mV
-2.0mV
SEL>>
V (IMPEDANCE-MATCH-OUT)
4706
0s
100ns
200ns
300ns
400ns
500ns

FIG. 49

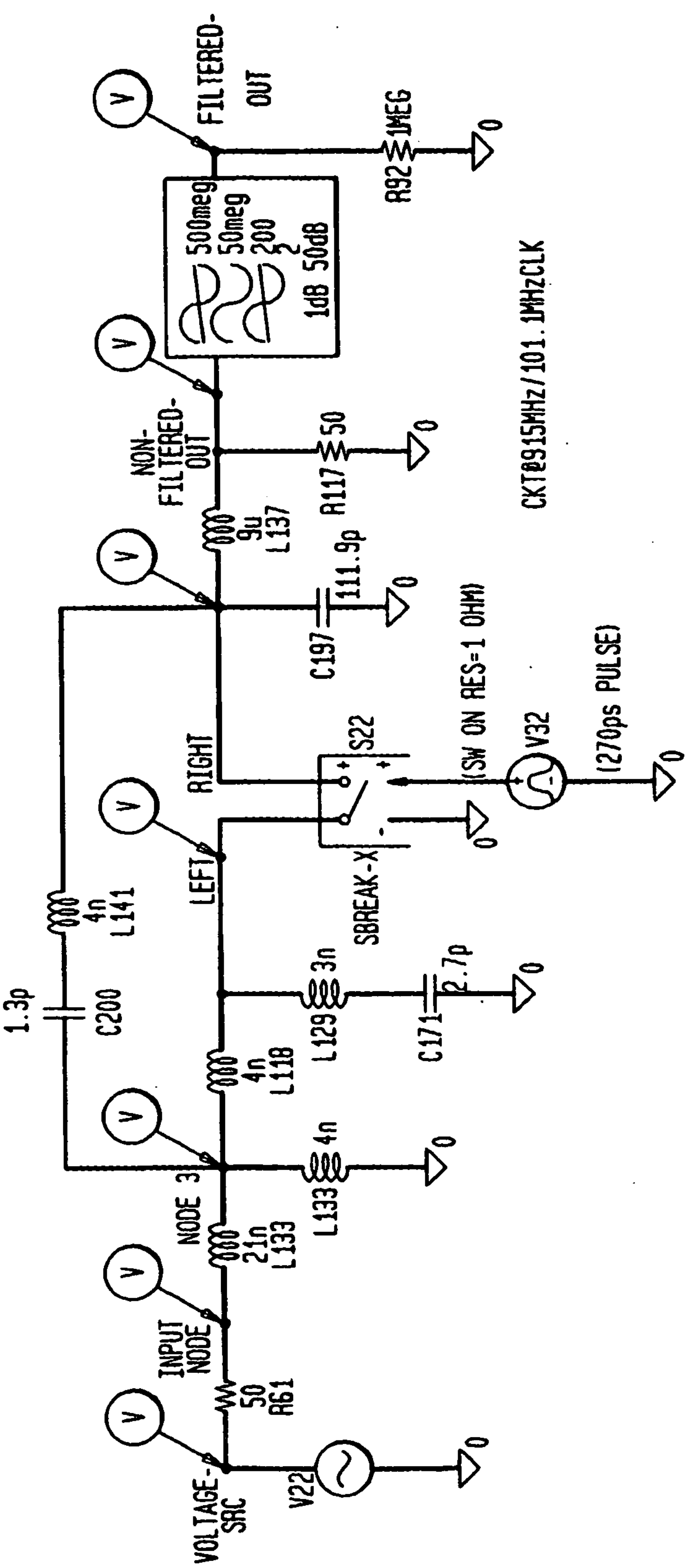
FILTERED-OUT
R92 1MEG
500meg
50meg
200
2
1dB 50dB
NON-FILTERED-OUT
R117 50
9u
L137
111.9p
C197
CKT@915MHz/101.1MHzCLK
RIGHT
S22
SBREAK-X
LEFT
(SW ON RES=1 OHM)
V32
(270ps PULSE)
4n
L141
1.3p
C200
3n
L129
2.7p
C171
4n
L118
4n
L133
NODE 3
21n
L133
INPUT NODE
50
R61
VOLTAGE-SRC
V22
0

FIG. 50

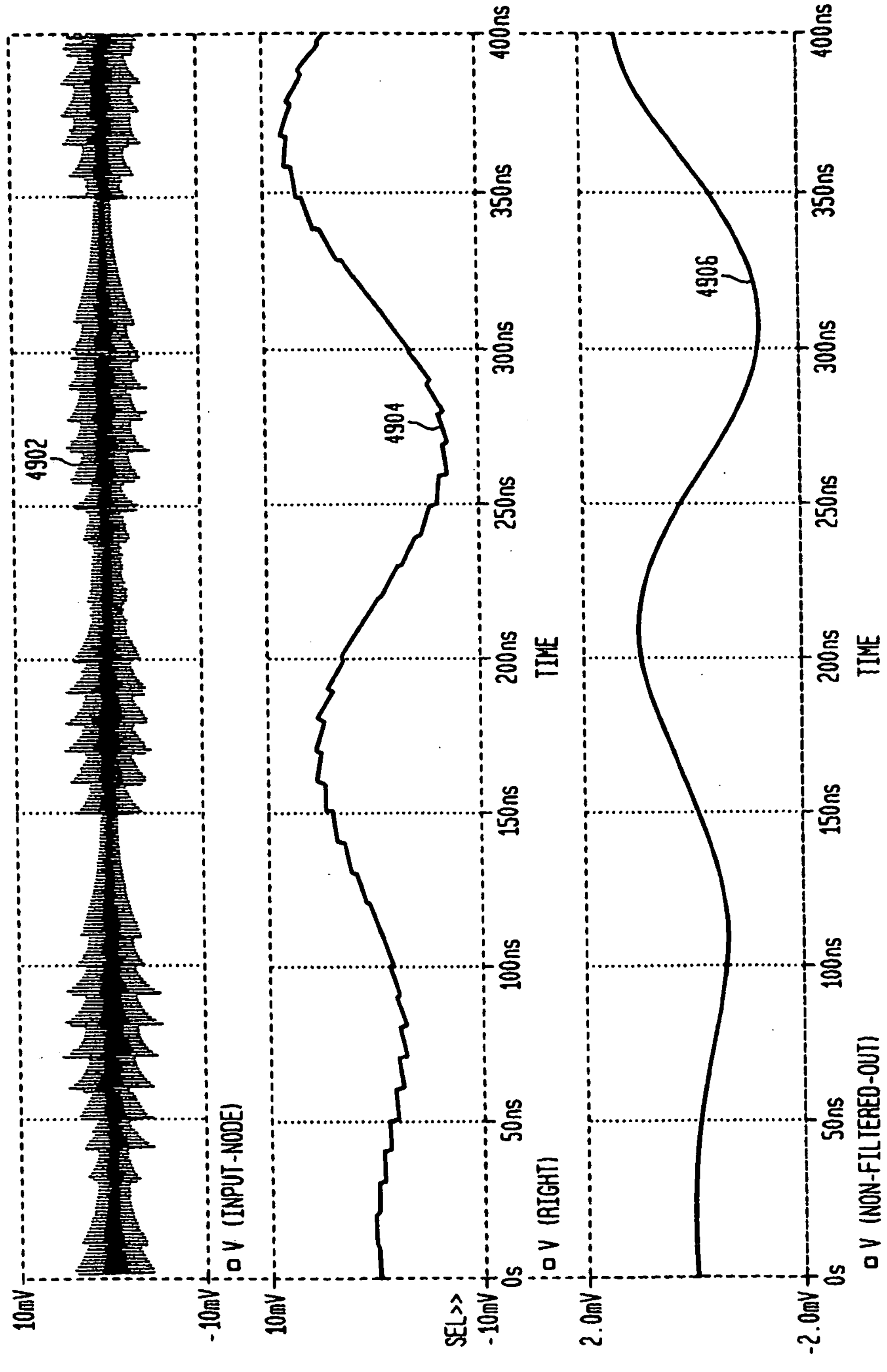
10mV
-10mV
□ V (INPUT-NODE)
10mV
SEL>>
-10mV
□ V (RIGHT)
2.0mV
-2.0mV
□ V (NON-FILTERED-OUT)
0s
50ns
100ns
150ns
200ns
250ns
300ns
350ns
400ns
TIME
4902
4904
4906

FIG. 51

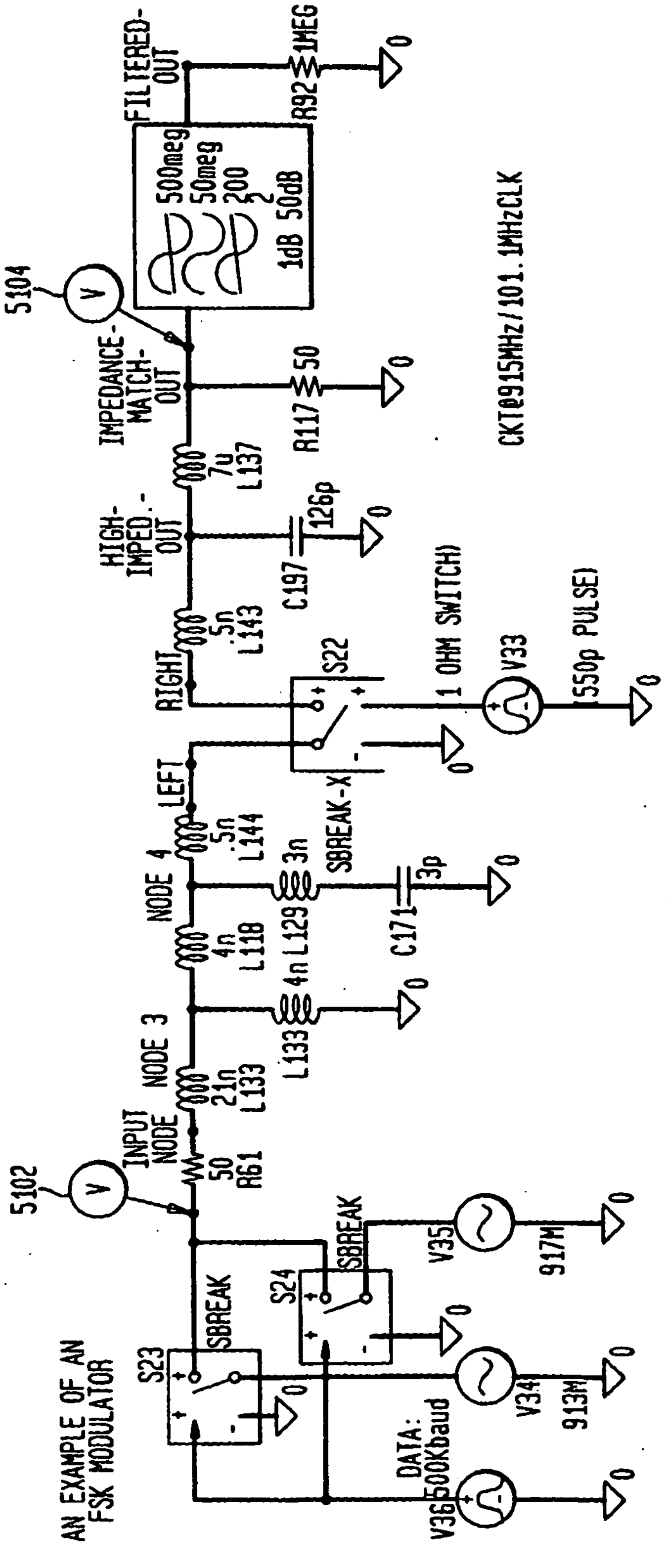
AN EXAMPLE OF AN FSK MODULATOR
S23
SBREAK
S24
SBREAK
5102
V
INPUT NODE
50
R61
NODE 3
21n
L133
L133
4n
L118
NODE 4
4n L129
3n
SBREAK-X
C171
3p
.5n
L144
LEFT
S22
1 OHM SWITCH)
V33
550p PULSE)
RIGHT
.5n
L143
HIGH-IMPED.-OUT
C197
126p
7u
L137
IMPEDANCE-MATCH-OUT
R117
50
5104
500meg
50meg
200
2
1dB 50dB
FILTERED-OUT
R92
1MEG
CKT@915MHz/101.1MHzCLK
V35
917M
V34
913M
DATA:
V36
500Kbaud
0

FIG. 52

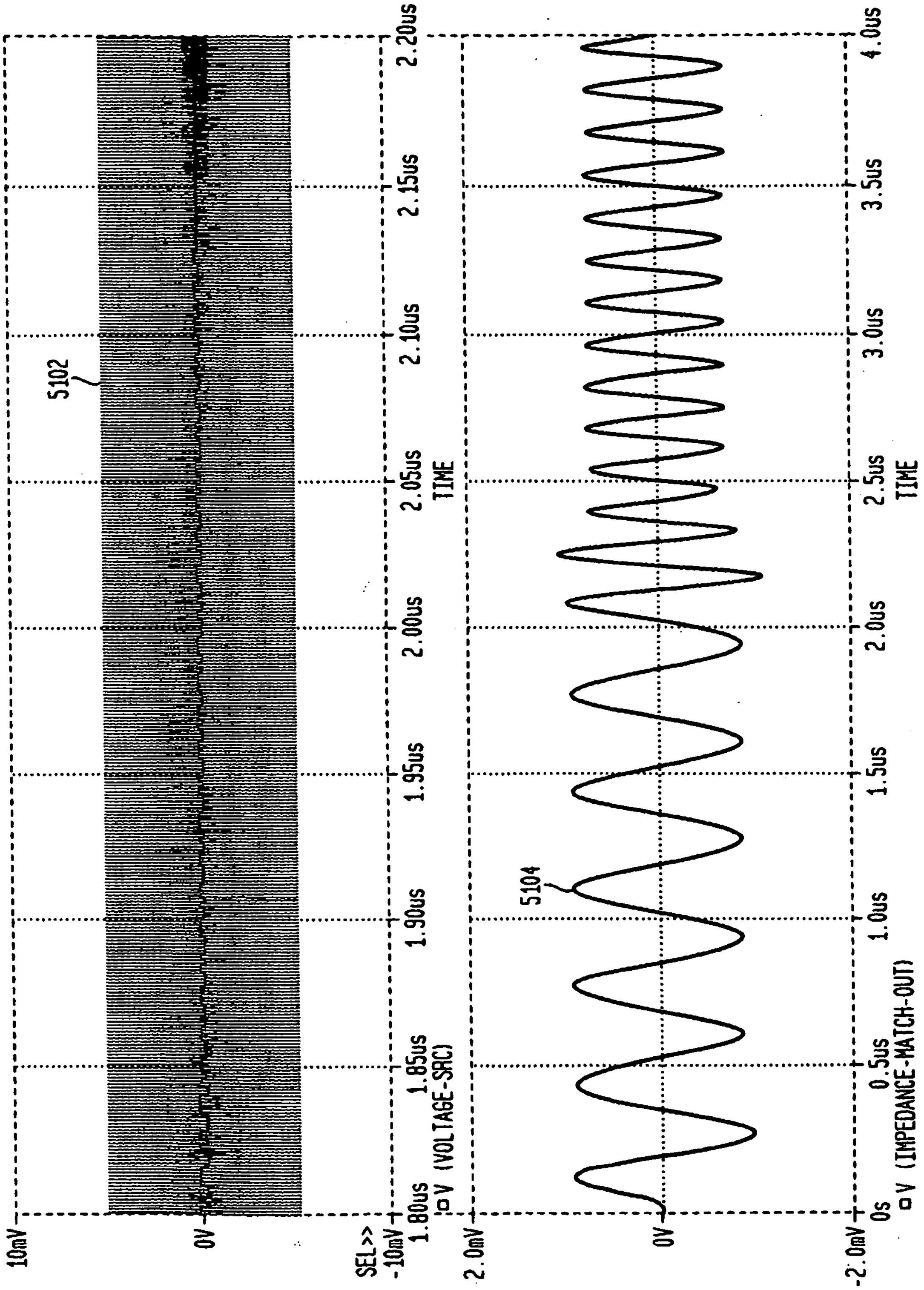
5102
10mV
0V
SEL>>
-10mV
1.80us
1.85us
1.90us
1.95us
2.00us
2.05us
2.10us
2.15us
2.20us
□ V (VOLTAGE-SRC)
TIME
5104
2.0mV
0V
-2.0mV
0s
0.5us
1.0us
1.5us
2.0us
2.5us
3.0us
3.5us
4.0us
□ V (IMPEDANCE-MATCH-OUT)
TIME

FIG. 53A

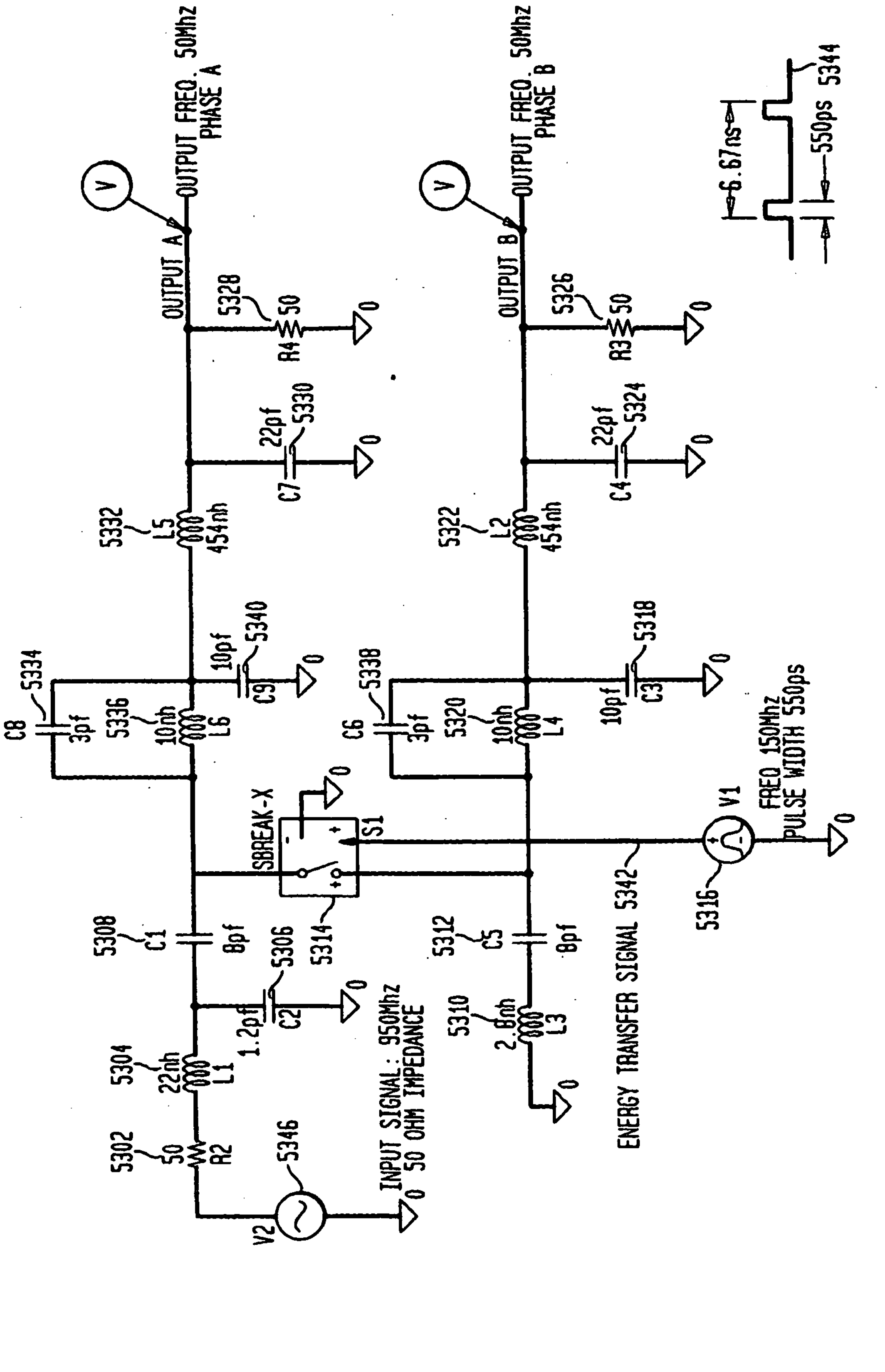
OUTPUT FREQ. 50Mhz PHASE A
OUTPUT A
OUTPUT FREQ. 50Mhz PHASE B
OUTPUT B
V
5328
R4 50
5326
R3 50
C7 22pf 5330
C4 22pf 5324
5332 L5 454nh
5322 L2 454nh
C8 5334 3pf
5336 10nh L6
10pf 5340 C9
C6 5338 3pf
5320 10nh L4
10pf 5318 C3
SBREAK-X
S1
5314
5308 C1 8pf
5306 1.2pf C2
5312 C5 8pf
5304 22nh L1
5310 2.8nh L3
5302 50 R2
5346
V2
INPUT SIGNAL: 950Mhz 50 OHM IMPEDANCE
ENERGY TRANSFER SIGNAL 5342
5316
V1
FREQ 150Mhz PULSE WIDTH 550ps
6.67ns
550ps
5344
0

FIG. 53B

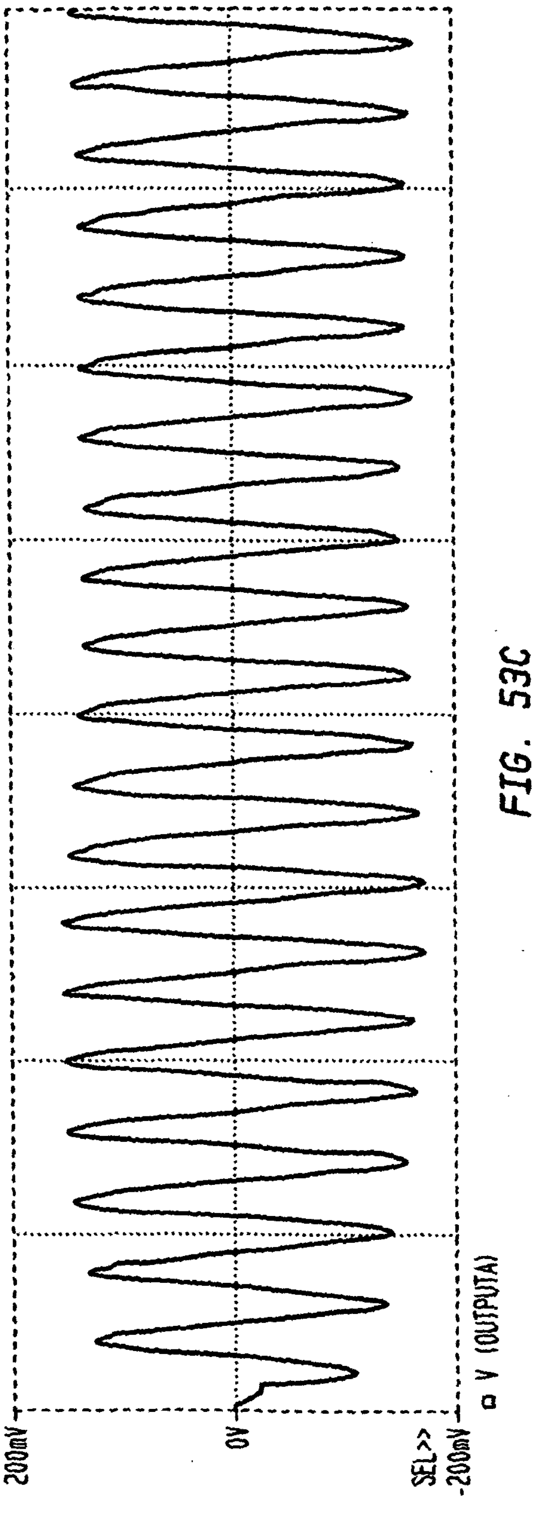


FIG. 53C

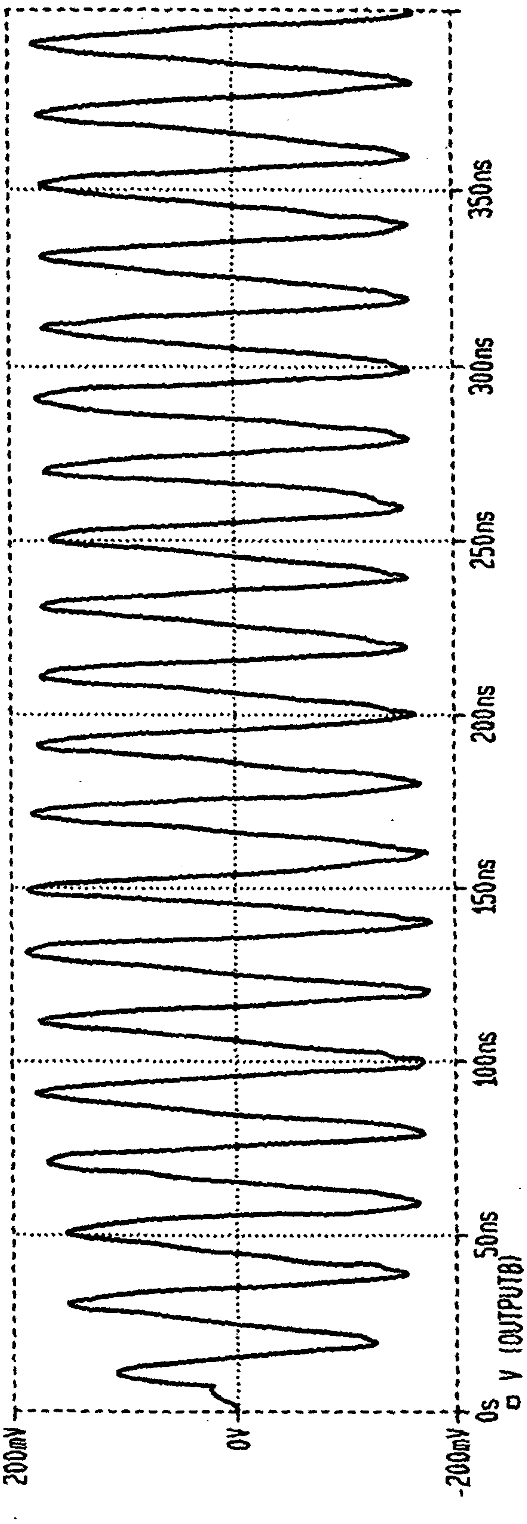

FIG. 54

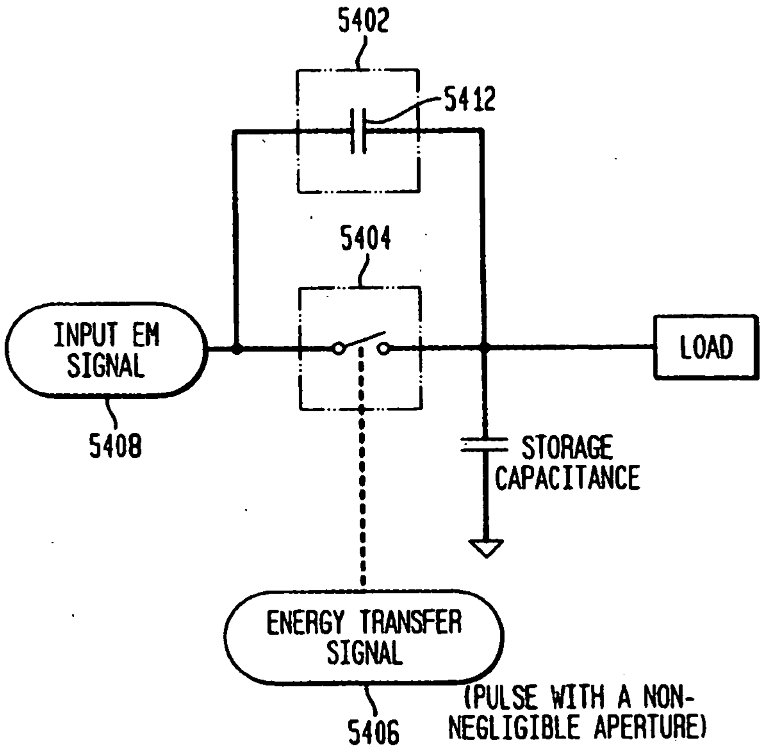
5402
5412
5404
INPUT EM SIGNAL
LOAD
5408
STORAGE CAPACITANCE
ENERGY TRANSFER SIGNAL
(PULSE WITH A NON-NEGLIGIBLE APERTURE)
5406

FIG. 55

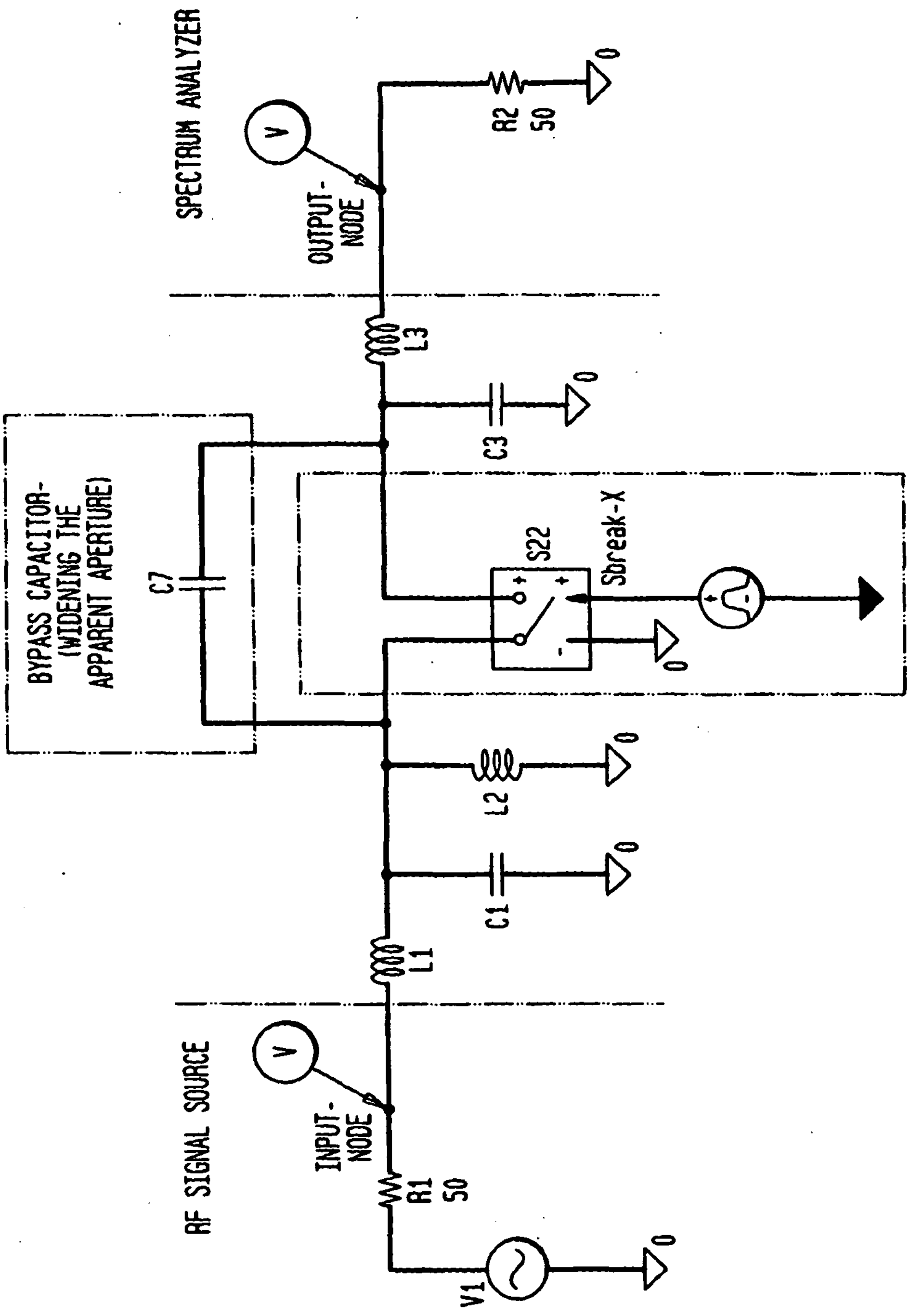
SPECTRUM ANALYZER
OUTPUT-NODE
R2
50
0
L3
C3
C7
BYPASS CAPACITOR-
(WIDENING THE
APPARENT APERTURE)
S22
Sbreak-X
L2
C1
L1
RF SIGNAL SOURCE
INPUT-NODE
R1
50
V1
V

FIG. 56

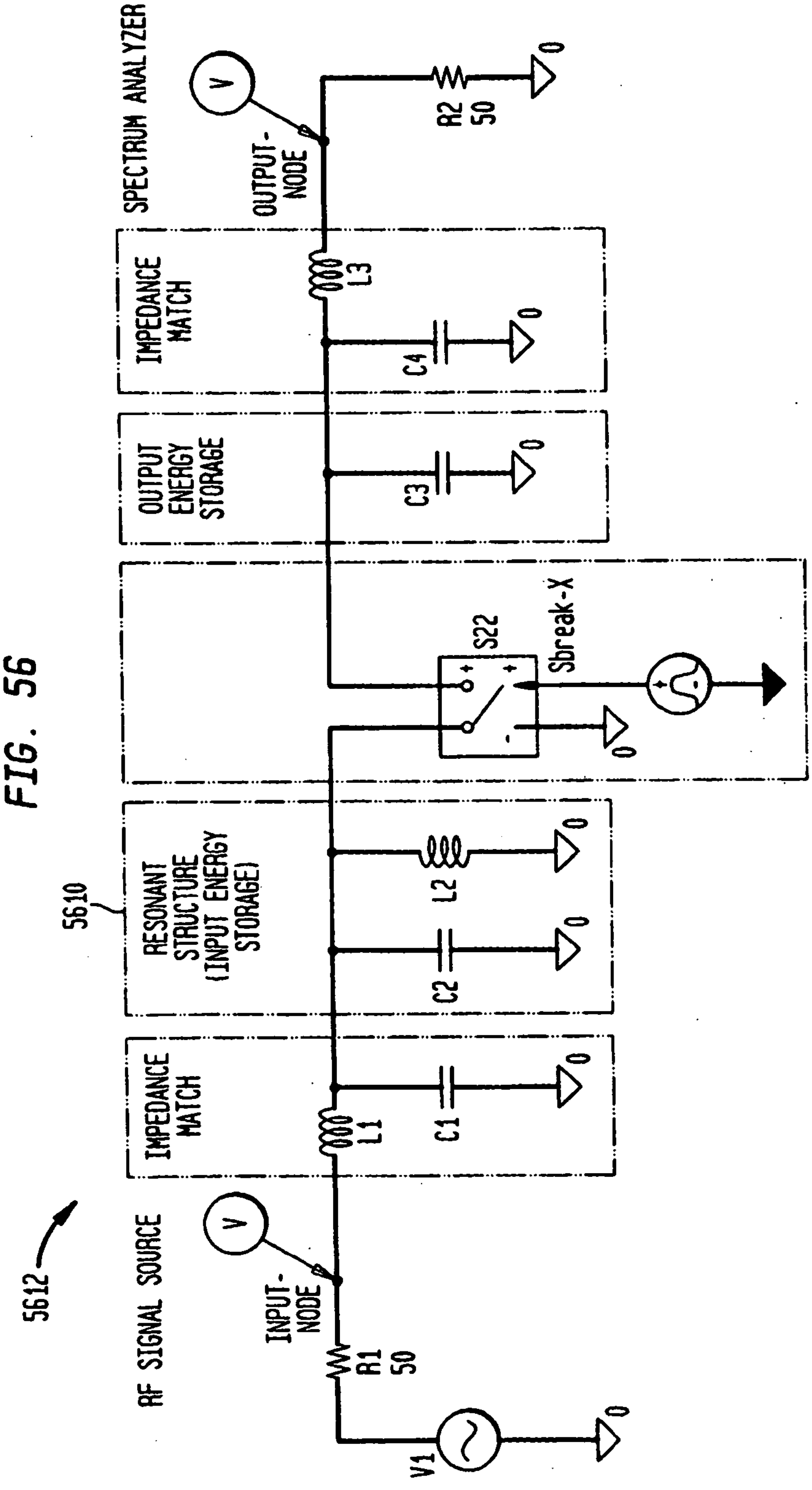
5612
RF SIGNAL SOURCE
V
INPUT-
NODE
R1
50
V1
0
IMPEDANCE
MATCH
L1
C1
5610
RESONANT
STRUCTURE
(INPUT ENERGY
STORAGE)
C2
L2
S22
Sbreak-X
OUTPUT
ENERGY
STORAGE
C3
IMPEDANCE
MATCH
C4
L3
SPECTRUM ANALYZER
OUTPUT-
NODE
R2
50

FIG. 57A

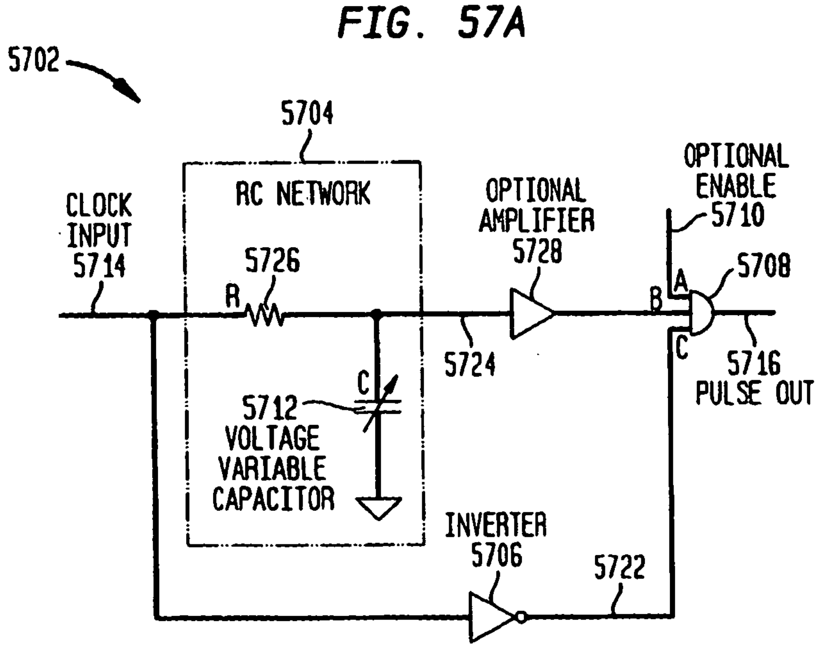
5702
5704
RC NETWORK
CLOCK INPUT 5714
5726
R
C
5712 VOLTAGE VARIABLE CAPACITOR
5724
OPTIONAL AMPLIFIER 5728
OPTIONAL ENABLE 5710
A
B
C
5708
5716 PULSE OUT
INVERTER 5706
5722

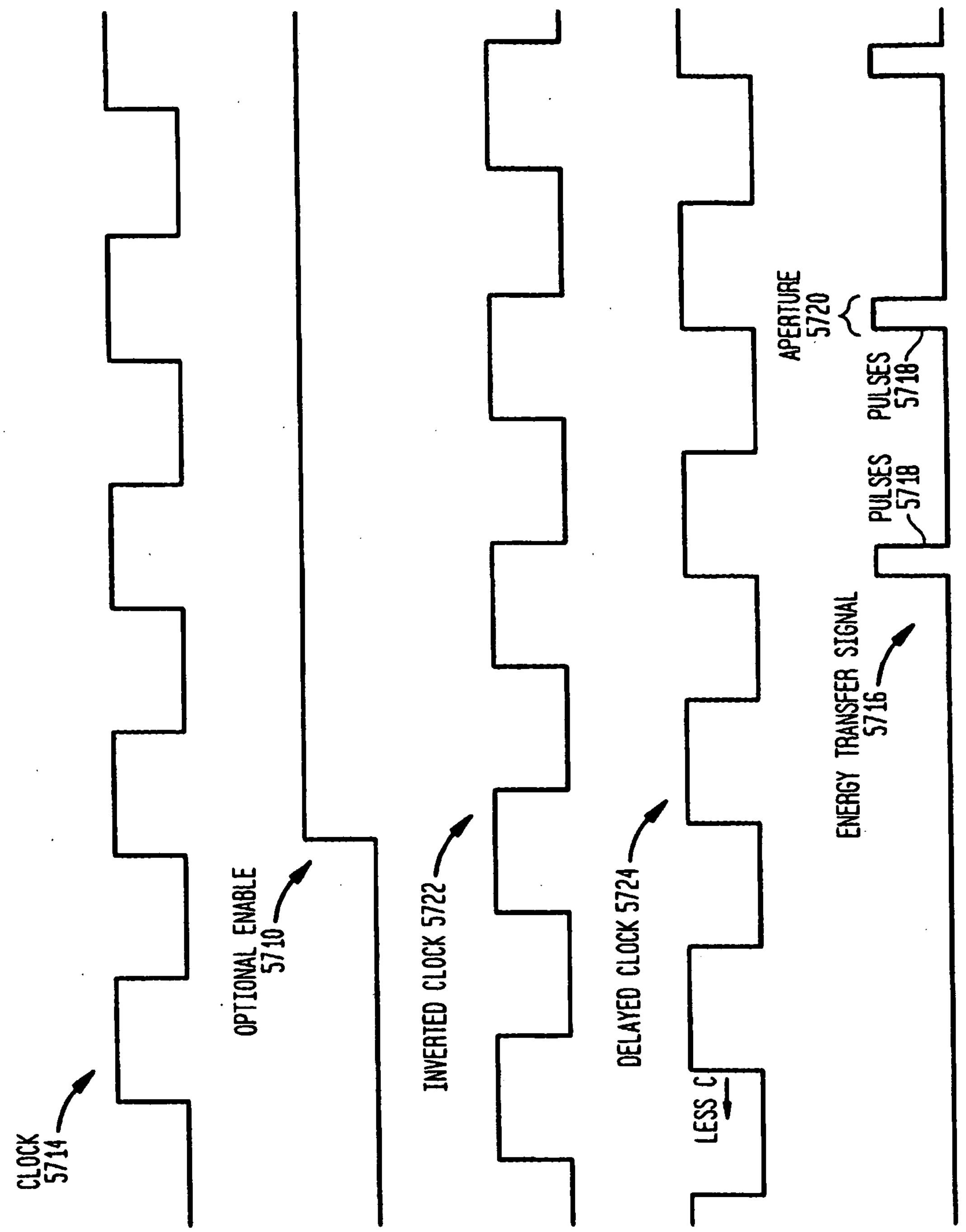


FIG. 57B

FIG. 57C

FIG. 57D

FIG. 57E

FIG. 57F

FIG. 58

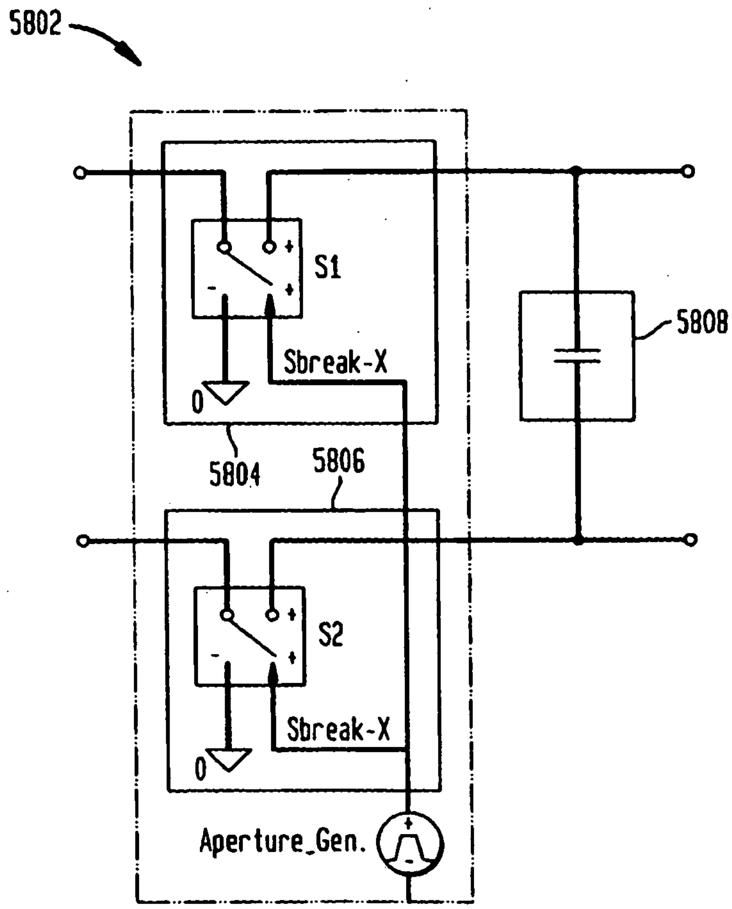

FIG. 59

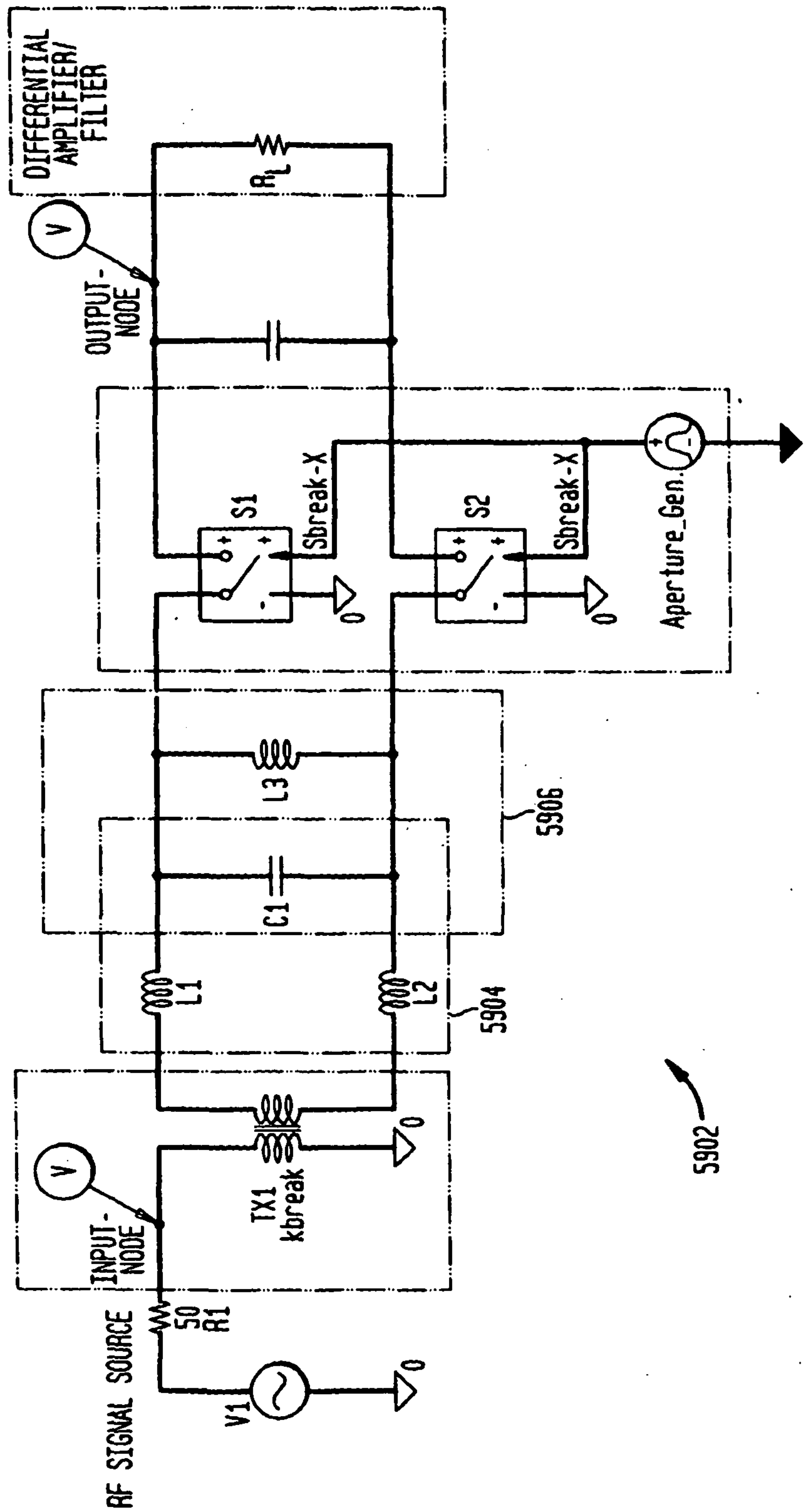
DIFFERENTIAL
AMPLIFIER/
FILTER
$R_L$
OUTPUT-
NODE
V
S1
Sbreak-X
S2
Sbreak-X
Aperture_Gen.
0
0
L3
5906
C1
L1
L2
5904
0
TX1
kbreak
INPUT-
NODE
V
50
R1
RF SIGNAL SOURCE
V1
0
5902

FIG. 60

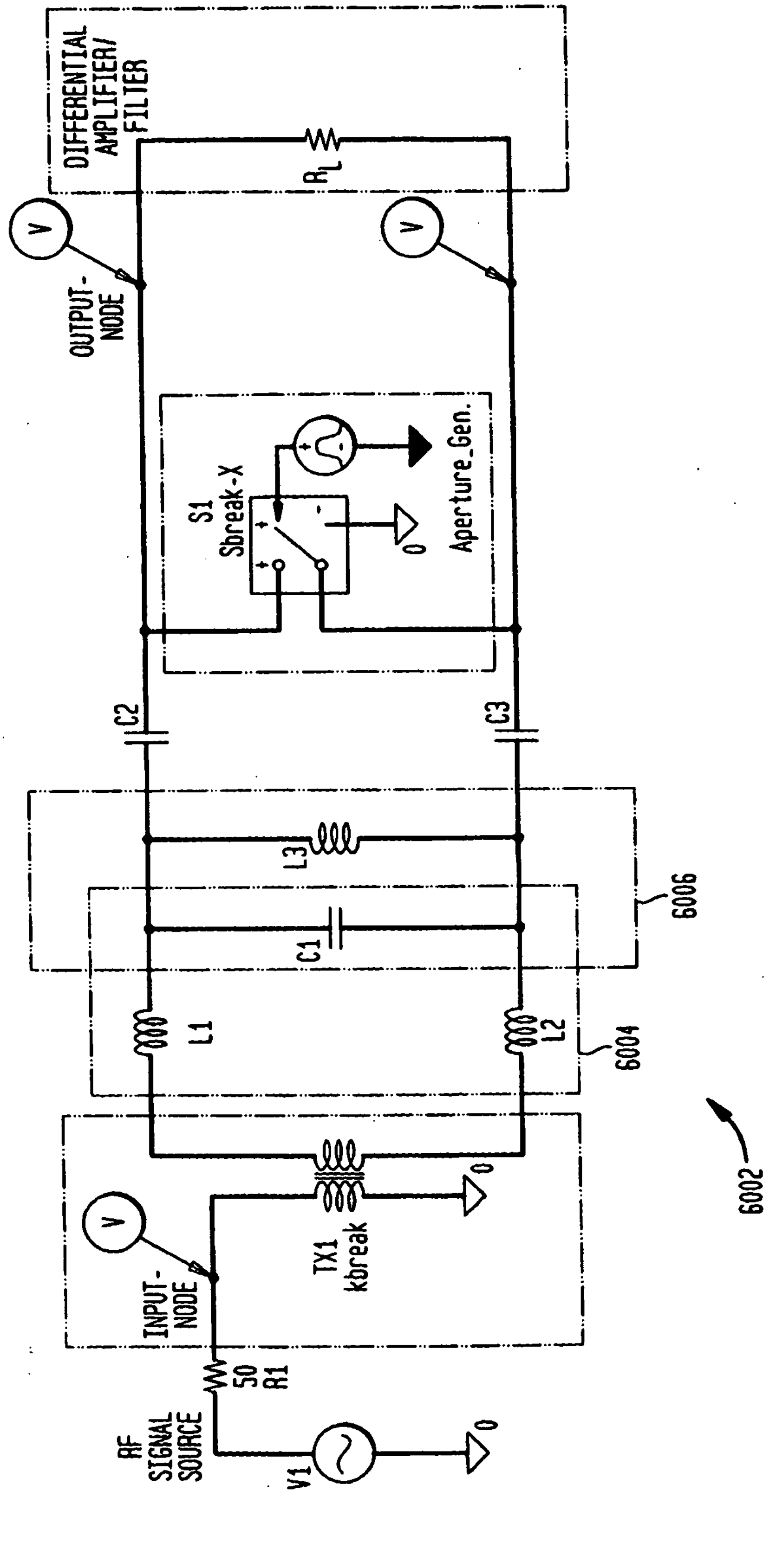
DIFFERENTIAL AMPLIFIER/ FILTER
$R_L$
V
V
OUTPUT- NODE
S1
Sbreak-X
Aperture_Gen.
0
C2
C3
L3
C1
L1
L2
6006
6004
TX1
kbreak
0
V
INPUT- NODE
50
R1
RF SIGNAL SOURCE
V1
0
6002

FIG. 61

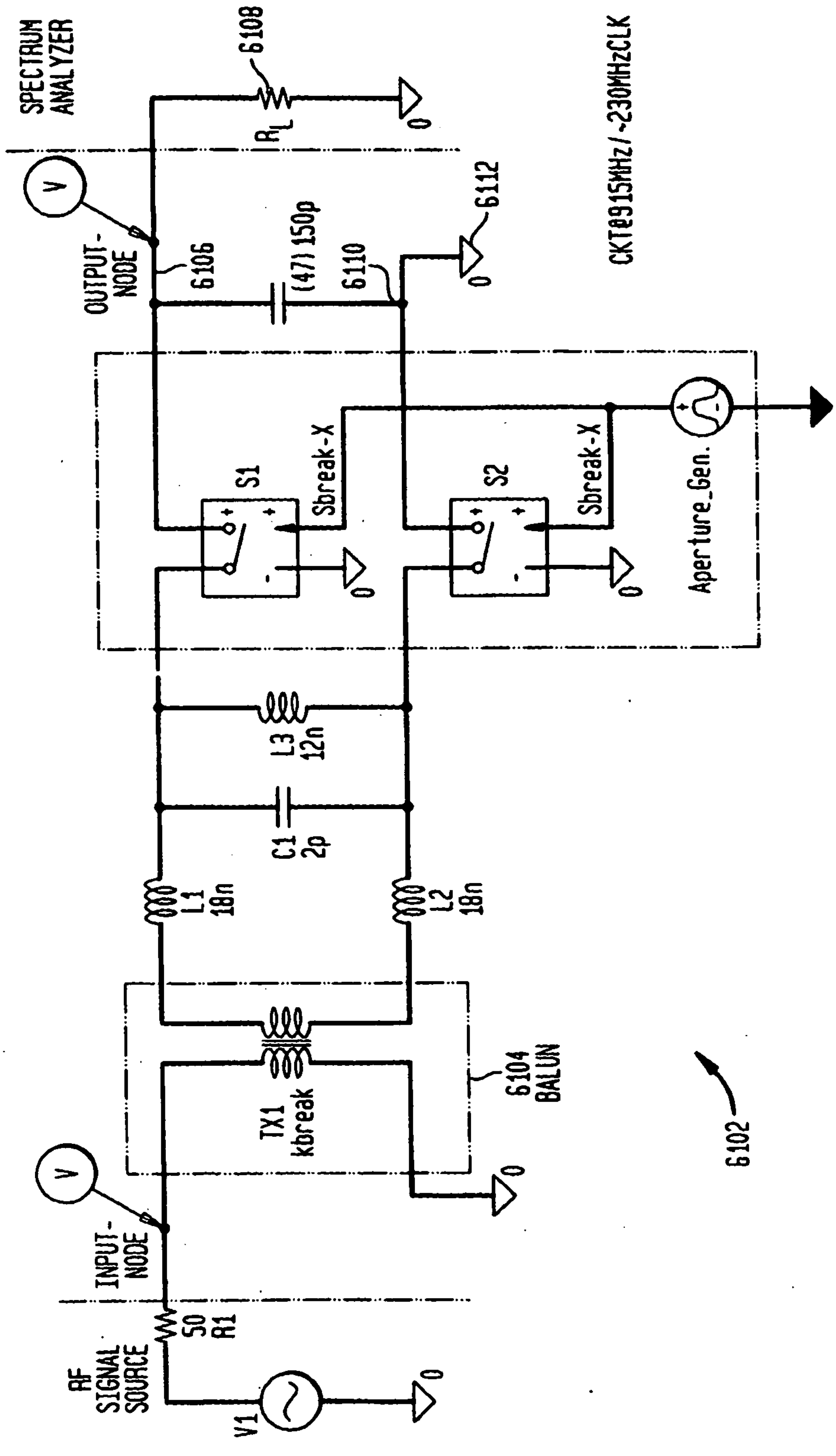
SPECTRUM ANALYZER
6108
$R_L$
0
OUTPUT-NODE
6106
(47) 150p
6110
6112
0
CKT@915MHz/~230MHzCLK
S1
Sbreak-X
0
S2
Sbreak-X
0
Aperture_Gen.
L3
12n
C1
2p
L1
18n
L2
18n
TX1
kbreak
6104
BALUN
0
6102
INPUT-NODE
RF SIGNAL SOURCE
50
R1
V1
0
V
V

FIG. 62

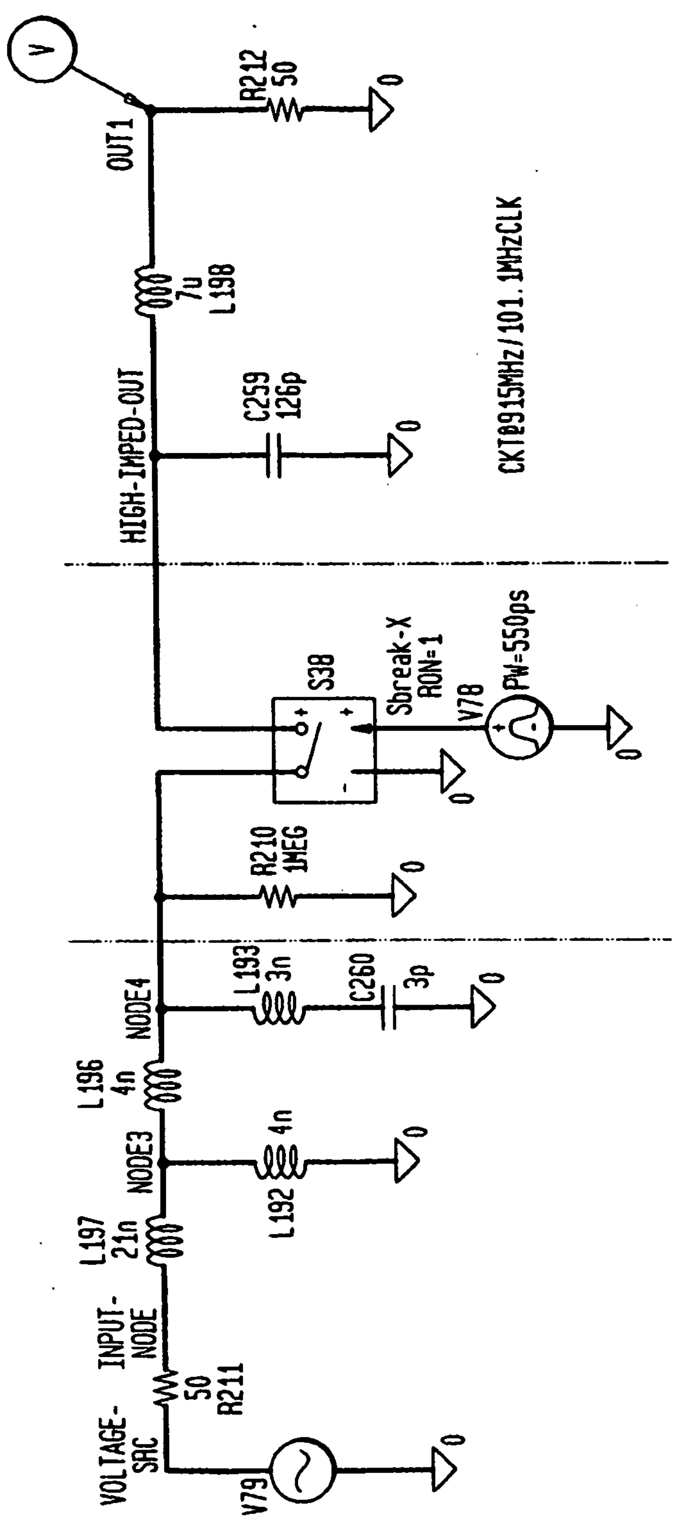
V
OUT1
R212
50
0
L198
7u
HIGH-IMPED-OUT
C259
126p
CKT@915MHz/101.1MHzCLK
S38
Sbreak-X
RON=1
V78
PW=550ps
R210
1MEG
NODE4
L193
3n
C260
3p
L196
4n
NODE3
L192
4n
L197
21n
INPUT-NODE
VOLTAGE-SRC
50
R211
V79

FIG. 63

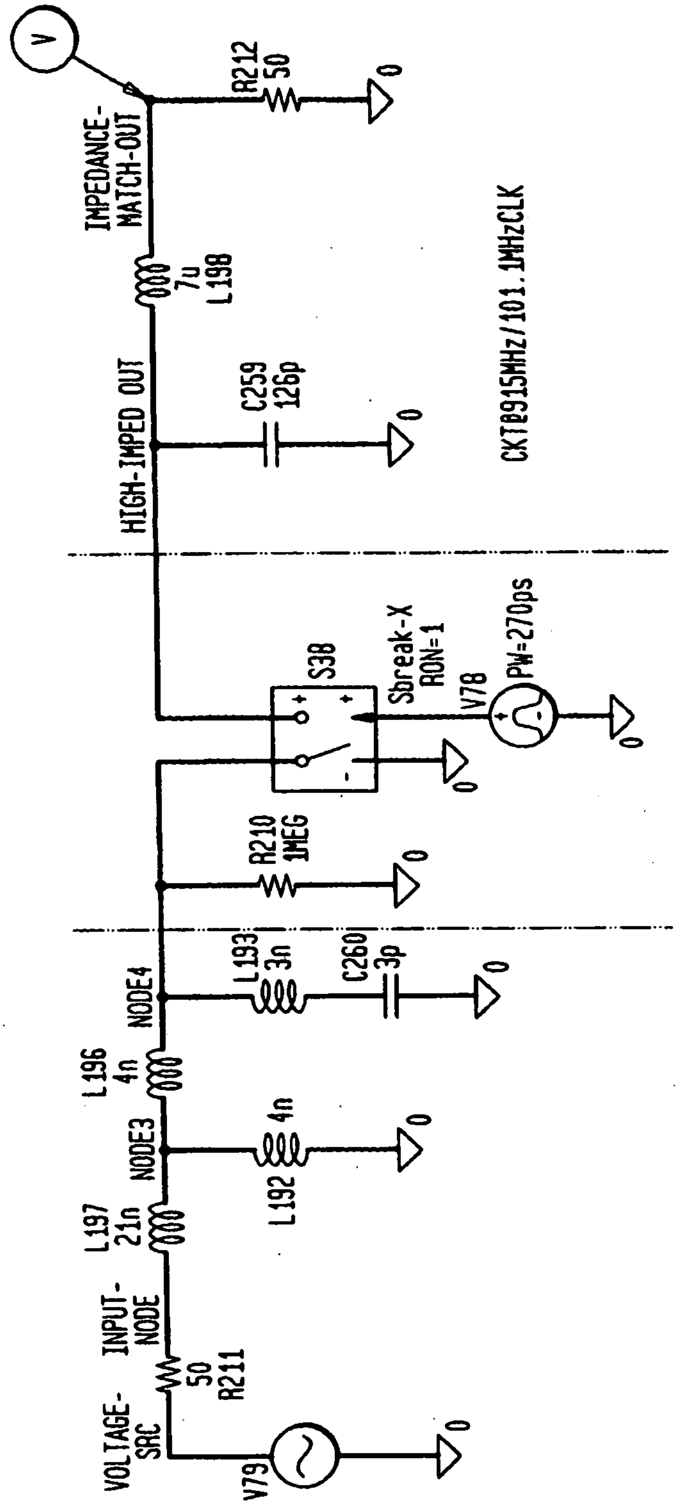
V
IMPEDANCE-MATCH-OUT
R212 50
0
L198 7u
CKT915MHz/101.1MHzCLK
HIGH-IMPED OUT
C259 126p
S38
Sbreak-X
RON=1
V78
PW=270ps
R210 1MEG
NODE4
L193 3n
C260 3p
L196 4n
NODE3
L192 4n
L197 21n
INPUT-NODE
R211 50
VOLTAGE-SRC
V79

FIG. 64

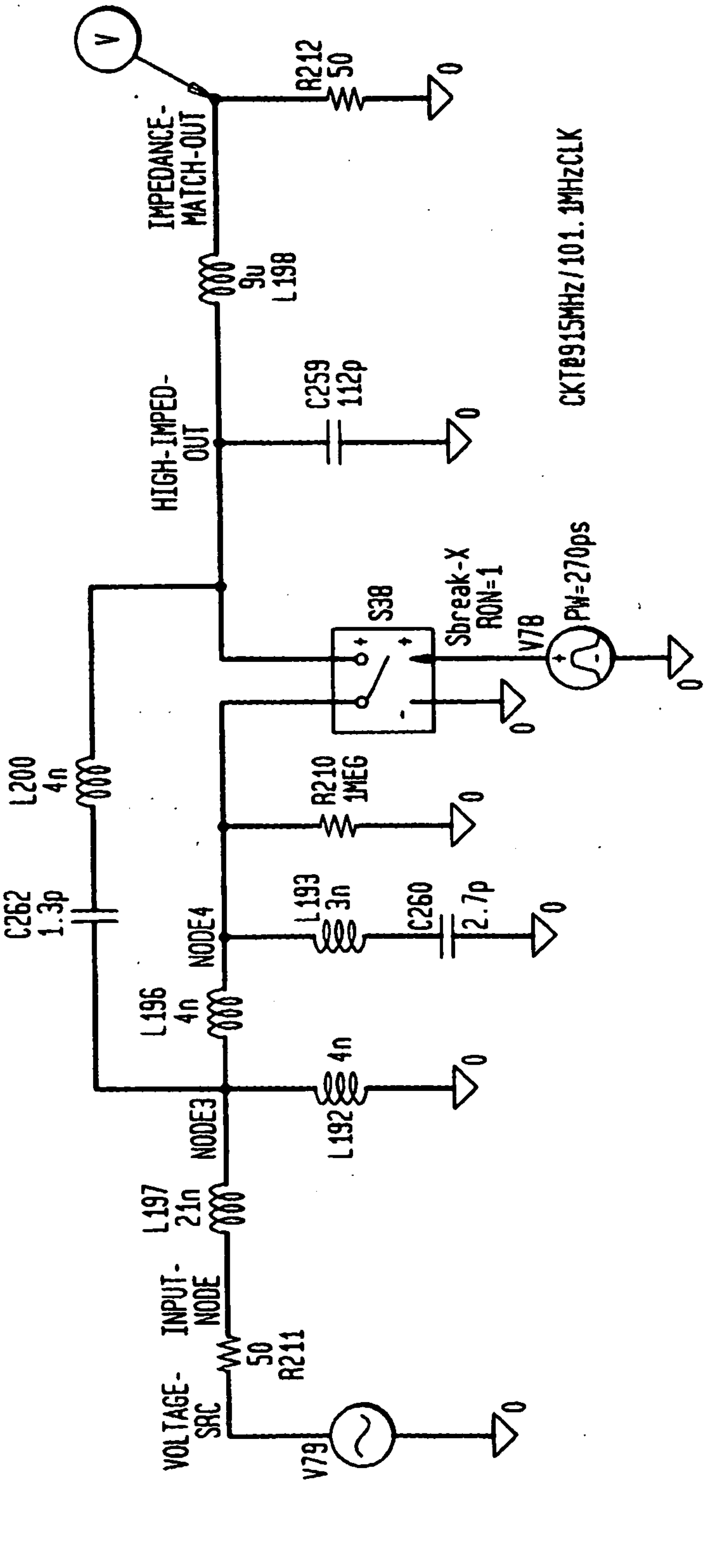
V
IMPEDANCE-
MATCH-OUT
R212
50
0
L198
9u
HIGH-IMPED-
OUT
C259
112p
0
CKT@915MHz/101.1MHzCLK
S38
Sbreak-X
RON=1
V78
PW=270ps
0
0
L200
4n
C262
1.3p
R210
1MEG
0
NODE4
L193
3n
C260
2.7p
0
L196
4n
NODE3
L192
4n
0
L197
21n
INPUT-
NODE
50
R211
VOLTAGE-
SRC
V79
0

FIG. 65

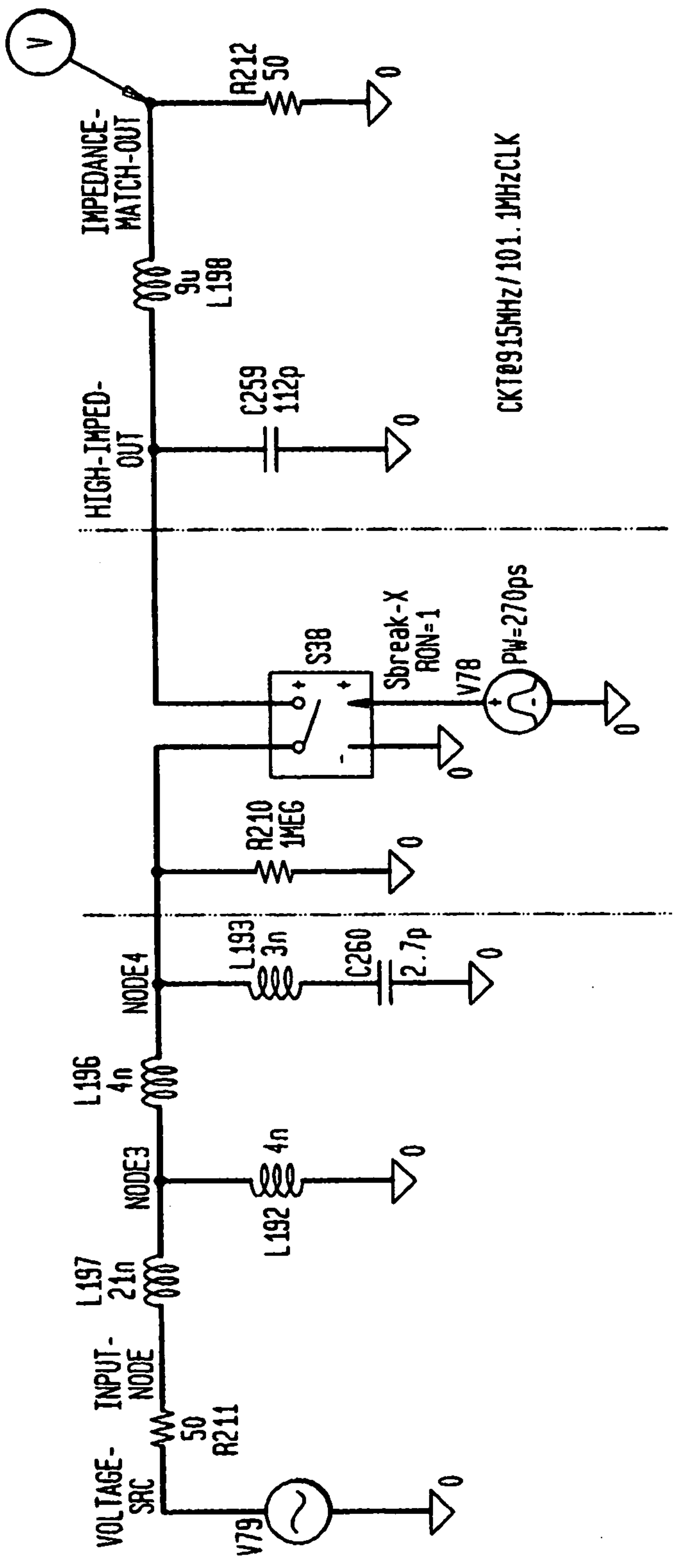
V
R212
50
0
IMPEDANCE-
MATCH-OUT
9u
L198
HIGH-IMPED-
OUT
C259
112p
0
CKT@915MHz/101.1MHzCLK
S38
Sbreak-X
RON=1
V78
PW=270ps
0
0
R210
1MEG
0
NODE4
L193
3n
C260
2.7p
0
L196
4n
NODE3
4n
L192
0
L197
21n
INPUT-
NODE
50
R211
VOLTAGE-
SRC
V79
0

FIG. 66A

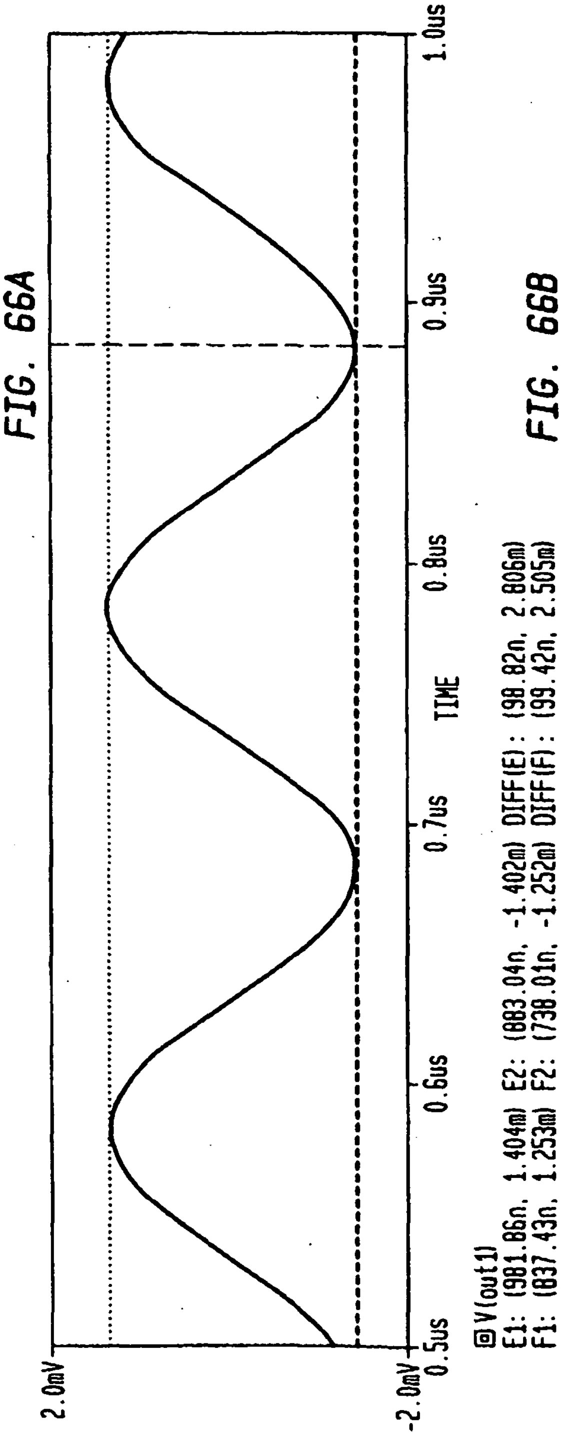


FIG. 66B

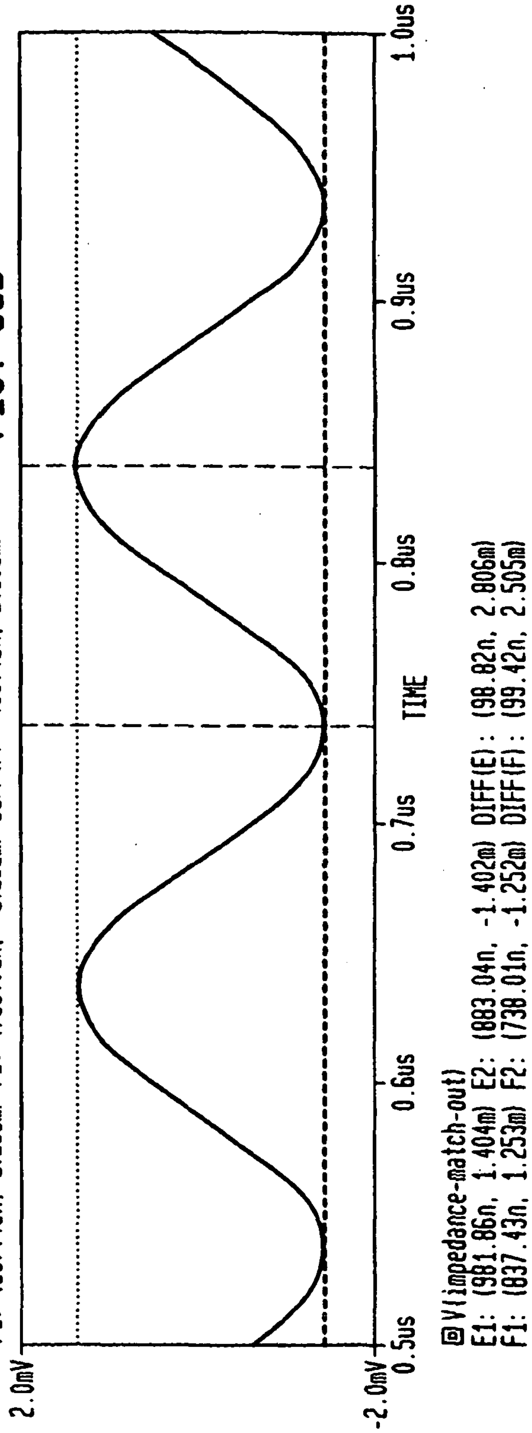

FIG. 67A

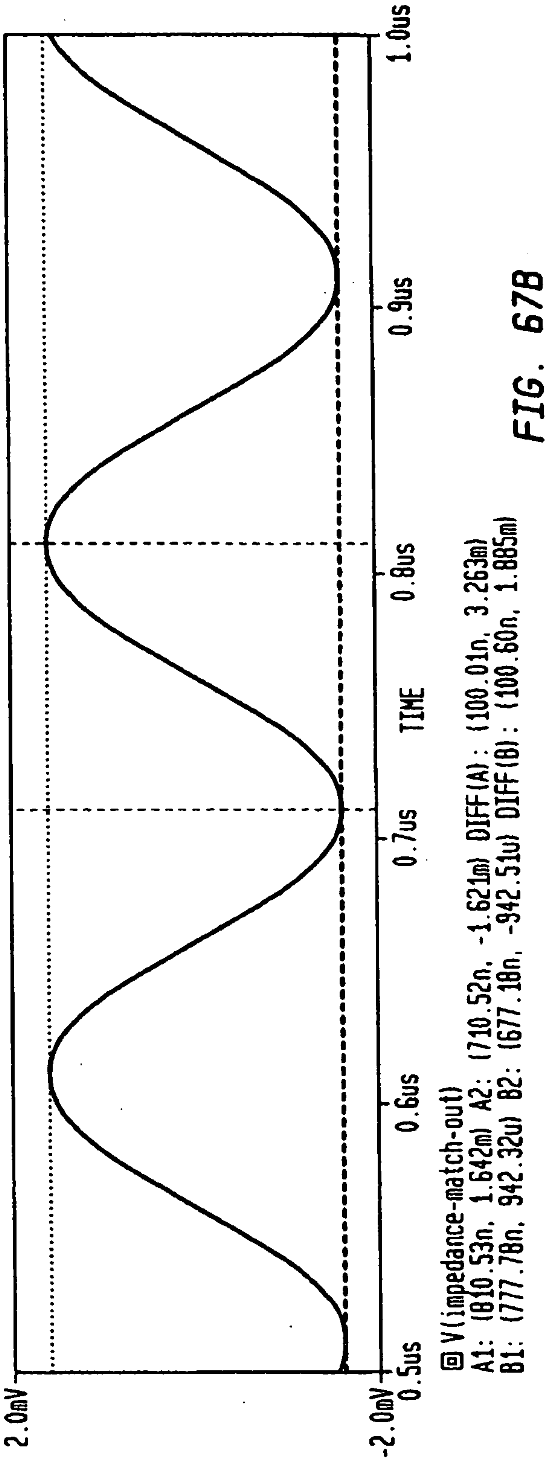


FIG. 67B

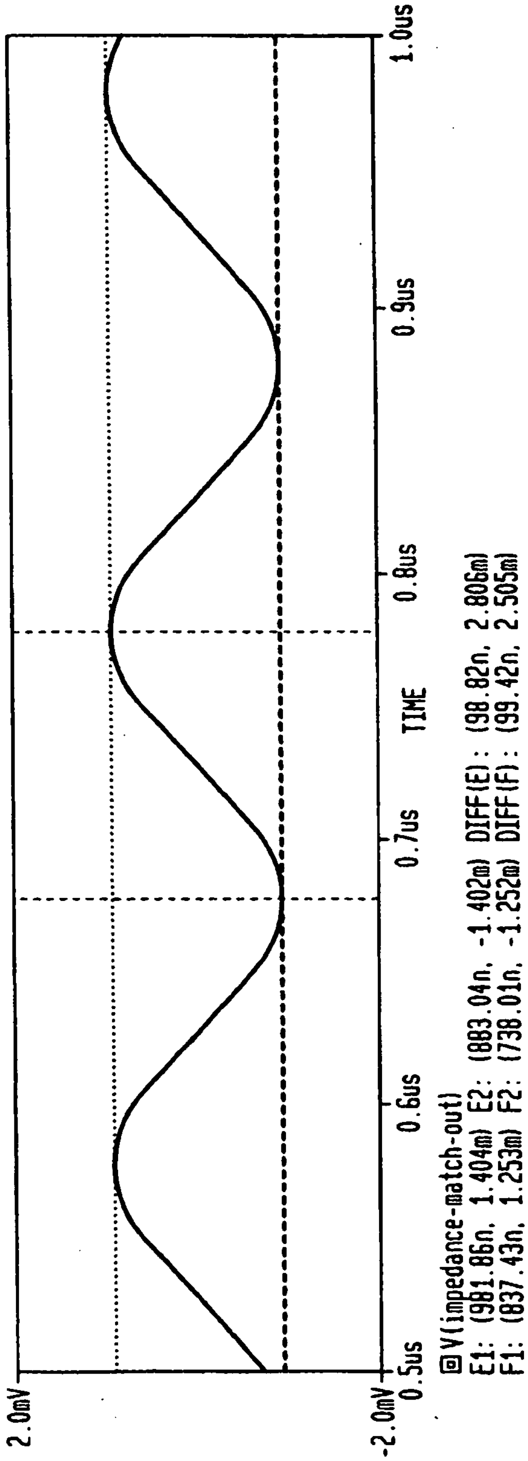

FIG. 68A

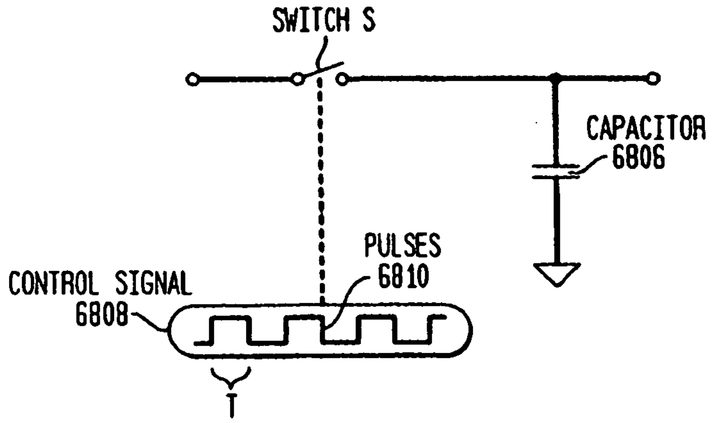


FIG. 68B

| | |
|---|---|
| $q=C\cdot V$ | EQ. 10 |
| $V=A\cdot \sin(t)$ | EQ. 11 |
| $q(t)=C\cdot A\cdot \sin(t)$ | EQ. 12 |
| $\Delta q(t)=C\cdot A\cdot \sin(t)-C\cdot A\cdot \sin(t-T)$ | EQ. 13 |
| $\Delta q(t)=C\cdot A\cdot (\sin(t)-\sin(t-T))$ | EQ. 14 |
| $\sin(\alpha)-\sin(\beta)=2\cdot \sin(\frac{\alpha-\beta}{2})\cdot \cos(\frac{\alpha+\beta}{2})$ | EQ. 15 |
| $\Delta q(t)=2\cdot C\cdot A\cdot \sin[\frac{t-(t-T)}{2}]\cdot \cos[\frac{t+(t-T)}{2}]$ | EQ. 16 |
| $\Delta q(t)=2\cdot C\cdot A\cdot \sin(\frac{1}{2}\cdot T)\cdot \cos(t-\frac{1}{2}\cdot T)$ | EQ. 17 |
| $q(t)=\int C\cdot A\cdot (\sin(t)-\sin(t-T))dt$ | EQ. 18 |
| $q(t)=-\cos(t)\cdot C\cdot A+\cos(t-T)\cdot C\cdot A$ | EQ. 19 |
| $q(t)=C\cdot A\cdot (\cos(t-T)-\cos(t))$ | EQ. 20 |

FIG. 68C

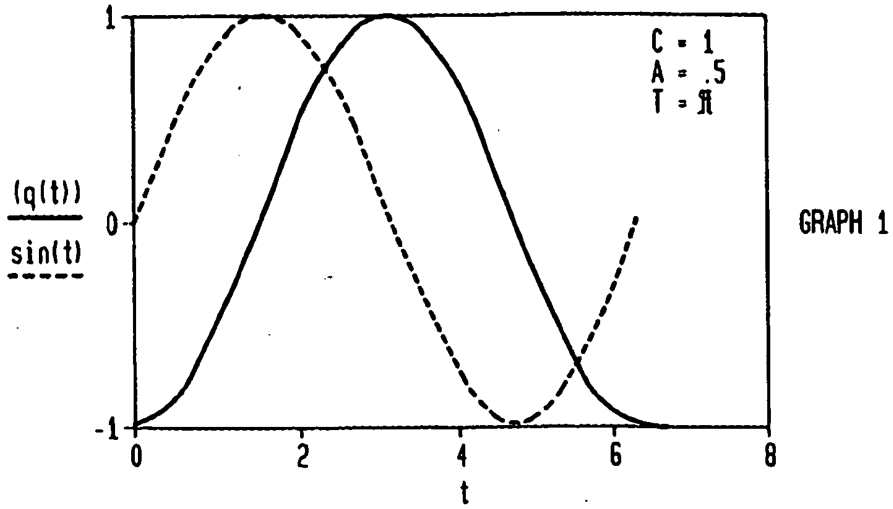


FIG. 68D

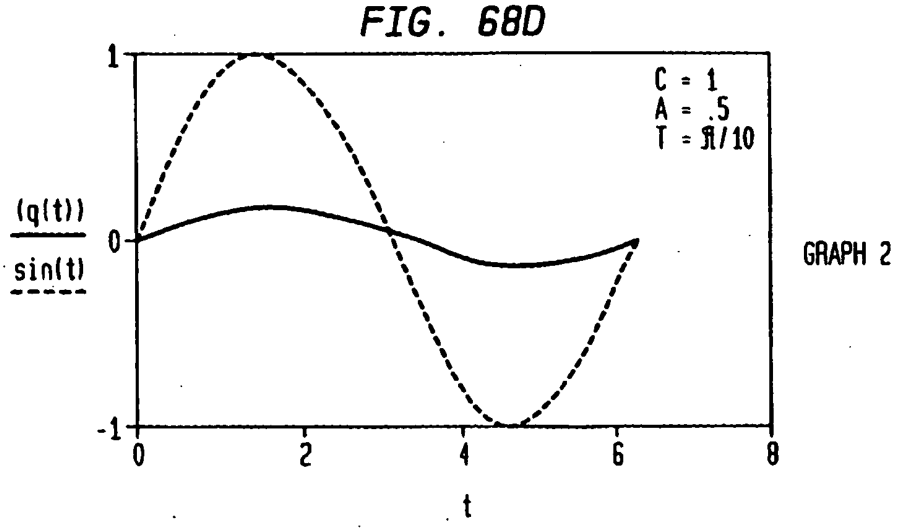


FIG. 68E

POWER-CHARGE RELATIONSHIP

| | |
|---|---|
| $q=C\cdot V$ | EQ. 21 |
| $V=q/C$ | EQ. 22 |
| $V=J/C$ | EQ. 23 |
| $J=q^2/C$ | EQ. 24 |
| $P=J/S$ | EQ. 25 |
| $P=\frac{q^2}{C\cdot S}$ | EQ. 26 |

FIG. 68F

INSERTION LOSS

INSERTION LOSS IN dB IS EXPRESSED BY:

$$ILdB=10\cdot\log\left(\frac{Pin}{Pout}\right) \text{ or}$$

$$ILdB=10\cdot\log\left[\frac{\left(\frac{Vin^2}{Rin}\right)}{\left(\frac{Vout^2}{Rout}\right)}\right]$$

FIG. 69A

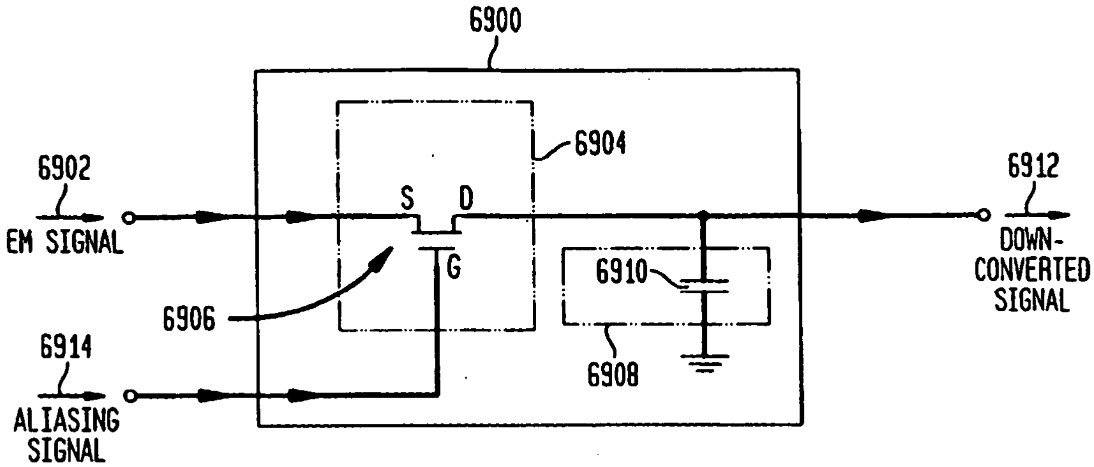


FIG. 69B

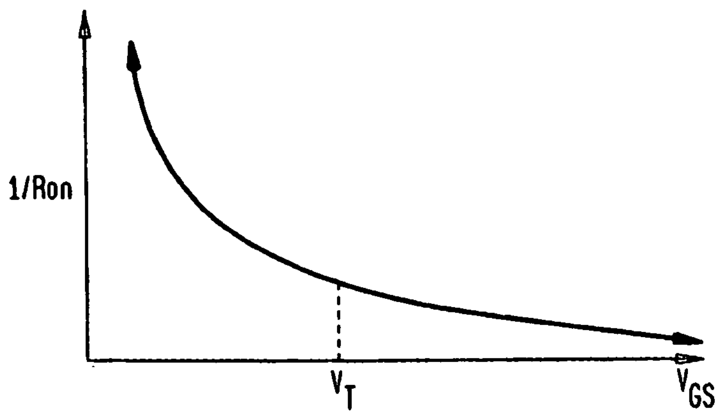

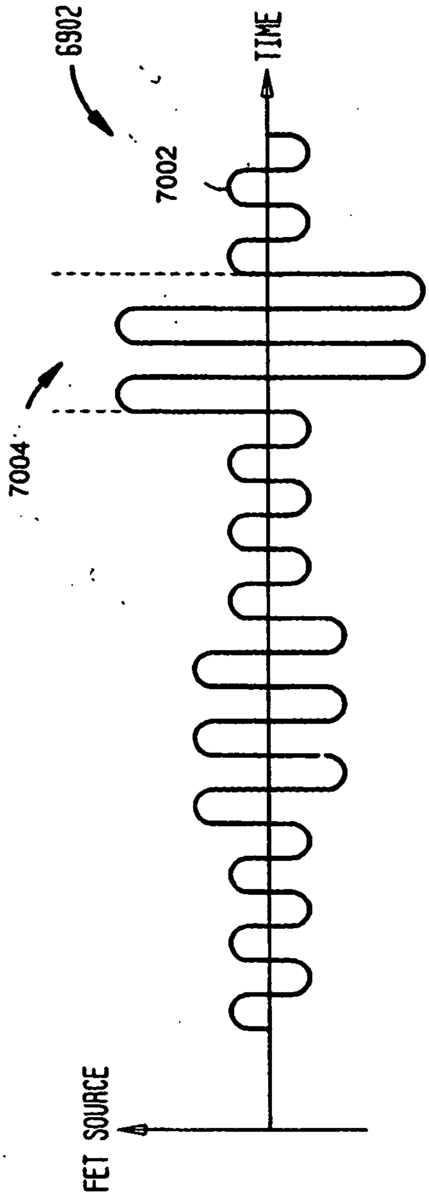


FIG. 70A

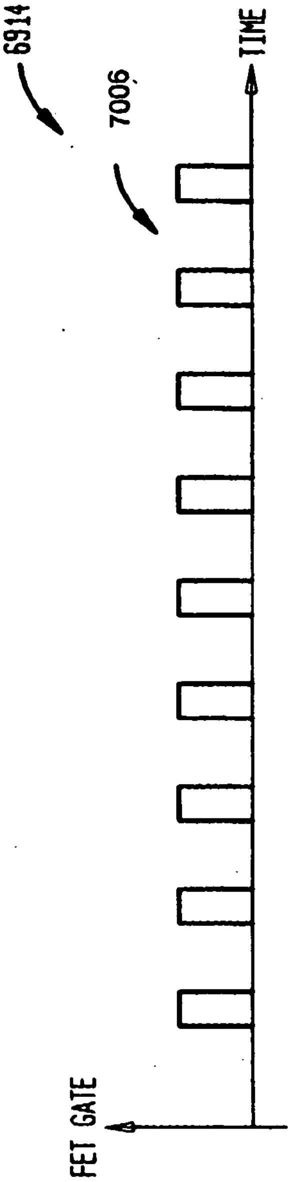


FIG. 70B

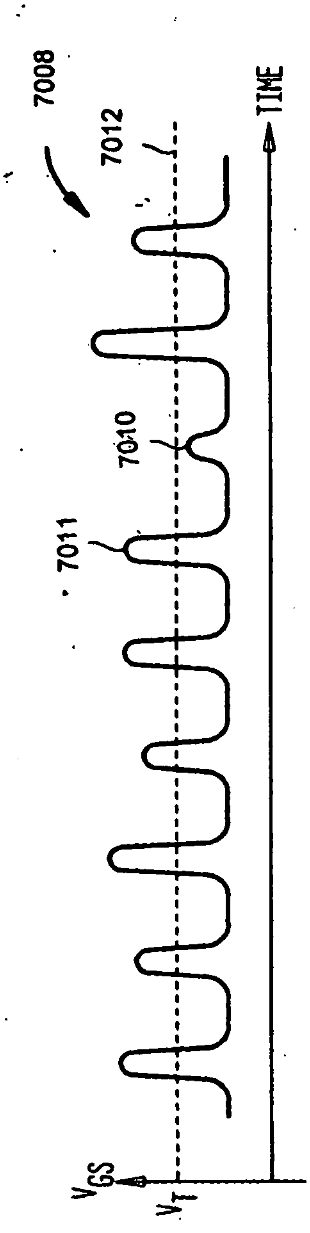


FIG. 70C

FIG. 71

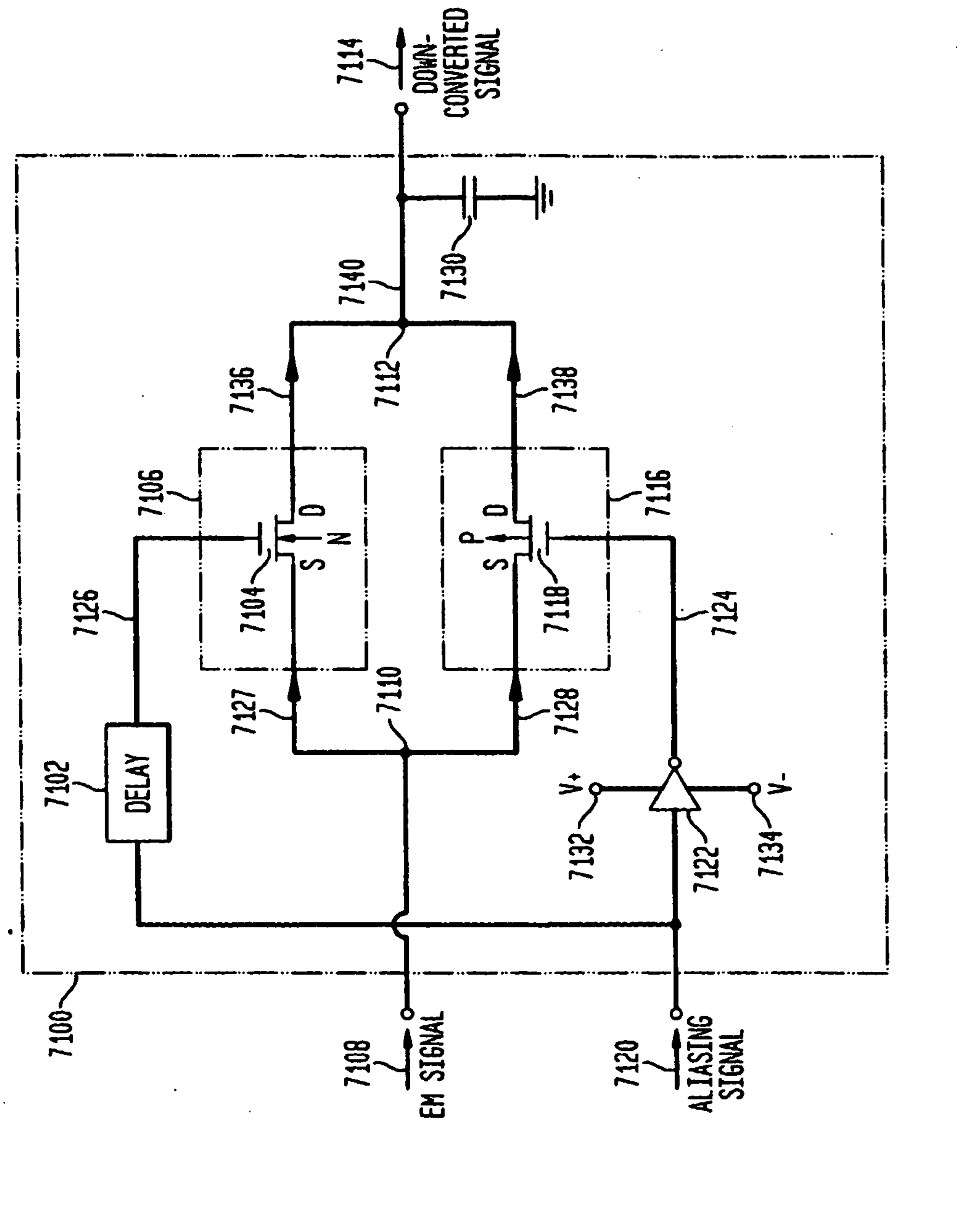
7100
7102
DELAY
7104
7106
7108
EM SIGNAL
7110
7112
7114
DOWN-
CONVERTED
SIGNAL
7116
7118
7120
ALIASING
SIGNAL
7122
7124
7126
7127
7128
7130
7132
7134
7136
7138
7140
V+
V-
S
D
N
P

FIG. 72A

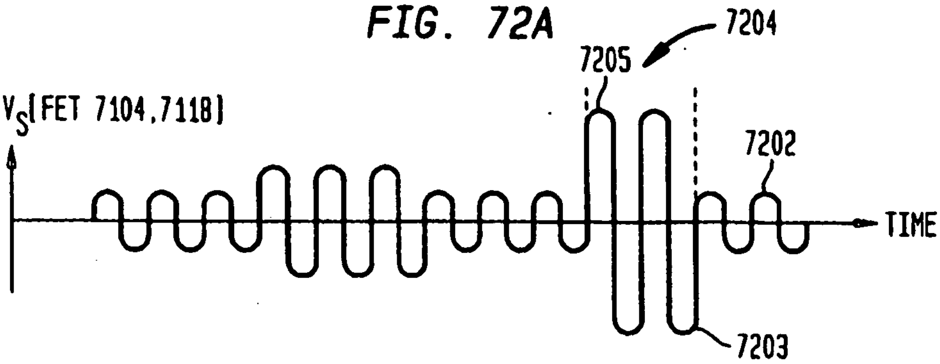


FIG. 72B

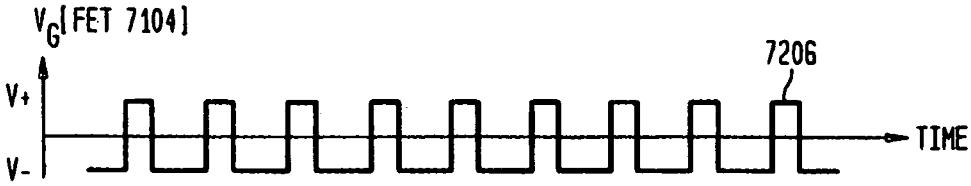


FIG. 72C

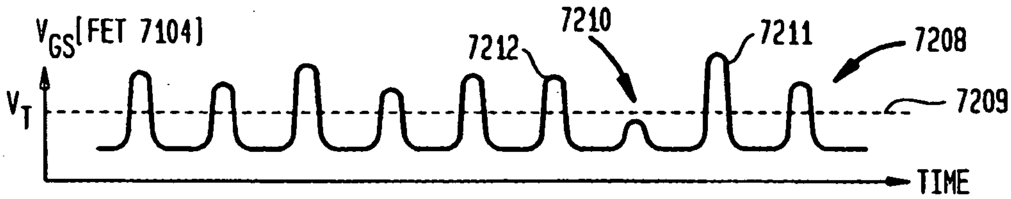


FIG. 72D

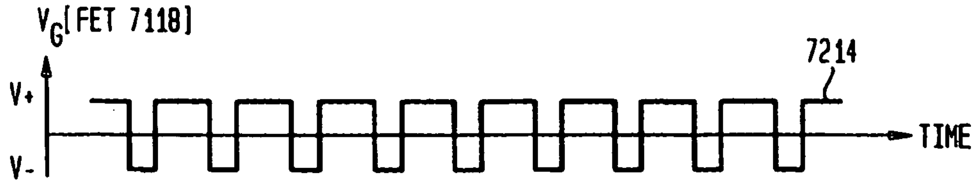


FIG. 72E

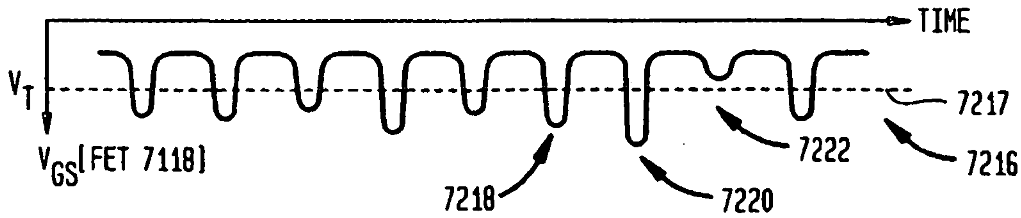

FIG. 73

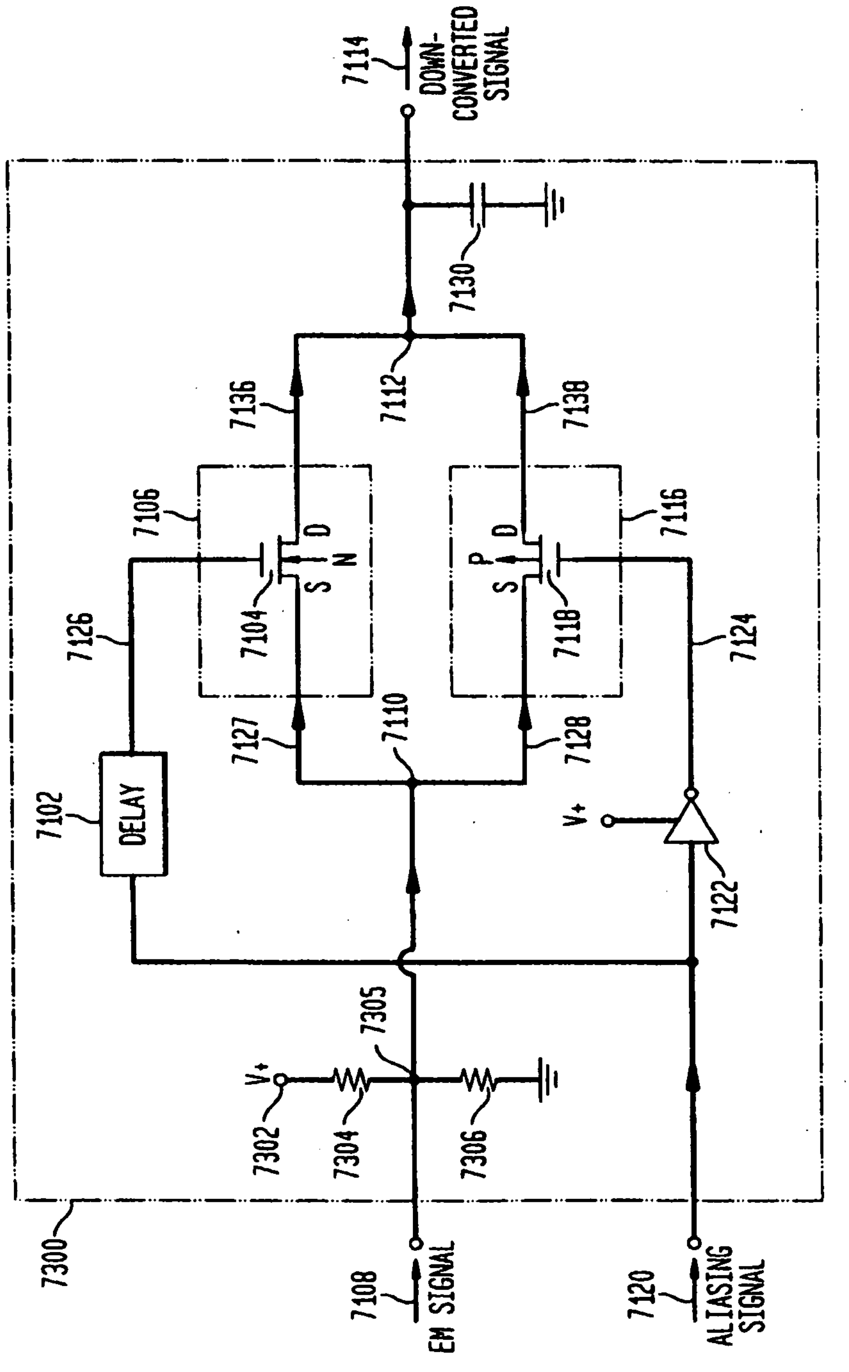
7114
DOWN-CONVERTED SIGNAL
7130
7112
7136
7138
7106
7116
D
N
S
P
7104
7118
7126
7124
7127
7110
7128
7102
DELAY
V+
7122
7305
V+
7302
7304
7306
7300
7108
EM SIGNAL
7120
ALIASING SIGNAL

FIG. 74

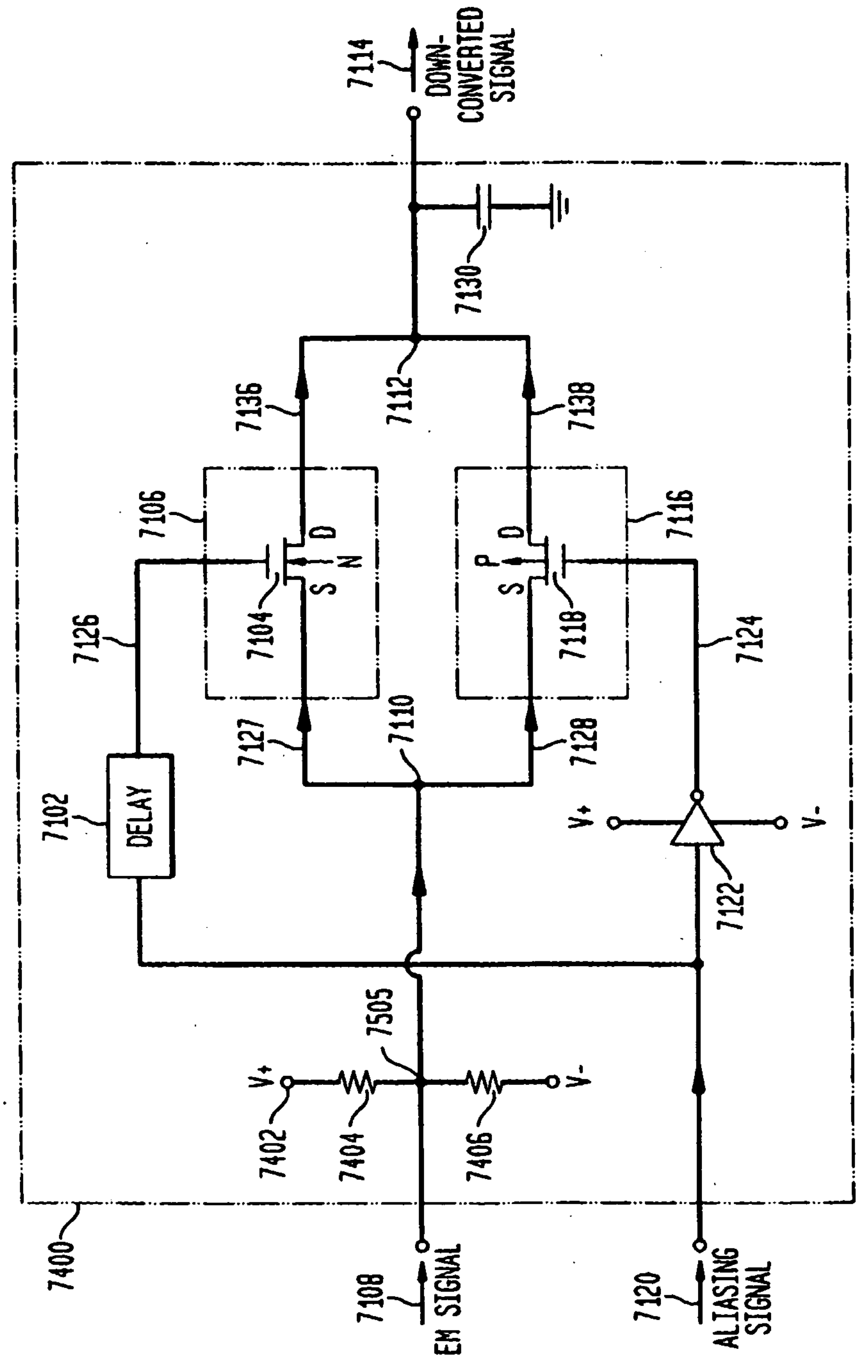
7114
DOWN-CONVERTED SIGNAL
7130
7112
7136
7138
7106
7116
7104
7118
D
S
N
P
7126
7124
7127
7110
7128
7102
DELAY
V+
V-
7122
7505
7402
7404
7406
7400
7108
EM SIGNAL
7120
ALIASING SIGNAL

FIG. 75

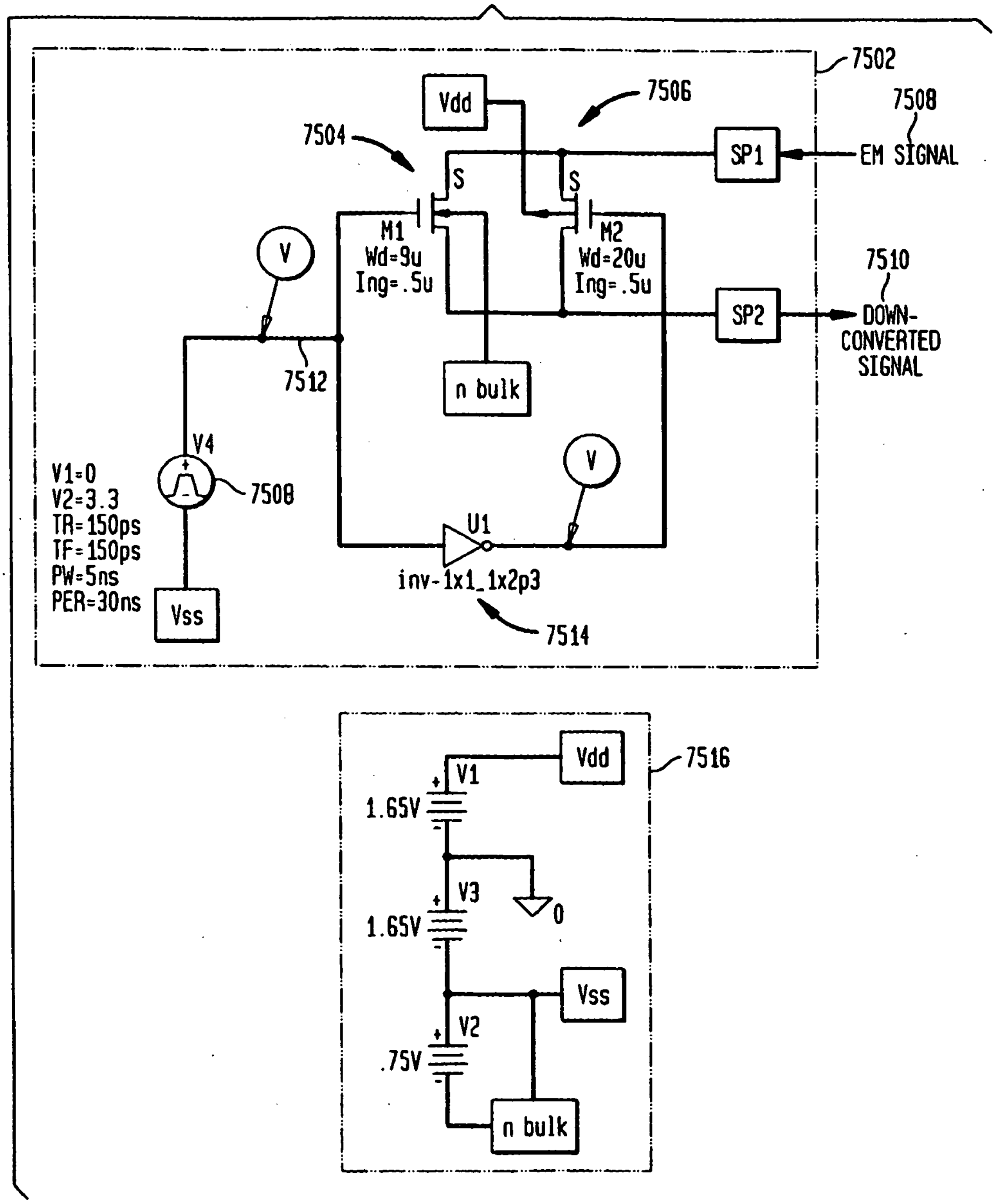
7502
7504
7506
Vdd
S
S
SP1
7508
EM SIGNAL
M1
Wd=9u
Lng=.5u
M2
Wd=20u
Lng=.5u
V
SP2
7510
DOWN-
CONVERTED
SIGNAL
7512
n bulk
V4
V1=0
V2=3.3
TR=150ps
TF=150ps
PW=5ns
PER=30ns
7508
Vss
V
U1
inv-1x1_1x2p3
7514
7516
Vdd
V1
1.65V
V3
1.65V
0
Vss
V2
.75V
n bulk

FIG. 76

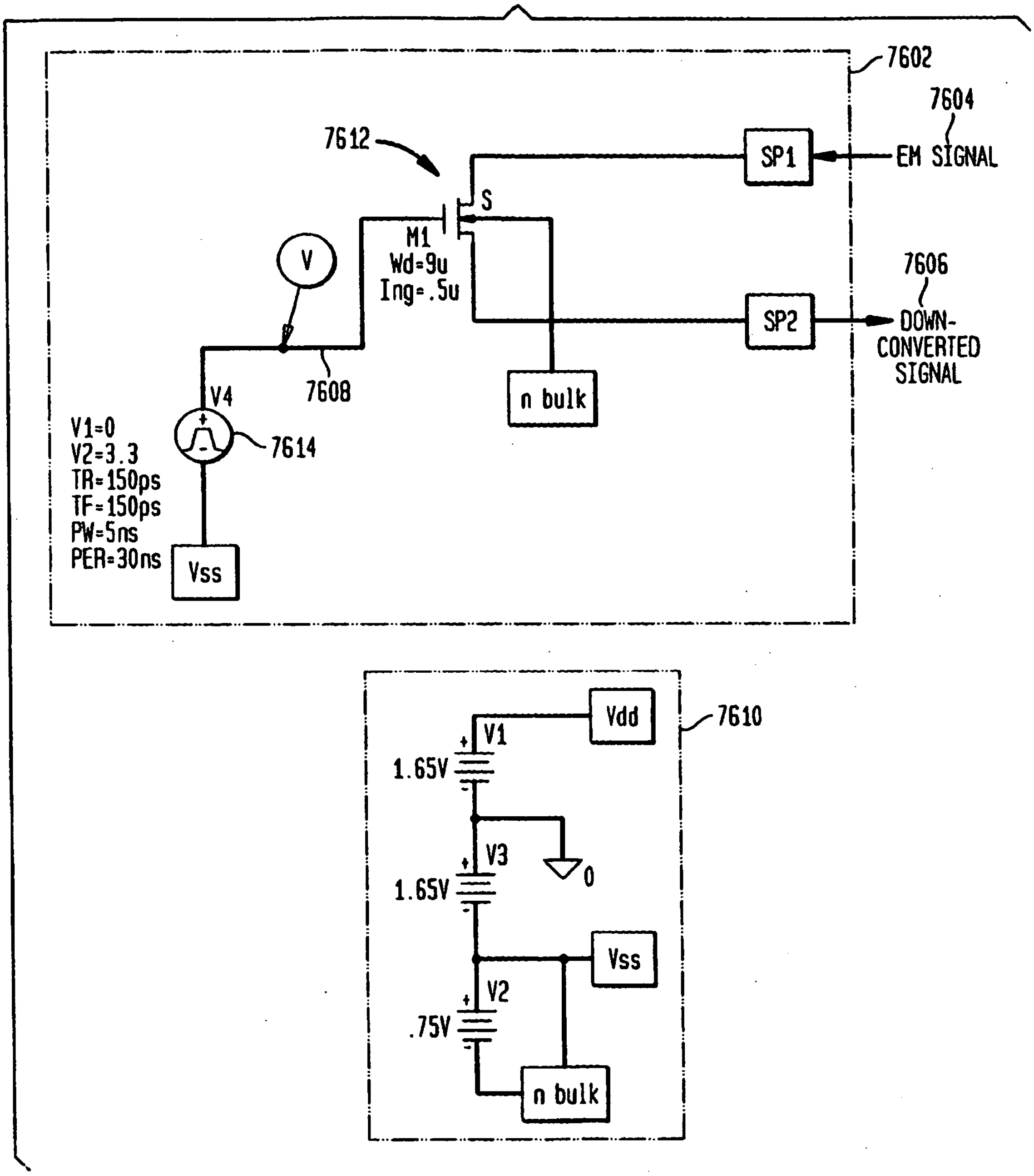
7602
7604
EM SIGNAL
7612
SP1
S
M1
Wd=9u
lng=.5u
V
7606
SP2
DOWN-
CONVERTED
SIGNAL
V4
7608
n bulk
V1=0
V2=3.3
TR=150ps
TF=150ps
PW=5ns
PER=30ns
7614
Vss
Vdd
7610
V1
1.65V
V3
1.65V
0
Vss
V2
.75V
n bulk

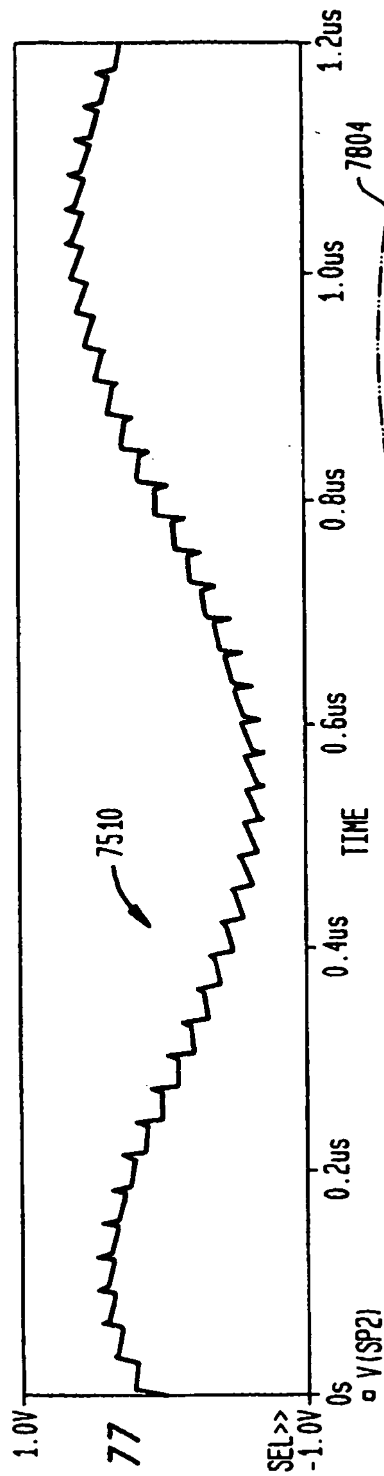


FIG. 77

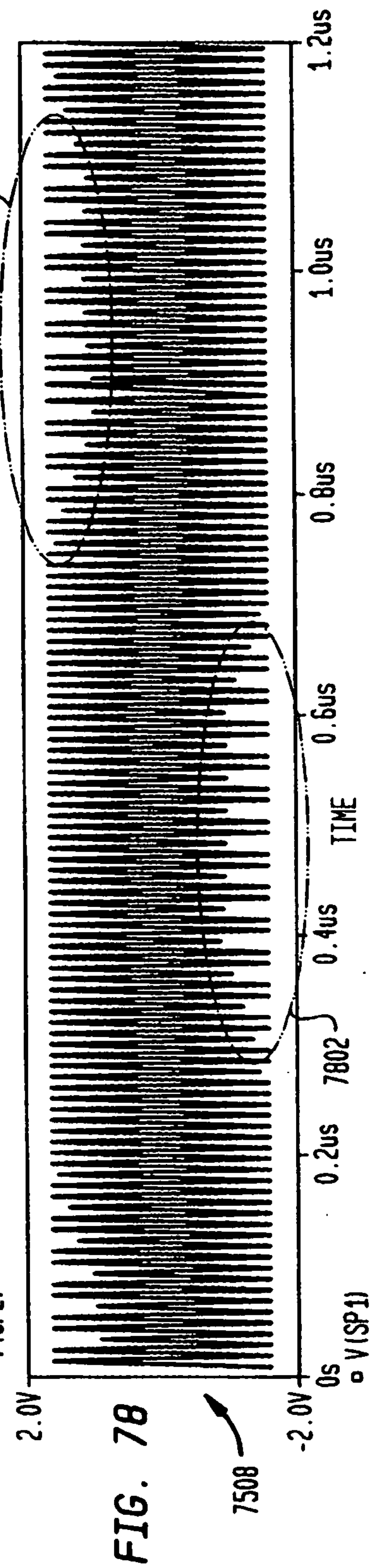


FIG. 78

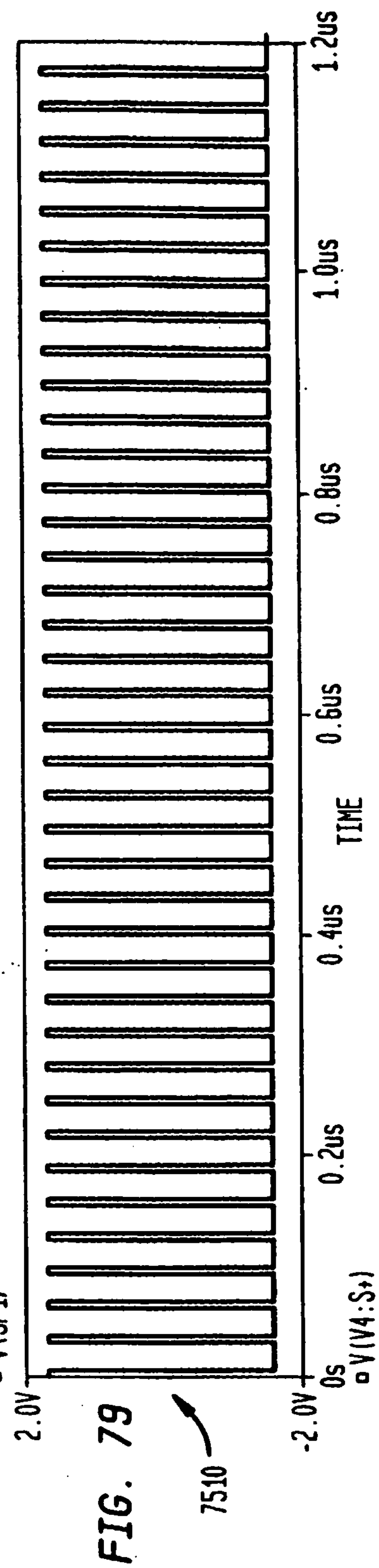


FIG. 79

FIG. 80

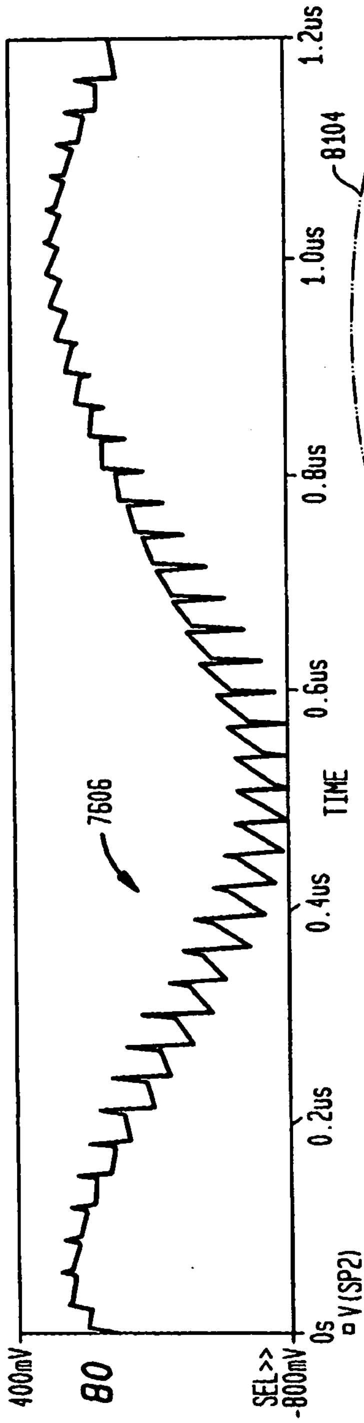


FIG. 81

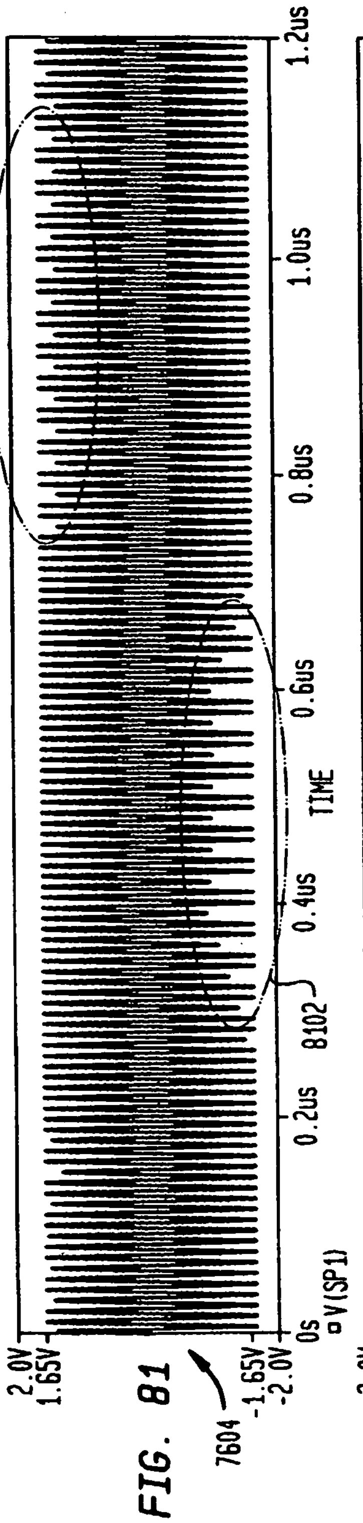


FIG. 82

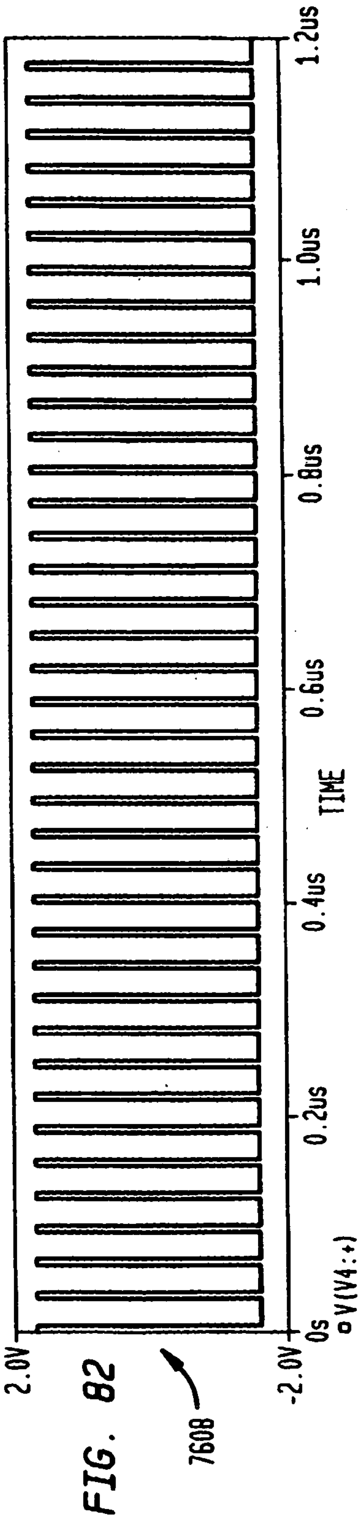

FIG. 83A

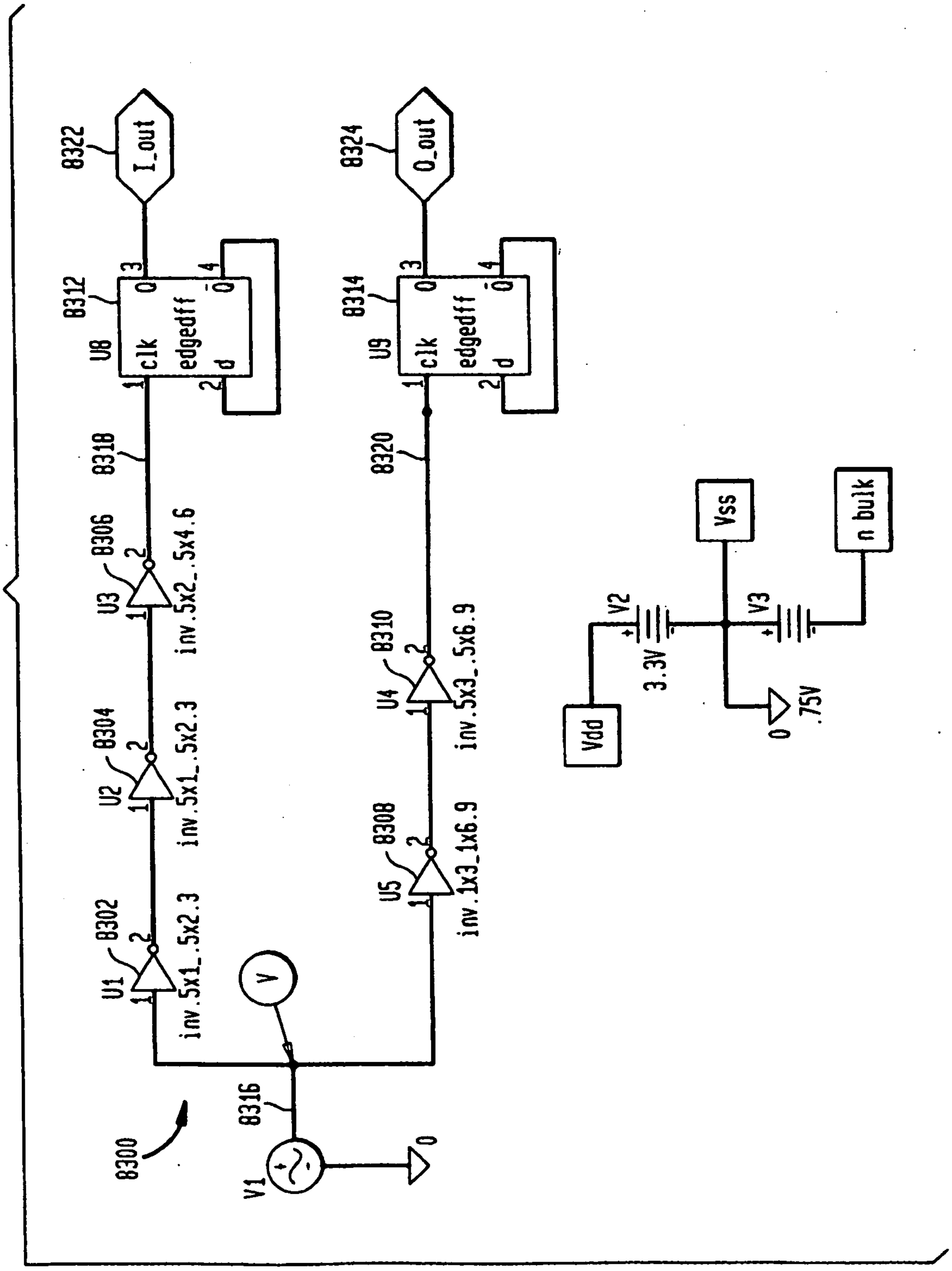
8322
I_out
8324
Q_out
8312
U8
clk
edgedff
d
Q
8314
U9
8318
8320
8306
U3
inv.5x2_.5x4.6
8304
U2
inv.5x1_.5x2.3
8302
U1
inv.5x1_.5x2.3
8310
U4
inv.5x3_.5x6.9
8308
U5
inv.1x3_1x6.9
V
8316
V1
0
8300
Vss
n bulk
V2
V3
3.3V
.75V
Vdd

FIG. 83B

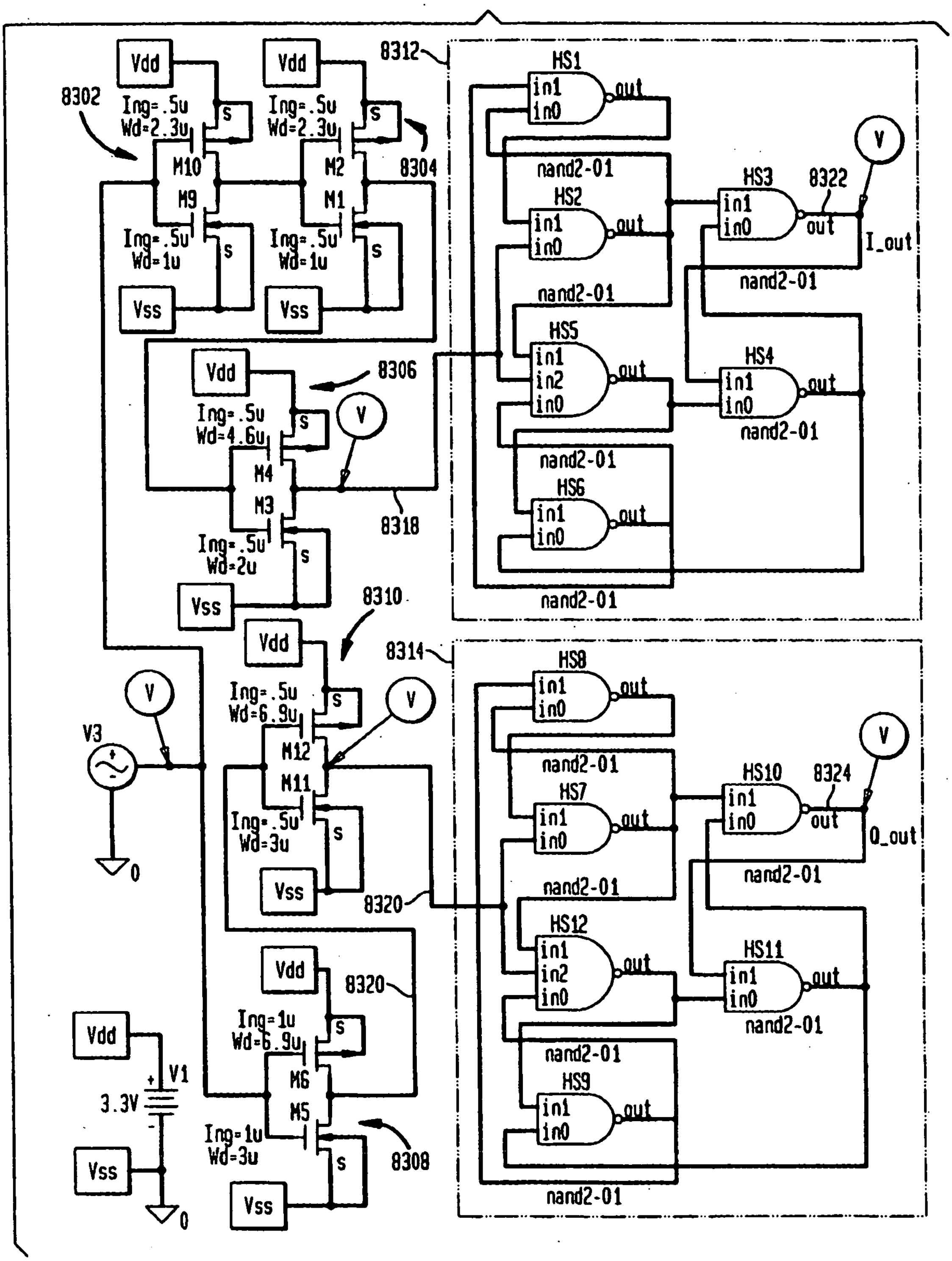

Vdd
Vss
Ing=.5u
Wd=2.3u
Wd=1u
M10
M9
M2
M1
8302
8304
8306
Ing=.5u
Wd=4.6u
M4
M3
Wd=2u
8318
8310
Wd=6.9u
M12
M11
Wd=3u
8320
Ing=1u
M6
M5
8308
V3
V1
3.3V
0
8312
HS1
HS2
HS3
HS4
HS5
HS6
in1
in0
in2
out
nand2-01
8322
I_out
8314
HS7
HS8
HS9
HS10
HS11
HS12
8324
Q_out
V
s

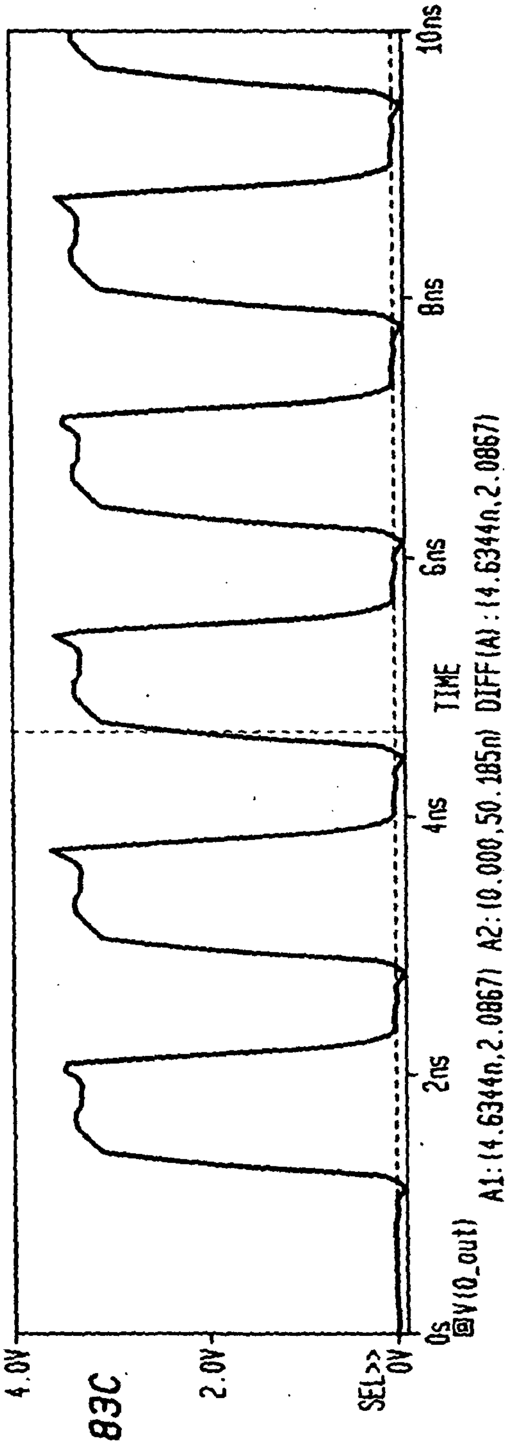


FIG. 83C

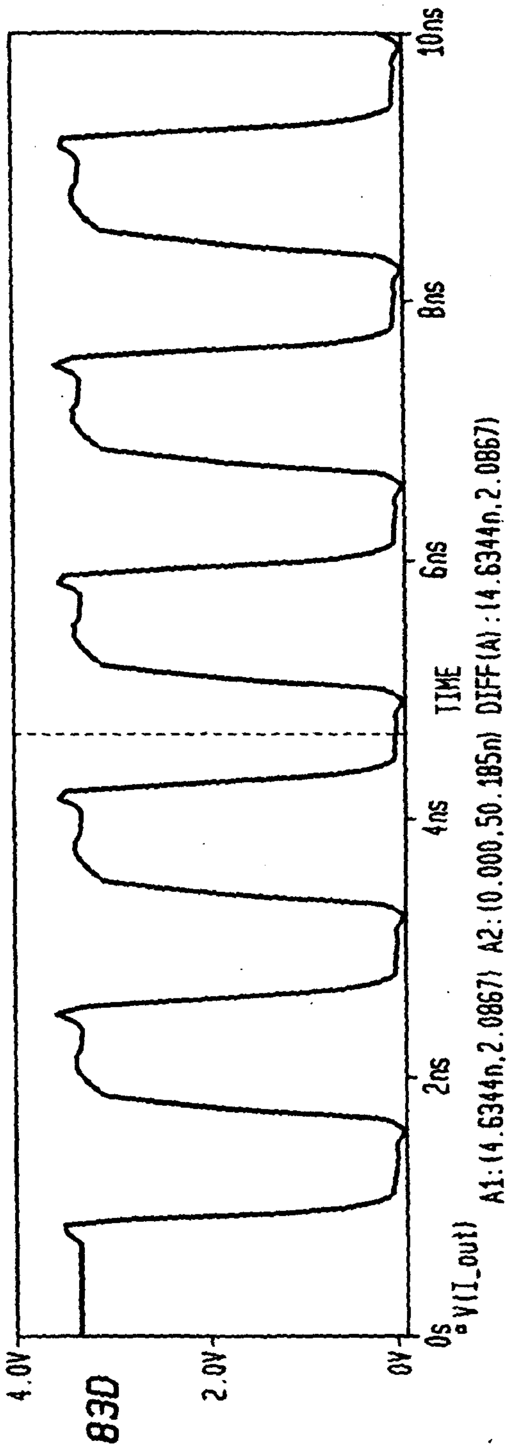


FIG. 83D

FIG. 83E

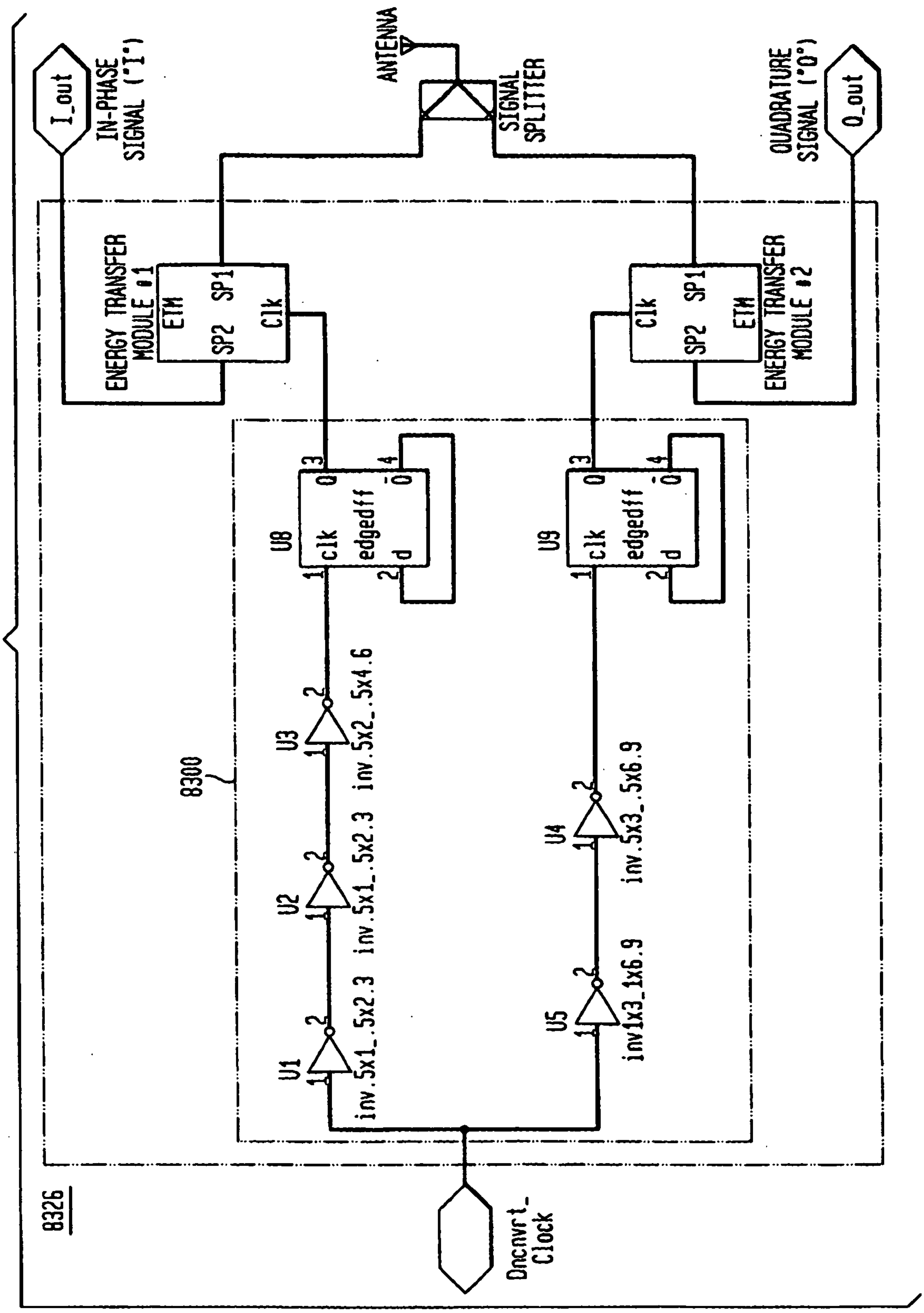
I_out
IN-PHASE SIGNAL ("I")
ANTENNA
SIGNAL SPLITTER
QUADRATURE SIGNAL ("Q")
Q_out
ENERGY TRANSFER MODULE #1
ETM
SP1
SP2
Clk
ENERGY TRANSFER MODULE #2
8300
U8
U9
clk
edgedff
d
Q
U1
U2
U3
U4
U5
inv.5x1_.5x2.3
inv.5x1_.5x2.3
inv.5x2_.5x4.6
inv.5x3_.5x6.9
inv1x3_1x6.9
8326
Dncnvrt_Clock

FIG. 83F

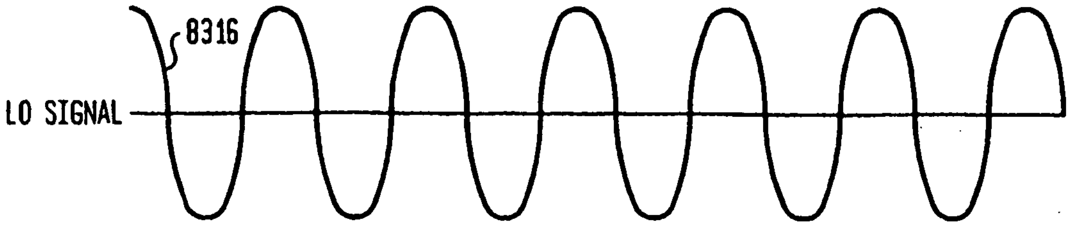


FIG. 83G

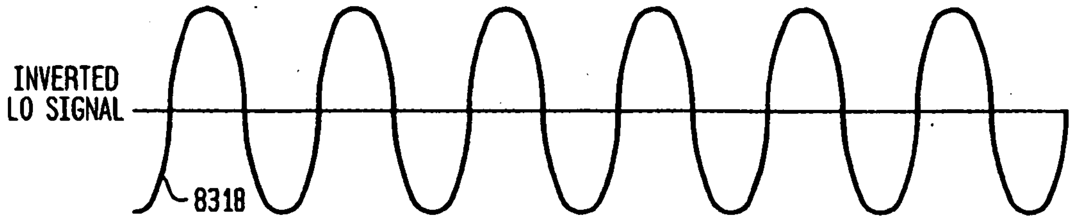


FIG. 83H

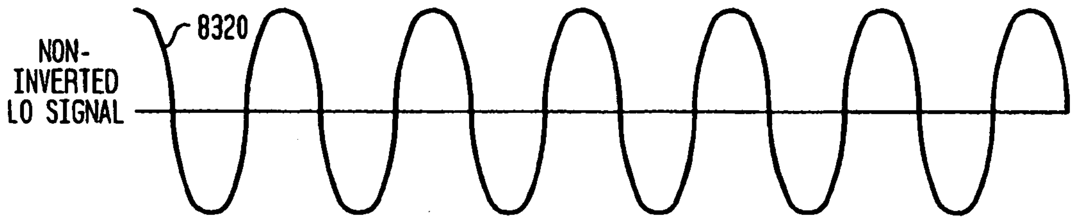


FIG. 83I

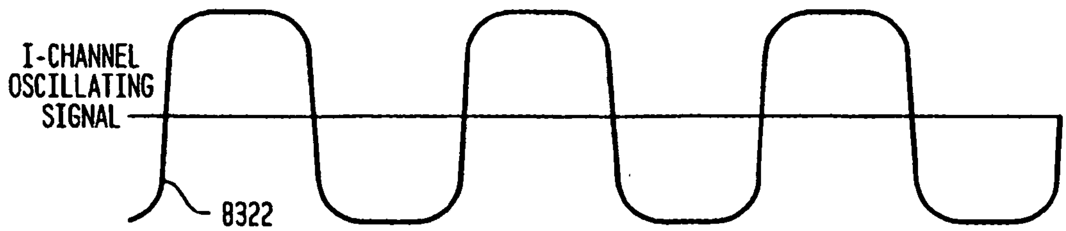


FIG. 83J

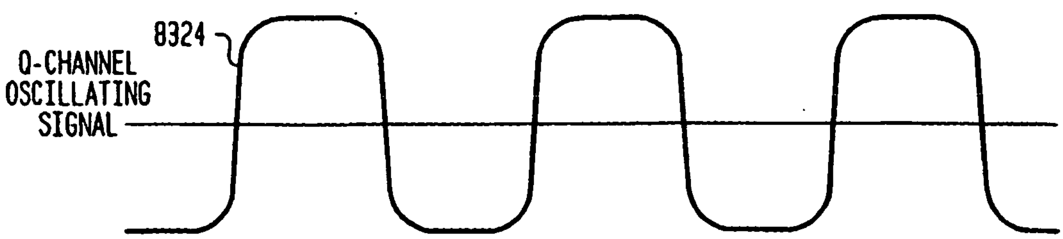

FIG. 84

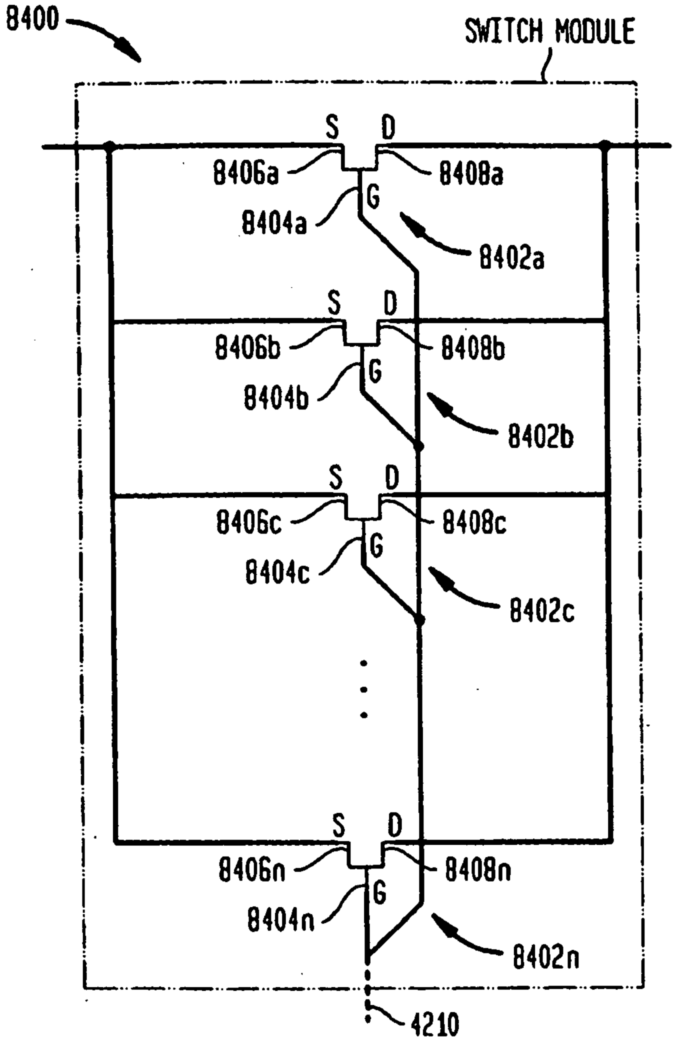
8400
SWITCH MODULE
S
D
8406a
8408a
G
8404a
8402a
8406b
8408b
8404b
8402b
8406c
8408c
8404c
8402c
8406n
8408n
8404n
8402n
4210

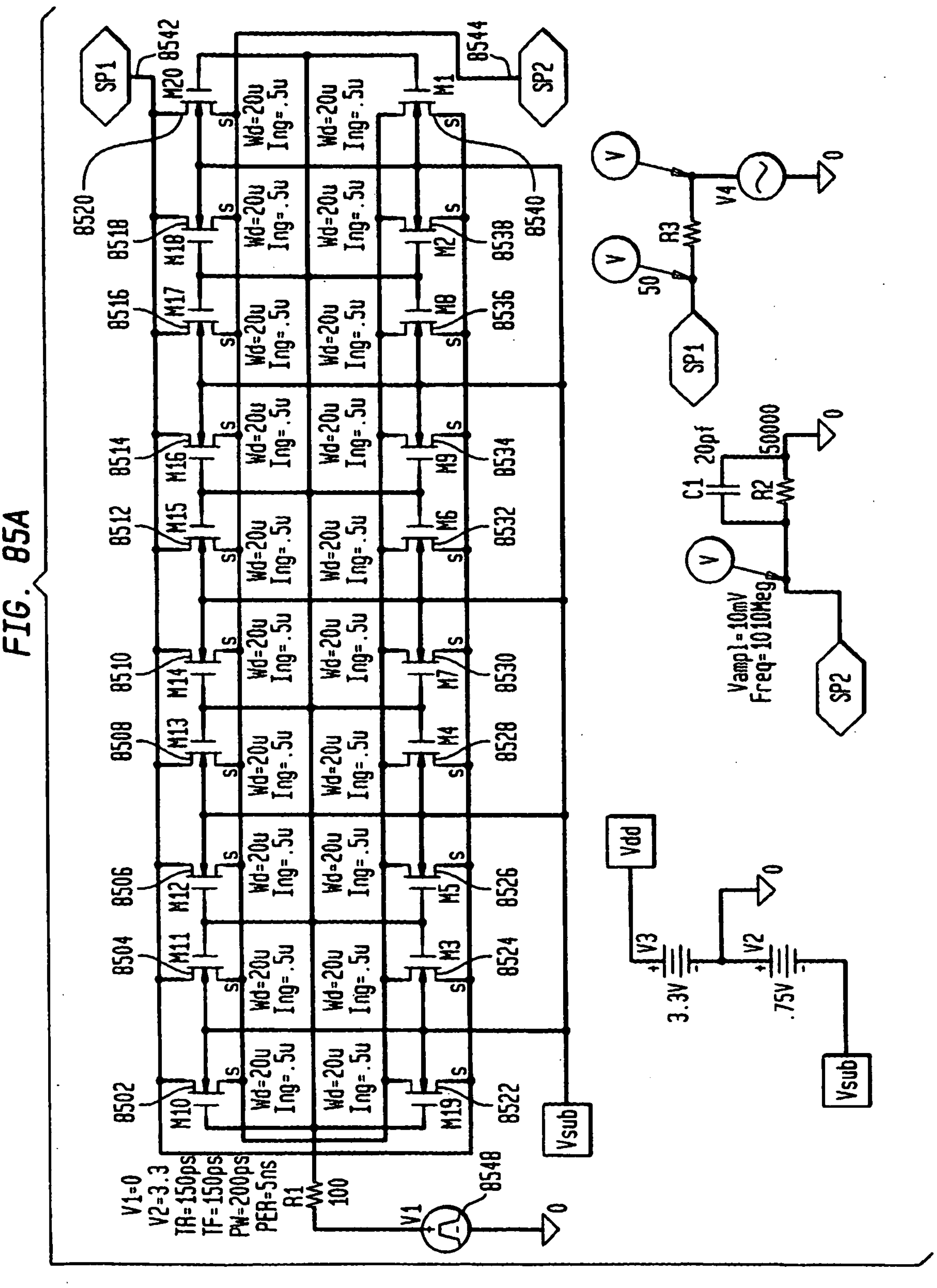
SP1
8542
M20
8520
8518
M18
8516
M17
8514
M16
8512
M15
8510
M14
8508
M13
8506
M12
8504
M11
8502
M10
SP2
8544
M1
8540
8538
M2
8536
M8
8534
M9
8532
M6
8530
M7
8528
M4
8526
M5
8524
M3
8522
M19
Wd=20u
Lng=.5u
s
Vsub
V1=0
V2=3.3
TR=150ps
TF=150ps
PW=200ps
PER=5ns
R1
100
V1
8548
0
V
V4
R3
50
C1
20pf
R2
50000
Vampl=10mV
Freq=1010Meg
Vdd
V3
3.3V
V2
.75V

FIG. 85A

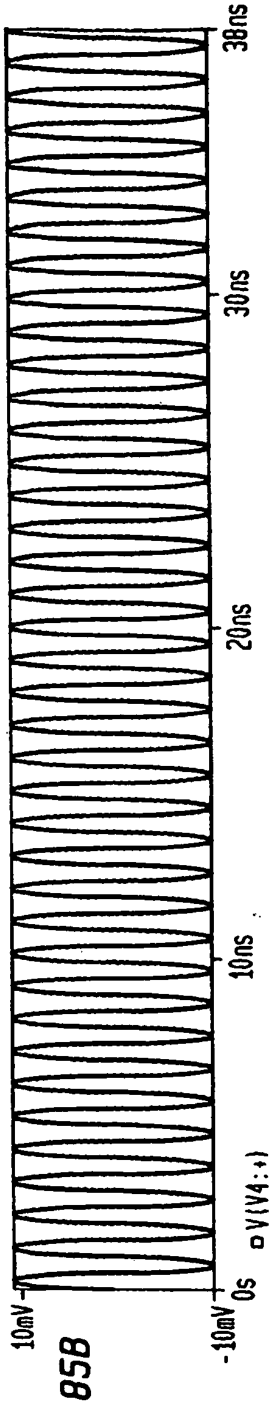


FIG. 85B

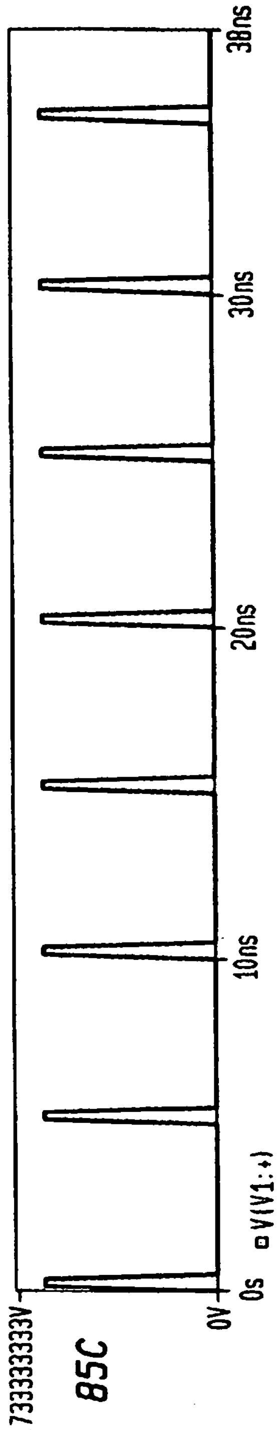


FIG. 85C

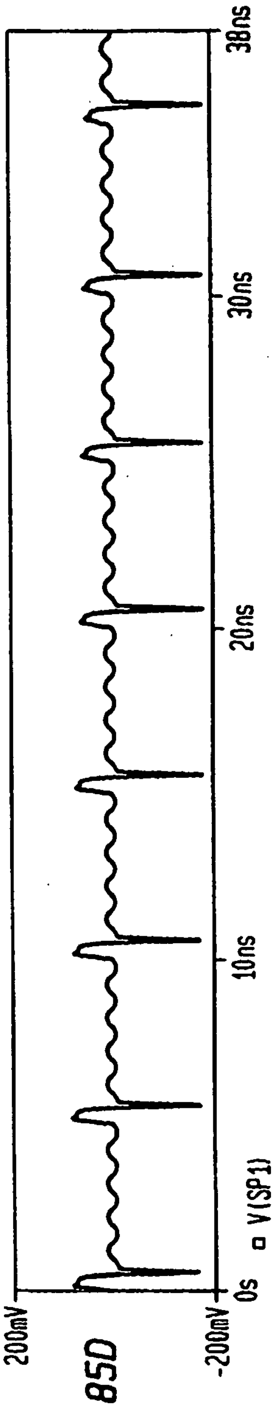


FIG. 85D

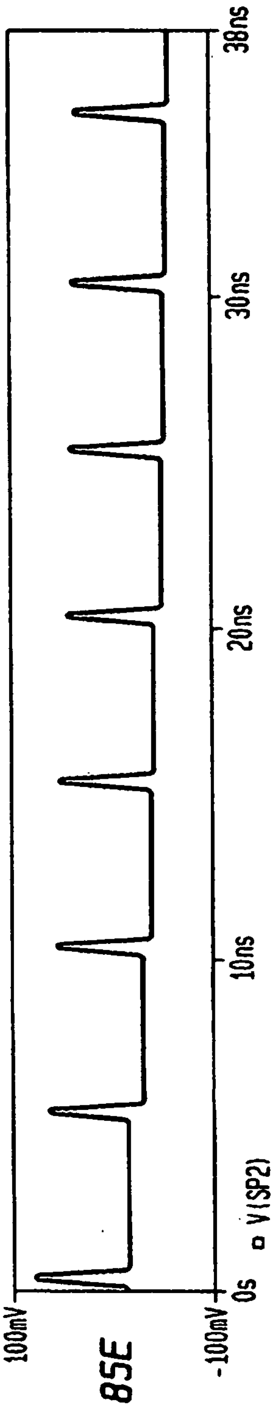


FIG. 85E

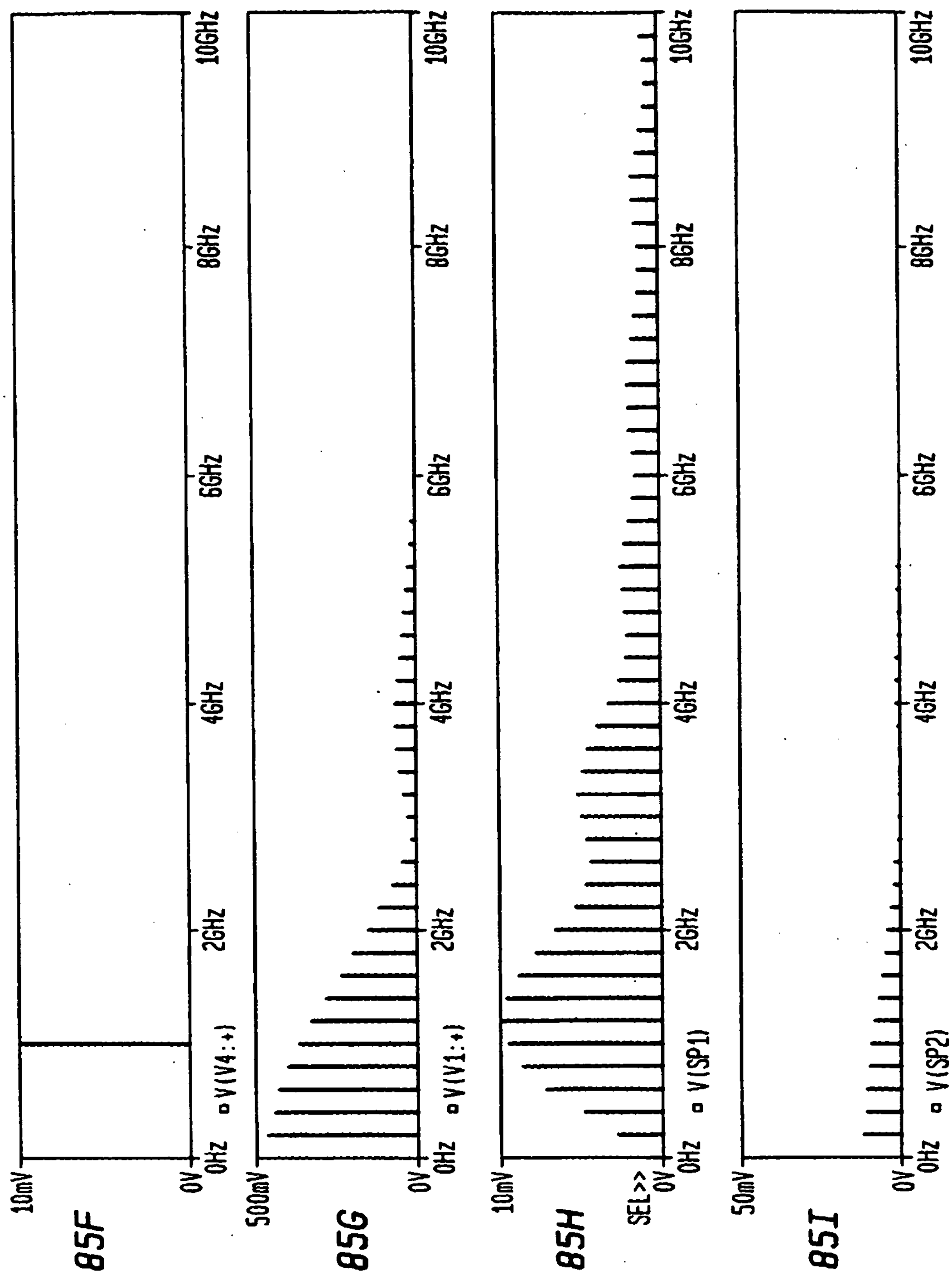


FIG. 85F

FIG. 85G

FIG. 85H

FIG. 85I

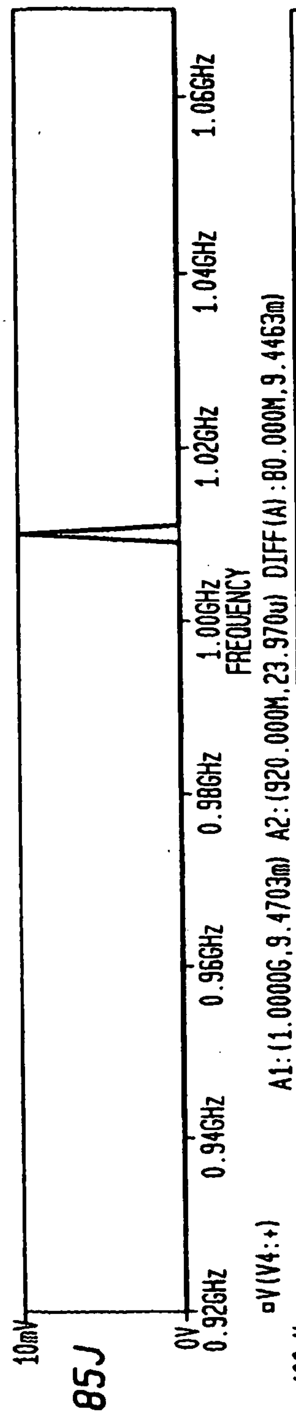


FIG. 85J

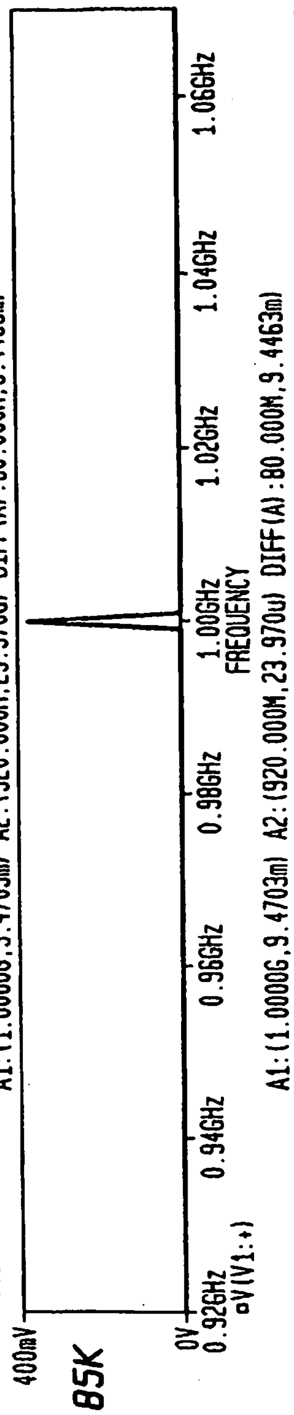


FIG. 85K

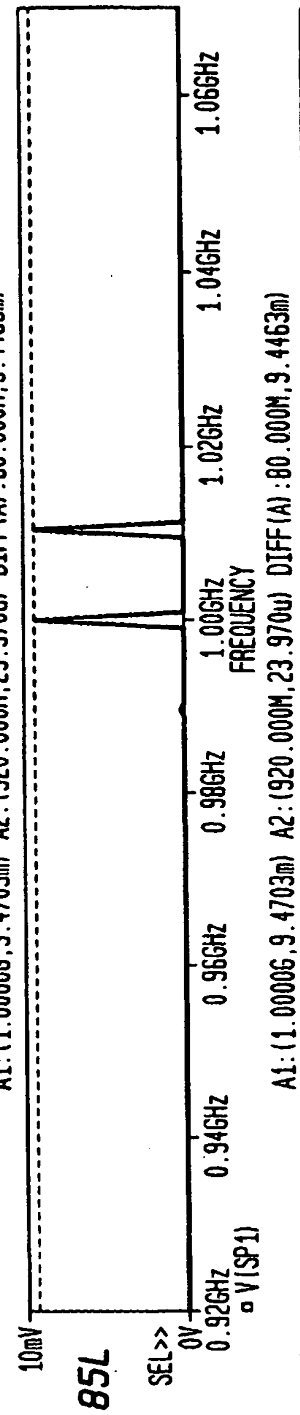


FIG. 85L

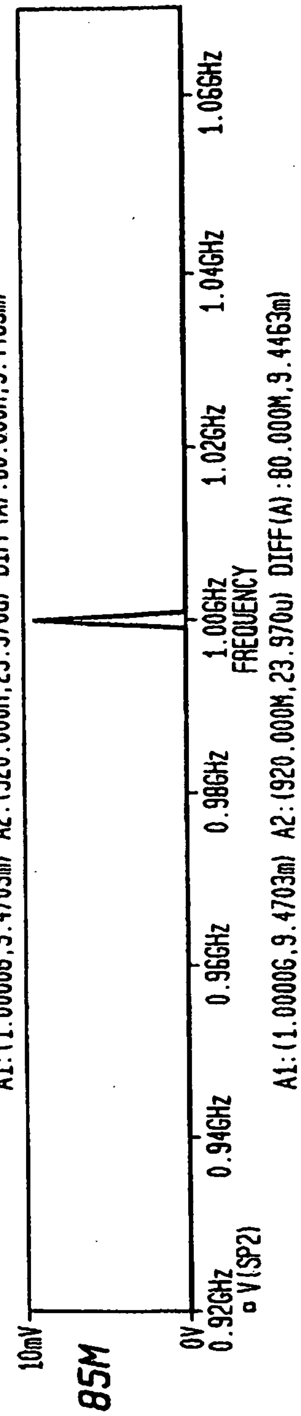


FIG. 85M

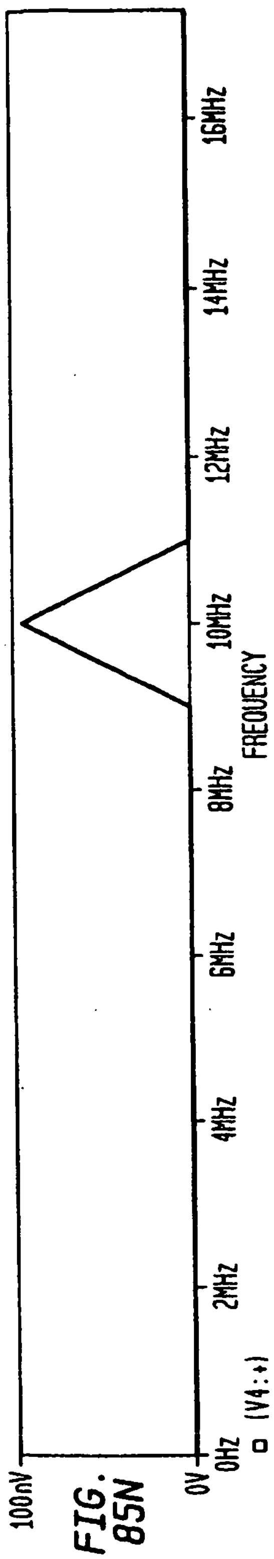


FIG. 85N

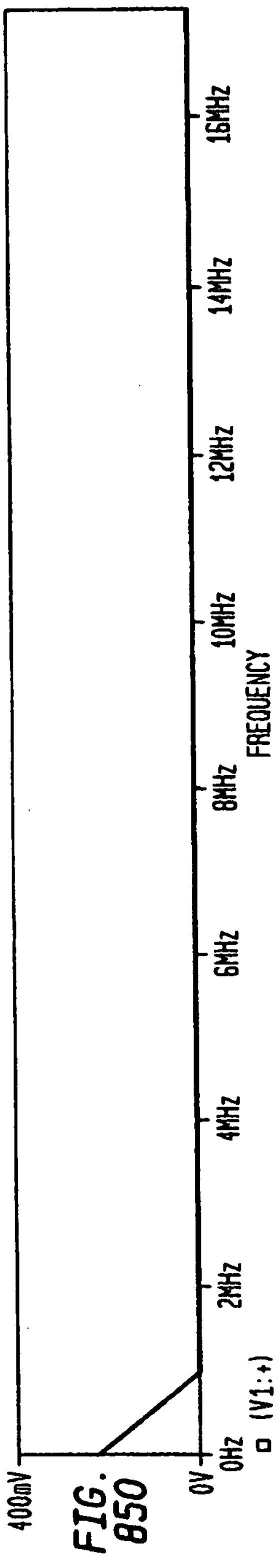


FIG. 85O

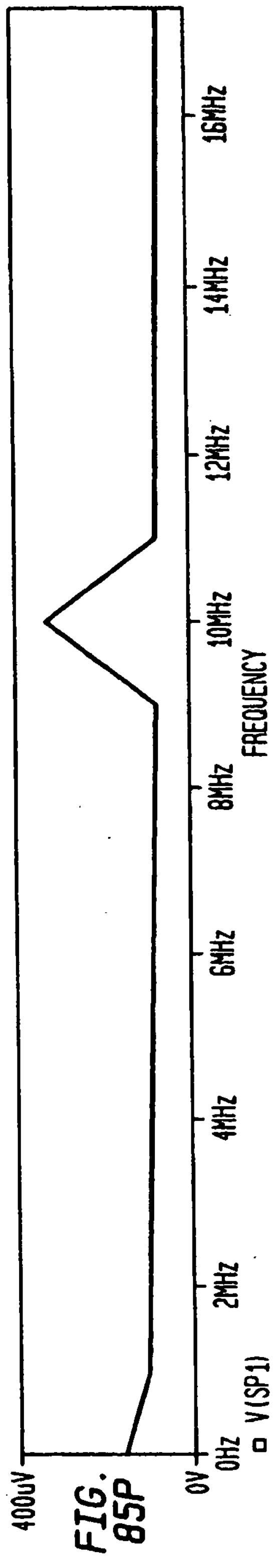


FIG. 85P

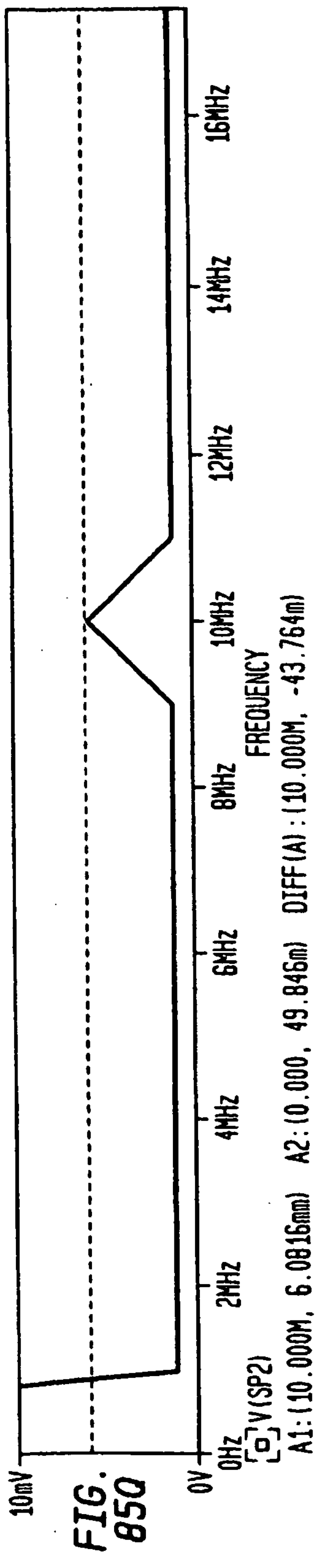


FIG. 85Q

FIG. 86A

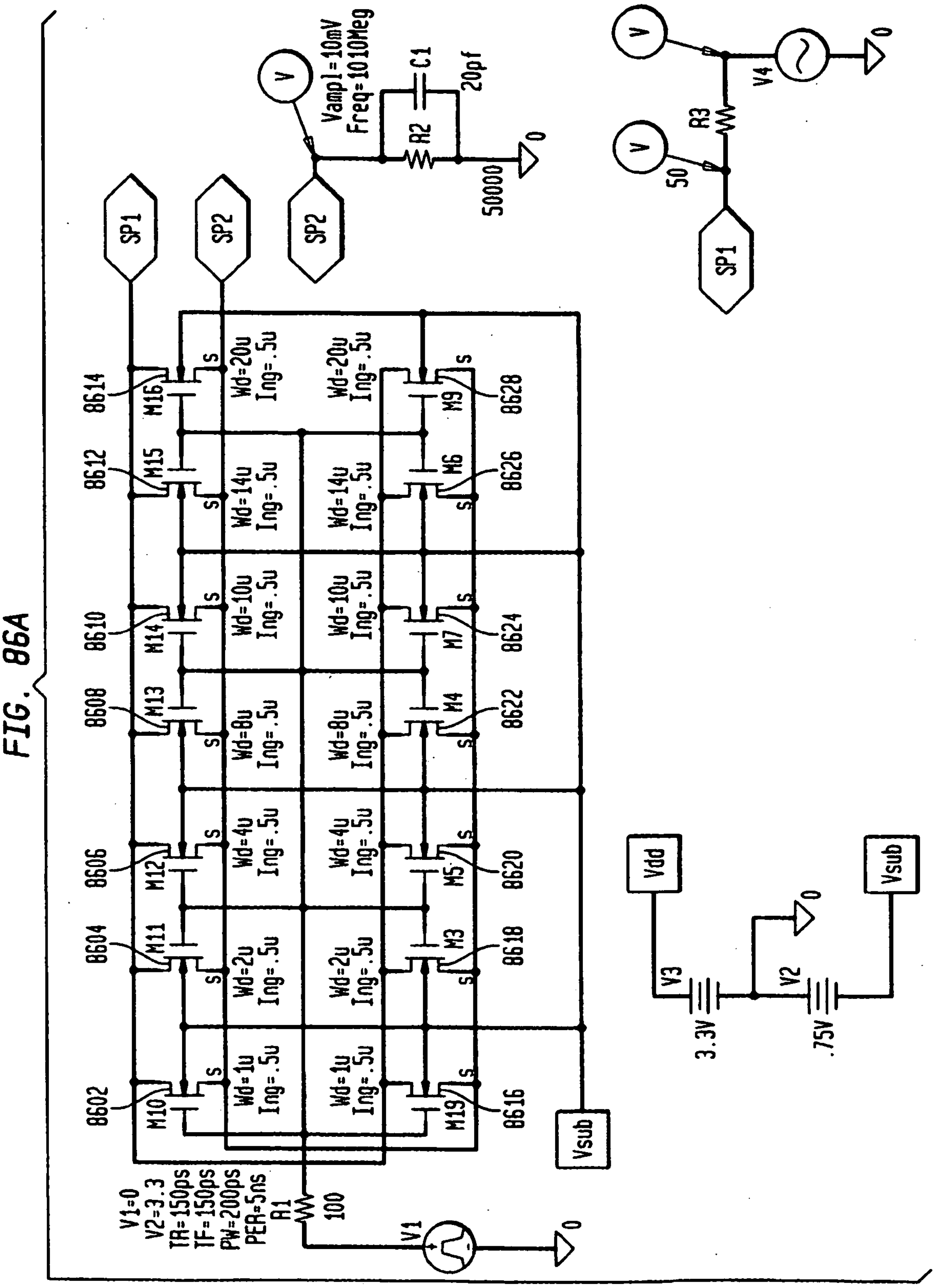
SP1
SP2
SP2
Vampl=10mV
Freq=1010Meg
C1
20pf
R2
50000
0
V
V
V
R3
50
V4
0
SP1
8602
8604
8606
8608
8610
8612
8614
M10
M11
M12
M13
M14
M15
M16
M19
M3
M5
M4
M7
M6
M9
8616
8618
8620
8622
8624
8626
8628
Wd=1u
Ing=.5u
Wd=2u
Ing=.5u
Wd=4u
Ing=.5u
Wd=8u
Ing=.5u
Wd=10u
Ing=.5u
Wd=14u
Ing=.5u
Wd=20u
Ing=.5u
Vsub
Vdd
V3
3.3V
V2
.75V
Vsub
0
V1=0
V2=3.3
TR=150ps
TF=150ps
PW=200ps
PER=5ns
R1
100
V1
0

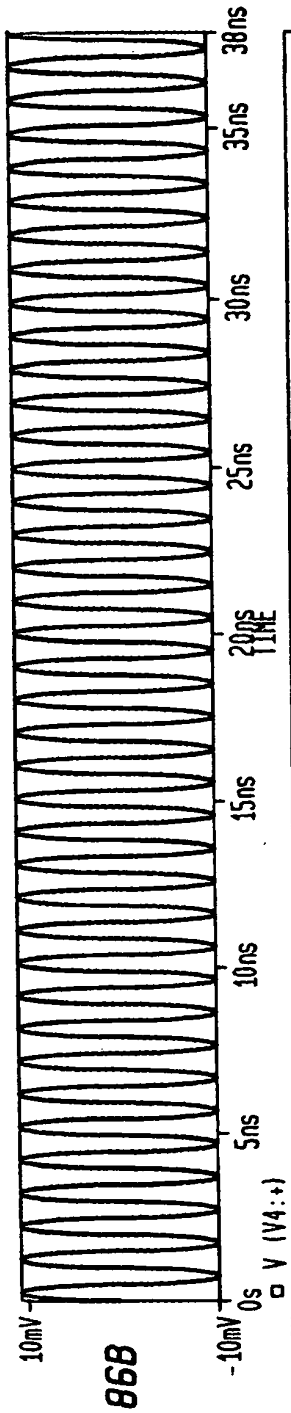


FIG. 86B

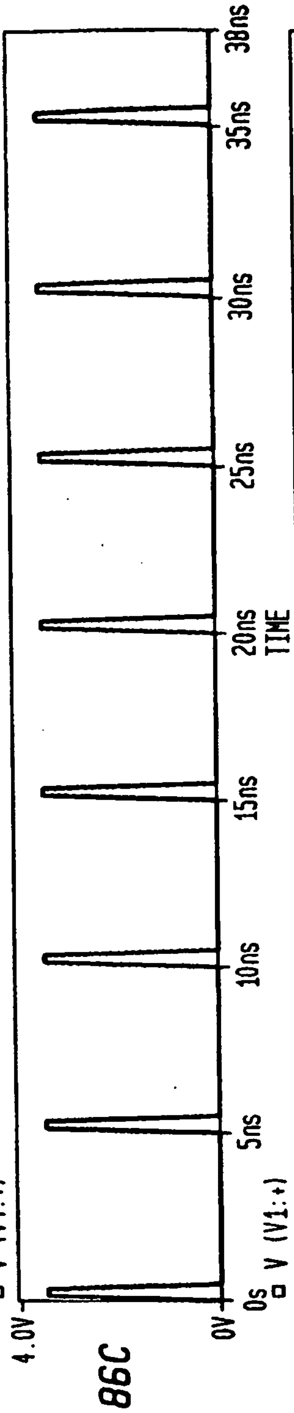


FIG. 86C

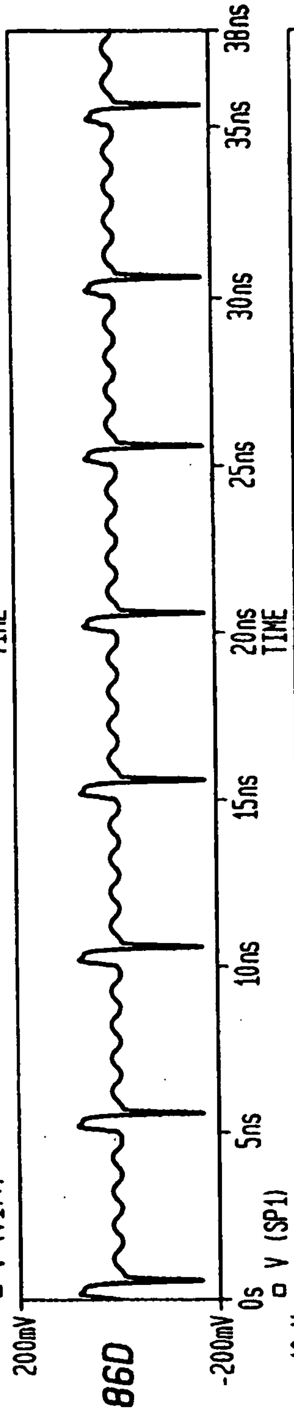


FIG. 86D

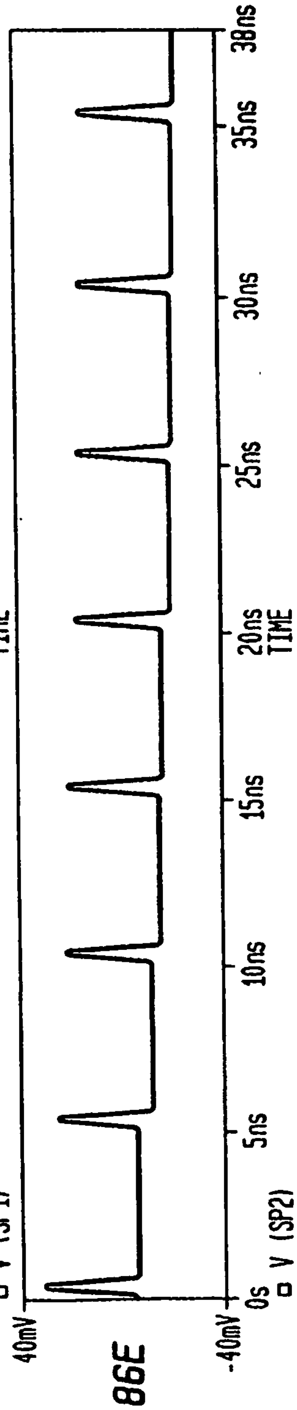


FIG. 86E

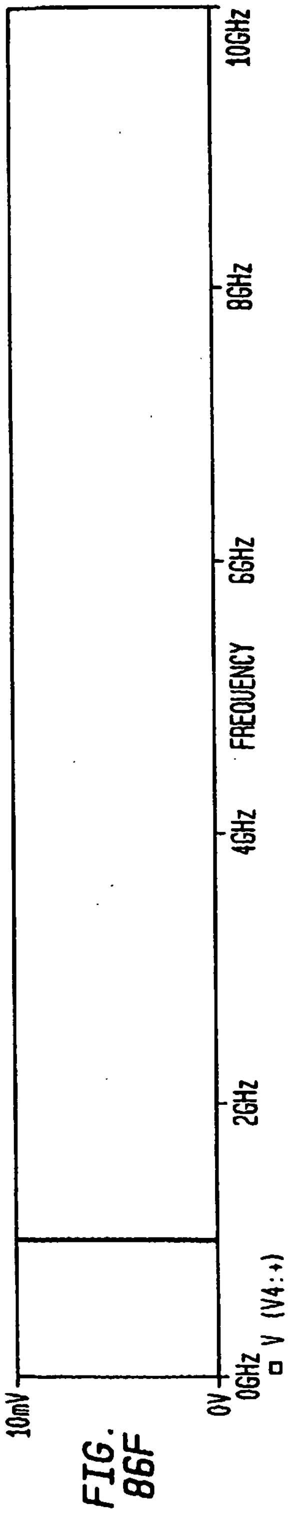


FIG. 86F

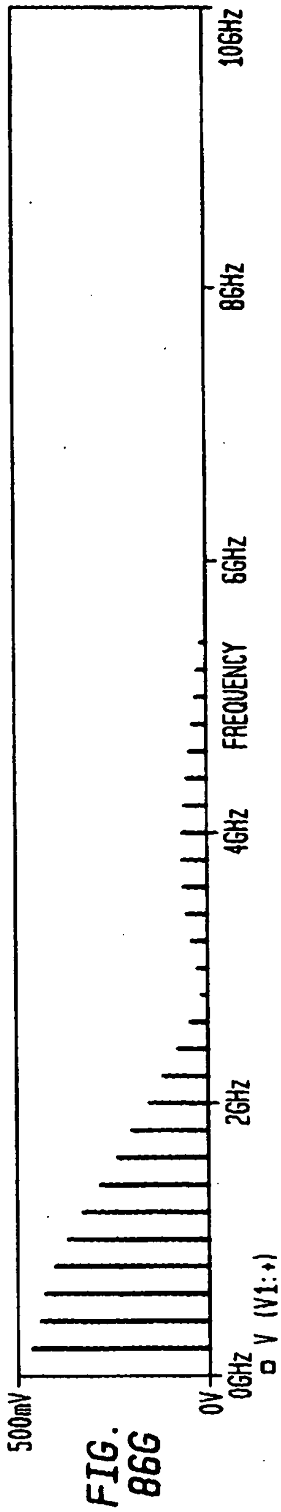


FIG. 86G

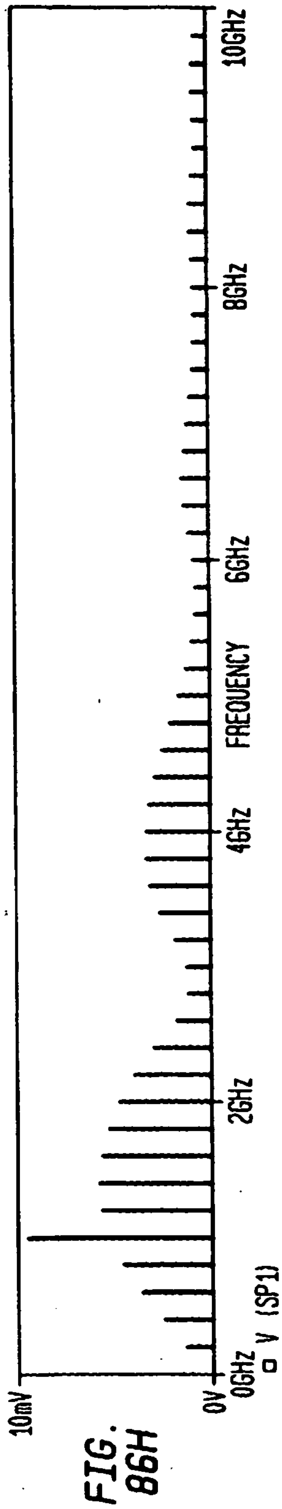


FIG. 86H

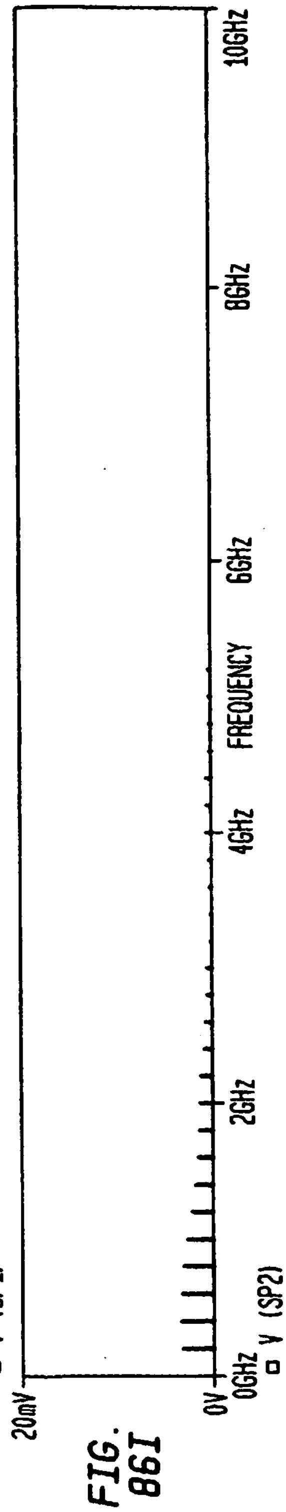


FIG. 86I

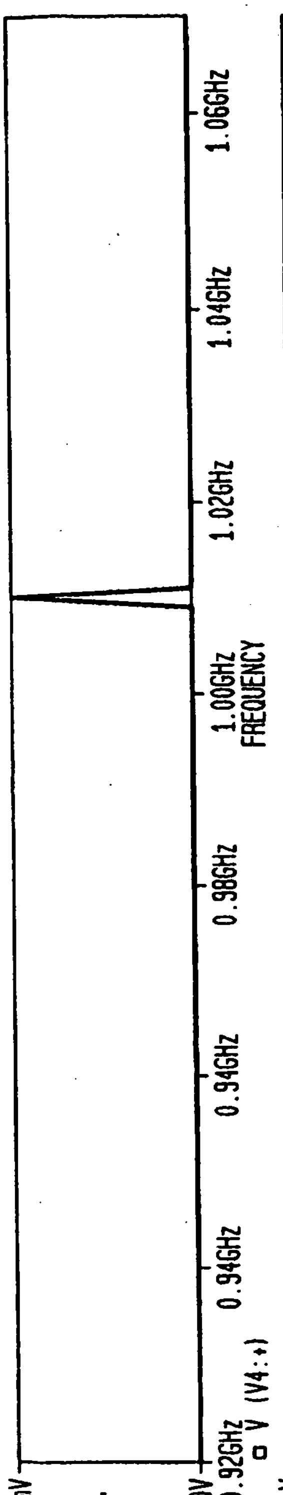


FIG. 86J

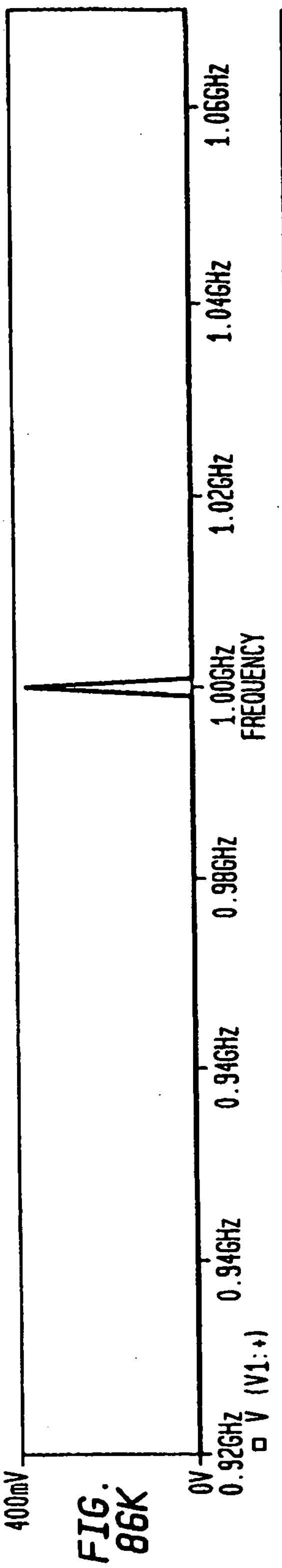


FIG. 86K

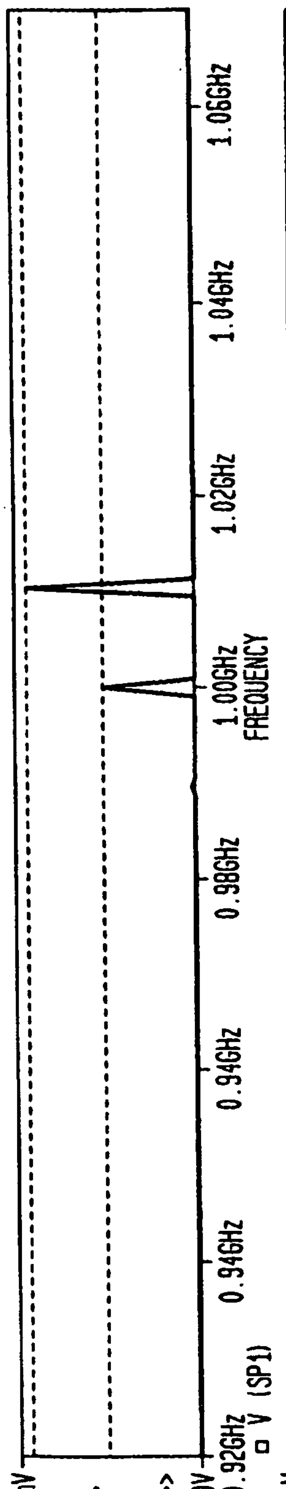


FIG. 86L

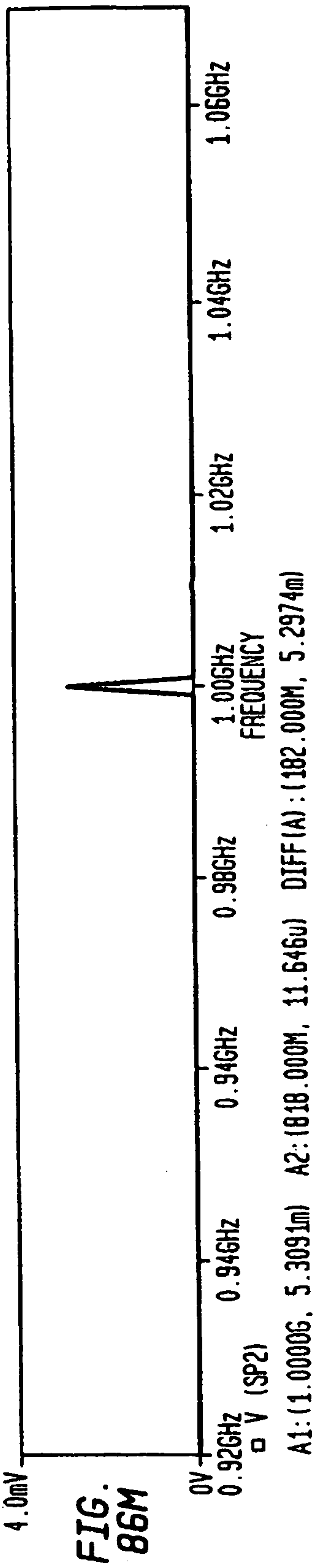


FIG. 86M

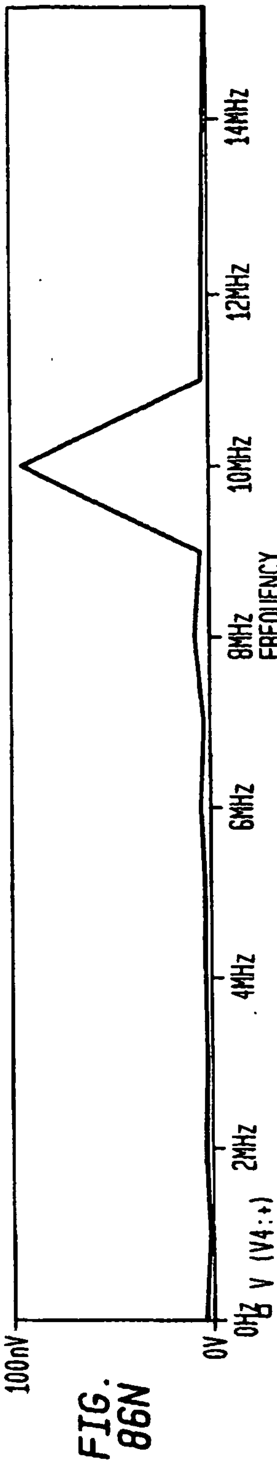


FIG. 86N

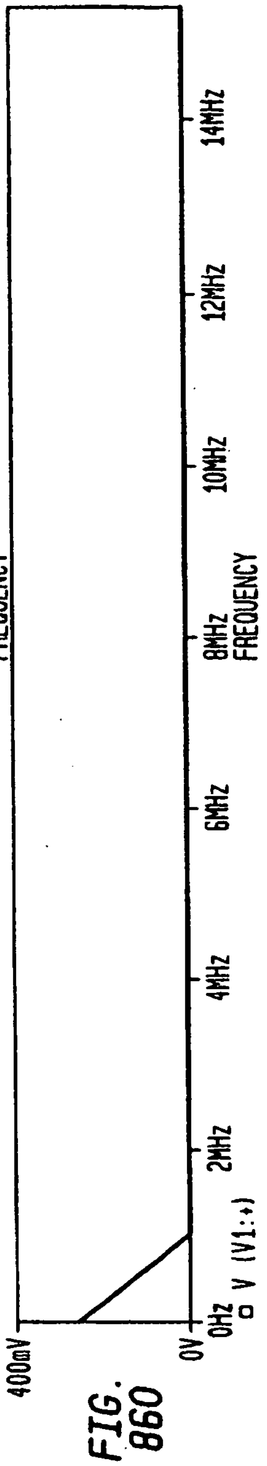


FIG. 86O

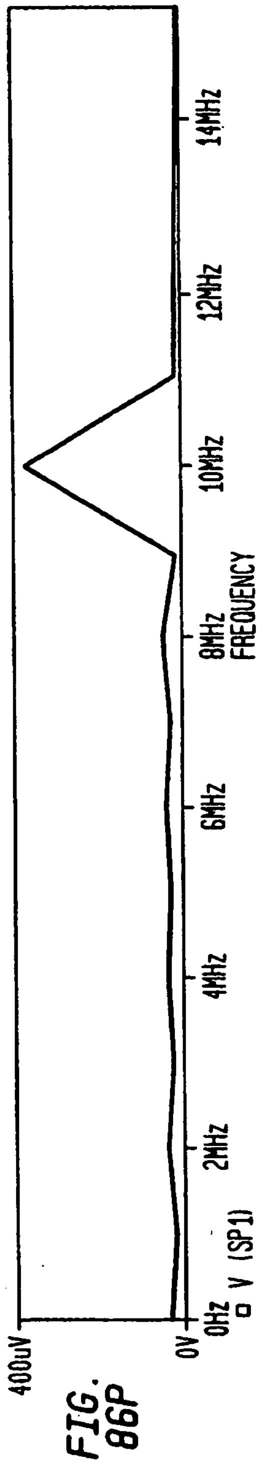


FIG. 86P

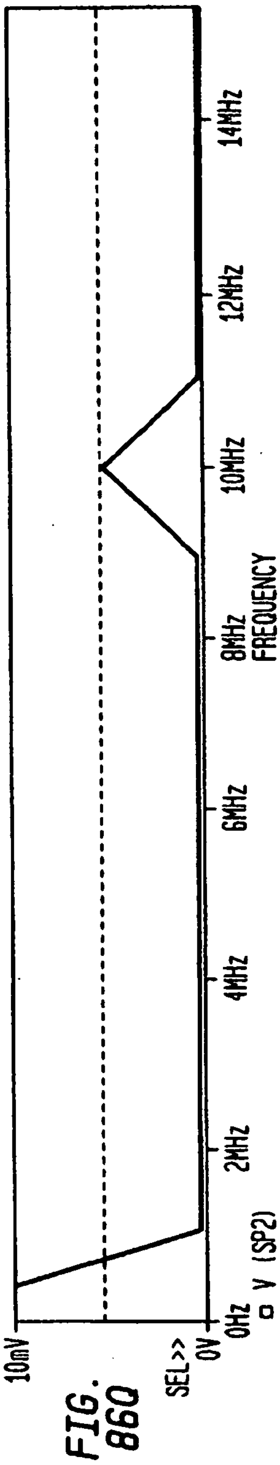


FIG. 86Q

FIG. 87A

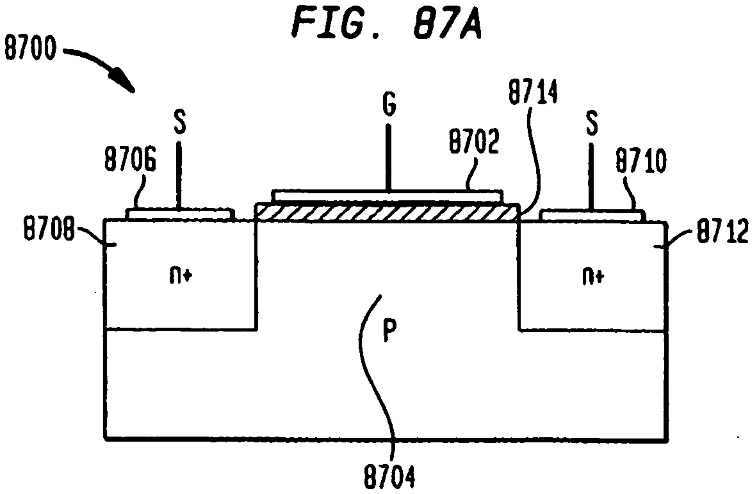


FIG. 87B

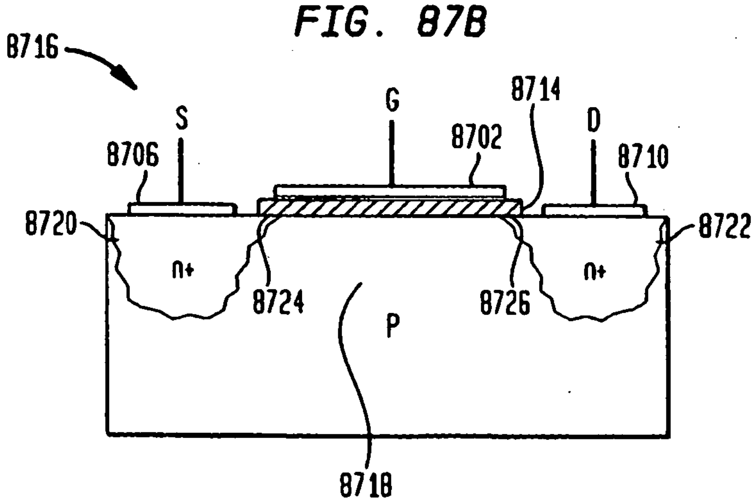

FIG. 87C

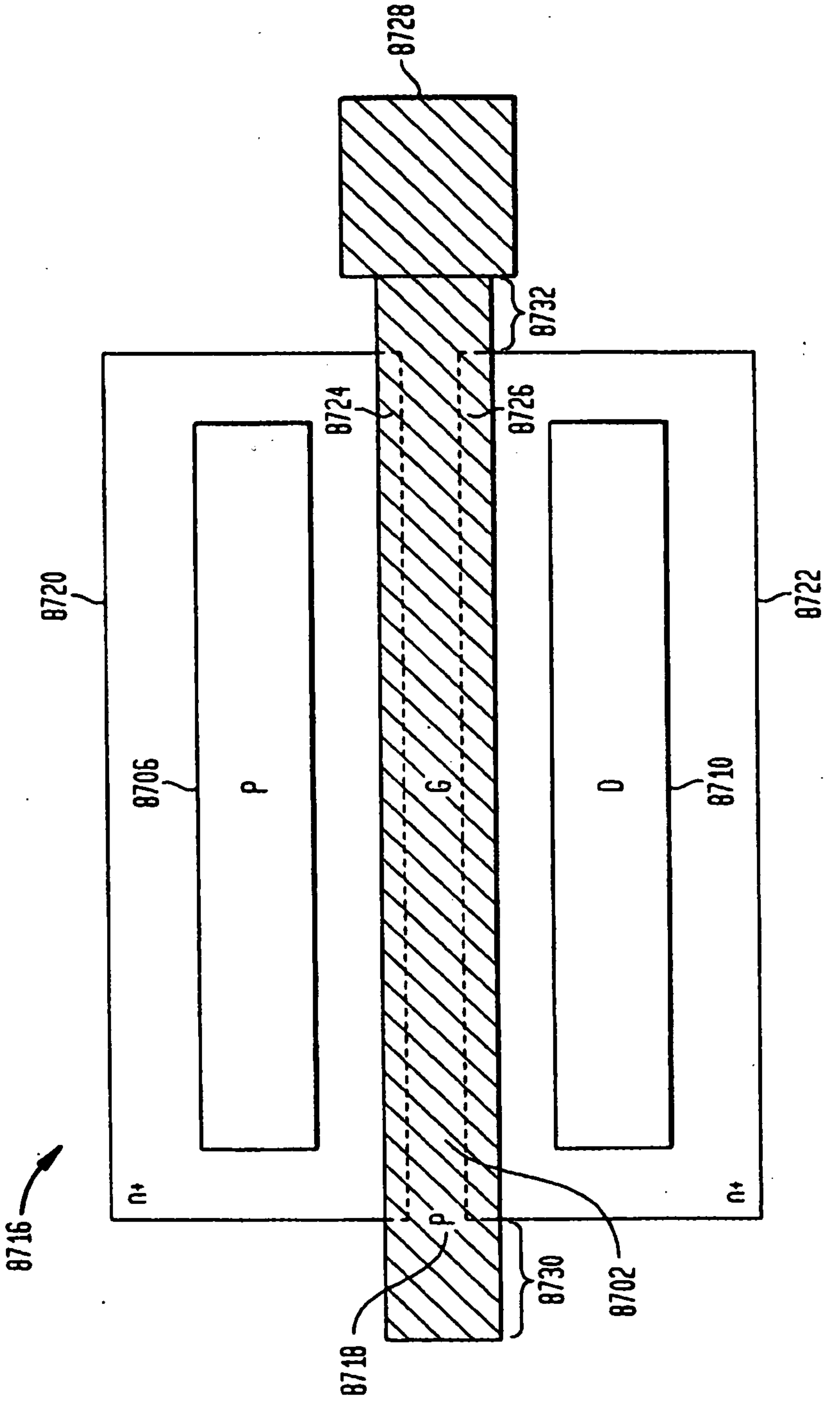
8728
8732
8724
8726
8720
8722
8706
P
G
D
8710
n+
n+
8716
P
8730
8702
8718

FIG. 88A

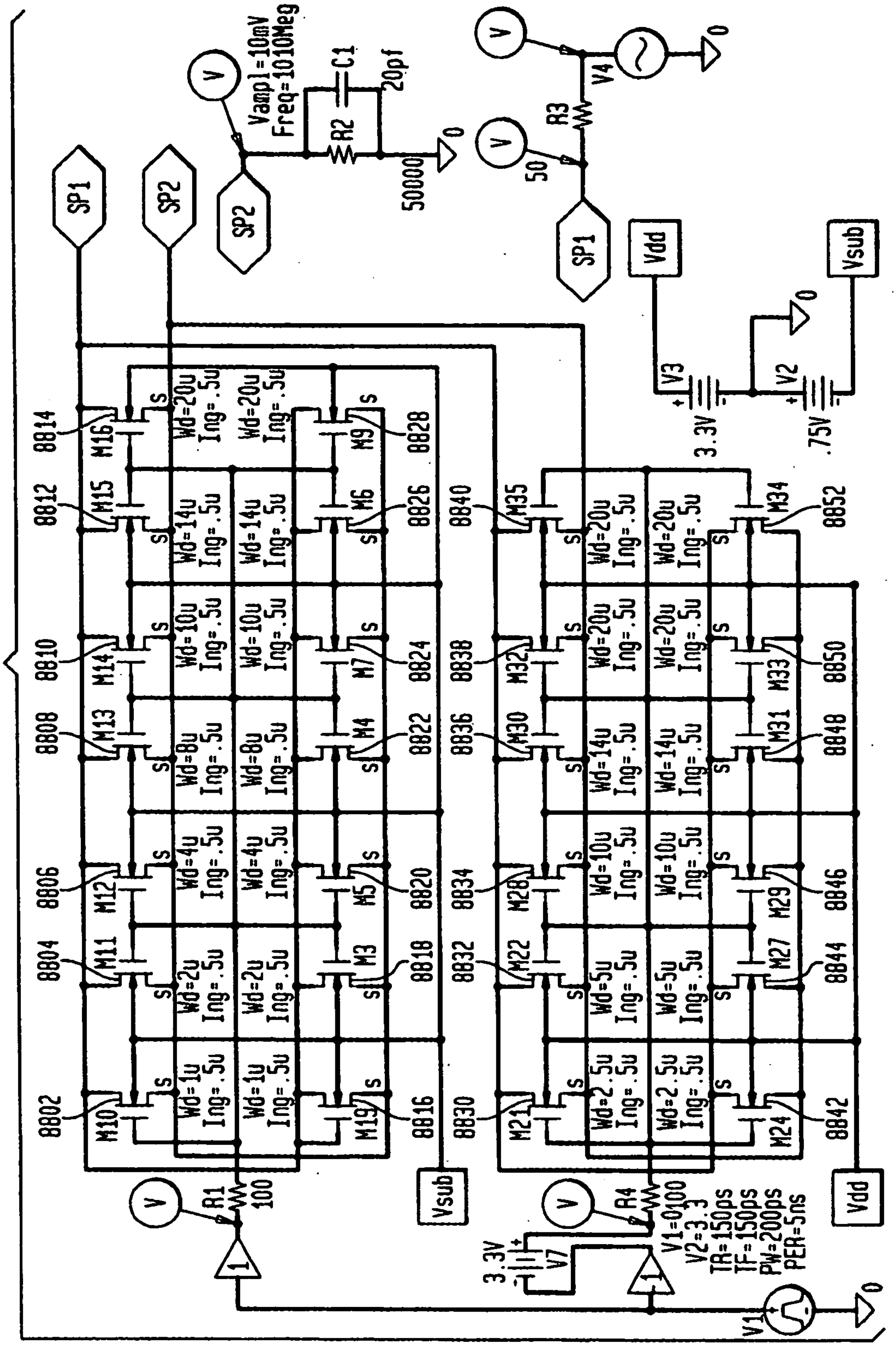
SP1
SP2
Vampl=10mV
Freq=1010Meg
R2
C1
20pf
50000
0
R3
50
V4
Vdd
Vsub
V3
3.3V
V2
.75V
8802
8804
8806
8808
8810
8812
8814
8816
8818
8820
8822
8824
8826
8828
8830
8832
8834
8836
8838
8840
8842
8844
8846
8848
8850
8852
Wd=1u
Wd=2u
Wd=4u
Wd=8u
Wd=10u
Wd=14u
Wd=20u
Wd=2.5u
Wd=5u
Lng=.5u
R1
100
R4
100
V7
3.3V
V1=0
V2=3.3
TR=150ps
TF=150ps
PW=200ps
PER=5ns
V1

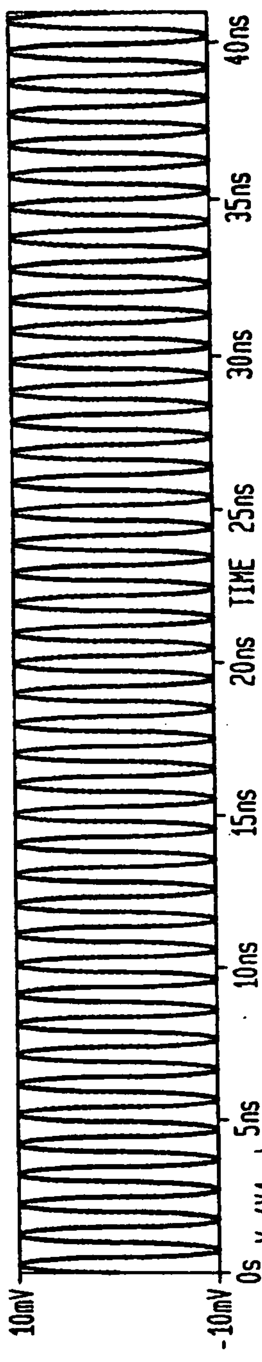


FIG. 88B

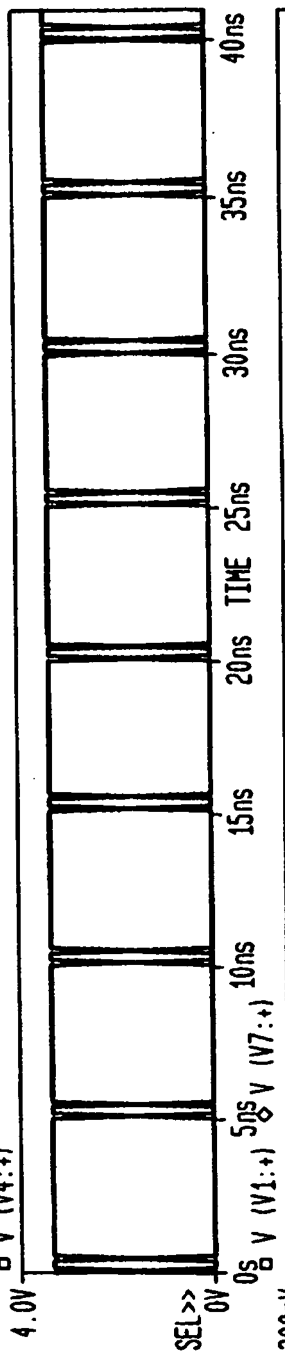


FIG. 88C

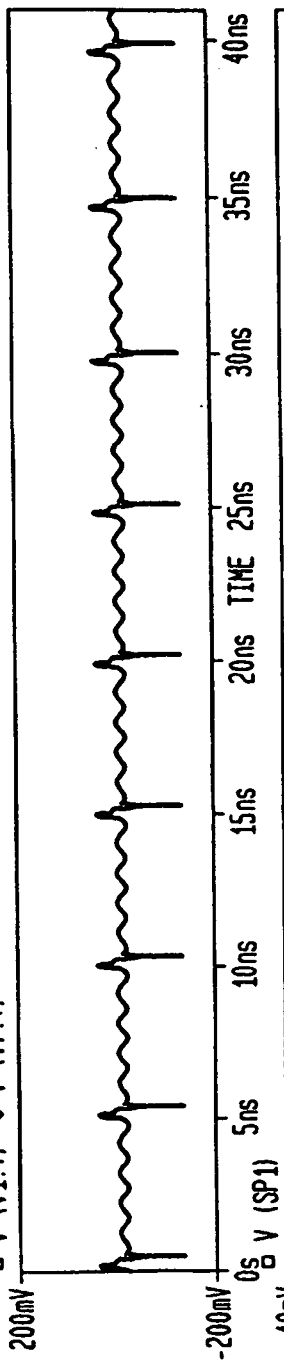


FIG. 88D

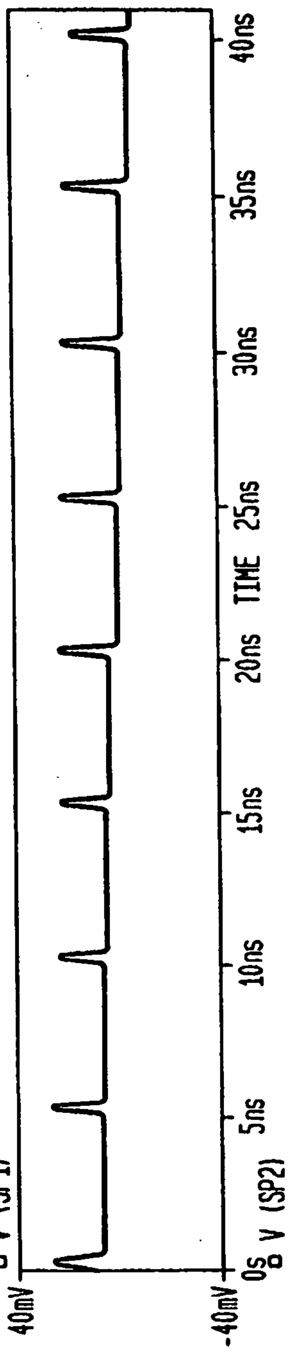


FIG. 88E

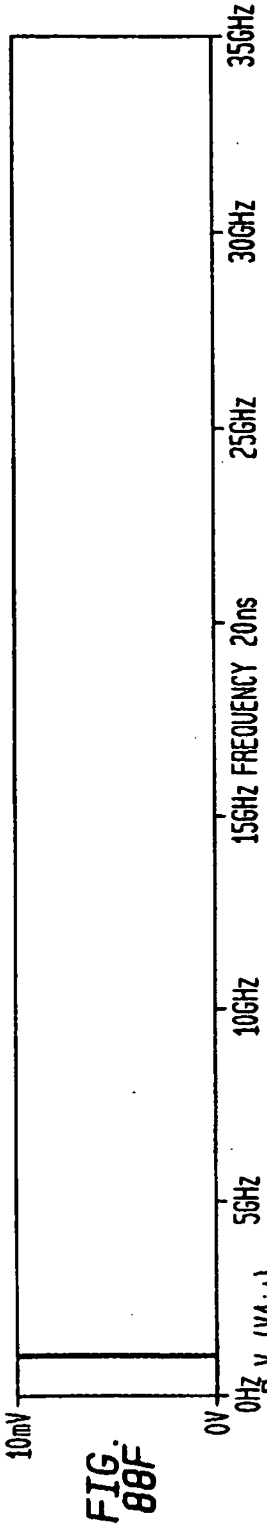


FIG. 88F

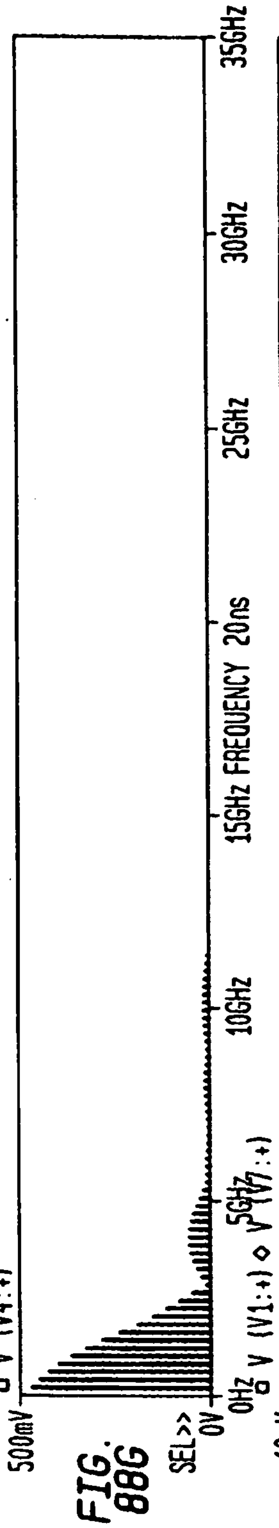


FIG. 88G

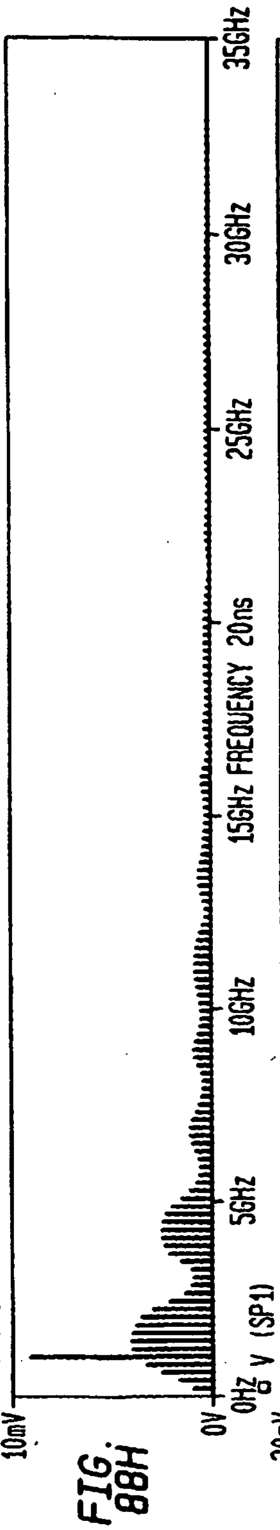


FIG. 88H

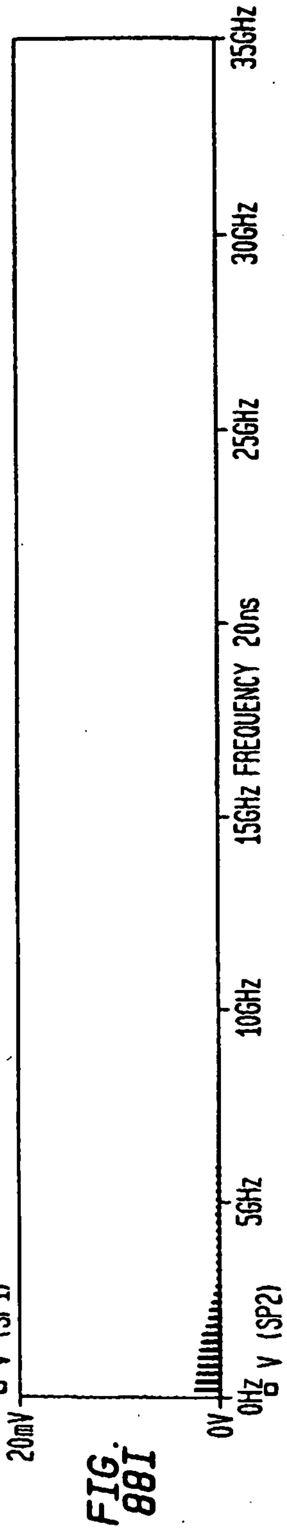


FIG. 88I

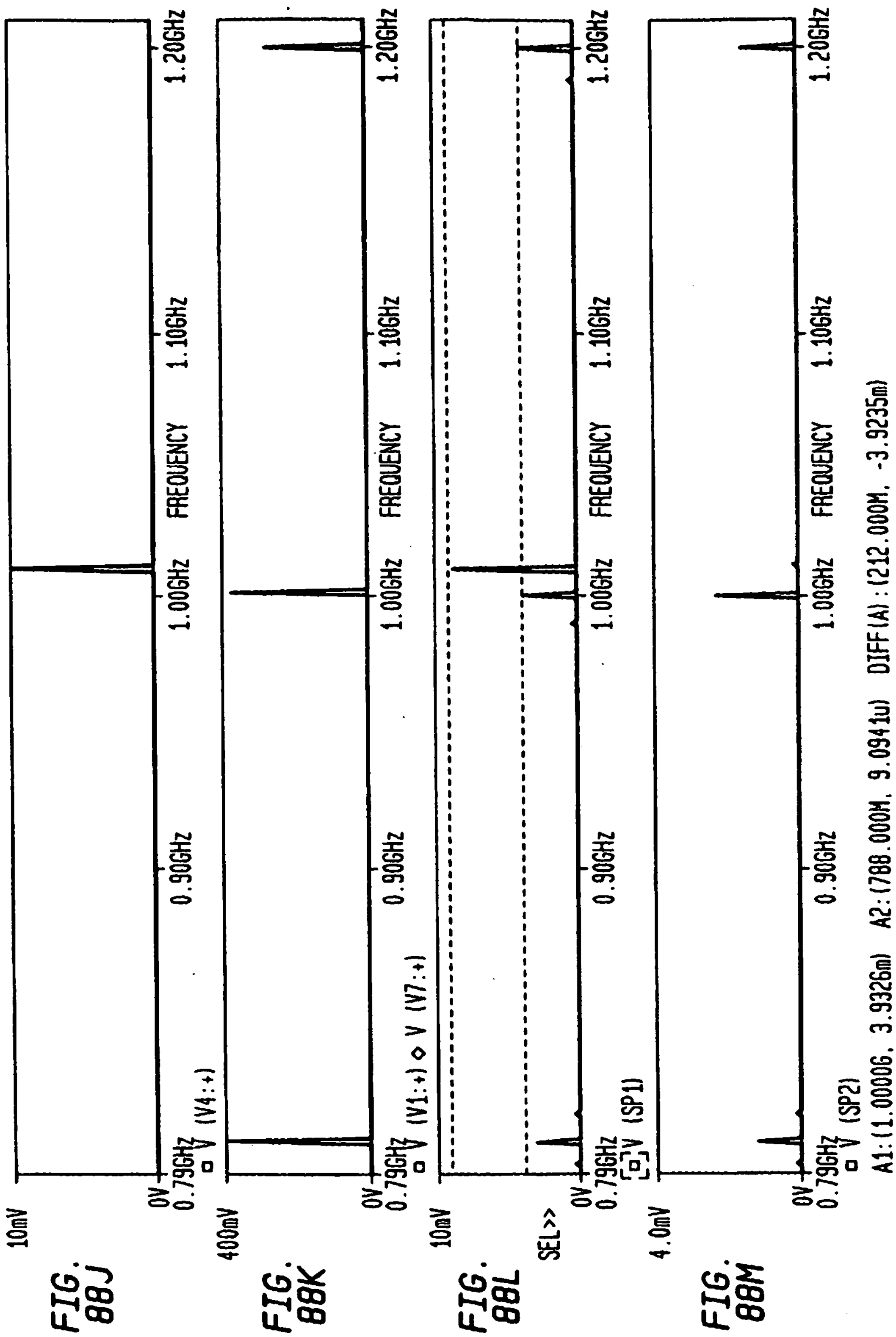


FIG. 88J

FIG. 88K

FIG. 88L

FIG. 88M

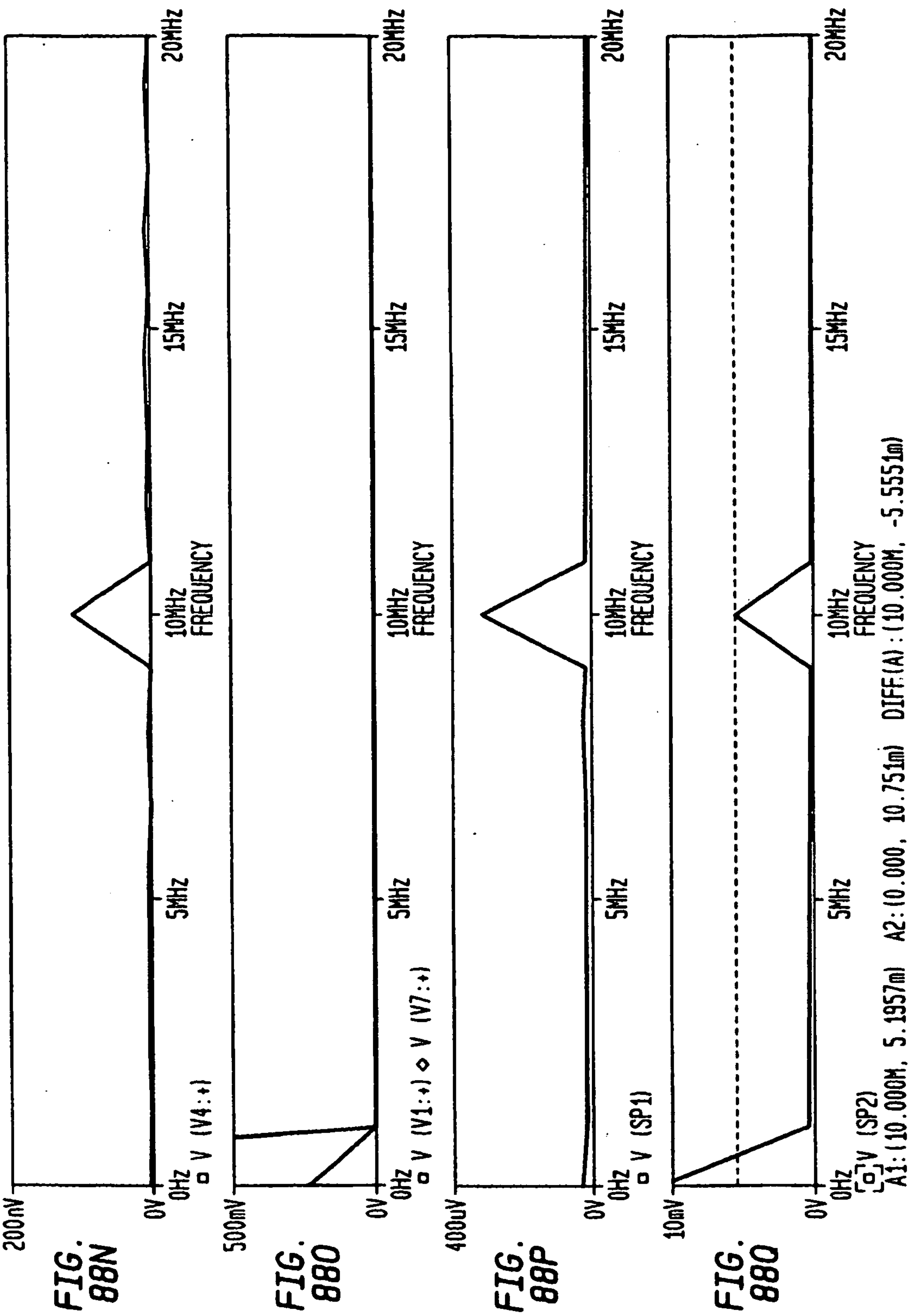


FIG. 88N

FIG. 88O

FIG. 88P

FIG. 88Q

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 9602977 A